# EUROPEAN PATENT APPLICATION

(11) **EP 4 492 948 A1**
(43) Date of publication of application: **15.01.2025**
(21) Application number: 23767053.4
(22) Date of filing: 23.02.2023
(51) Int. Cl.: H10K 85/60, H10K 50/11

(54) **ORGANIC LIGHT-EMITTING DEVICE, METHOD FOR MANUFACTURING SAME, AND COMPOSITION FOR ORGANIC MATERIAL LAYER**

(30) Priority: 07.03.2022 KR 20220028918
(71) Applicant: LT Materials Co., Ltd., Yongin-si, Gyeonggi-do 17118 (KR)
(72) Inventor: CHAE, Woo-Jeong, Yongin-si, Gyeonggi-do 17118 (KR); MO, Jun-Tae, Yongin-si, Gyeonggi-do 17118 (KR); KIM, Dong-Jun, Yongin-si, Gyeonggi-do 17118 (KR)
(74) Representative: Goddar, Heinz J.
(86) International application number: PCT/KR2023/002608
(87) International publication number: WO 2023/171951

(57) **Abstract**

The present specification relates to an organic light emitting device including a heterocyclic compound represented by Chemical Formula 1 and a heterocyclic compound represented by Chemical Formula 2, a method for manufacturing the same, and a composition for an organic material layer. Accordingly, it is possible to lower a driving voltage of the device, improve the light efficiency, and particularly improve the service life characteristics of the device by the thermal stability of the compound.

## Description

### <Cross-Reference to Related Applications>

This application claims priority to and the benefit of Korean Patent Application No. 10-2022-0028918 filed in the Korean Intellectual Property Office on March 7, 2022, the entire contents of which are incorporated herein by reference.

### [Technical Field]

The present specification relates to an organic light emitting device, a method for manufacturing the same and a composition for an organic material layer.

### [Background Art]

An organic electroluminescence device is a kind of self-emitting type display device, and has an advantage in that the viewing angle is wide, the contrast is excellent, and the response speed is fast.

An organic light emitting device has a structure in which an organic thin film is disposed between two electrodes. When a voltage is applied to an organic light emitting device having the structure, electrons and holes injected from the two electrodes combine with each other in an organic thin film to make a pair, and then, emit light while being extinguished. The organic thin film may be composed of a single layer or multiple layers, if necessary.

A material for the organic thin film may have a light emitting function, if necessary. For example, as the material for the organic thin film, it is also possible to use a compound, which may itself constitute a light emitting layer alone, or it is also possible to use a compound, which may serve as a host or a dopant of a host-dopant-based light emitting layer. In addition, as a material for the organic thin film, it is also possible to use a compound, which may perform a function such as hole injection, hole transport, electron blocking, hole blocking, electron transport or electron injection.

In order to improve the performance, service life, or efficiency of the organic light emitting device, there is a continuous need for developing a material for an organic thin film.

It is necessary to perform studies on an organic light emitting device including a compound having a chemical structure, which may satisfy conditions required for a material which is available for the organic light emitting device, for example, appropriate energy levels, electrochemical stability, thermal stability, and the like, and may perform various functions required for the organic light emitting device according to the substituent.

### [Citation List] (Patent Document 1) US Patent No. 4,356,429

### [Disclosure]

### [Technical Problem]

The present invention has been made in an effort to provide an organic light emitting device, a method for manufacturing the same, and a composition for an organic material layer.

### [Technical Solution]

Provided is an organic light emitting device including a first electrode, a second electrode and an organic material layer having one or more layers provided between the first electrode and the second electrode, in which the organic material layer includes a heterocyclic compound represented by the following Chemical Formula 1 and a heterocyclic compound represented by the following Chemical Formula 2.

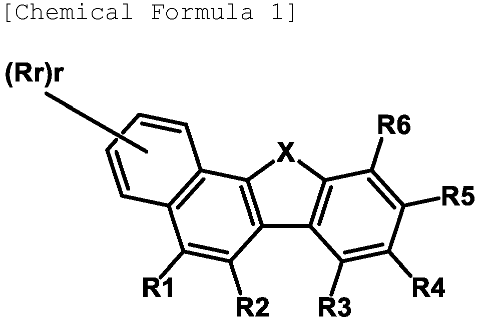

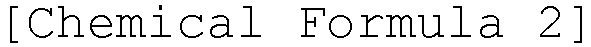

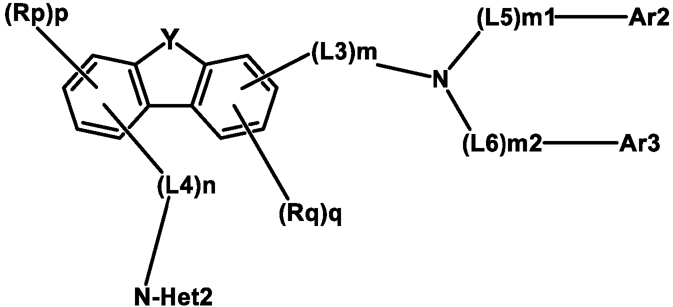

In Chemical Formulae 1 and 2,
X is O; or S,
one of R1 to R6 is 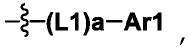 one of the others is 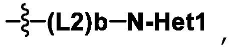 and the others are the same as or different from each other, and are each independently selected from the group consisting of hydrogen; deuterium; a halogen; a cyano group; a substituted or unsubstituted C1 to C60 alkyl group; a substituted or unsubstituted C2 to C60 alkenyl group; a substituted or unsubstituted C2 to C60 alkynyl group; a substituted or unsubstituted C1 to C60 alkoxy group; a substituted or unsubstituted C3 to C60 cycloalkyl group; a substituted or unsubstituted C2 to C60 heterocycloalkyl group; a substituted or unsubstituted C6 to C60 aryl group; a substituted or unsubstituted C2 to C60 heteroaryl group; - P(=O)RR'; -SiRR'R" and -NRR', 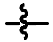
is a position which is each bonded to R1 to R6,
L1 to L6 are the same as or different from each other, and are each independently a direct bond; a substituted or unsubstituted C6 to C60 arylene group; or a substituted or unsubstituted C2 to C60 heteroarylene group, a, b, m, n, m1 and m2 are each an integer from 0 to 3, and when a, b, m, n, m1 and m2 are each 2 or higher, substituents in the parenthesis are the same as or different from each other,
N-Het1 and N-Het2 are each independently a monocyclic or polycyclic heterocyclic group which is substituted or unsubstituted and includes one or more N's,
Ar1 is a substituted or unsubstituted C6 to C60 aryl group; or a substituted or unsubstituted C2 to C60 heteroaryl group,
Y is O; or S,
Ar2 and Ar3 are the same as or different from each other, and are each independently a substituted or unsubstituted C6 to C60 aryl group; a substituted or unsubstituted C2 to C60 heteroaryl group; or -NRR',
adjacent substituents of L3, L5, L6, Ar2 and Ar3 may be bonded to each other to form a substituted or unsubstituted aliphatic or aromatic hydrocarbon ring or a substituted or unsubstituted aliphatic or aromatic hetero ring,
Rr, Rp and Rq are the same as or different from each other, and are each independently selected from the group consisting of hydrogen; deuterium; a halogen; a cyano group; a substituted or unsubstituted C1 to C60 alkyl group; a substituted or unsubstituted C2 to C60 alkenyl group; a substituted or unsubstituted C2 to C60 alkynyl group; a substituted or unsubstituted C1 to C60 alkoxy group; a substituted or unsubstituted C3 to C60 cycloalkyl group; a substituted or unsubstituted C2 to C60 heterocycloalkyl group; a substituted or unsubstituted C6 to C60 aryl group; a substituted or unsubstituted C2 to C60 heteroaryl group; - P(=O)RR'; -SiRR'R" and -NRR', r is an integer from 0 to 4, p and q are each an integer from 0 to 3, and when r, p and q are each 2 or higher, substituents in the parenthesis are the same as or different from each other, and
R, R' and R" are the same as or different from each other, and are each independently hydrogen; deuterium; a substituted or unsubstituted C1 to C60 alkyl group; a substituted or unsubstituted C6 to C60 aryl group; or a substituted or unsubstituted C2 to C60 heteroaryl group.

Further, another exemplary embodiment of the present application provides a composition for an organic material layer of an organic light emitting device, including the heterocyclic compound represented by Chemical Formula 1; and the heterocyclic compound represented by Chemical Formula 2.

Finally, an exemplary embodiment of the present application provides a method for manufacturing an organic light emitting device, the method including: preparing a substrate; forming a first electrode on the substrate; forming an organic material layer having one or more layers on the first electrode; and forming a second electrode on the organic material layer, in which the forming of the organic material layer includes forming the organic material layer having one or more layers by using the composition for an organic material layer according to an exemplary embodiment of the present application.

### [Advantageous Effects]

The compound described in the present specification may be used as a material for the organic material layer of the organic light emitting device. The compound can serve as a hole injection material, a hole transport material, a light emitting material, an electron transport material, an electron injection material, an electron blocking material, a hole blocking material, and the like in an organic light emitting device. In particular, the compound can be used as a light emitting material of an organic light emitting device.

In addition, both the heterocyclic compound represented by Chemical Formula 1 and the heterocyclic compound represented by Chemical Formula 2 can be used as a material for a light emitting layer of an organic light emitting device. In this case, it is possible to lower a driving voltage of the device, improve the light efficiency, and particularly improve the service life characteristics of the device by the thermal stability of the compound.

### [Description of Drawings]

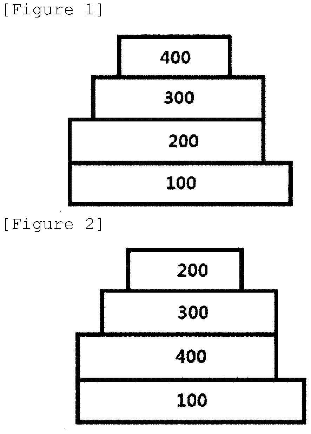

FIGS. 1 to 4 each are views schematically illustrating a stacking structure of an organic light emitting device according to an exemplary embodiment of the present application.

### [Explanation of Reference Numerals and Symbols]

100: Substrate
200: Positive electrode
300: Organic material layer
301: Hole injection layer
302: Hole transport layer
303: Light emitting layer
304: Hole blocking layer
305: Electron transport layer
306: Electron injection layer
400: Negative electrode

### [Best Mode]

Hereinafter, the present application will be described in detail.

Provided is an organic light emitting device including a first electrode, a second electrode and an organic material layer having one or more layers provided between the first electrode and the second electrode, in which the organic material layer includes a heterocyclic compound represented by the following Chemical Formula 1 and a heterocyclic compound represented by the following Chemical Formula 2.

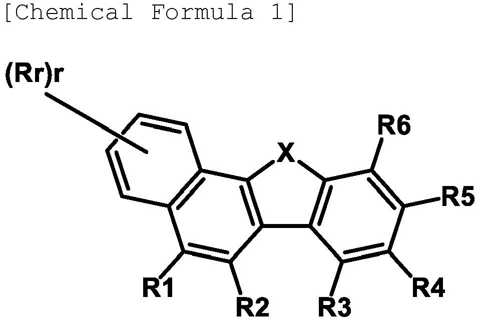

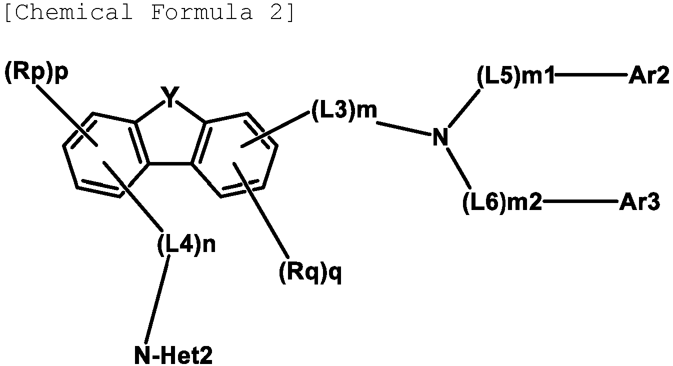

In Chemical Formulae 1 and 2,
X is O; or S,
one of R1 to R6 is **-** 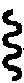 **-(L1)a-Ar1**, one of the others is **-** 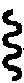 **-(L2)b-N-Het1**, and the others are the same as or different from each other, and are each independently selected from the group consisting of hydrogen; deuterium; a halogen; a cyano group; a substituted or unsubstituted C1 to C60 alkyl group; a substituted or unsubstituted C2 to C60 alkenyl group; a substituted or unsubstituted C2 to C60 alkynyl group; a substituted or unsubstituted C1 to C60 alkoxy group; a substituted or unsubstituted C3 to C60 cycloalkyl group; a substituted or unsubstituted C2 to C60 heterocycloalkyl group; a substituted or unsubstituted C6 to C60 aryl group; a substituted or unsubstituted C2 to C60 heteroaryl group; - P(=O)RR'; -SiRR'R" and -NRR', 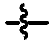
is a position which is each bonded to R1 to R6,
L1 to L6 are the same as or different from each other, and are each independently a direct bond; a substituted or unsubstituted C6 to C60 arylene group; or a substituted or unsubstituted C2 to C60 heteroarylene group, a, b, m, n, m1 and m2 are each an integer from 0 to 3, and when a, b, m, n, m1 and m2 are each 2 or higher, substituents in the parenthesis are the same as or different from each other,
N-Het1 and N-Het2 are each independently a monocyclic or polycyclic heterocyclic group which is substituted or unsubstituted and includes one or more N's,
Ar1 is a substituted or unsubstituted C6 to C60 aryl group; or a substituted or unsubstituted C2 to C60 heteroaryl group,
Y is O; or S,
Ar2 and Ar3 are the same as or different from each other, and are each independently a substituted or unsubstituted C6 to C60 aryl group; a substituted or unsubstituted C2 to C60 heteroaryl group; or -NRR',
adjacent substituents of L3, L5, L6, Ar2 and Ar3 may be bonded to each other to form a substituted or unsubstituted aliphatic or aromatic hydrocarbon ring or a substituted or unsubstituted aliphatic or aromatic hetero ring,
Rr, Rp and Rq are the same as or different from each other, and are each independently selected from the group consisting of hydrogen; deuterium; a halogen; a cyano group; a substituted or unsubstituted C1 to C60 alkyl group; a substituted or unsubstituted C2 to C60 alkenyl group; a substituted or unsubstituted C2 to C60 alkynyl group; a substituted or unsubstituted C1 to C60 alkoxy group; a substituted or unsubstituted C3 to C60 cycloalkyl group; a substituted or unsubstituted C2 to C60 heterocycloalkyl group; a substituted or unsubstituted C6 to C60 aryl group; a substituted or unsubstituted C2 to C60 heteroaryl group; - P(=O)RR'; -SiRR'R" and -NRR', r is an integer from 0 to 4, p and q are each an integer from 0 to 3, and when r, p and q are each 2 or higher, substituents in the parenthesis are the same as or different from each other, and
R, R' and R" are the same as or different from each other, and are each independently hydrogen; deuterium; a substituted or unsubstituted C1 to C60 alkyl group; a substituted or unsubstituted C6 to C60 aryl group; or a substituted or unsubstituted C2 to C60 heteroaryl group.

The heterocyclic compound of Chemical Formula 1 of the present invention has excellent electron transport ability, high thermal stability and appropriate molecular weight and band-gap. Such an appropriate band-gap has a good hole transport ability, and prevents the loss of electrons to enable the effective formation of a recombination zone.

Furthermore, the heterocyclic compound represented by Chemical Formula 2 of the present invention has excellent hole mobility, and easily reduces current leakage and confines electrons by blocking electrons.

Therefore, when the organic material layer of an organic light emitting device includes the heterocyclic compound represented by Chemical Formula 1 and the heterocyclic compound represented by Chemical Formula 2, the efficiency and service life of the device may be improved. In particular, when the organic material layer is a light emitting layer, the efficiency and service life of the device may be further improved.

When one part "includes" one constituent element in the present specification, unless otherwise specifically described, this does not mean that another constituent element is excluded, but means that another constituent element may be further included.

In the present specification, 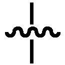 of a chemical formula means a position to which a constituent element is bonded.

The term "substitution" means that a hydrogen atom bonded to a carbon atom of a compound is changed into another substituent, and a position to be substituted is not limited as long as the position is a position at which the hydrogen atom is substituted, that is, a position at which the substituent may be substituted, and when two or more are substituted, the two or more substituents may be the same as or different from each other.

In the present specification, "substituted or unsubstituted" means being unsubstituted or substituted with one or more substituents selected from the group consisting of deuterium; a halogen group; -CN; a C1 to C60 alkyl group; a C2 to C60 alkenyl group; a C2 to C60 alkynyl group; a C1 to C60 haloalkyl group; a C1 to C60 alkoxy group; a C6 to C60 aryloxy group; a C1 to C60 alkylthioxy group; a C6 to C60 arylthioxy group; a C1 to C60 alkylsulfoxy group; a C6 to C60 arylsulfoxy group; a C3 to C60 cycloalkyl group; a C2 to C60 heterocycloalkyl group; a C6 to C60 aryl group; a C2 to C60 heteroaryl group; -SiRR'R"; -P(=O)RR'; and -NRR', or a substituent to which two or more substituents selected among the exemplified substituents are linked, and R, R' and R" are each independently a substituent composed of at least one of hydrogen; deuterium; a halogen group; an alkyl group; an alkenyl group; an alkoxy group; a cycloalkyl group; a heterocycloalkyl group; an aryl group; and a heteroaryl group.

In the present specification, "Cn" means that the number of carbon atoms is n. For example, C6 means 6 carbon atoms and C60 means 60 carbon atoms.

In the present specification, "when a substituent is not indicated in the structure of a chemical formula or compound" means that a hydrogen atom is bonded to a carbon atom. However, since deuterium (²H) is an isotope of hydrogen, some hydrogen atoms may be deuterium.

In an exemplary embodiment of the present application, "when a substituent is not indicated in the structure of a chemical formula or compound" may mean that all the positions that may be reached by the substituent are hydrogen or deuterium. That is, deuterium is an isotope of hydrogen, and some hydrogen atoms may be deuterium which is an isotope, and in this case, the content of deuterium may be 0% to 100%.

In an exemplary embodiment of the present application, in "the case where a substituent is not indicated in the structure of a chemical formula or compound", when the content of deuterium is 0%, the content of hydrogen is 100%, and all the substituents do not explicitly exclude deuterium such as hydrogen, hydrogen and deuterium may be mixed and used in the compound.

In an exemplary embodiment of the present application, deuterium is one of the isotopes of hydrogen, is an element that has a deuteron composed of one proton and one neutron as a nucleus, and may be represented by hydrogen-2, and the element symbol may also be expressed as D or ²H.

In an exemplary embodiment of the present application, the isotope means an atom with the same atomic number (Z), but different mass numbers (A), and the isotope may also be interpreted as an element which has the same number of protons, but different number of neutrons.

In an exemplary embodiment of the present application, when the total number of substituents of a basic compound is defined as T1 and the number of specific substituents among the substituents is defined as T2, the content T% of the specific substituent may be defined as T2/T1×100 = T%.

That is, in an example, the deuterium content of 20% in a phenyl group represented by 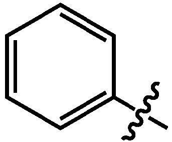 may be represented by 20% when the total number of substituents that the phenyl group can have is 5 (T1 in the formula) and the number of deuteriums among the substituents is 1 (T2 in the formula). That is, a deuterium content of 20% in the phenyl group may be represented by the following structural formula.

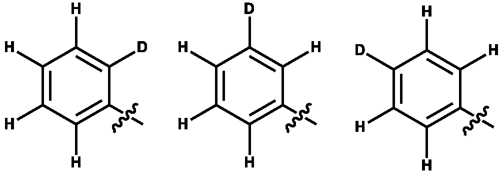

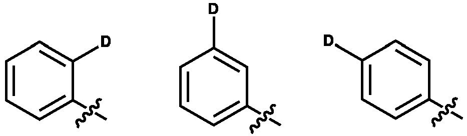

Further, in an exemplary embodiment of the present application, "a phenyl group having a deuterium content of 0%" may mean a phenyl group that does not include a deuterium atom, that is, has five hydrogen atoms.

In the present specification, the halogen may be fluorine, chlorine, bromine or iodine.

In the present specification, an alkyl group includes a straight-chain or branched-chain having 1 to 60 carbon atoms, and may be additionally substituted with another substituent. The number of carbon atoms of the alkyl group may be 1 to 60, specifically 1 to 40, and more specifically 1 to 20. Specific examples thereof include a methyl group, an ethyl group, a propyl group, an n-propyl group, an isopropyl group, a butyl group, an n-butyl group, an isobutyl group, a tert-butyl group, a sec-butyl group, a 1-methyl-butyl group, a 1-ethyl-butyl group, a pentyl group, an n-pentyl group, an isopentyl group, a neopentyl group, a tert-pentyl group, a hexyl group, an n-hexyl group, a 1-methylpentyl group, a 2-methylpentyl group, a 4-methyl-2-pentyl group, a 3,3-dimethylbutyl group, a 2-ethylbutyl group, a heptyl group, an n-heptyl group, a 1-methylhexyl group, an octyl group, an n-octyl group, a tert-octyl group, a 1-methylheptyl group, a 2-ethylhexyl group, a 2-propylpentyl group, an n-nonyl group, a 2,2-dimethylheptyl group, a 1-ethyl-propyl group, a 1,1-dimethyl-propyl group, an isohexyl group, a 2-methylpentyl group, a 4-methylhexyl group, a 5-methylhexyl group, and the like, but are not limited thereto.

In the present specification, an alkenyl group includes a straight-chain or branched-chain having 2 to 60 carbon atoms, and may be additionally substituted with another substituent. The number of carbon atoms of the alkenyl group may be 2 to 60, specifically 2 to 40, and more specifically 2 to 20. Specific examples thereof include a vinyl group, a 1-propenyl group, an isopropenyl group, a 1-butenyl group, a 2-butenyl group, a 3-butenyl group, a 1-pentenyl group, a 2-pentenyl group, a 3-pentenyl group, a 3-methyl-1-butenyl group, a 1,3-butadienyl group, an allyl group, a 1-phenylvinyl-1-yl group, a 2-phenylvinyl-1-yl group, a 2,2-diphenylvinyl-1-yl group, a 2-phenyl-2-(naphthyl-1-yl)vinyl-1-yl group, a 2,2-bis(diphenyl-1-yl)vinyl-1-yl group, a stilbenyl group, a styrenyl group, and the like, but are not limited thereto.

In the present specification, an alkynyl group includes a straight-chain or branched-chain having 2 to 60 carbon atoms, and may be additionally substituted with another substituent. The number of carbon atoms of the alkynyl group may be 2 to 60, specifically 2 to 40, and more specifically 2 to 20.

In the present specification, a haloalkyl group means an alkyl group substituted with a halogen group, and specific examples thereof include -CF₃, -CF₂CF₃, and the like, but are not limited thereto.

In the present specification, an alkoxy group is represented by -O(R101), and the above-described examples of the alkyl group may be applied to R101.

In the present specification, an aryloxy group is represented by -O(R102), and the above-described examples of the aryl group may be applied to R102.

In the present specification, an alkylthioxy group is represented by -S(R103), and the above-described examples of the alkyl group may be applied to R103.

In the present specification, an arylthioxy group is represented by -S(R104), and the above-described examples of the aryl group may be applied to R104.

In the present specification, an alkylsulfoxy group is represented by -S(=0)₂(R105), and the above-described examples of the alkyl group may be applied to R105.

In the present specification, an arylsulfoxy group is represented by -S(=0)₂(R106), and the above-described examples of the aryl group may be applied to R106.

In the present specification, a cycloalkyl group includes a monocycle or polycycle having 3 to 60 carbon atoms, and may be additionally substituted with another substituent. Here, the polycycle means a group in which a cycloalkyl group is directly linked to or fused with another cyclic group. Here, another cyclic group may also be a cycloalkyl group, but may also be another kind of cyclic group, for example, a heterocycloalkyl group, an aryl group, a heteroaryl group, and the like. The number of carbon atoms of the cycloalkyl group may be 3 to 60, specifically 3 to 40, and more specifically 5 to 20. Specific examples thereof include a cyclopropyl group, a cyclobutyl group, a cyclopentyl group, a 3-methylcyclopentyl group, a 2,3-dimethylcyclopentyl group, a cyclohexyl group, a 3-methylcyclohexyl group, a 4-methylcyclohexyl group, a 2,3-dimethylcyclohexyl group, a 3,4,5-trimethylcyclohexyl group, a 4-tert-butylcyclohexyl group, a cycloheptyl group, a cyclooctyl group, and the like, but are not limited thereto.

In the present specification, a heterocycloalkyl group includes O, S, Se, N, or Si as a heteroatom, includes a monocycle or polycycle having 2 to 60 carbon atoms, and may be additionally substituted with another substituent. Here, the polycycle means a group in which a heterocycloalkyl group is directly linked to or fused with another cyclic group. Here, another cyclic group may also be a heterocycloalkyl group, but may also be another kind of cyclic group, for example, a cycloalkyl group, an aryl group, a heteroaryl group, and the like. The number of carbon atoms of the heterocycloalkyl group may be 2 to 60, specifically 2 to 40, and more specifically 3 to 20.

In the present specification, an aryl group includes a monocycle or polycycle having 6 to 60 carbon atoms, and may be additionally substituted with another substituent. Here, the polycycle means a group in which an aryl group is directly linked to or fused with another cyclic group. Here, another cyclic group may also be an aryl group, but may also be another kind of cyclic group, for example, a cycloalkyl group, a heterocycloalkyl group, a heteroaryl group, and the like. The aryl group includes a spiro group. The number of carbon atoms of the aryl group may be 6 to 60, specifically 6 to 40, and more specifically 6 to 25. Specific examples of the aryl group include a phenyl group, a biphenyl group, a terphenyl group, a naphthyl group, an anthryl group, a chrysenyl group, a phenanthrenyl group, a perylenyl group, a fluoranthenyl group, a triphenylenyl group, a phenalenyl group, a pyrenyl group, a tetracenyl group, a pentacenyl group, a fluorenyl group, an indenyl group, an acenaphthylenyl group, a benzofluorenyl group, a spirobifluorenyl group, a 2,3-dihydro-1H-indenyl group, a fused cyclic group thereof, and the like, but are not limited thereto.

In the present specification, the terphenyl group may be selected from the following structures.

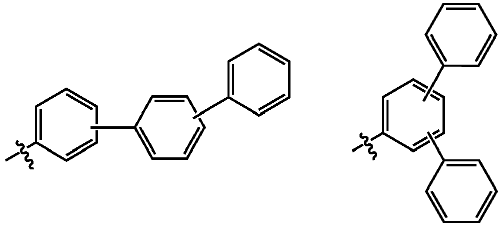

In the present specification, the fluorenyl group may be substituted, and adjacent substituents may be bonded to each other to form a ring.When the fluorenyl group is substituted, the substituent may be the following structures, but is not limited thereto.

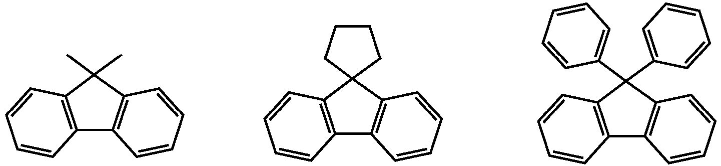

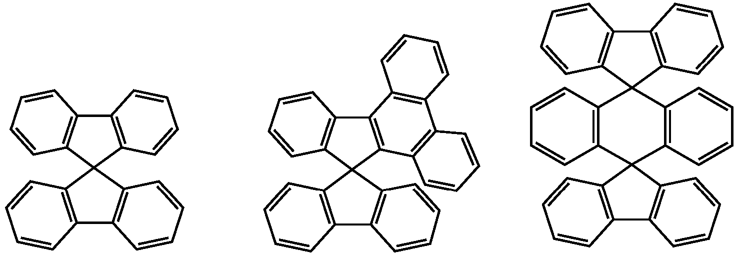

In the present specification, a heteroaryl group includes S, O, Se, N, or Si as a heteroatom, includes a monocycle or polycycle having 2 to 60 carbon atoms, and may be additionally substituted with another substituent. Here, the polycycle means a group in which a heteroaryl group is directly linked to or fused with another cyclic group. Here, another cyclic group may also be a heteroaryl group, but may also be another kind of cyclic group, for example, a cycloalkyl group, a heterocycloalkyl group, an aryl group, and the like. The number of carbon atoms of the heteroaryl group may be 2 to 60, specifically 2 to 40, and more specifically 3 to 25. Specific examples of the heteroaryl group include a pyridine group, a pyrrole group, a pyrimidine group, a pyridazine group, a furan group, a thiophene group, an imidazole group, a pyrazole group, an oxazole group, an isoxazole group, a thiazole group, an isothiazole group, a triazole group, a furazan group, an oxadiazole group, a thiadiazole group, a dithiazole group, a tetrazolyl group, a pyran group, a thiopyran group, a diazine group, an oxazine group, a thiazine group, a dioxin group, a triazine group, a tetrazine group, a quinoline group, an isoquinoline group, a quinazoline group, an isoquinazoline group, a quinozoline group, a naphthyridine group, an acridine group, a phenanthridine group, an imidazopyridine group, a diazanaphthalene group, a triazaindene group, an indole group, an indolizine group, a benzothiazole group, a benzoxazole group, a benzimidazole group, a benzothiophene group, a benzofuran group, a dibenzothiophene group, a dibenzofuran group, a carbazole group, a benzocarbazole group, a dibenzocarbazole group, a phenazine group, a dibenzosilole group, spirobi(dibenzosilole) group, a dihydrophenazine group, a phenoxazine group, a phenanthridine group, a thienyl group, an indolo[2,3-a]carbazole group, an indolo[2,3-b]carbazole group, an indoline group, a 10,11-dihydro-dibenzo[b,f]azepine group, a 9,10-dihydroacridine group, a phenanthrazine group, a phenothiazine group, a phthalazine group, a phenanthroline group, a naphthobenzofuran group, a naphthobenzothiophene group, a benzo[c][1,2,5]thiadiazole group, a 2,3-dihydrobenzo[b]thiophene group, a 2,3-dihydrobenzofuran group, a 5,10-dihydrodibenzo[b,e][1,4]azasiline group, a pyrazolo[1,5-c]quinazoline group, a pyrido[1,2-b]indazole group, a pyrido[1,2-a]imidazo[1,2-e]indoline group, a 5,11-dihydroindeno[1,2-b]carbazole group, and the like, but are not limited thereto.

In the present specification, when the substituent is a carbazole group, it means being bonded to nitrogen or carbon of carbazole.

In the present specification, when a carbazole group is substituted, an additional substituent may be substituted with the nitrogen or carbon of the carbazole.
In the present specification, a benzocarbazole group may be any one of the following structures.

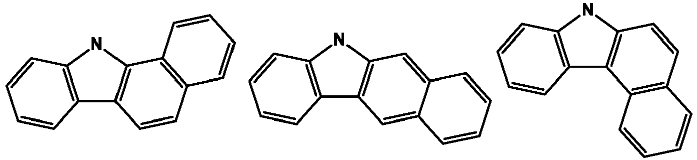

In the present specification, a dibenzocarbazole group may be any one of the following structures.

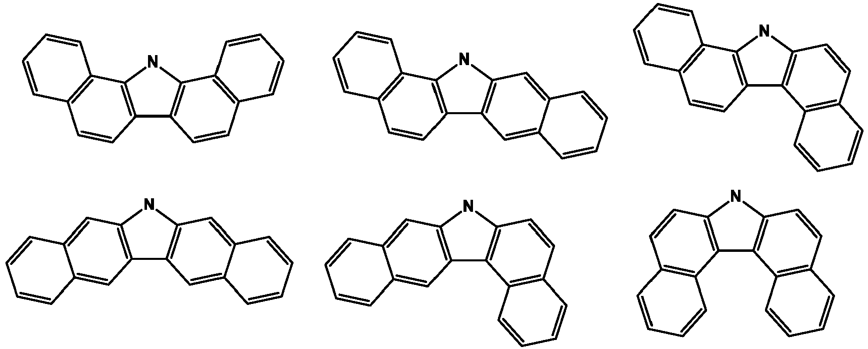

In the present specification, a naphthobenzofuran group may be any one of the following structures.

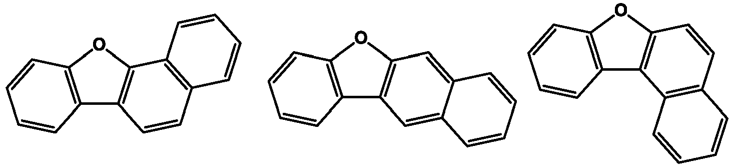

In the present specification, a naphthobenzothiophene group may be any one of the following structures.

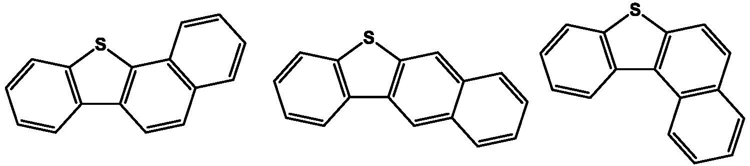

In the present specification, a silyl group includes Si and is a substituent to which the Si atom is directly linked as a radical, and is represented by -Si(R107) (R108) (R109), and R107 to R109 are the same as or different from each other, and may be each independently a substituent composed of at least one of hydrogen; deuterium; a halogen group; an alkyl group; an alkenyl group; an alkoxy group; a cycloalkyl group; a heterocycloalkyl group; an aryl group; and a heteroaryl group.

Specific examples of the silyl group include 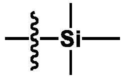 (a trimethylsilyl group), 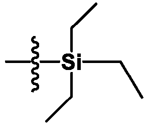 (a triethylsilyl group), 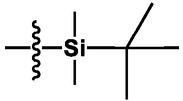 (a t-butyldimethylsilyl group), 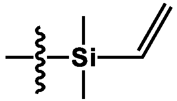 (a vinyldimethylsilyl group), 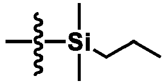 (a propyldimethylsilyl group), 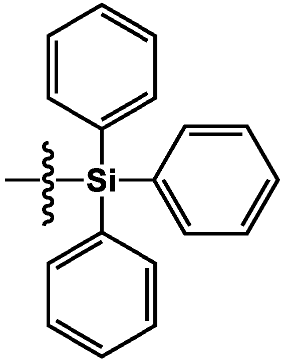 (a triphenylsilyl group), 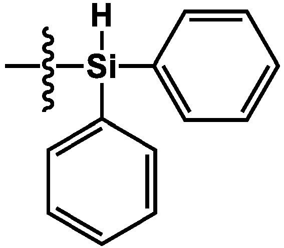 (a diphenylsilyl group), 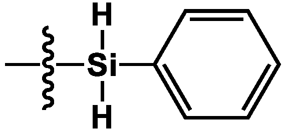 (a phenylsilyl group) and the like, but are not limited thereto.

In the present specification, a phosphine oxide group is represented by -P(=O)(R110) (R111), and R110 and R111 are the same as or different from each other, and may be each independently a substituent composed of at least one of hydrogen; deuterium; a halogen group; an alkyl group; an alkenyl group; an alkoxy group; a cycloalkyl group; a heterocycloalkyl group; an aryl group; and a heteroaryl group. Specifically, the phosphine oxide group may be substituted with an alkyl group or an aryl group, and the above-described example may be applied to the alkyl group and the aryl group. Examples of the phosphine oxide group include a dimethylphosphine oxide group, a diphenylphosphine oxide group, a dinaphthylphosphine oxide group, and the like, but are not limited thereto.

In the present specification, an amine group is represented by -N(R112) (R113), and R112 and R113 are the same as or different from each other, and may be each independently a substituent composed of at least one of hydrogen; deuterium; a halogen group; an alkyl group; an alkenyl group; an alkoxy group; a cycloalkyl group; a heterocycloalkyl group; an aryl group; and a heteroaryl group. The amine group may be selected from the group consisting of -NH₂; a monoalkylamine group; a monoarylamine group; a monoheteroarylamine group; a dialkylamine group; a diarylamine group; a diheteroarylamine group; an alkylarylamine group; an alkylheteroarylamine group; and an arylheteroarylamine group, and the number of carbon atoms thereof is not particularly limited, but is preferably 1 to 30. Specific examples of the amine group include a methylamine group, a dimethylamine group, an ethylamine group, a diethylamine group, a phenylamine group, a naphthylamine group, a biphenylamine group, a dibiphenylamine group, an anthracenylamine group, a 9-methyl-anthracenylamine group, a diphenylamine group, a phenylnaphthylamine group, a ditolylamine group, a phenyltolylamine group, a triphenylamine group, a biphenylnaphthylamine group, a phenylbiphenylamine group, a biphenylfluorenylamine group, a phenyltriphenylenylamine group, a biphenyltriphenylenylamine group, and the like, but are not limited thereto.

In the present specification, the above-described examples of the aryl group may be applied to an arylene group except for a divalent arylene group.

In the present specification, the above-described examples of the heteroaryl group may be applied to a heteroarylene group except for a divalent heteroarylene group.

In the present specification, the "adjacent" group may mean a substituent substituted with an atom directly linked to an atom in which the corresponding substituent is substituted, a substituent disposed to be sterically closest to the corresponding substituent, or another substituent substituted with an atom in which the corresponding substituent is substituted. For example, two substituents substituted at the ortho position in a benzene ring and two substituents substituted at the same carbon in an aliphatic ring may be interpreted as groups which are "adjacent" to each other.

Hydrocarbon rings and hetero rings that adjacent groups may form include an aliphatic hydrocarbon ring, an aromatic hydrocarbon ring, an aliphatic hetero ring and an aromatic hetero ring, and structures exemplified by the above-described cycloalkyl group, aryl group, heterocycloalkyl group and heteroaryl group may be applied to the rings, except for those that are not monovalent groups.

In an exemplary embodiment of the present application, the deuterium content of the heterocyclic compound represented by Chemical Formula 1 may be 0% or more and 100% or less, preferably 20% or more and 100% or less, and more preferably 40% or more and 100% or less.

In particular, in Chemical Formula 1, those not represented by substituents may be hydrogen or deuterium.

Since the heterocyclic compound represented by Chemical Formula 1 of the present invention has a band gap and a T1 value which can be easily regulated, has an improved hole transport ability, and also has a decomposition temperature that can be easily regulated, thermal stability is excellent and molecular stability is also enhanced, so that it is possible to lower the driving voltage of the device, improve the light efficiency, and improve the service life characteristics of the device due to the thermal stability of the compound.
In an exemplary embodiment of the present application, X of Chemical Formula 1 is O; or S.

In an exemplary embodiment of the present application, X is O.

In an exemplary embodiment of the present application, X is S.

In an exemplary embodiment of the present application, one of R1 to R6 of Chemical Formula 1 is 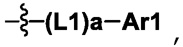 one of the others is 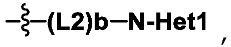 and the others are the same as or different from each other, and may be each independently selected from the group consisting of hydrogen; deuterium; a halogen; a cyano group; a substituted or unsubstituted C1 to C60 alkyl group; a substituted or unsubstituted C2 to C60 alkenyl group; a substituted or unsubstituted C2 to C60 alkynyl group; a substituted or unsubstituted C1 to C60 alkoxy group; a substituted or unsubstituted C3 to C60 cycloalkyl group; a substituted or unsubstituted C2 to C60 heterocycloalkyl group; a substituted or unsubstituted C6 to C60 aryl group; a substituted or unsubstituted C2 to C60 heteroaryl group; -P(=O)RR'; -SiRR'R" and -NRR'.

In an exemplary embodiment of the present application, one of R1 to R6 is 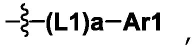 one of the others is 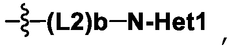 and the others are the same as or different from each other, and may be each independently selected from the group consisting of hydrogen; deuterium; a substituted or unsubstituted C1 to C60 alkyl group; a substituted or unsubstituted C6 to C60 aryl group; and a substituted or unsubstituted C2 to C60 heteroaryl group.

In another exemplary embodiment, one of R1 to R6 is 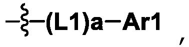 one of the others is 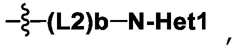 and the others are the same as or different from each other, and may be each independently selected from the group consisting of hydrogen; deuterium; a C1 to C60 alkyl group; a C6 to C60 aryl group; and a C2 to C60 heteroaryl group.

In still another exemplary embodiment, one of R1 to R6 is 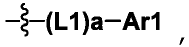 one of the others is 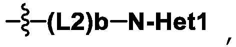 and the others are the same as or different from each other, and may be each independently selected from the group consisting of hydrogen; deuterium; a C1 to C40 alkyl group; a C6 to C40 aryl group; and a C2 to C40 heteroaryl group.

In yet another exemplary embodiment, one of R1 to R6 is 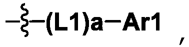 one of the others is 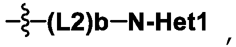 and the others are the same as or different from each other, and may be each independently selected from the group consisting of hydrogen; deuterium; a C1 to C30 alkyl group; a C6 to C30 aryl group; and a C2 to C30 heteroaryl group.

In still yet another exemplary embodiment, one of R1 to R6 is 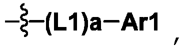 one of the others is 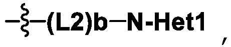 and the others are the same as or different from each other, and may be each independently hydrogen; or deuterium.

In an exemplary embodiment of the present application, R1 is 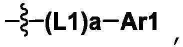 R2 is 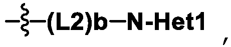 and R3 to R6 are the same as or different from each other, and may be each independently selected from the group consisting of hydrogen; deuterium; a halogen; a cyano group; a substituted or unsubstituted C1 to C60 alkyl group; a substituted or unsubstituted C2 to C60 alkenyl group; a substituted or unsubstituted C2 to C60 alkynyl group; a substituted or unsubstituted C1 to C60 alkoxy group; a substituted or unsubstituted C3 to C60 cycloalkyl group; a substituted or unsubstituted C2 to C60 heterocycloalkyl group; a substituted or unsubstituted C6 to C60 aryl group; and a substituted or unsubstituted C2 to C60 heteroaryl group.

In an exemplary embodiment of the present application, R1 is 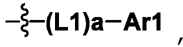 R2 is 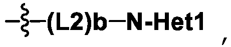 and R3 to R6 are the same as or different from each other, and may be each independently hydrogen; or deuterium.

In an exemplary embodiment of the present application, R1 is 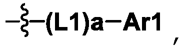 R3 is 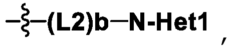 and R2 and R4 to R6 are the same as or different from each other, and may be each independently selected from the group consisting of hydrogen; deuterium; a halogen group; a cyano group; a substituted or unsubstituted C1 to C60 alkyl group; a substituted or unsubstituted C2 to C60 alkenyl group; a substituted or unsubstituted C2 to C60 alkynyl group; a substituted or unsubstituted C1 to C60 alkoxy group; a substituted or unsubstituted C3 to C60 cycloalkyl group; a substituted or unsubstituted C2 to C60 heterocycloalkyl group; a substituted or unsubstituted C6 to C60 aryl group; a substituted or unsubstituted C2 to C60 heteroaryl group; -P(=O)RR'; -SiRR'R" and -NRR'.

In an exemplary embodiment of the present application, R1 is 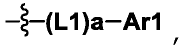 R3 is 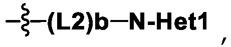 and R2 and R4 to R6 are the same as or different from each other, and may be each independently hydrogen; or deuterium.

In an exemplary embodiment of the present application, R1 is 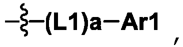 R4 is 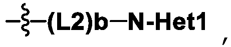 and R2, R3, R5 and R6 are the same as or different from each other, and may be each independently selected from the group consisting of hydrogen; deuterium; a halogen; a cyano group; a substituted or unsubstituted C1 to C60 alkyl group; a substituted or unsubstituted C2 to C60 alkenyl group; a substituted or unsubstituted C2 to C60 alkynyl group; a substituted or unsubstituted C1 to C60 alkoxy group; a substituted or unsubstituted C3 to C60 cycloalkyl group; a substituted or unsubstituted C2 to C60 heterocycloalkyl group; a substituted or unsubstituted C6 to C60 aryl group; a substituted or unsubstituted C2 to C60 heteroaryl group; -P(=O)RR'; -SiRR'R" and -NRR'.

In an exemplary embodiment of the present application, R1 is 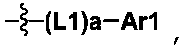 R4 is 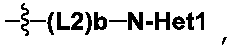 and R2, R3, R5 and R6 are the same as or different from each other, and R2 and R4 to R6 are the same as or different from each other, and may be each independently hydrogen; or deuterium.

In an exemplary embodiment of the present application, R1 is 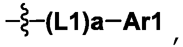 R5 is 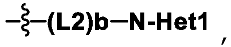 and R2 to R4 and R6 are the same as or different from each other, and may be each independently selected from the group consisting of hydrogen; deuterium; a halogen group; a cyano group; a substituted or unsubstituted C1 to C60 alkyl group; a substituted or unsubstituted C2 to C60 alkenyl group; a substituted or unsubstituted C2 to C60 alkynyl group; a substituted or unsubstituted C1 to C60 alkoxy group; a substituted or unsubstituted C3 to C60 cycloalkyl group; a substituted or unsubstituted C2 to C60 heterocycloalkyl group; a substituted or unsubstituted C6 to C60 aryl group; a substituted or unsubstituted C2 to C60 heteroaryl group; -P(=O)RR'; -SiRR'R" and -NRR'.

In an exemplary embodiment of the present application, R1 is 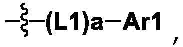 R5 is 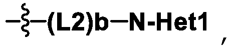 and R2 to R4 and R6 are the same as or different from each other, and may be each independently hydrogen; or deuterium.

In an exemplary embodiment of the present application, R1 is 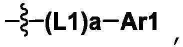 R6 is 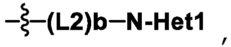 and R2 to R5 are the same as or different from each other, and may be each independently selected from the group consisting of hydrogen; deuterium; a halogen; a cyano group; a substituted or unsubstituted C1 to C60 alkyl group; a substituted or unsubstituted C2 to C60 alkenyl group; a substituted or unsubstituted C2 to C60 alkynyl group; a substituted or unsubstituted C1 to C60 alkoxy group; a substituted or unsubstituted C3 to C60 cycloalkyl group; a substituted or unsubstituted C2 to C60 heterocycloalkyl group; a substituted or unsubstituted C6 to C60 aryl group; a substituted or unsubstituted C2 to C60 heteroaryl group; -P(=O)RR'; -SiRR'R" and -NRR'.

In an exemplary embodiment of the present application, R1 is 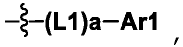 R6 is 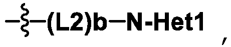 and R2 to R5 are the same as or different from each other, and may be each independently hydrogen; or deuterium.

In an exemplary embodiment of the present application, R1 is 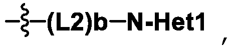 R2 is 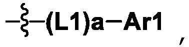 and R3 to R6 are the same as or different from each other, and may be each independently selected from the group consisting of hydrogen; deuterium; a halogen; a cyano group; a substituted or unsubstituted C1 to C60 alkyl group; a substituted or unsubstituted C2 to C60 alkenyl group; a substituted or unsubstituted C2 to C60 alkynyl group; a substituted or unsubstituted C1 to C60 alkoxy group; a substituted or unsubstituted C3 to C60 cycloalkyl group; a substituted or unsubstituted C2 to C60 heterocycloalkyl group; a substituted or unsubstituted C6 to C60 aryl group; a substituted or unsubstituted C2 to C60 heteroaryl group; -P(=O)RR'; -SiRR'R" and -NRR'.

In an exemplary embodiment of the present application, R1 is 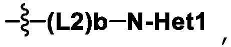 R2 is 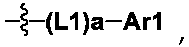 and R3 to R6 are the same as or different from each other, and may be each independently hydrogen; or deuterium.

In an exemplary embodiment of the present application, R1 is 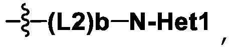 R3 is 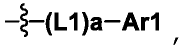 and R2 and R4 to R6 are the same as or different from each other, and may be each independently selected from the group consisting of hydrogen; deuterium; a halogen group; a cyano group; a substituted or unsubstituted C1 to C60 alkyl group; a substituted or unsubstituted C2 to C60 alkenyl group; a substituted or unsubstituted C2 to C60 alkynyl group; a substituted or unsubstituted C1 to C60 alkoxy group; a substituted or unsubstituted C3 to C60 cycloalkyl group; a substituted or unsubstituted C2 to C60 heterocycloalkyl group; a substituted or unsubstituted C6 to C60 aryl group; a substituted or unsubstituted C2 to C60 heteroaryl group; -P(=O)RR'; -SiRR'R" and -NRR'.

In an exemplary embodiment of the present application, R1 is 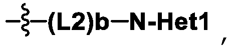 R3 is 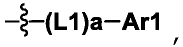 and R2 and R4 to R6 are the same as or different from each other, and may be each independently hydrogen; or deuterium.

In an exemplary embodiment of the present application, R1 is 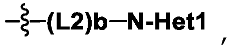 R4 is 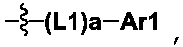 and R2, R3, R5 and R6 are the same as or different from each other, and may be each independently selected from the group consisting of hydrogen; deuterium; a halogen; a cyano group; a substituted or unsubstituted C1 to C60 alkyl group; a substituted or unsubstituted C2 to C60 alkenyl group; a substituted or unsubstituted C2 to C60 alkynyl group; a substituted or unsubstituted C1 to C60 alkoxy group; a substituted or unsubstituted C3 to C60 cycloalkyl group; a substituted or unsubstituted C2 to C60 heterocycloalkyl group; a substituted or unsubstituted C6 to C60 aryl group; a substituted or unsubstituted C2 to C60 heteroaryl group; -P(=O)RR'; -SiRR'R" and -NRR'.

In an exemplary embodiment of the present application, R1 is 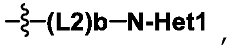 R4 is 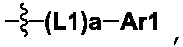 and R2, R3, R5 and R6 are the same as or different from each other, and may be each independently hydrogen; or deuterium.

In an exemplary embodiment of the present application, R1 is 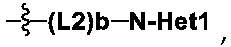 R5 is 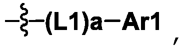 and R2 to R4 and R6 are the same as or different from each other, and may be each independently selected from the group consisting of hydrogen; deuterium; a halogen group; a cyano group; a substituted or unsubstituted C1 to C60 alkyl group; a substituted or unsubstituted C2 to C60 alkenyl group; a substituted or unsubstituted C2 to C60 alkynyl group; a substituted or unsubstituted C1 to C60 alkoxy group; a substituted or unsubstituted C3 to C60 cycloalkyl group; a substituted or unsubstituted C2 to C60 heterocycloalkyl group; a substituted or unsubstituted C6 to C60 aryl group; a substituted or unsubstituted C2 to C60 heteroaryl group; -P(=O)RR'; -SiRR'R" and -NRR'.

In an exemplary embodiment of the present application, R1 is 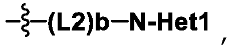 R5 is 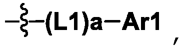 and R2 to R4 and R6 are the same as or different from each other, and may be each independently hydrogen; or deuterium.

In an exemplary embodiment of the present application, R1 is 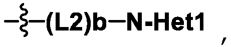 R6 is 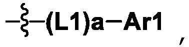 and R2 to R5 are the same as or different from each other, and may be each independently selected from the group consisting of hydrogen; deuterium; a halogen; a cyano group; a substituted or unsubstituted C1 to C60 alkyl group; a substituted or unsubstituted C2 to C60 alkenyl group; a substituted or unsubstituted C2 to C60 alkynyl group; a substituted or unsubstituted C1 to C60 alkoxy group; a substituted or unsubstituted C3 to C60 cycloalkyl group; a substituted or unsubstituted C2 to C60 heterocycloalkyl group; a substituted or unsubstituted C6 to C60 aryl group; a substituted or unsubstituted C2 to C60 heteroaryl group; -P(=O)RR'; -SiRR'R" and -NRR'.

In an exemplary embodiment of the present application, R1 is 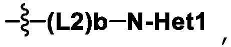 R6 is 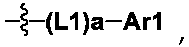 and R2 to R5 are the same as or different from each other, and may be each independently hydrogen; or deuterium.

In an exemplary embodiment of the present application, L1 and L2 of Chemical Formula 1 are the same as or different from each other, and may be each independently a direct bond; a substituted or unsubstituted C6 to C60 arylene group; or a substituted or unsubstituted C2 to C60 heteroarylene group.

In another exemplary embodiment, L1 and L2 are the same as or different from each other, and may be each independently a direct bond; a substituted or unsubstituted C6 to C40 arylene group; or a substituted or unsubstituted C2 to C40 heteroarylene group.

In still another exemplary embodiment, L1 and L2 are the same as or different from each other, and may be each independently a direct bond; or a substituted or unsubstituted C6 to C40 arylene group.

In yet another exemplary embodiment, L1 and L2 are the same as or different from each other, and may be each independently a direct bond; or a substituted or unsubstituted C6 to C40 monocyclic or polycyclic arylene group.

In still yet another exemplary embodiment, L1 and L2 are the same as or different from each other, and may be each independently a direct bond; a substituted or unsubstituted C6 to C10 monocyclic arylene group; or a substituted or unsubstituted C10 to C40 polycyclic arylene group.

In a further exemplary embodiment, L1 and L2 are the same as or different from each other, and may be each independently a direct bond; a substituted or unsubstituted phenylene group; a substituted or unsubstituted biphenylene group; a substituted or unsubstituted naphthylene group; or a substituted or unsubstituted anthracenylene group.

The phenylene group, the biphenylene group, the naphthylene group and the anthracenylene group are divalent groups of a phenyl group, a biphenyl group, a naphthyl group and an anthracenyl group, respectively.

In an exemplary embodiment of the present application, L1 and L2 may be unsubstituted or substituted with deuterium.

In an exemplary embodiment of the present application, the deuterium content of L1 and L2 may be 0% or more and 100% or less, preferably 20% or more and 100% or less, and more preferably 40% or more and 100% or less.

In an exemplary embodiment of the present application, a and b are each an integer from 0 to 3, and when a and b are each 2 or higher, substituents in the parenthesis are the same as or different from each other.

In an exemplary embodiment of the present application, a is 0. a is 1. a is 2. a is 3. When a is 2 or higher, L1's in the parenthesis are the same as or different from each other.

In an exemplary embodiment of the present application, b is 0. b is 1. b is 2. b is 3. When b is 2 or higher, L2's in the parenthesis are the same as or different from each other.

In an exemplary embodiment of the present application, Ar1 may be a substituted or unsubstituted C6 to C60 aryl group; or a substituted or unsubstituted C2 to C60 heteroaryl group.

In an exemplary embodiment of the present application, Ar1 may be a substituted or unsubstituted C6 to C40 aryl group; or a substituted or unsubstituted C2 to C40 heteroaryl group.

In an exemplary embodiment of the present application, Ar1 may be a substituted or unsubstituted C6 to C20 aryl group; or a substituted or unsubstituted C2 to C20 heteroaryl group.

In another exemplary embodiment, Ar1 may be a C6 to C40 aryl group which is unsubstituted or substituted with one or more substituents selected from the group consisting of deuterium, a cyano group, a halogen group, a C6 to C40 aryl group and a C2 to C40 heteroaryl group; or a C2 to C40 heteroaryl group which is unsubstituted or substituted with one or more substituents selected from the group consisting of deuterium, a cyano group, a halogen group, a C6 to C40 aryl group and a C2 to C40 heteroaryl group.

In still another exemplary embodiment, Ar1 may be a C6 to C40 aryl group which is unsubstituted or substituted with one or more substituents selected from the group consisting of deuterium, a cyano group and a halogen group; or a C2 to C40 heteroaryl group which is unsubstituted or substituted with one or more substituents selected from the group consisting of deuterium, a cyano group and a halogen group.

In yet another exemplary embodiment, Ar1 may be a substituted or unsubstituted phenyl group; a substituted or unsubstituted biphenyl group; a substituted or unsubstituted terphenyl group; a substituted or unsubstituted naphthyl group; a substituted or unsubstituted triphenylenyl group; a substituted or unsubstituted phenanthrenyl group; a substituted or unsubstituted fluoranthenyl group; a substituted or unsubstituted chrysenyl group; a substituted or unsubstituted dimethylfluorenyl group; a substituted or unsubstituted benzo[e]acephenanthrylene group; a substituted or unsubstituted dibenzofuran group; a substituted or unsubstituted dibenzothiophene group; a substituted or unsubstituted carbazole group; a fluoranthenyl group in which a substituted or unsubstituted benzene ring is fused; a dibenzofuran group in which a substituted or unsubstituted benzene ring is fused; a dibenzothiophene group in which a substituted or unsubstituted benzene ring is fused; or a dimethylfluorenyl group in which a substituted or unsubstituted benzene ring is fused.

In still yet another exemplary embodiment, Ar1's are the same as or different from each other, and may be each independently a phenyl group which is unsubstituted or substituted with one or more substituents selected from the group consisting of deuterium, a cyano group and a halogen group; a biphenyl group which is unsubstituted or substituted with one or more substituents selected from the group consisting of deuterium, a cyano group and a halogen group; a terphenyl group which is unsubstituted or substituted with one or more substituents selected from the group consisting of deuterium, a cyano group and a halogen group; a naphthyl group which is unsubstituted or substituted with one or more substituents selected from the group consisting of deuterium, a cyano group and a halogen group; a triphenylenyl group which is unsubstituted or substituted with one or more substituents selected from the group consisting of deuterium, a cyano group and a halogen group; a phenanthrenyl group which is unsubstituted or substituted with one or more substituents selected from the group consisting of deuterium, a cyano group and a halogen group; a fluoranthenyl group which is unsubstituted or substituted with one or more substituents selected from the group consisting of deuterium, a cyano group and a halogen group; chrysenyl group which is unsubstituted or substituted with one or more substituents selected from the group consisting of deuterium, a cyano group and a halogen group; a dimethylfluorenyl group which is unsubstituted or substituted with one or more substituents selected from the group consisting of deuterium, a cyano group and a halogen group; a benzo[e]acephenanthrylene group which is unsubstituted or substituted with one or more substituents selected from the group consisting of deuterium, a cyano group and a halogen group; a dibenzofuran group which is unsubstituted or substituted with one or more substituents selected from the group consisting of deuterium, a cyano group and a halogen group; a dibenzothiophene group which is unsubstituted or substituted with one or more substituents selected from the group consisting of deuterium, a cyano group and a halogen group; a carbazole group which is unsubstituted or substituted with one or more substituents selected from the group consisting of deuterium and a phenyl group; a fluoranthenyl group in which a substituted or unsubstituted benzene ring, which is unsubstituted or substituted with one or more substituents selected from the group consisting of deuterium, a cyano group and a halogen group, is fused; a dibenzofuran group in which a benzene ring, which is unsubstituted or substituted with one or more substituents selected from the group consisting of deuterium, a cyano group and a halogen group, is fused; a dibenzothiophene group in which a benzene ring, which is unsubstituted or substituted with one or more substituents selected from the group consisting of deuterium, a cyano group and a halogen group, is fused; or a dimethylfluorenyl group in which a benzene ring, which is unsubstituted or substituted with one or more substituents selected from the group consisting of deuterium, a cyano group and a halogen group, is fused.

In an exemplary embodiment of the present application, the deuterium content of Ar1 may be 0% or more and 100% or less, preferably 20% or more and 100% or less, and more preferably 40% or more and 100% or less.

In an exemplary embodiment of the present application, the N-Het1 is a monocyclic or polycyclic heterocyclic group which is substituted or unsubstituted and includes one or more N's.

In an exemplary embodiment of the present application, the N-Het1 may be an N-Het1 in which a monocyclic or polycyclic heterocyclic group, which is substituted or unsubstituted and includes one or more N's, includes one or more and three or less N's.

In an exemplary embodiment of the present application, L3 and L4 of Chemical Formula 2 are the same as or different from each other, and may be each independently a direct bond; a substituted or unsubstituted C6 to C60 arylene group; or a substituted or unsubstituted C2 to C60 heteroarylene group.

In another exemplary embodiment, L3 and L4 are the same as or different from each other, and may be each independently a direct bond; a substituted or unsubstituted C6 to C40 arylene group; or a substituted or unsubstituted C2 to C40 heteroarylene group.

In still another exemplary embodiment, L3 and L4 are the same as or different from each other, and may be each independently a direct bond; a substituted or unsubstituted C6 to C20 arylene group; or a substituted or unsubstituted C2 to C20 heteroarylene group.

In yet another exemplary embodiment, L3 and L4 are the same as or different from each other, and may be each independently a direct bond; a substituted or unsubstituted phenylene group; a substituted or unsubstituted furanylene group; a substituted or unsubstituted naphthylene group; or a substituted or unsubstituted anthracenylene group.

The phenylene group, the furanylene group, the naphthylene group and the anthracenylene group are divalent groups of a phenyl group, a furan group, a naphthyl group and an anthracenyl group, respectively.

In an exemplary embodiment of the present application, L3 and L4 may be unsubstituted or substituted with deuterium.

In an exemplary embodiment of the present application, the deuterium content of L3 and L4 may be 0% or more and 100% or less, preferably 20% or more and 100% or less, and more preferably 40% or more and 100% or less.

In an exemplary embodiment of the present application, m and n are each an integer from 0 to 3, and when m and n are each 2 or higher, substituents in the parenthesis are the same as or different from each other.

In an exemplary embodiment of the present application, m is 0. m is 1. m is 2. m is 3. When m is 2 or higher, L3's in the parenthesis are the same as or different from each other.

In an exemplary embodiment of the present application, n is 0. n is 1. n is 2. n is 3. When n is 2 or higher, L4's in the parenthesis are the same as or different from each other.

In an exemplary embodiment of the present application, the N-Het2 is a monocyclic or polycyclic heterocyclic group which is substituted or unsubstituted and includes one or more N's.

In an exemplary embodiment of the present application, the N-Het2 may be an N-Het2 in which a monocyclic or polycyclic heterocyclic group, which is substituted or unsubstituted and includes one or more N's, includes one or more and three or less N's.

In an exemplary embodiment of the present application, the N-Het1 and the N-Het2 may be each independently represented by the following Chemical Formula 3.

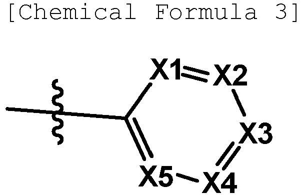

In Chemical Formula 3,
X1 is CR101 or N, X2 is CR102 or N, X3 is CR103 or N, X4 is CR104 or N, X5 is CR105 or N, and at least one of X1 to X5 is N, and
R101 to R105 are the same as or different from each other, and are each independently selected from the group consisting of hydrogen; deuterium; a halogen; a cyano group; a substituted or unsubstituted C1 to C60 alkyl group; a substituted or unsubstituted C2 to C60 alkenyl group; a substituted or unsubstituted C2 to C60 alkynyl group; a substituted or unsubstituted C1 to C20 alkoxy group; a substituted or unsubstituted C3 to C60 cycloalkyl group; a substituted or unsubstituted C2 to C60 heterocycloalkyl group; a substituted or unsubstituted C6 to C60 aryl group; a substituted or unsubstituted C2 to C60 heteroaryl group; a substituted or unsubstituted phosphine oxide group; and a substituted or unsubstituted amine group, or two or more adjacent groups are bonded to each other to form a substituted or unsubstituted aliphatic or aromatic hydrocarbon ring or hetero ring, and here, 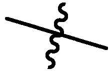 is a moiety linked to Chemical Formula 1 or 2.

In an exemplary embodiment of the present application, Chemical Formula 3 may be represented by any one of the following Chemical Formulae 4 to 8.

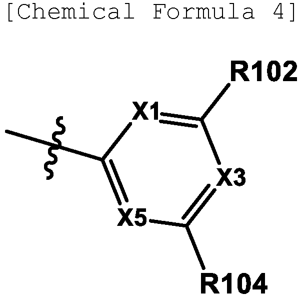

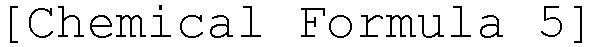

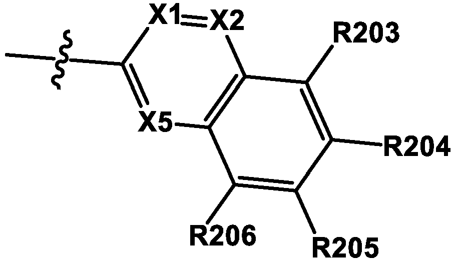

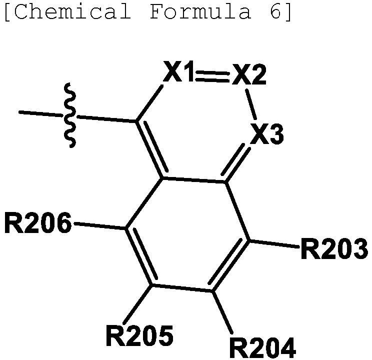

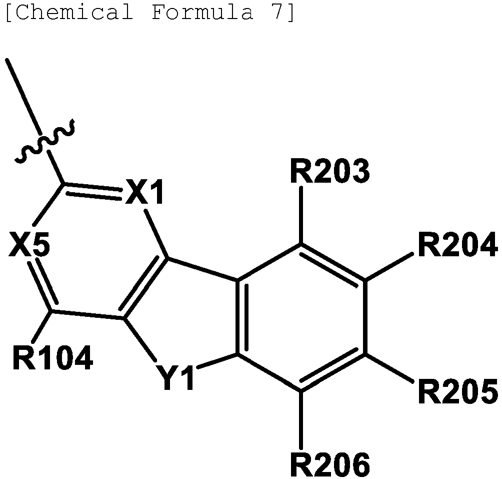

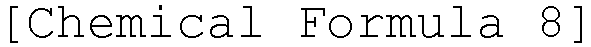

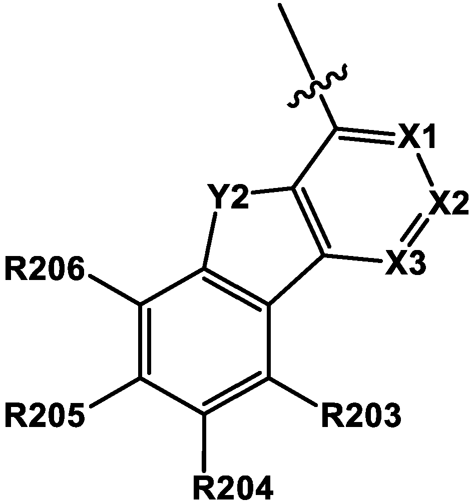

In Chemical Formula 4, one or more of X1, X3 and X5 are N, and the others are the same as those defined in Chemical Formula 3,
in Chemical Formula 5, one or more of X1, X2 and X5 is N, and the others are the same as those defined in Chemical Formula 3,
in Chemical Formula 6, one or more of X1 to X3 are N, and the others are the same as those defined in Chemical Formula 3,
in Chemical Formula 7, one or more of X1, X4 and X5 is N, and the others are the same as those defined in Chemical Formula 3,
in Chemical Formula 8, one or more of X1 to X3 are N, and the others are the same as those defined in Chemical Formula 3,
Y1 and Y2 are each independently O; or S,
R102, R104 and R203 to R206 are the same as or different from each other, and are each independently selected from the group consisting of hydrogen; deuterium; a halogen; a cyano group; a substituted or unsubstituted C1 to C60 alkyl group; a substituted or unsubstituted C2 to C60 alkenyl group; a substituted or unsubstituted C2 to C60 alkynyl group; a substituted or unsubstituted C1 to C20 alkoxy group; a substituted or unsubstituted C3 to C60 cycloalkyl group; a substituted or unsubstituted C2 to C60 heterocycloalkyl group; a substituted or unsubstituted C6 to C60 aryl group; a substituted or unsubstituted C2 to C60 heteroaryl group; a substituted or unsubstituted phosphine oxide group; and a substituted or unsubstituted amine group, or two or more adjacent groups are bonded to each other to form a substituted or unsubstituted aliphatic or aromatic hydrocarbon ring or hetero ring, and
the definition of 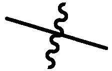 is the same as that in Chemical Formula 3.

In an exemplary embodiment of the present application, Chemical Formula 4 may be selected by any one of the structural formulae of the following Group A.

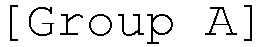

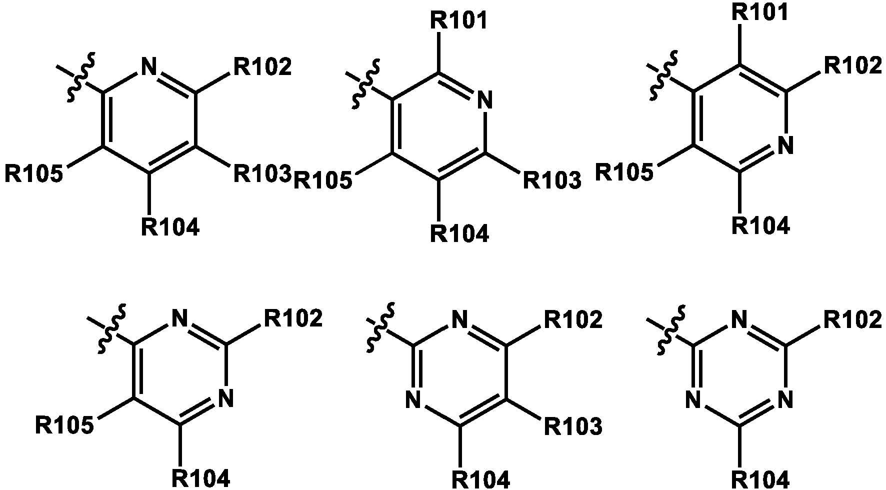

The definitions of the substituents of the structural formulae of Group A are the same as those in Chemical Formula 4.

In an exemplary embodiment of the present application, Chemical Formula 5 may be represented by the following Chemical Formula 5-1 or Chemical Formula 5-2.

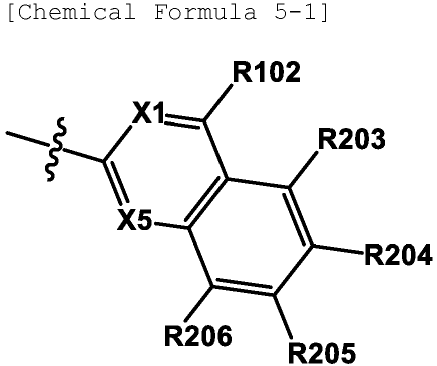

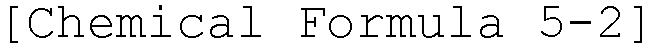

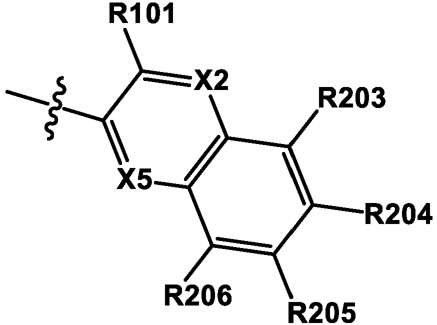

The substituents of Chemical Formulae 5-1 and 5-2 are the same as those defined in Chemical Formula 5.

In an exemplary embodiment of the present application, Chemical Formula 6 may be represented by the following Chemical Formula 6-1.

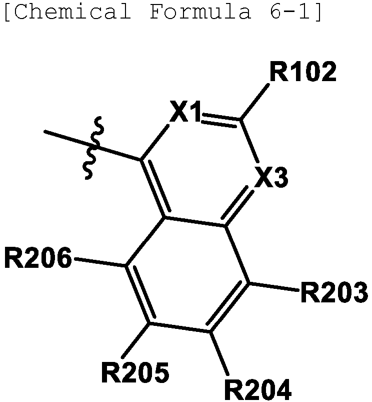

The substituents of Chemical Formula 6-1 are the same as those defined in Chemical Formula 6.

In an exemplary embodiment of the present application, Chemical Formula 7 may be represented by the following Chemical Formula 7-1.

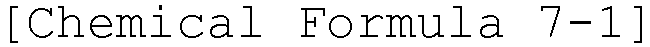

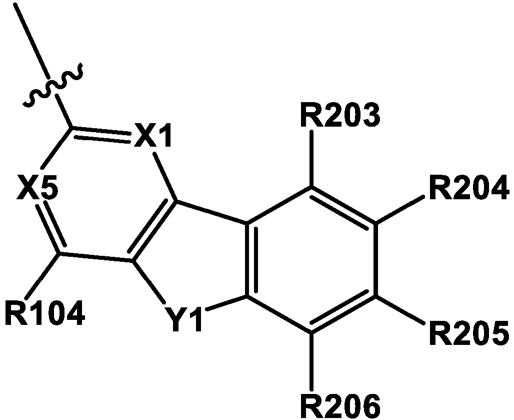

The substituents of Chemical Formula 7-1 are the same as those defined in Chemical Formula 7.

In an exemplary embodiment of the present application, Chemical Formula 8 may be represented by the following Chemical Formula 8-1.

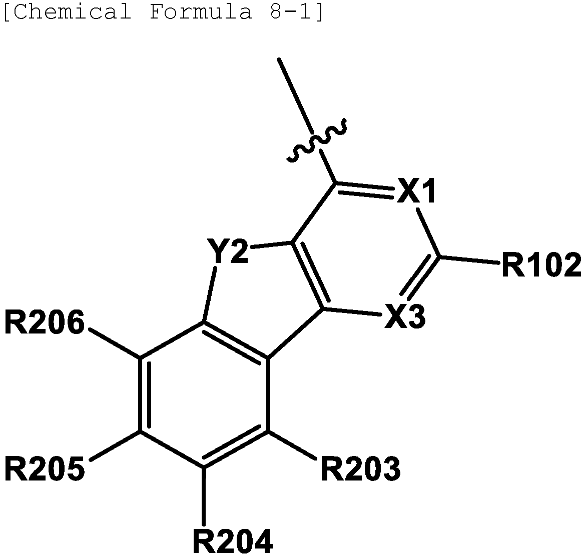

The substituents of Chemical Formula 8-1 are the same as those defined in Chemical Formula 8.

In an exemplary embodiment of the present application, R101 to R105 and R203 to R206 are the same as or different from each other, and may be each independently hydrogen; deuterium; a halogen; a cyano group; a substituted or unsubstituted C1 to C60 alkyl group; a substituted or unsubstituted C6 to C60 aryl group; or a substituted or unsubstituted C2 to C60 heteroaryl group.

In an exemplary embodiment of the present application, R101 to R105 and R203 to R206 are the same as or different from each other, and may be each independently hydrogen; deuterium; a substituted or unsubstituted C6 to C60 aryl group; or a substituted or unsubstituted C2 to C60 heteroaryl group.

In an exemplary embodiment of the present application, R101 to R105 and R203 to R206 are the same as or different from each other, and may be each independently hydrogen; deuterium; a substituted or unsubstituted C6 to C40 aryl group; or a substituted or unsubstituted C2 to C40 heteroaryl group.

In an exemplary embodiment of the present application, R101 to R105 and R203 to R206 are the same as or different from each other, and may be each independently hydrogen; deuterium; a substituted or unsubstituted C6 to C20 aryl group; or a substituted or unsubstituted C2 to C20 heteroaryl group.

In an exemplary embodiment of the present application, L5 and L6 of Chemical Formula 2 are the same as or different from each other, and may be each independently a direct bond; a substituted or unsubstituted C6 to C60 arylene group; or a substituted or unsubstituted C2 to C60 heteroarylene group.

In another exemplary embodiment, L5 and L6 are the same as or different from each other, and may be each independently a direct bond; a substituted or unsubstituted C6 to C40 arylene group; or a substituted or unsubstituted C2 to C40 heteroarylene group.

In still another exemplary embodiment, L5 and L6 are the same as or different from each other, and may be each independently a direct bond; a substituted or unsubstituted C6 to C20 arylene group; or a substituted or unsubstituted C2 to C20 heteroarylene group.

In yet another exemplary embodiment, L5 and L6 are the same as or different from each other, and may be each independently a direct bond; a substituted or unsubstituted phenylene group; a substituted or unsubstituted biphenylene group; a substituted or unsubstituted naphthylene group; a substituted or unsubstituted anthracenylene group; a substituted or unsubstituted carbazolene group; a substituted or unsubstituted fused carbazolene group; a substituted or unsubstituted furanylene group; or a substituted or unsubstituted thiophenylene group.

The phenylene group, the biphenylene group, the naphthylene group, the anthracenylene group, the carbazolene group, the fused carbazolene group, the furanylene group and the thiophenylene group are divalent groups of a phenyl group, a biphenyl group, a naphthyl group, an anthracenyl group, a carbazole group, a fused carbazole group, a furan group and a thiophene group, respectively.

In an exemplary embodiment of the present application, L5 and L6 may be unsubstituted or substituted with deuterium.

In an exemplary embodiment of the present application, the deuterium content of L5 and L6 may be 0% or more and 100% or less, preferably 20% or more and 100% or less, and more preferably 40% or more and 100% or less.

In an exemplary embodiment of the present application, m1 and m2 are each an integer from 0 to 3, and when m1 and m2 are each 2 or higher, substituents in the parenthesis are the same as or different from each other.

In an exemplary embodiment of the present application, m1 is 0. m1 is 1. m1 is 2. m1 is 3. When m1 is 2 or higher, L5's in the parenthesis are the same as or different from each other.

In an exemplary embodiment of the present application, m2 is 0. m2 is 1. m2 is 2. m2 is 3. When m2 is 2 or higher, L6's in the parenthesis are the same as or different from each other.

In an exemplary embodiment of the present application, Y of Chemical Formula 2 is O; or S.

In an exemplary embodiment of the present application, Y is O.

In an exemplary embodiment of the present application, Y is S.

In an exemplary embodiment of the present application, Ar2 and Ar3 of Chemical Formula 2 are the same as or different from each other, and are each independently a substituted or unsubstituted C6 to C60 aryl group; a substituted or unsubstituted C2 to C60 heteroaryl group; or -NRR'.

In an exemplary embodiment of the present application, Ar2 and Ar3 are the same as or different from each other, and may be each independently a substituted or unsubstituted C6 to C40 aryl group; a substituted or unsubstituted C2 to C40 heteroaryl group; or -NRR'.

In an exemplary embodiment of the present application, Ar2 and Ar3 are the same as or different from each other, and may be each independently a substituted or unsubstituted C6 to C20 aryl group; a substituted or unsubstituted C2 to C20 heteroaryl group; or -NRR'.

In an exemplary embodiment of the present application, Ar2 and Ar3 are the same as or different from each other, and may be each independently a substituted or unsubstituted phenyl group; a substituted or unsubstituted biphenyl group; a substituted or unsubstituted terphenyl group; a substituted or unsubstituted naphthyl group; a substituted or unsubstituted phenanthrenyl group; a substituted or unsubstituted pyrenyl group; a substituted or unsubstituted perylenyl group; a substituted or unsubstituted 4,5-diphenylbenzo[4,5]cyclohepta[1,2,3-de]naphthalenyl group; a substituted or unsubstituted dimethylfluorenyl group; a substituted or unsubstituted spirobifluorenyl group; a substituted or unsubstituted diphenylfluorenyl group; a substituted or unsubstituted carbazole group; a substituted or unsubstituted fused carbazole group; a substituted or unsubstituted fluoranthene group; a substituted or unsubstituted fused fluoranthene group; a substituted or unsubstituted dibenzofuran group; a substituted or unsubstituted naphthobenzofuran group; a substituted or unsubstituted dibenzothiophene group; or -NRR'.

In an exemplary embodiment of the present application, adjacent substituents of L3, L5, L6, Ar2 and Ar3 may be bonded to each other to form a substituted or unsubstituted aliphatic or aromatic hydrocarbon ring or a substituted or unsubstituted aliphatic or aromatic hetero ring, The fact that adjacent substituents of L3, L5, L6, Ar2 and Ar3 are bonded to each other means including all of the case where L3, Ar2 and Ar3 are bonded to each other, the case where L5, L6, Ar2, and Ar3 are bonded to each other, and the case where L3, L5, and L6 are bonded to each other in addition to the case where Ar2 and Ar3 are bonded to each other.

In an exemplary embodiment of the present application, Ar2 and Ar3 may be bonded to each other to form a substituted or unsubstituted aliphatic or aromatic hydrocarbon ring or a substituted or unsubstituted aliphatic or aromatic hetero ring.

In an exemplary embodiment of the present application, Ar2 and Ar3 are the same as or different from each other, and are each independently a substituted or unsubstituted C6 to C40 aryl group; a substituted or unsubstituted C2 to C40 heteroaryl group; or -NRR', or Ar2 and Ar3 may be bonded to each other to form a substituted or unsubstituted aliphatic or aromatic hydrocarbon ring or a substituted or unsubstituted aliphatic or aromatic hetero ring.

In an exemplary embodiment of the present application, Ar2 and Ar3 are the same as or different from each other, and are each independently a substituted or unsubstituted C6 to C20 aryl group; a substituted or unsubstituted C2 to C20 heteroaryl group; or -NRR', or Ar2 and Ar3 may be bonded to each other to form a substituted or unsubstituted aliphatic or aromatic hydrocarbon ring or a substituted or unsubstituted aliphatic or aromatic hetero ring.

In an exemplary embodiment of the present application, Ar2, Ar3 and L3 may be bonded to each other to form a substituted or unsubstituted aliphatic or aromatic hydrocarbon ring or a substituted or unsubstituted aliphatic or aromatic hetero ring. In this case, L5 and L6 may be a direct bond. In regard to the case where Ar2, Ar3 and L3 are bonded to each other to form a substituted or unsubstituted aliphatic or aromatic hydrocarbon ring or a substituted or unsubstituted aliphatic or aromatic hetero ring, Chemical Formula A-9 to be described below may be used as an example, but is not limited thereto.

In an exemplary embodiment of the present application, L5, L6, Ar2 and Ar3 may be bonded to each other to form a substituted or unsubstituted aliphatic or aromatic hydrocarbon ring or a substituted or unsubstituted aliphatic or aromatic hetero ring.

In an exemplary embodiment of the present application, L3, L5, and L6 may be bonded to each other to form a substituted or unsubstituted aliphatic or aromatic hydrocarbon ring or a substituted or unsubstituted aliphatic or aromatic hetero ring.

In an exemplary embodiment of the present application, R, R' and R" are the same as or different from each other, and may be each independently a substituted or unsubstituted C1 to C60 alkyl group; a substituted or unsubstituted C6 to C60 aryl group; or a substituted or unsubstituted C2 to C60 heteroaryl group.

In another exemplary embodiment, R, R' and R" are the same as or different from each other, and may be each independently a substituted or unsubstituted C6 to C60 aryl group.

In still another exemplary embodiment, R, R' and R" are the same as or different from each other, and may be each independently a substituted or unsubstituted C6 to C60 monocyclic or polycyclic aryl group.

In yet another exemplary embodiment, R, R' and R" are the same as or different from each other, and may be each independently a substituted or unsubstituted C6 to C40 monocyclic aryl group.

In still yet another exemplary embodiment, R, R' and R" are the same as or different from each other, and may be each independently C6 to C20 monocyclic aryl group.

In a further exemplary embodiment, R, R' and R" may be a phenyl group.

In an exemplary embodiment of the present application, 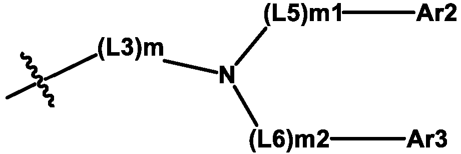 may be represented by any one of the following Chemical Formulae A-1 to A-12.

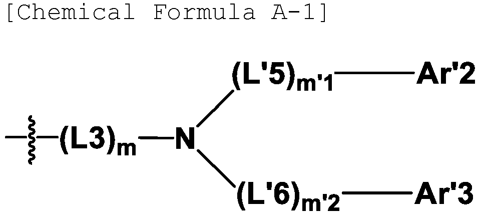

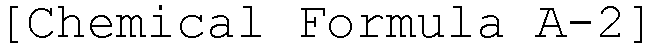

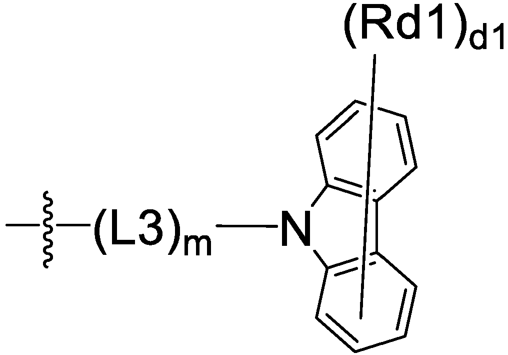

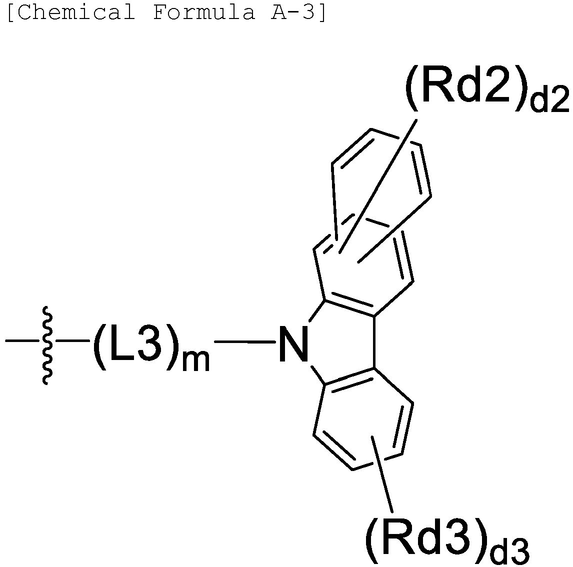

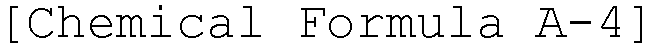

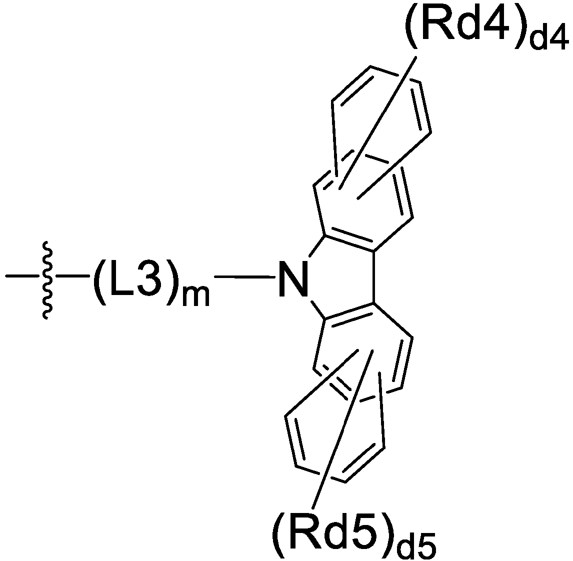

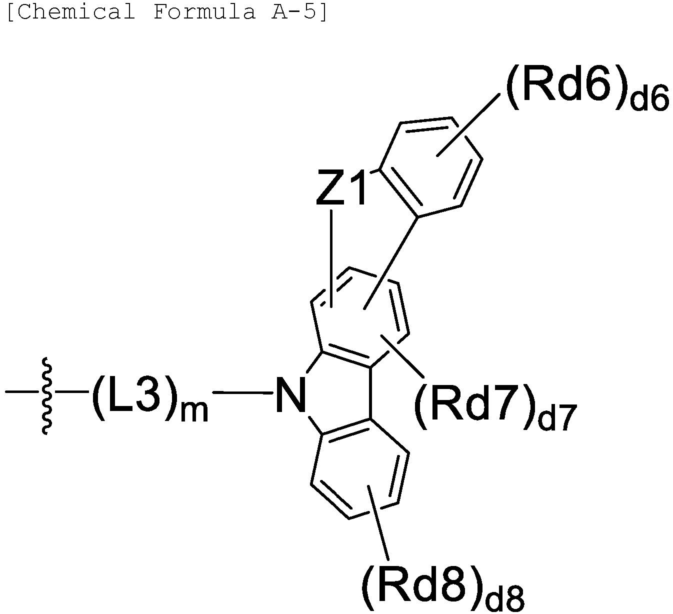

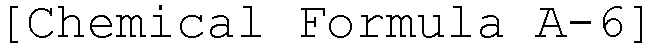

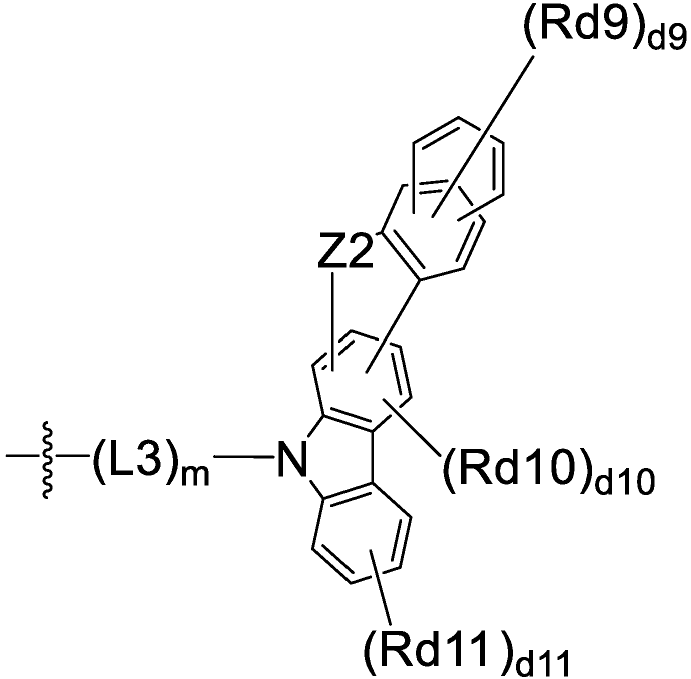

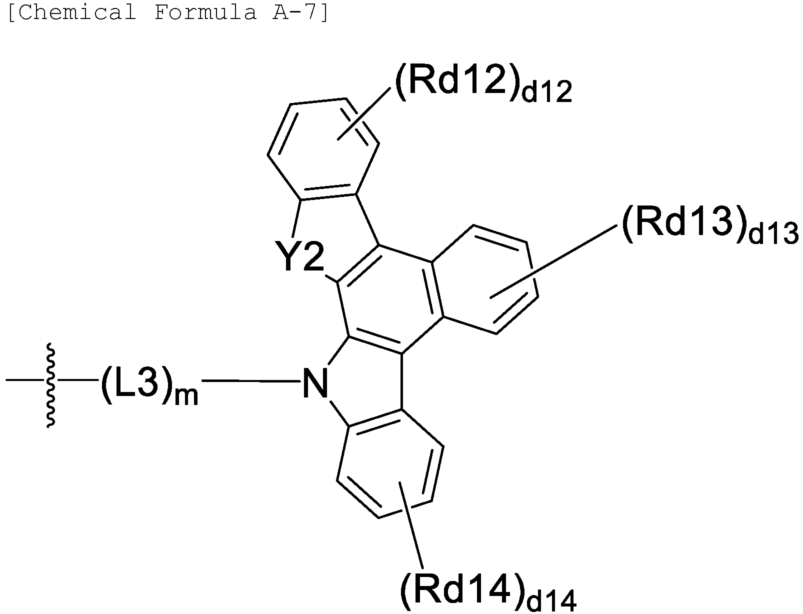

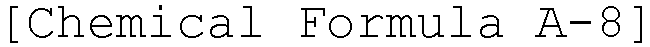

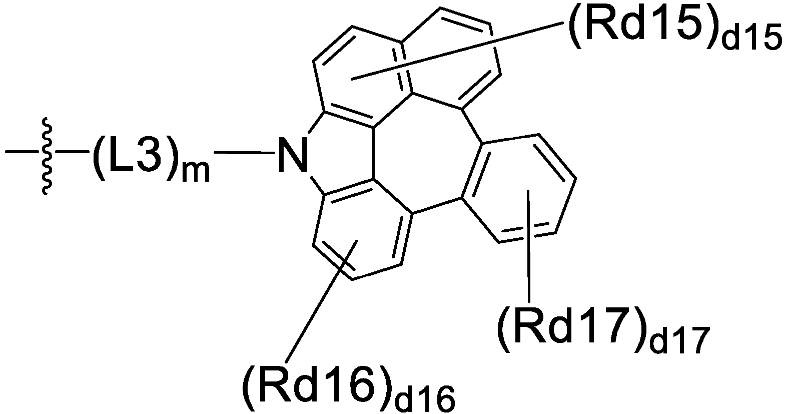

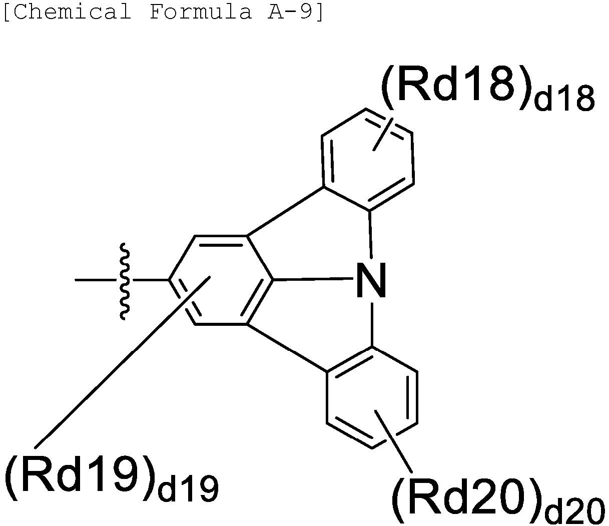

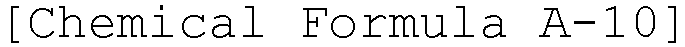

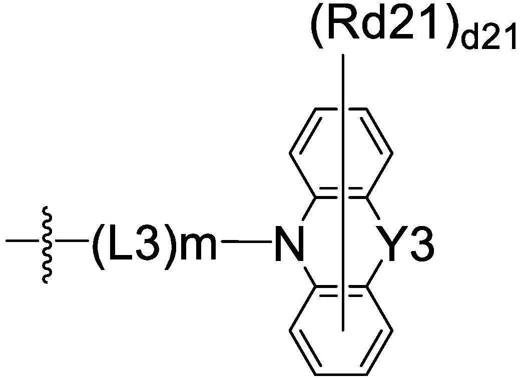

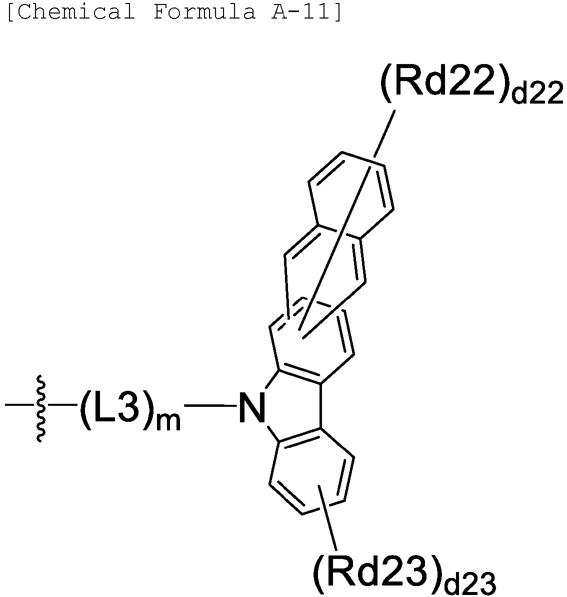

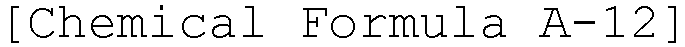

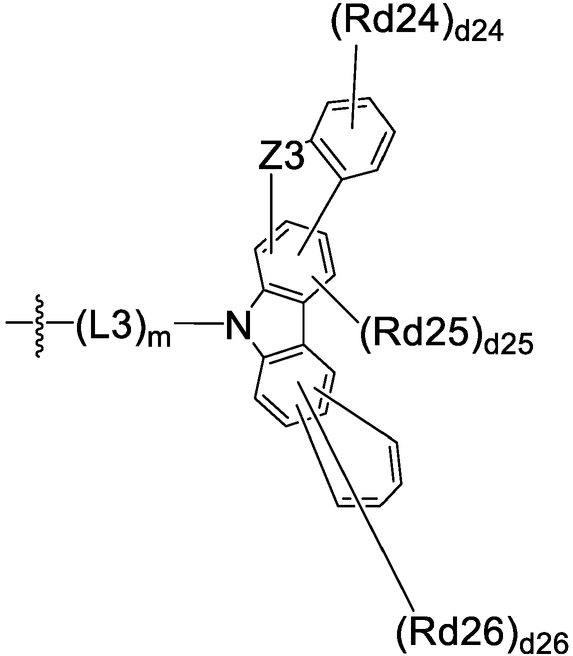

In Chemical Formulae A-1 to A-12,
the definitions of L3 and m are the same as the definitions in Chemical Formula 2,
L'5 and L'6 are the same as or different from each other, and are each independently a direct bond; a substituted or unsubstituted C6 to C60 arylene group; or a substituted or unsubstituted C2 to C60 heteroarylene group, m'1 and m'2 are each independently an integer from 0 to 3, and when m'1 and m'2 are each 2 or higher, substituents in the parenthesis are the same as or different from each other,
Ar'2 and Ar'3 are the same as or different from each other, and are each independently NRR'; a substituted or unsubstituted C6 to C60 aryl group; or a substituted or unsubstituted C2 to C60 heteroaryl group,
Z1 to Z3 are each independently O; S; CRaRb; or NRc,
Y2 and Y3 are each independently O; or S,
R, R', Ra, Rb, Rc and Rd1 to Rd26 are each independently hydrogen; deuterium; a halogen group; a cyano group; a substituted or unsubstituted C1 to C60 alkyl group; a substituted or unsubstituted C6 to C60 aryl group; or a substituted or unsubstituted C2 to C60 heteroaryl group,
d1, d21 and d22 are each independently an integer from 0 to 8,
d2, d4, d5, d9 and d26 are each independently an integer from 0 to 6,
d3, d6, d8, d11, d12 to d14, d17, d18, d20, d23 and d24 are each independently an integer from 0 to 4,
d7, d10, d19 and d25 are each independently an integer from 0 to 2,
d15 is an integer from 0 to 5,
d16 is an integer from 0 to 3, and
when d1 to d26 are each 2 or higher, substituents in the parenthesis are the same as or different from each other.

In an exemplary embodiment of the present application, the definitions of the substituents of Ar2 and Ar3 may be applied to Ar'2 and Ar'3, except that in the definitions of the substituents of Ar2 and Ar3, Ar2 and Ar3 are bonded to form a substituted or unsubstituted aliphatic or aromatic hydrocarbon ring or a substituted or unsubstituted aliphatic or aromatic hetero ring.

In an exemplary embodiment of the present application, Rr, Rp and Rq are the same as or different from each other, and are each independently selected from the group consisting of hydrogen; deuterium; a halogen; a cyano group; a substituted or unsubstituted C1 to C60 alkyl group; a substituted or unsubstituted C2 to C60 alkenyl group; a substituted or unsubstituted C2 to C60 alkynyl group; a substituted or unsubstituted C1 to C60 alkoxy group; a substituted or unsubstituted C3 to C60 cycloalkyl group; a substituted or unsubstituted C2 to C60 heterocycloalkyl group; a substituted or unsubstituted C6 to C60 aryl group; a substituted or unsubstituted C2 to C60 heteroaryl group; -P(=O)RR'; -SiRR'R" and -NRR', r is an integer from 0 to 4, p and q are each an integer from 0 to 3, and when r, p and q are each 2 or higher, substituents in the parenthesis are the same as or different from each other, and R, R' and R" are the same as or different from each other, and are each independently hydrogen; deuterium; a substituted or unsubstituted C1 to C60 alkyl group; a substituted or unsubstituted C6 to C60 aryl group; or a substituted or unsubstituted C2 to C60 heteroaryl group.

In an exemplary embodiment of the present application, Rr, Rp and Rq are the same as or different from each other, and are each independently hydrogen; deuterium; a halogen; a cyano group; a substituted or unsubstituted C6 to C60 aryl group; or a substituted or unsubstituted C2 to C60 heteroaryl group.

In an exemplary embodiment of the present application, Rr, Rp and Rq are the same as or different from each other, and are each independently hydrogen; deuterium; a halogen; or a cyano group.

In an exemplary embodiment of the present application, Rr, Rp and Rq are the same as or different from each other, and are each independently hydrogen; or deuterium.

In an exemplary embodiment of the present application, Chemical Formula 1 may be represented by the following Chemical Formula 1-1 or 1-2.

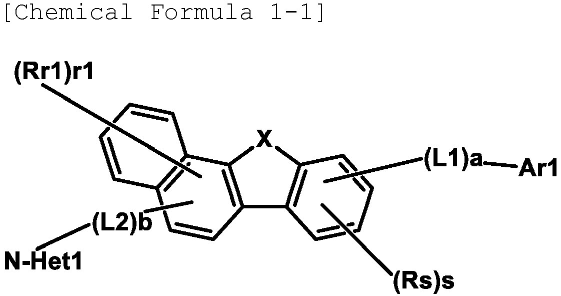

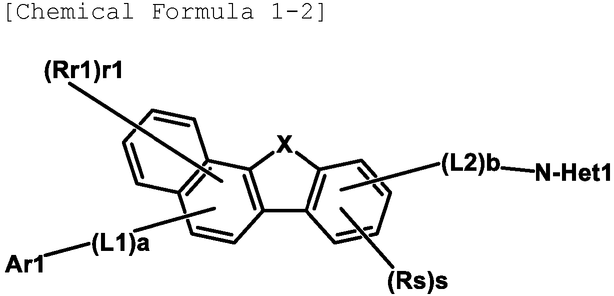

In Chemical Formulae 1-1 and 1-2,
Rr1 and Rs are the same as or different from each other, and are each independently hydrogen; deuterium; a cyano group; a halogen group; or a substituted or unsubstituted C1 to C60 alkyl group,
r1 is an integer from 0 to 5, and when r1 is 2 or higher, Rr1's in the parenthesis are the same as or different from each other,
s is an integer from 0 to 3, and when s is 2 or higher, Rs's in the parenthesis are the same as or different from each other, and
the definitions of X, L1, L2, Ar1, a, b and N-Het1 are the same as the definitions in Chemical Formula 1.

In an exemplary embodiment of the present application, Chemical Formula 1-1 may be represented by any one of the following Chemical Formulae 1-1-1 to 1-1-4.

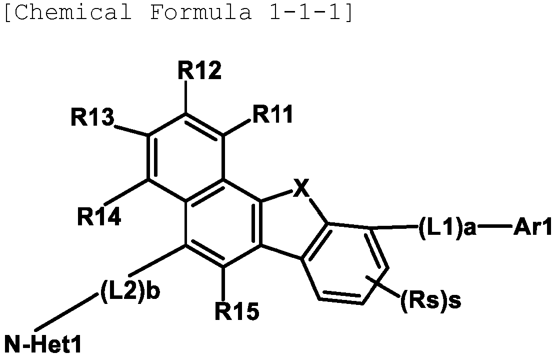

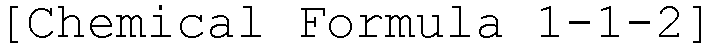

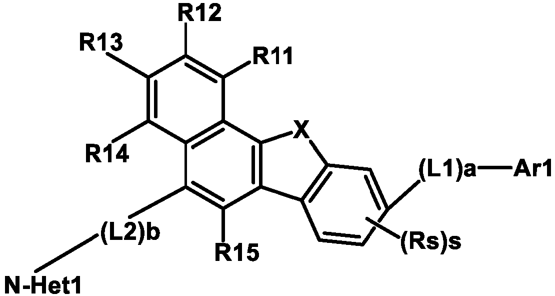

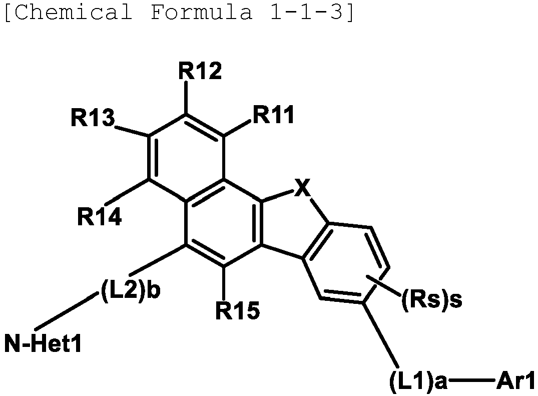

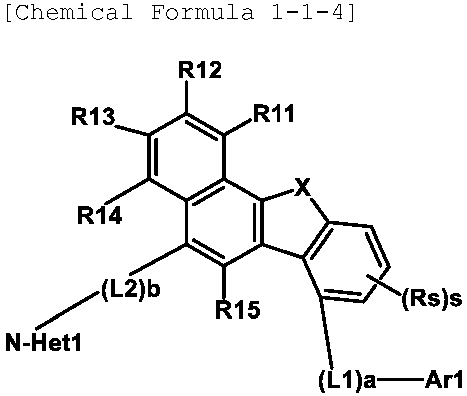

In Chemical Formulae 1-1-1 to 1-1-4,
R11 to R15 are the same as or different from each other, and are each independently hydrogen; deuterium; a cyano group; a halogen group; or a substituted or unsubstituted C1 to C60 alkyl group, and
the definitions of X, Rs, L1, L2, Ar1, a, b, s and N-Het1 are the same as the definitions in Chemical Formula 1-1.

In an exemplary embodiment of the present application, Chemical Formula 1-2 may be represented by any one of the following Chemical Formulae 1-2-1 to 1-2-4.

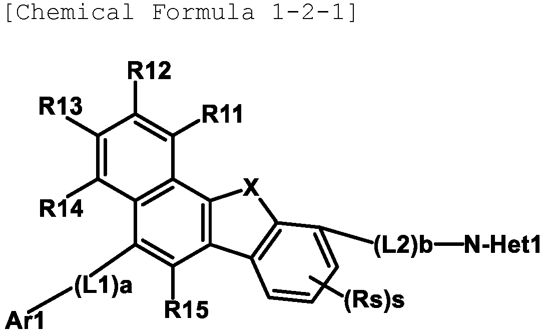

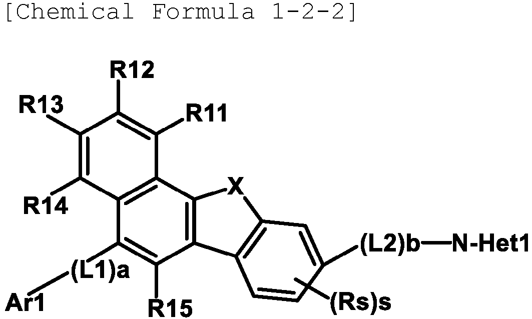

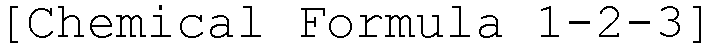

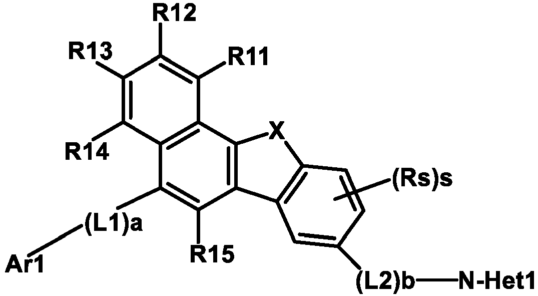

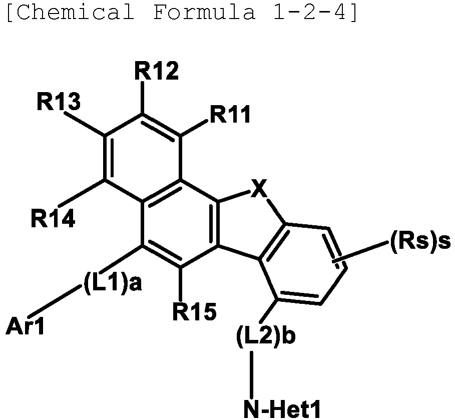

In Chemical Formulae 1-2-1 to 1-2-4,
R11 to R15 are the same as or different from each other, and are each independently hydrogen; deuterium; a cyano group; a halogen group; or a substituted or unsubstituted C1 to C60 alkyl group, and
the definitions of X, Rs, L1, L2, Ar1, a, b, s and N-Het1 are the same as the definitions in Chemical Formula 1-2.

According to an exemplary embodiment of the present application, Chemical Formula 1 may be represented by any one of the following compounds, but is not limited thereto.

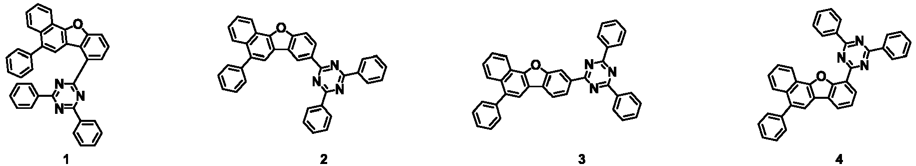

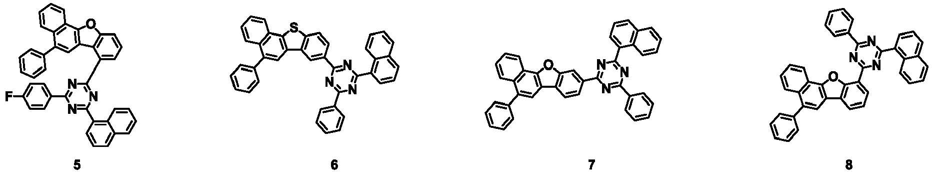

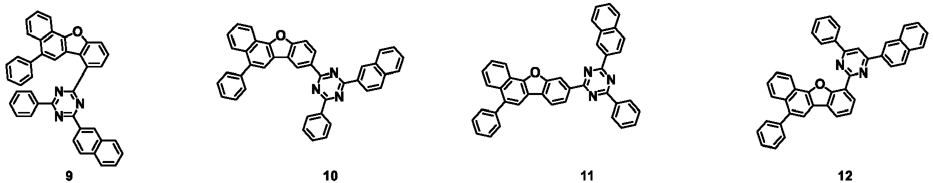

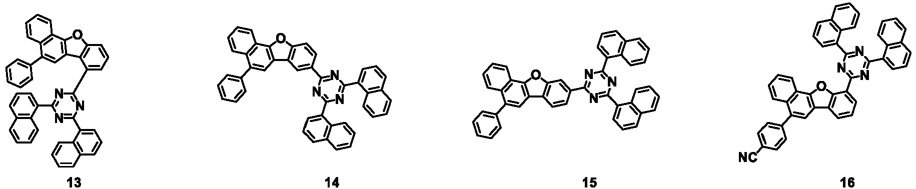

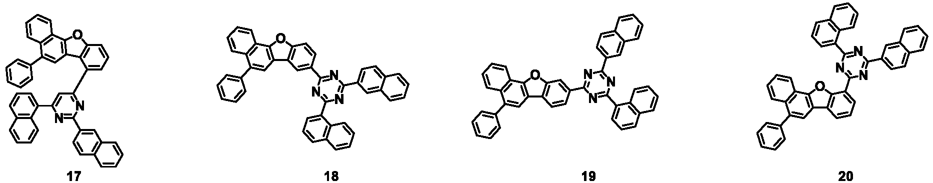

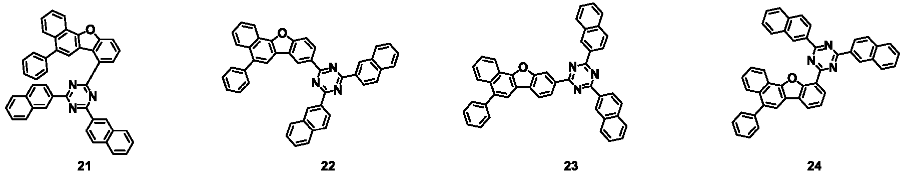

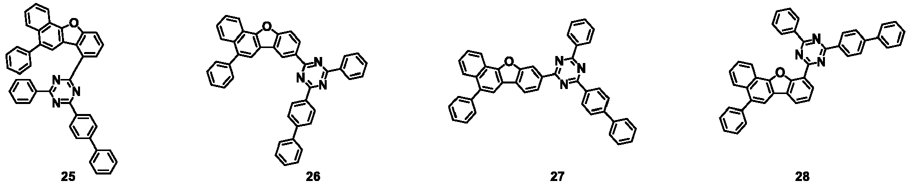

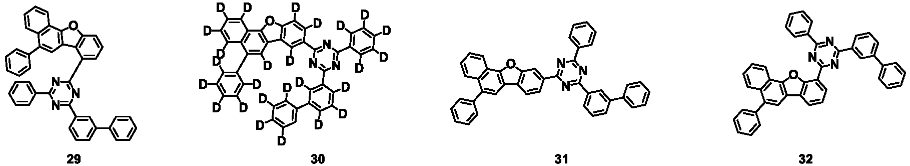

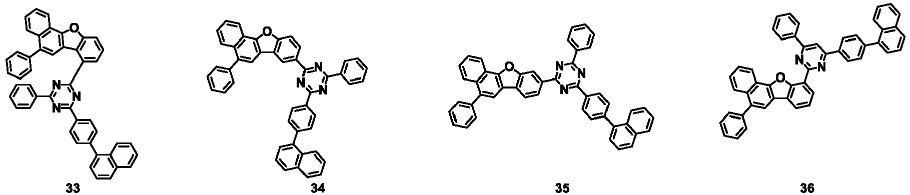

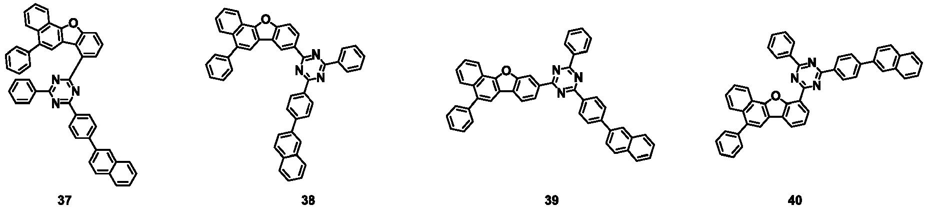

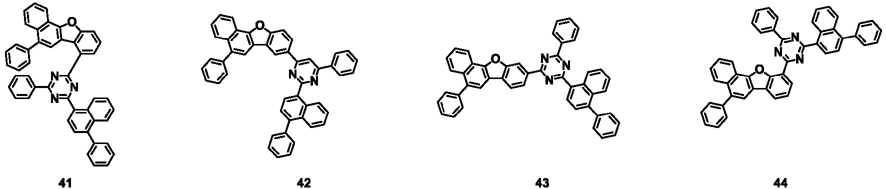

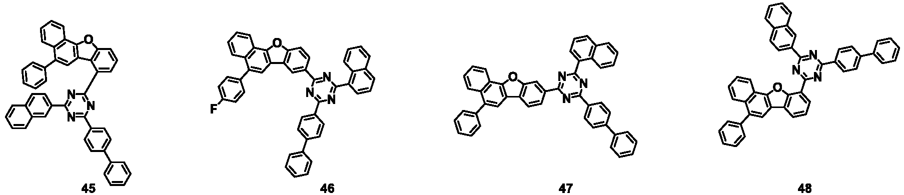

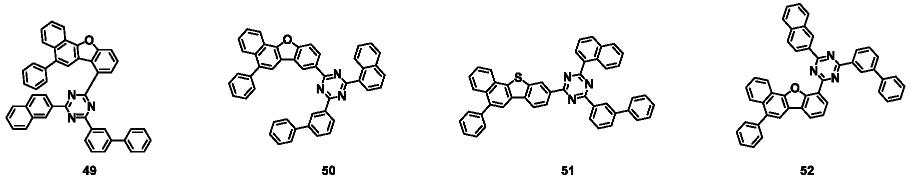

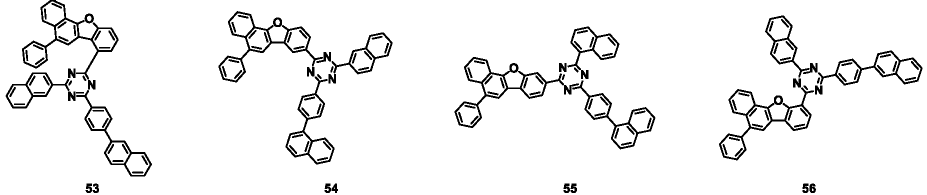

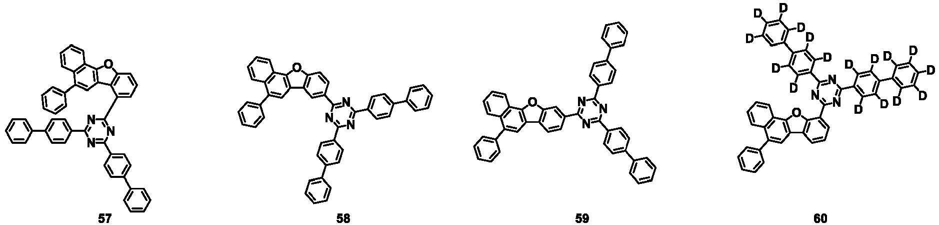

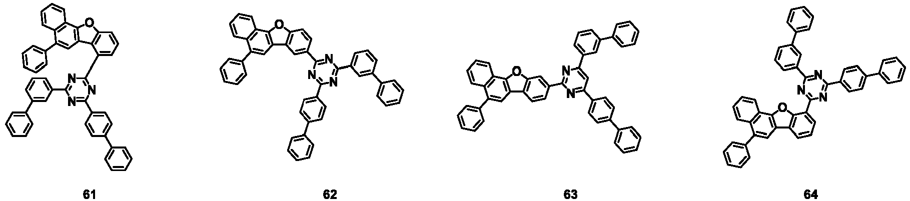

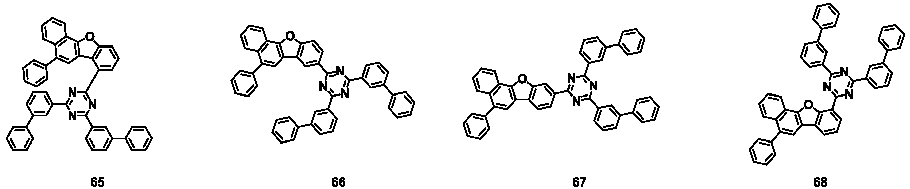

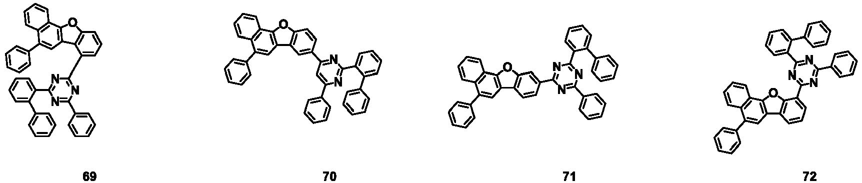

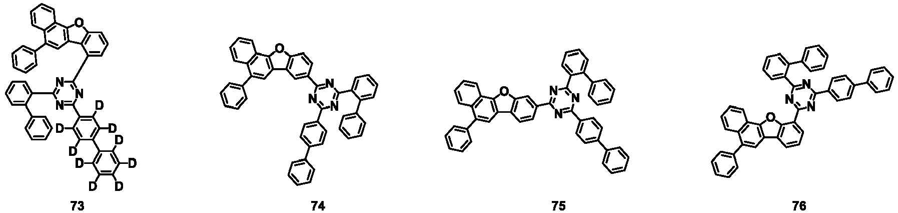

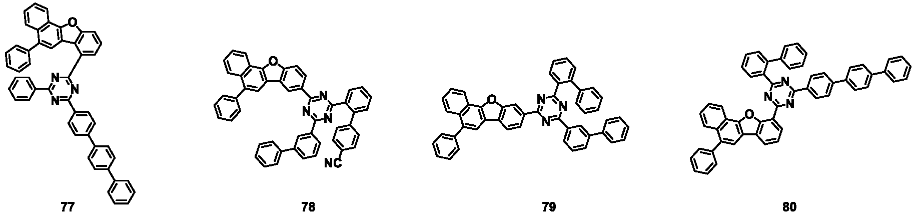

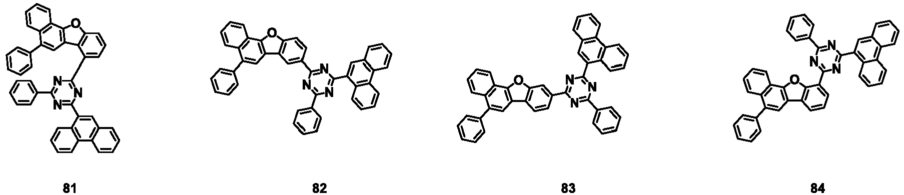

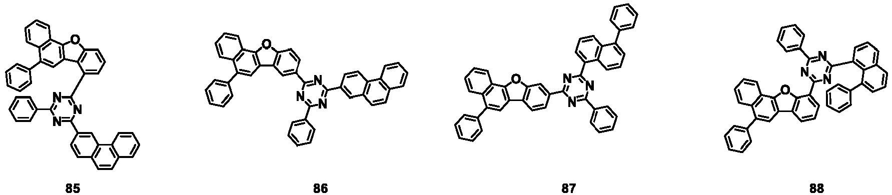

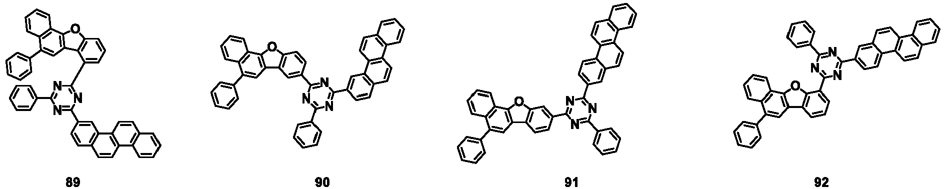

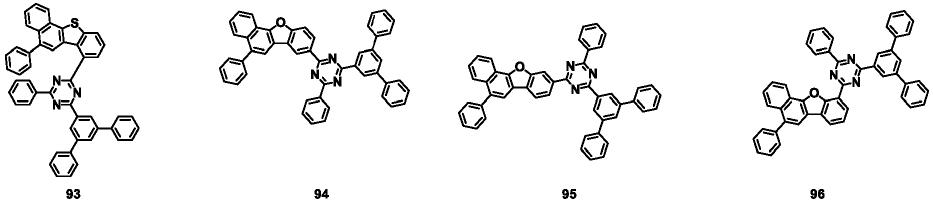

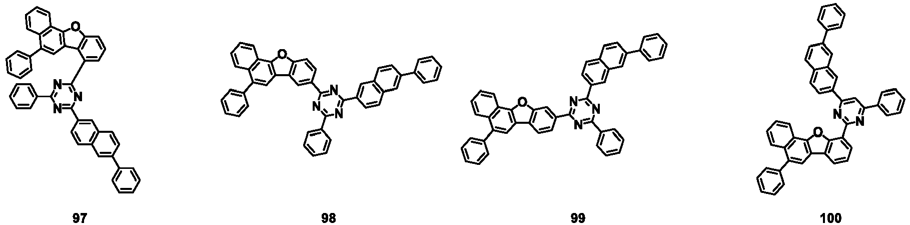

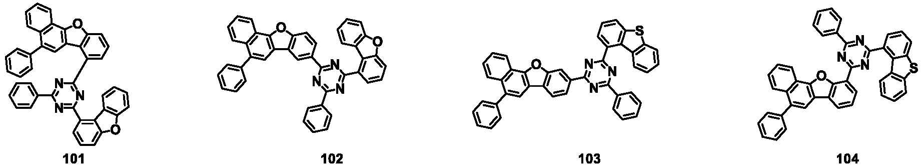

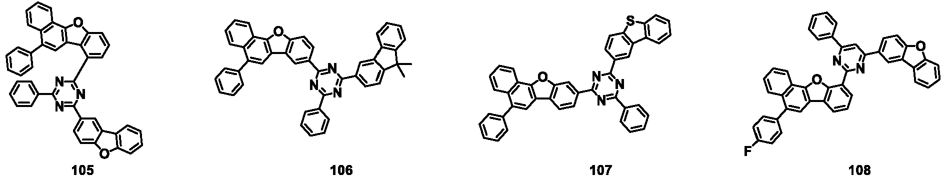

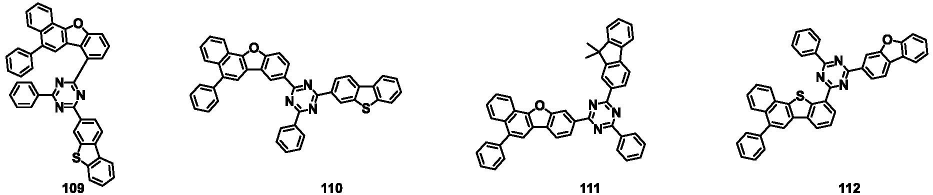

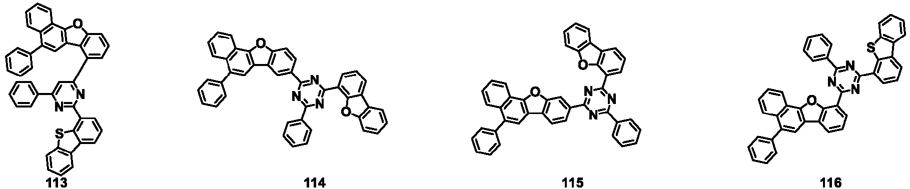

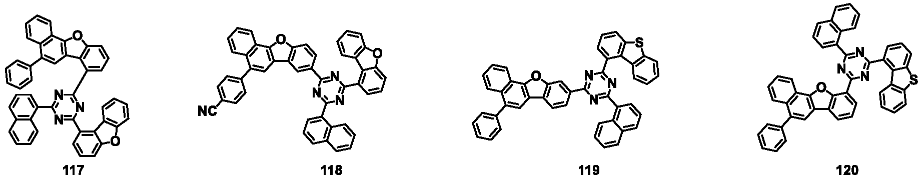

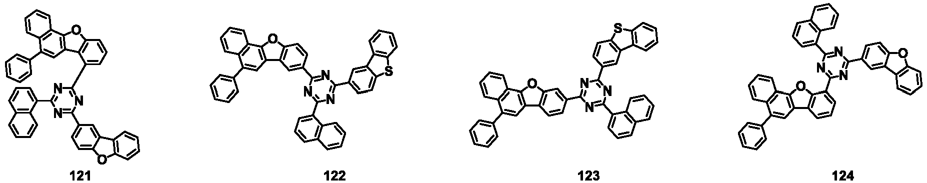

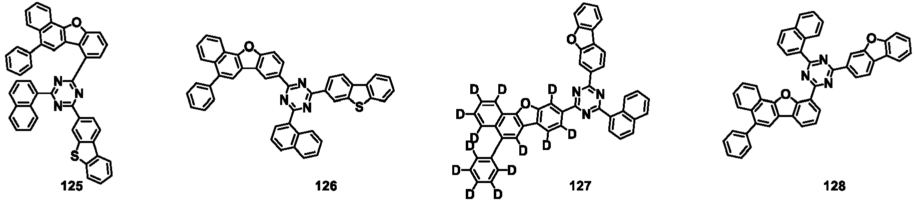

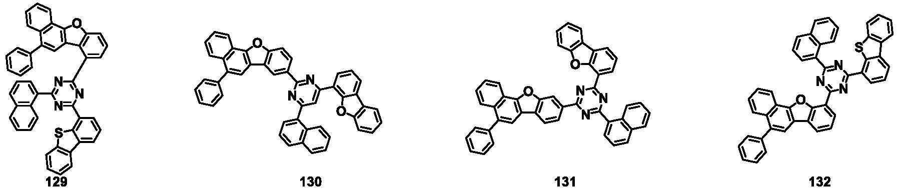

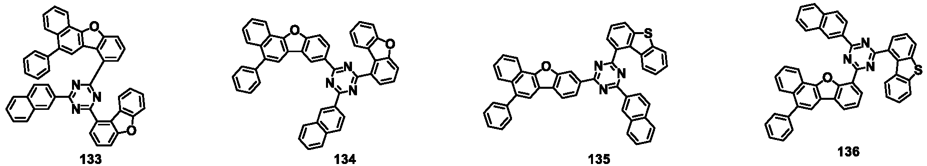

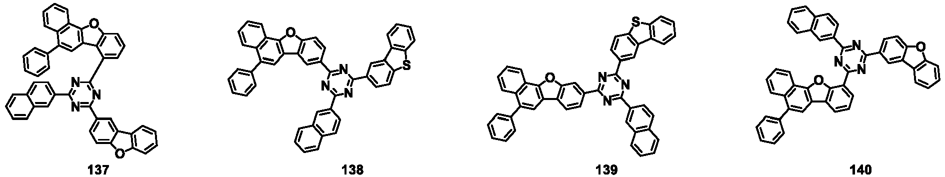

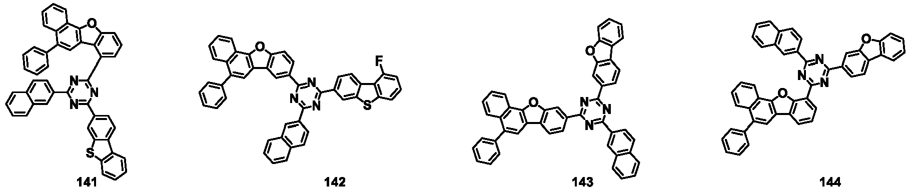

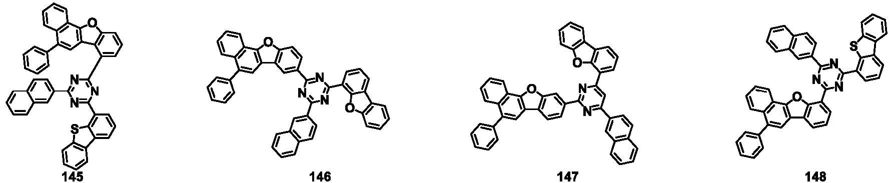

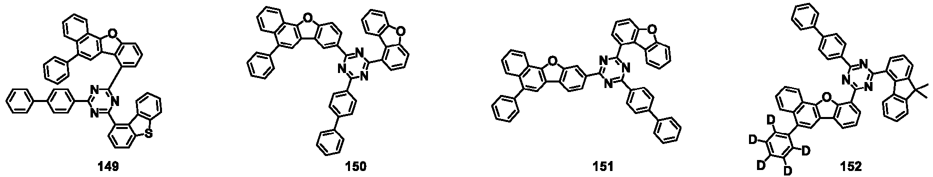

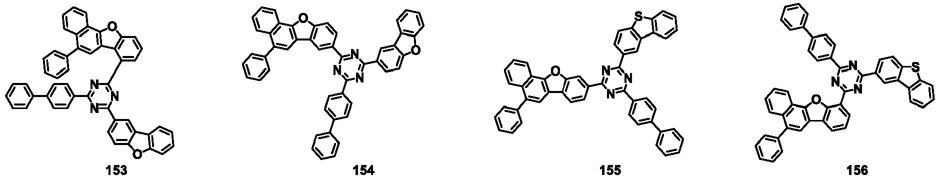

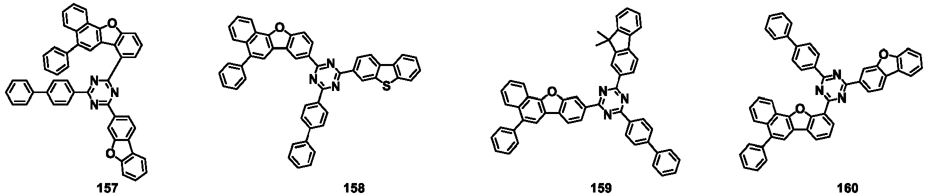

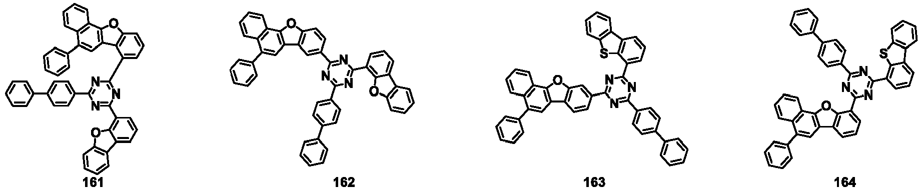

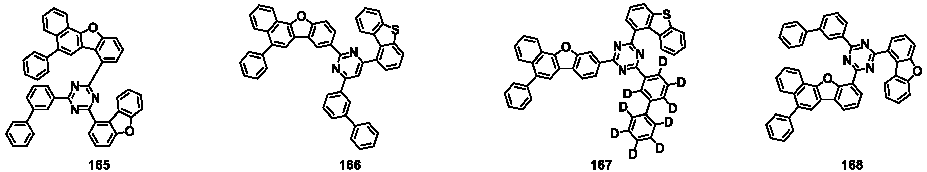

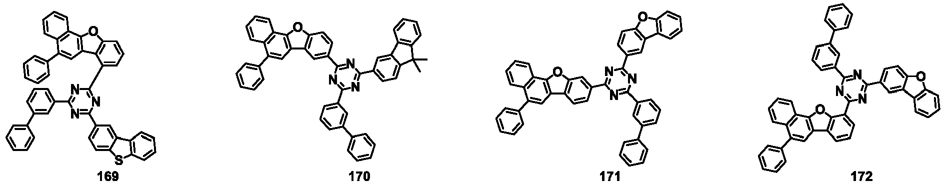

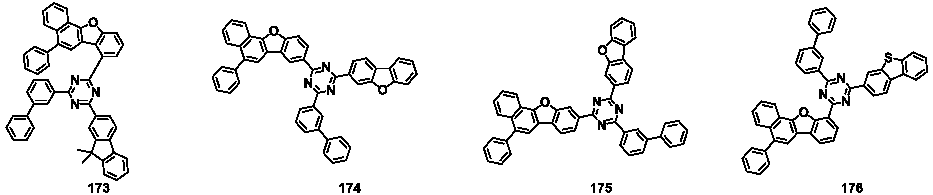

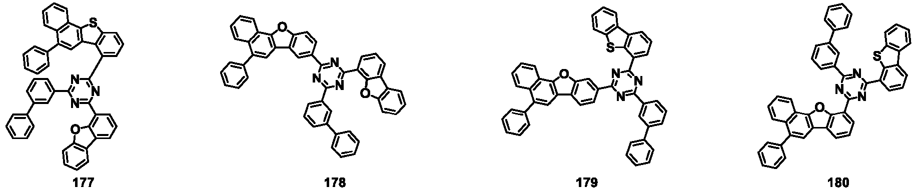

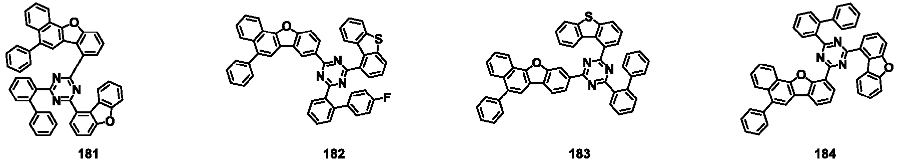

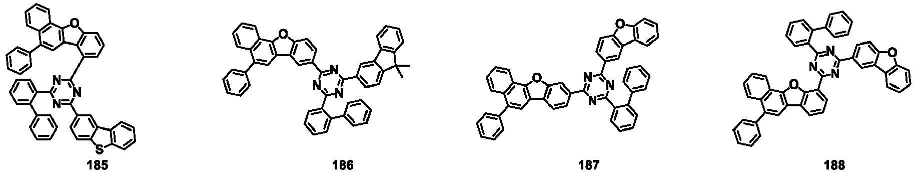

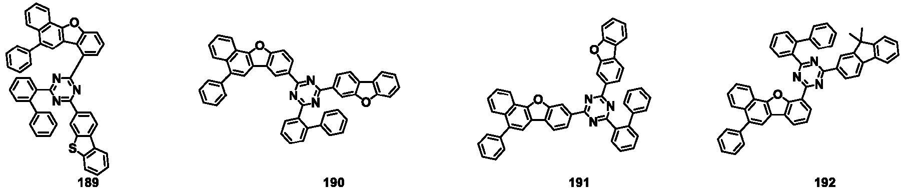

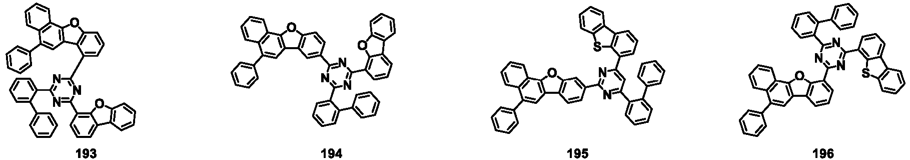

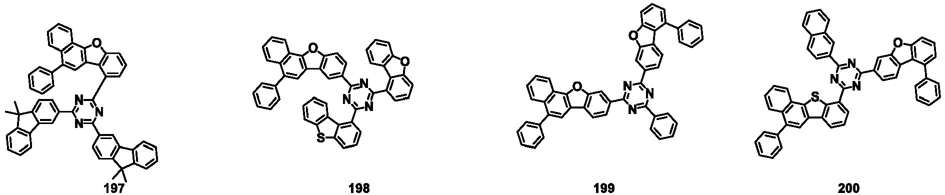

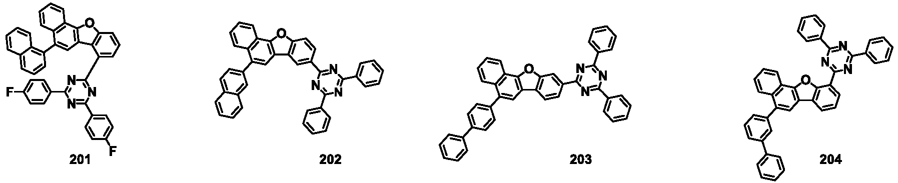

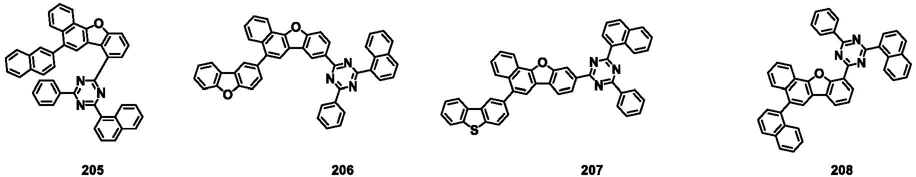

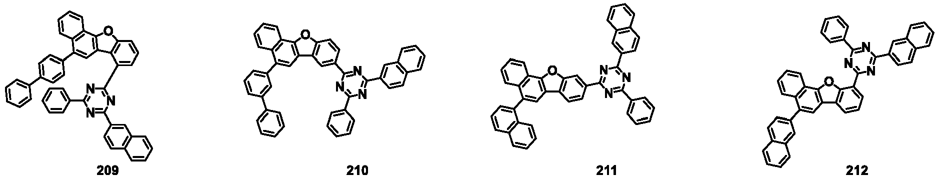

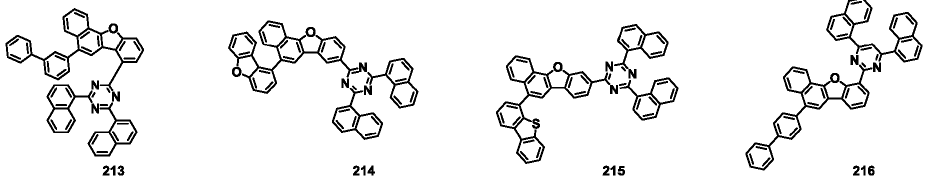

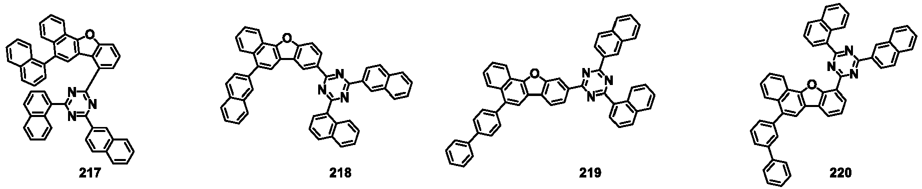

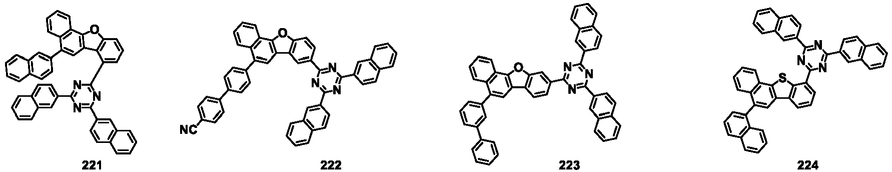

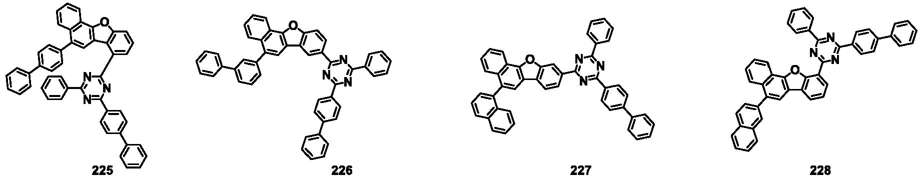

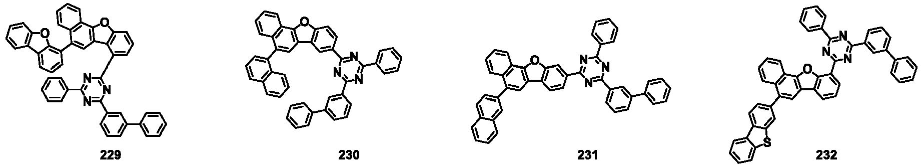

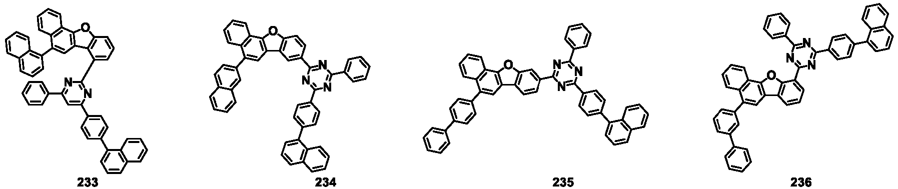

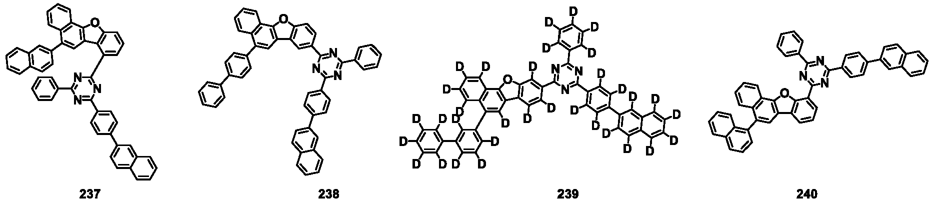

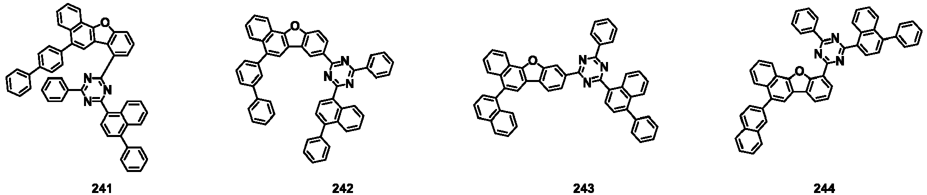

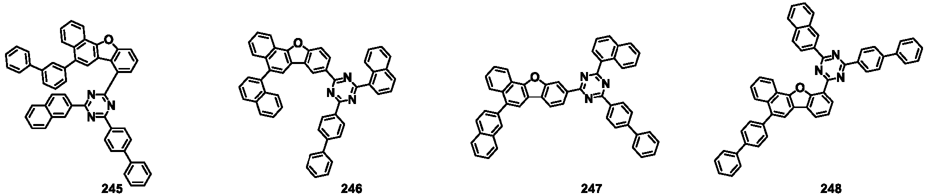

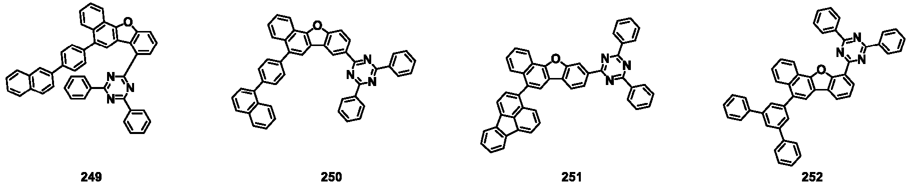

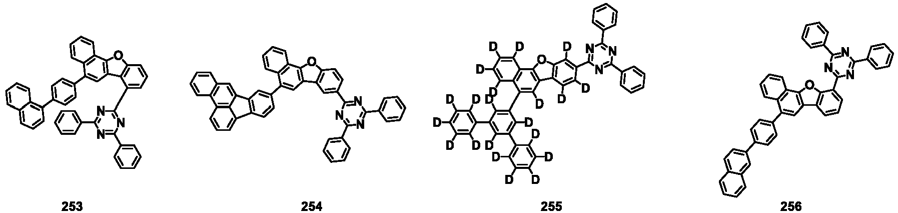

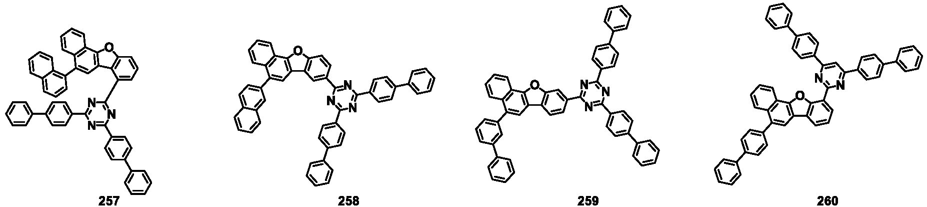

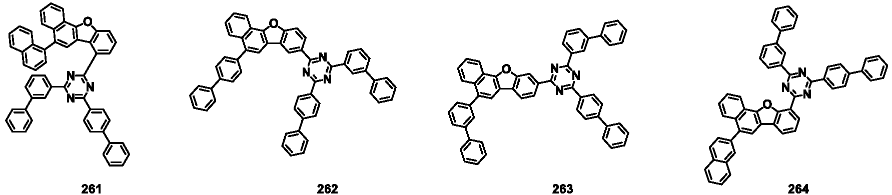

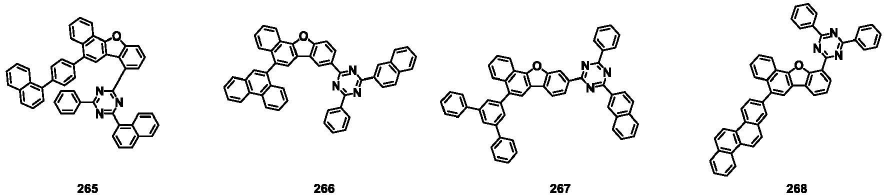

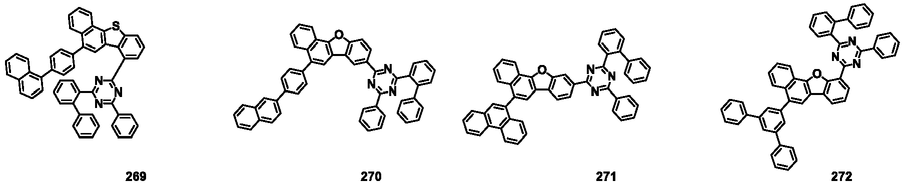

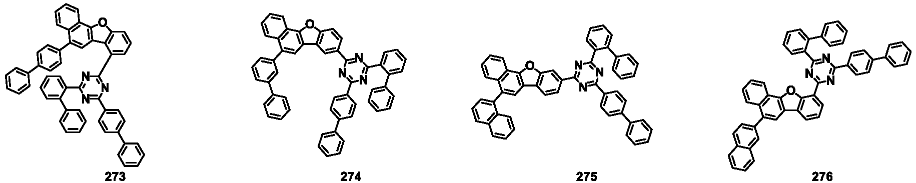

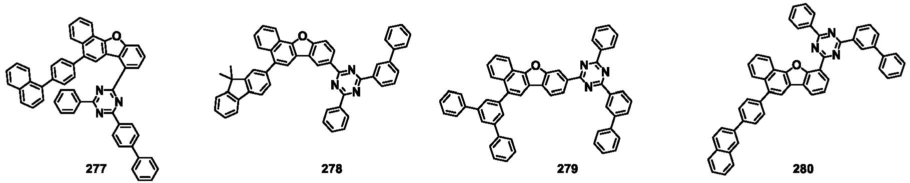

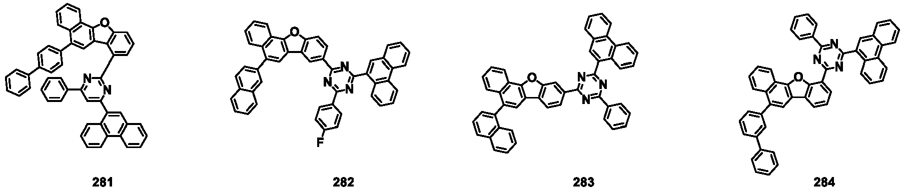

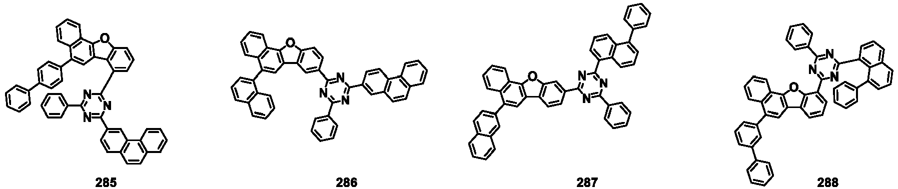

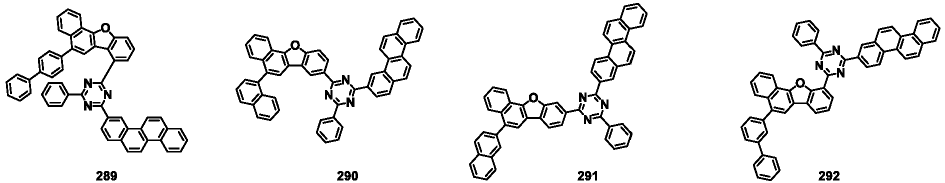

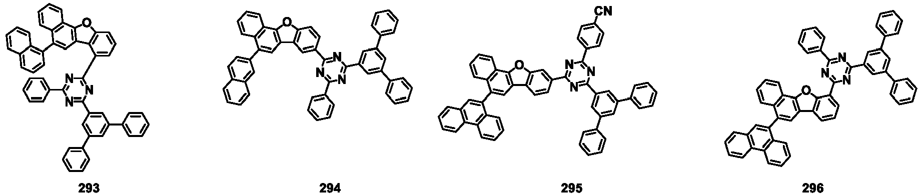

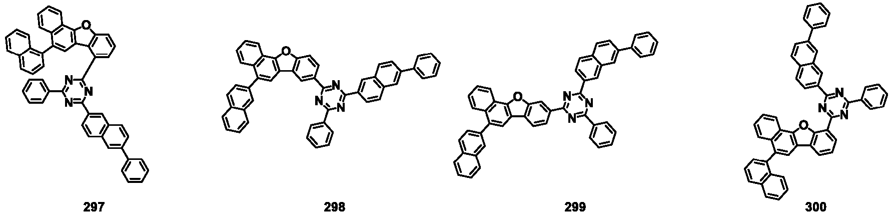

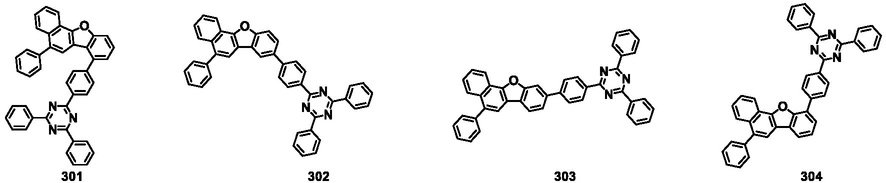

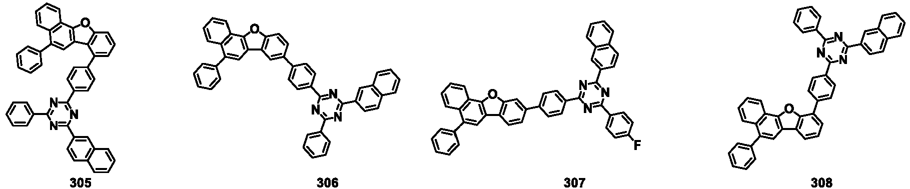

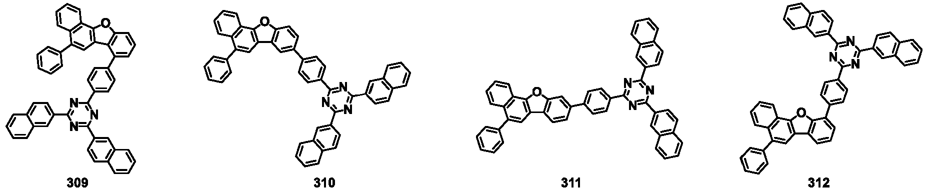

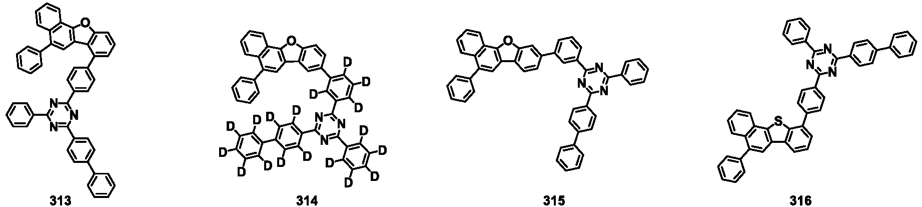

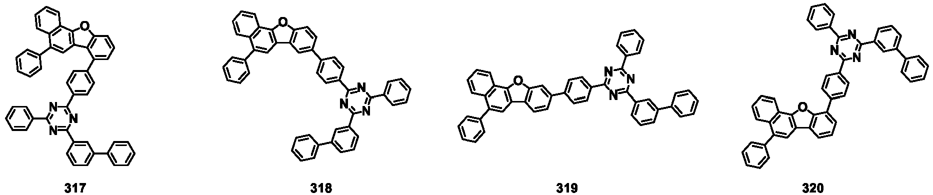

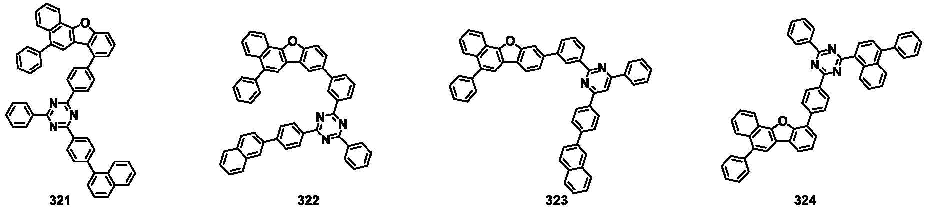

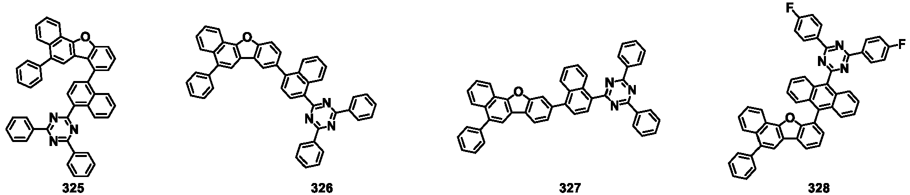

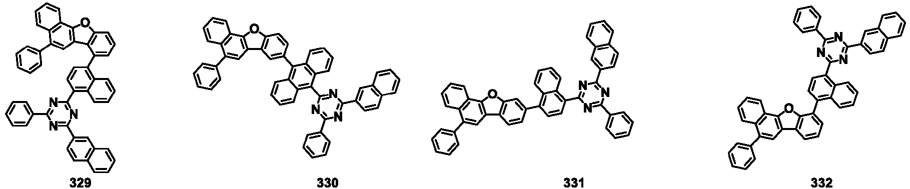

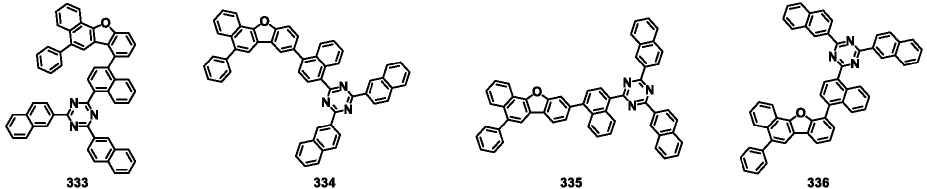

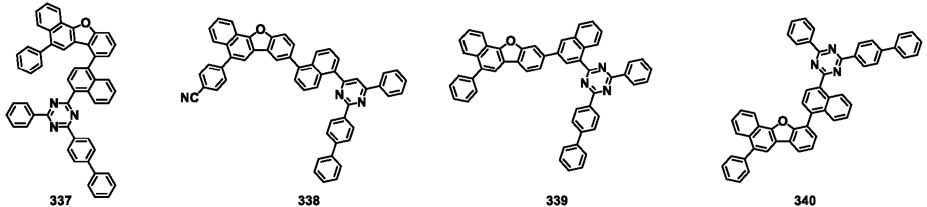

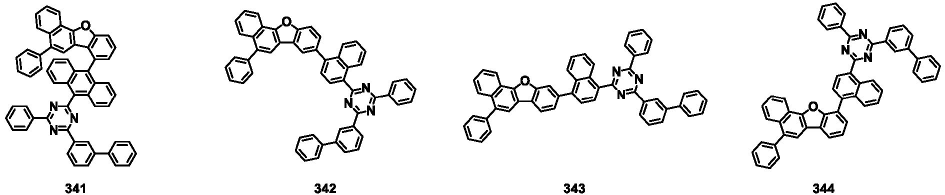

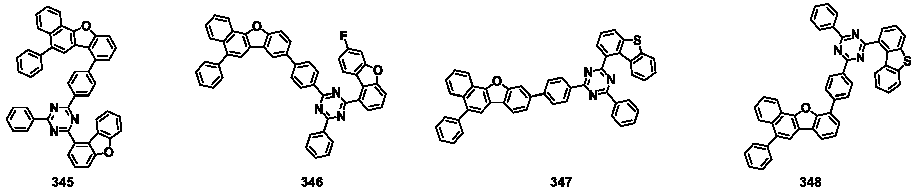

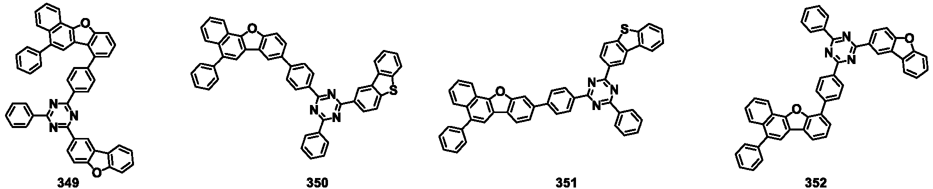

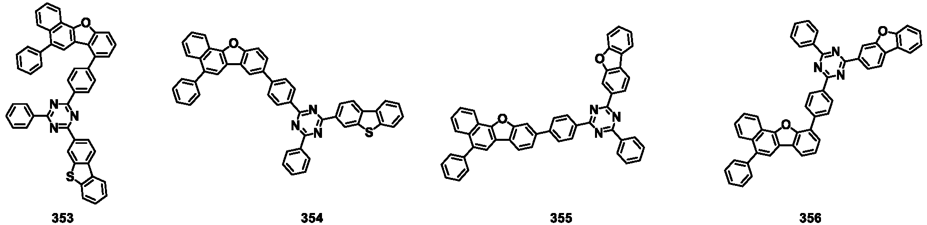

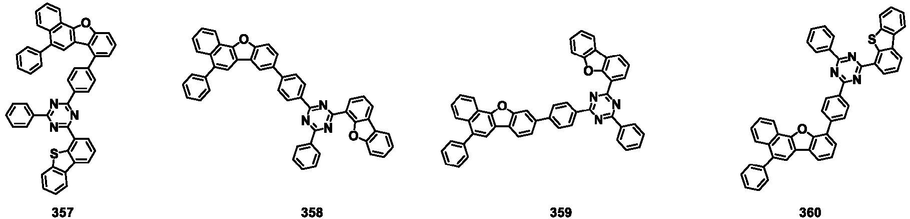

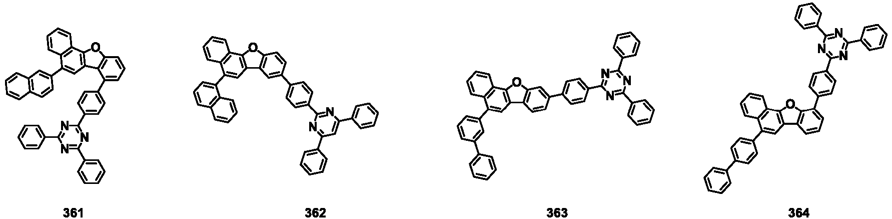

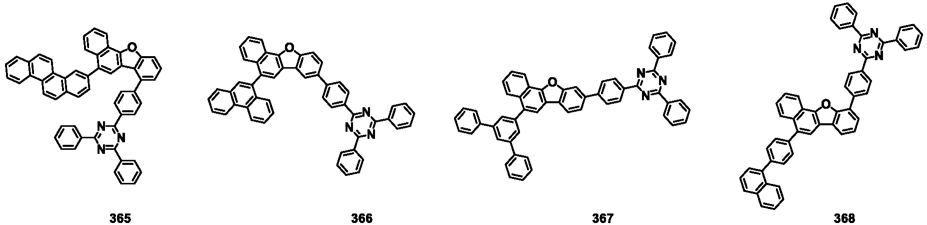

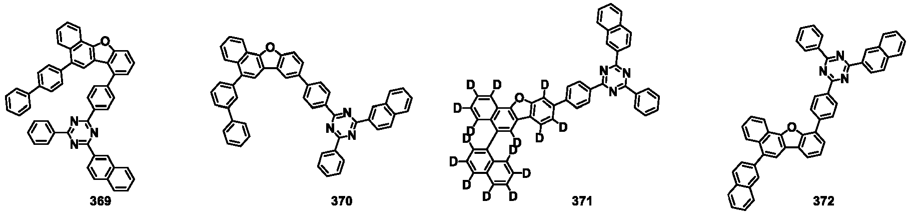

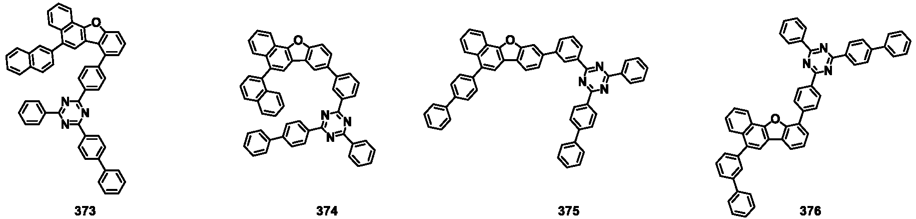

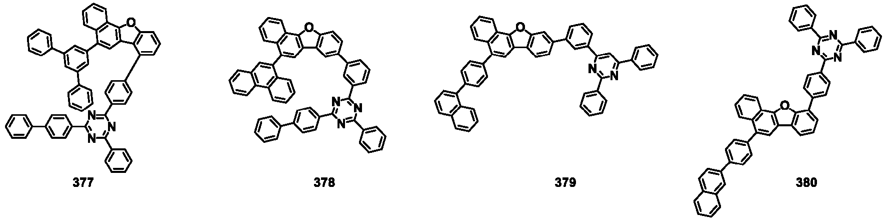

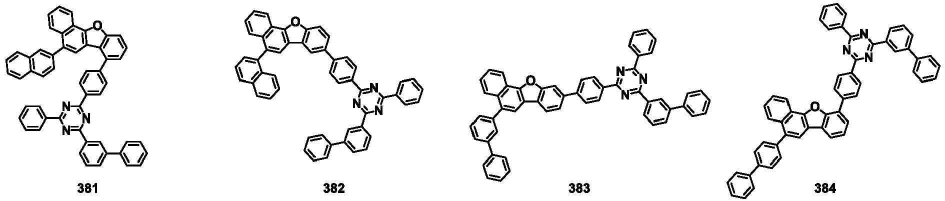

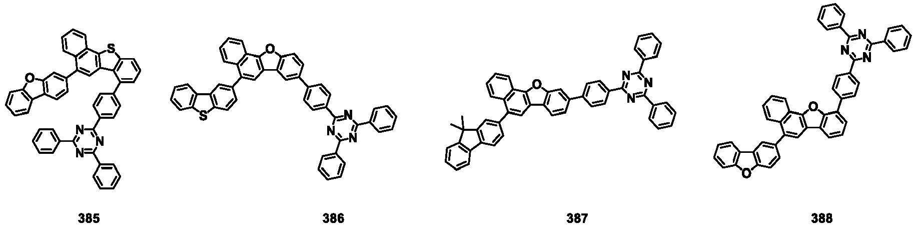

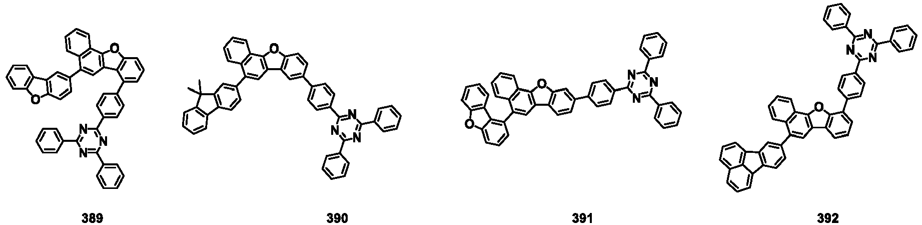

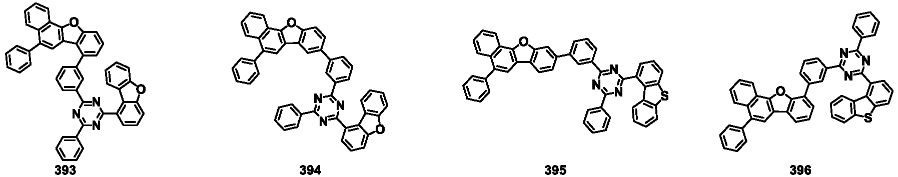

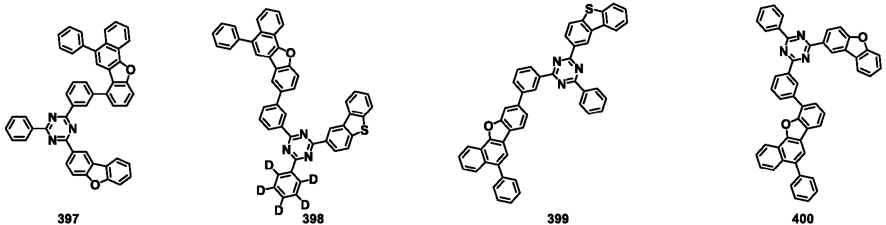

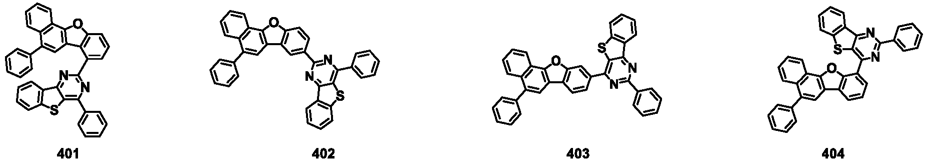

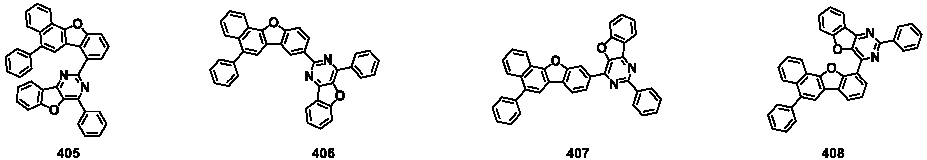

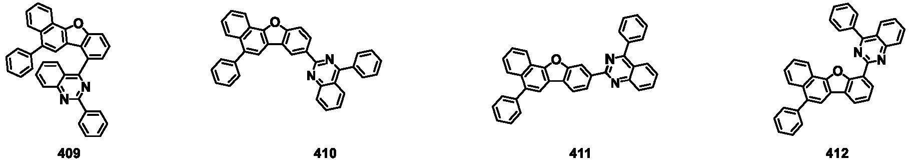

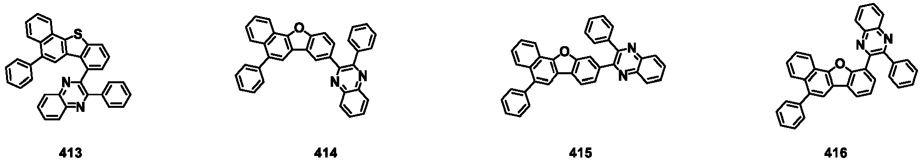

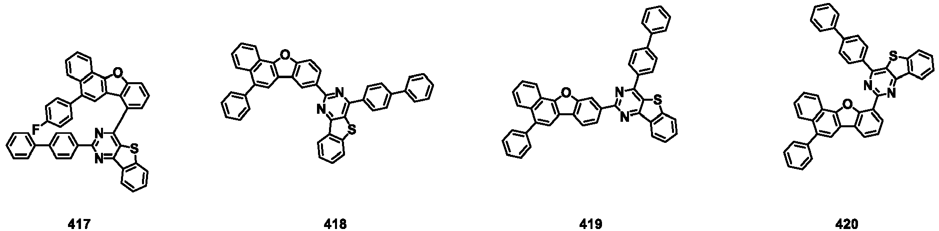

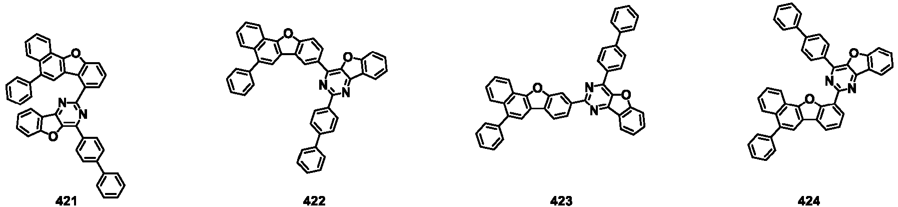

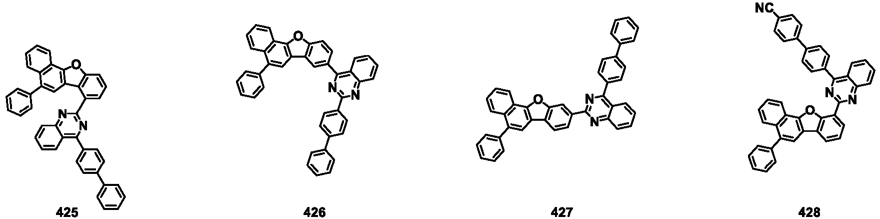

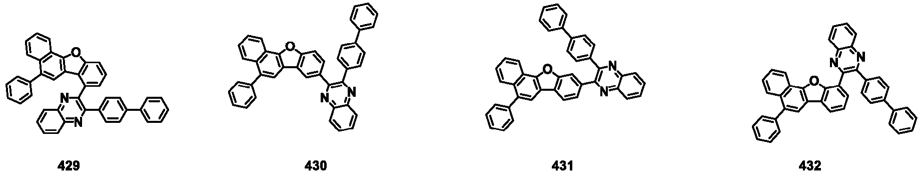

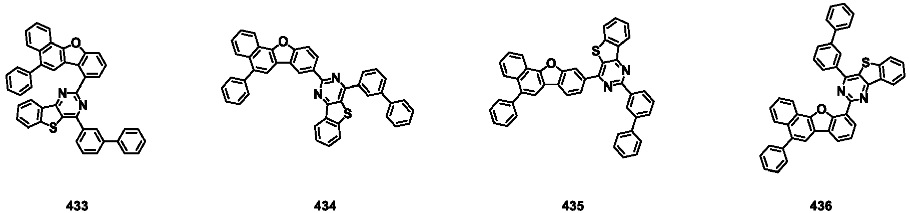

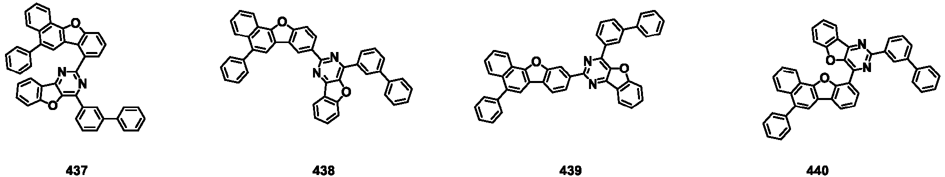

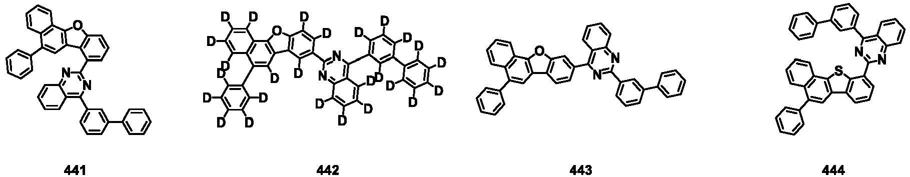

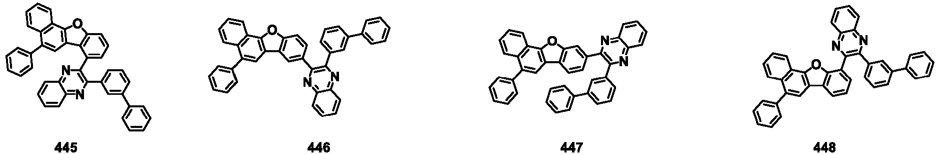

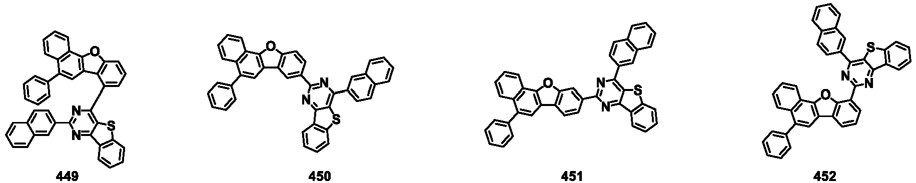

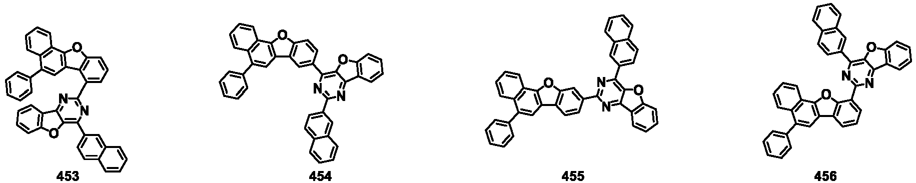

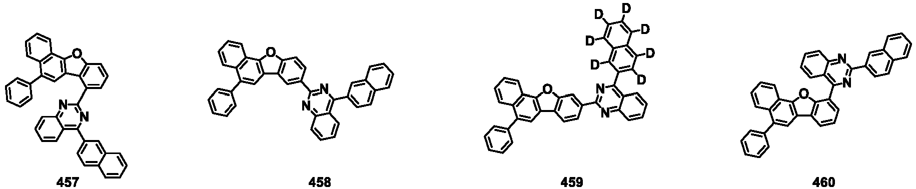

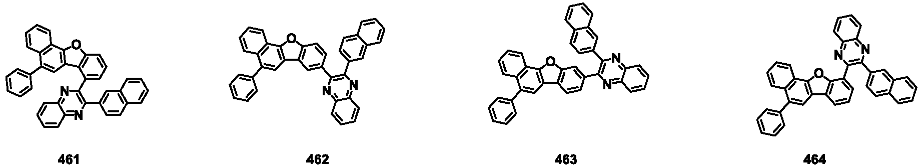

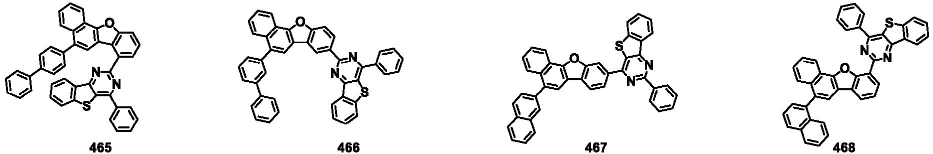

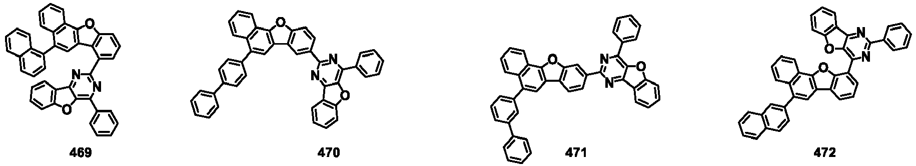

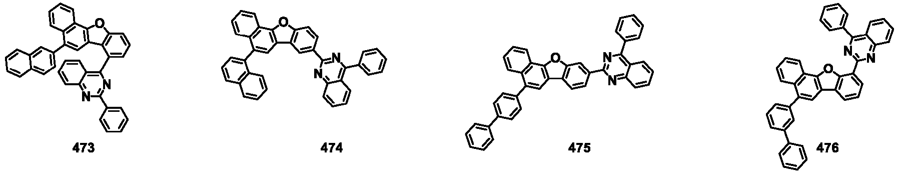

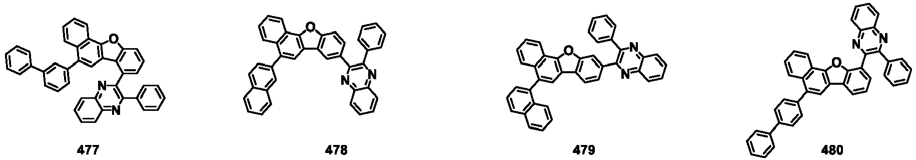

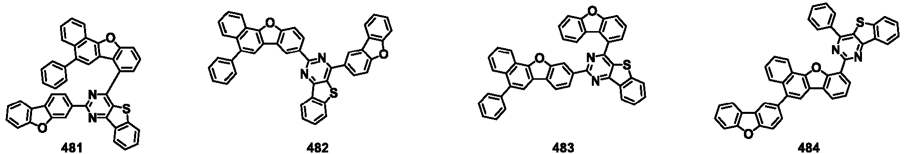

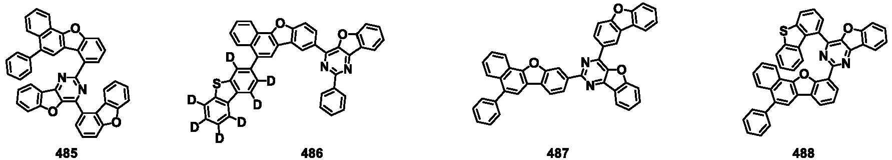

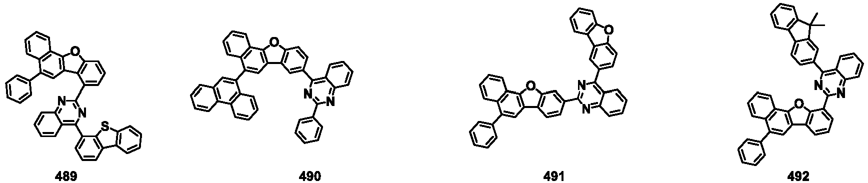

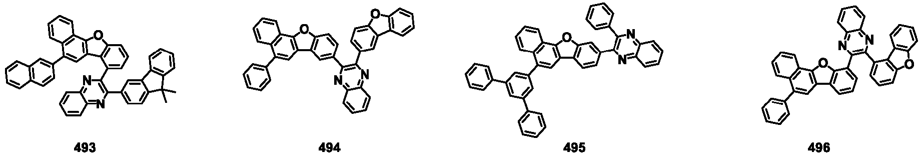

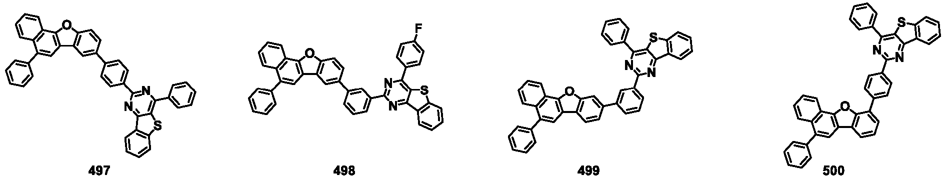

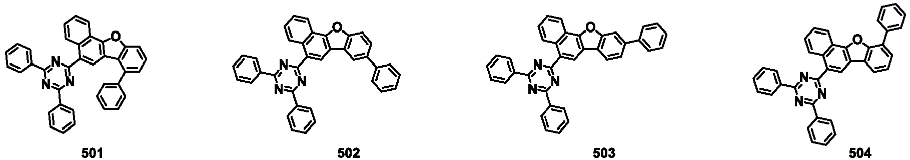

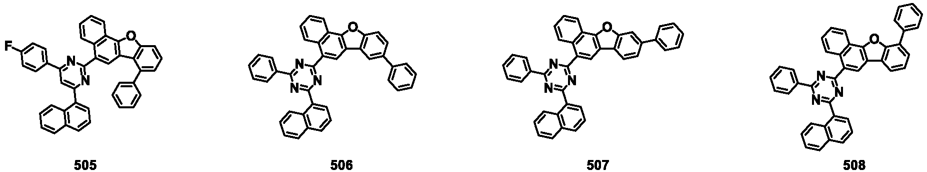

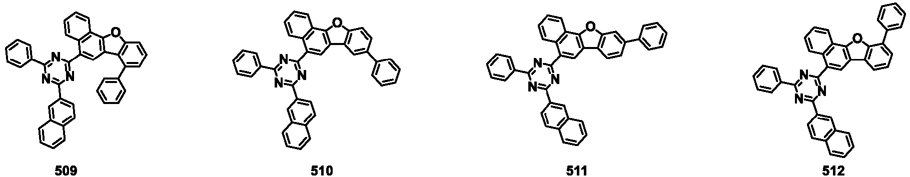

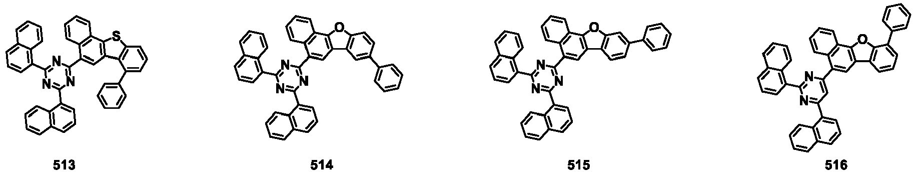

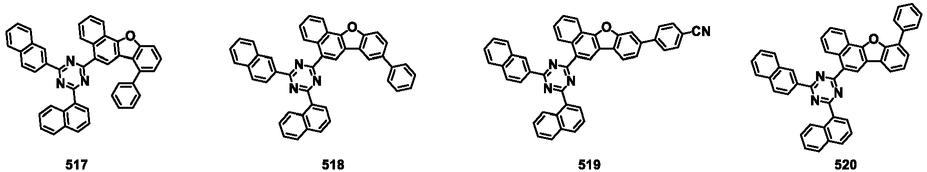

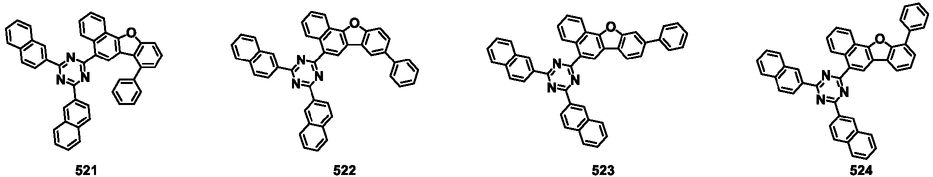

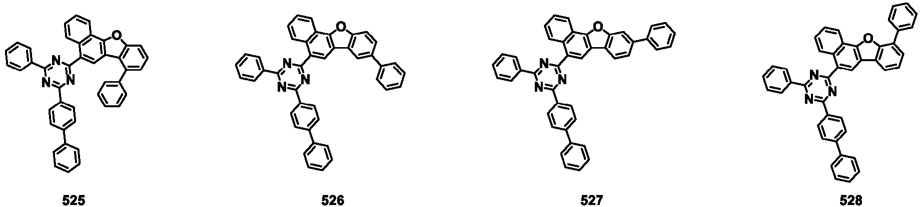

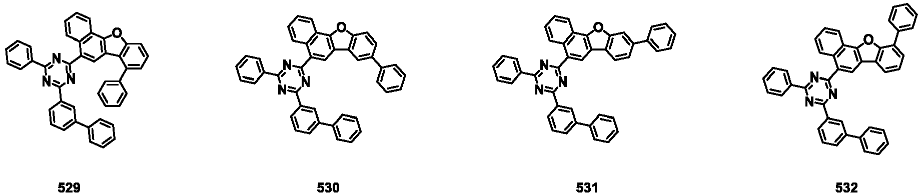

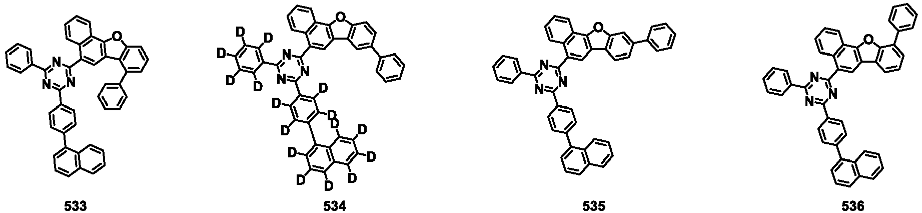

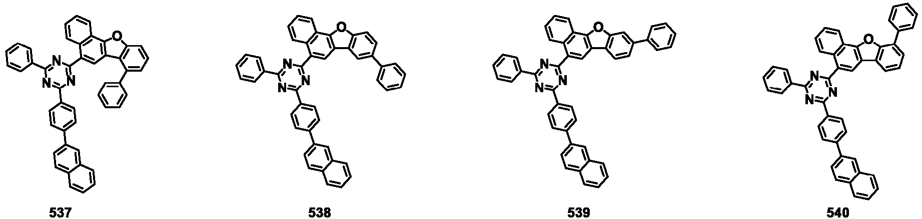

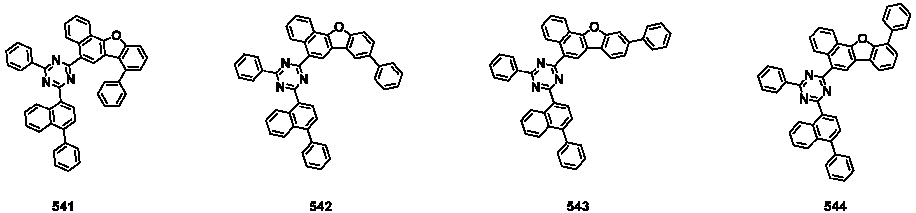

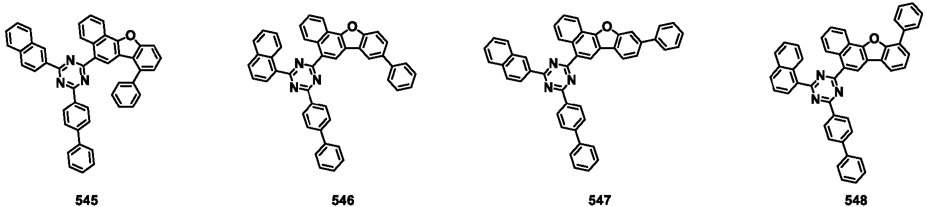

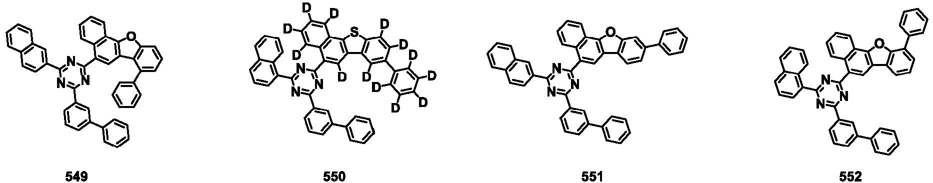

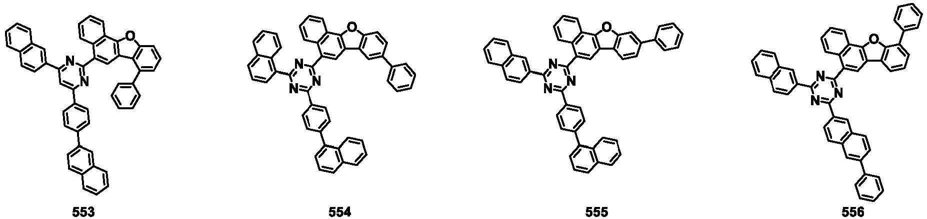

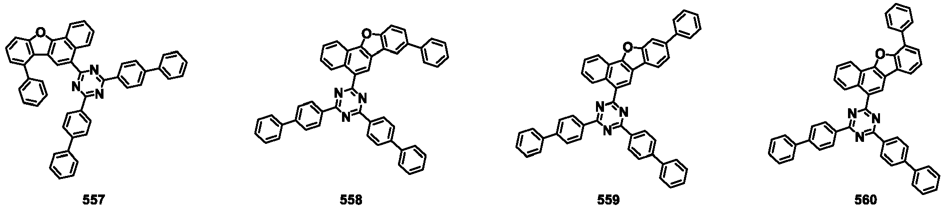

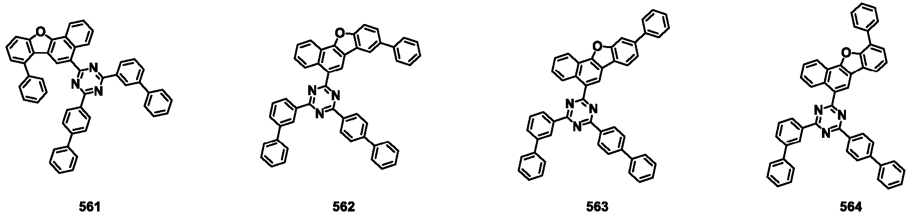

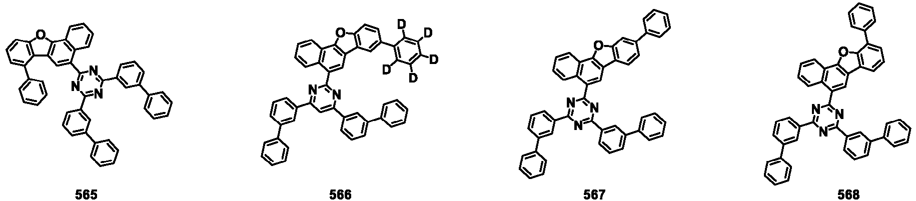

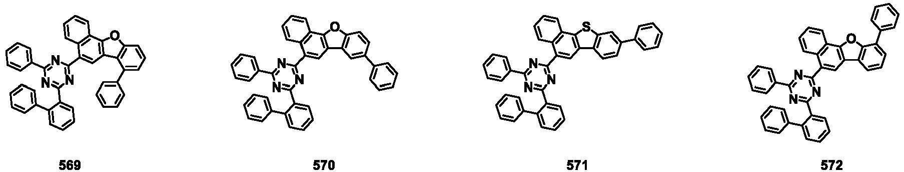

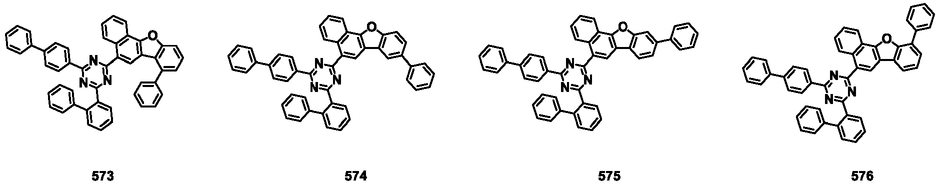

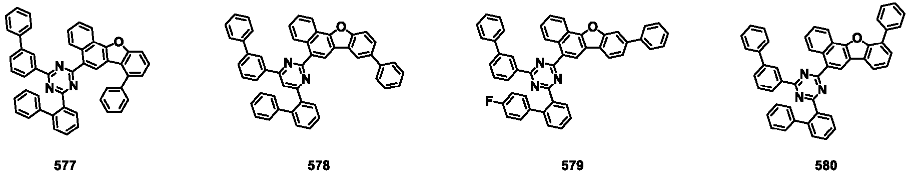

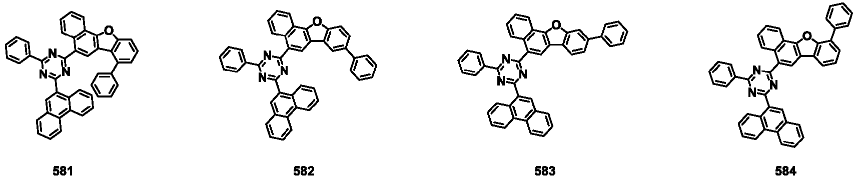

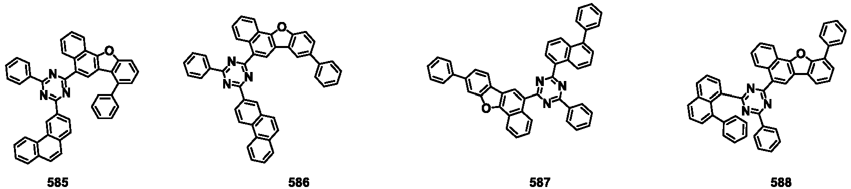

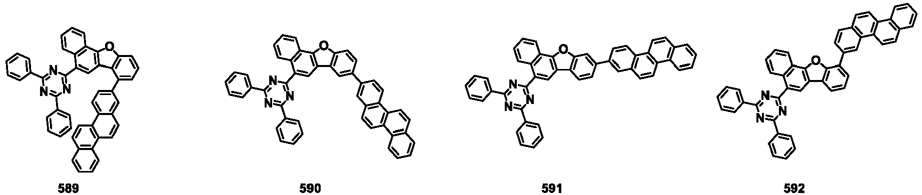

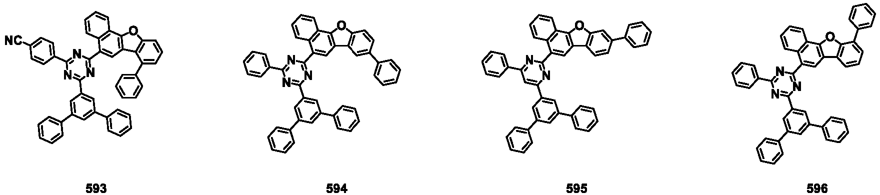

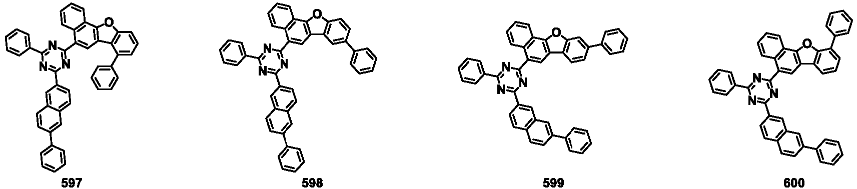

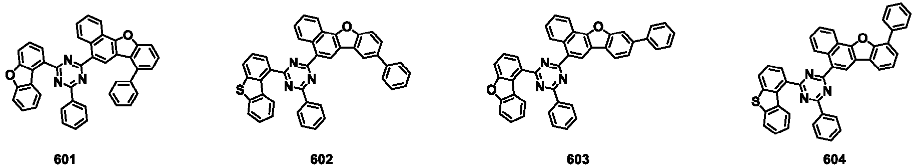

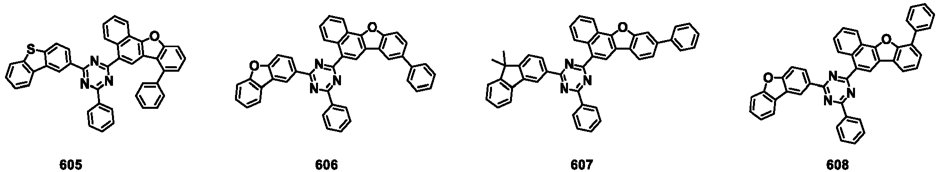

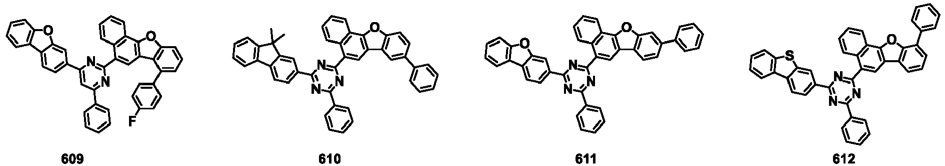

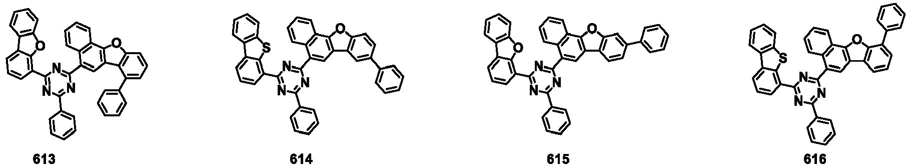

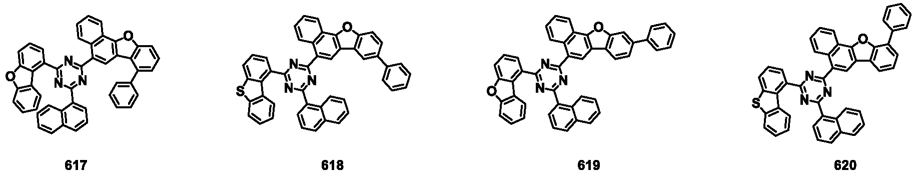

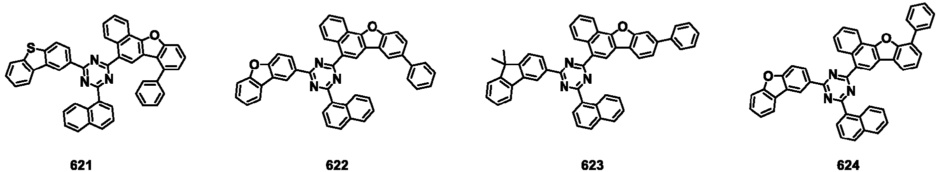

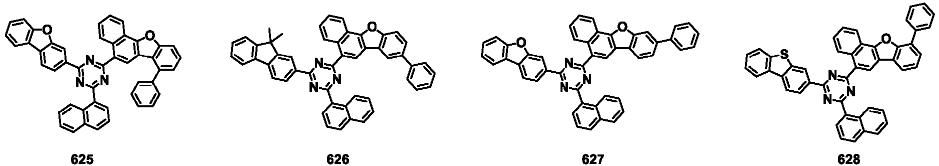

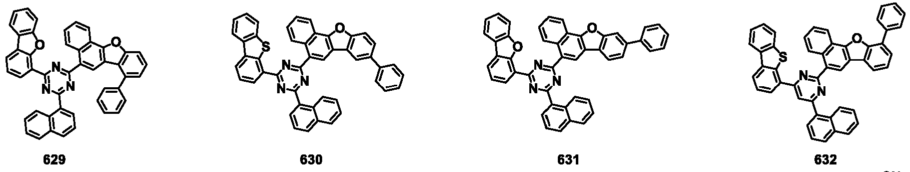

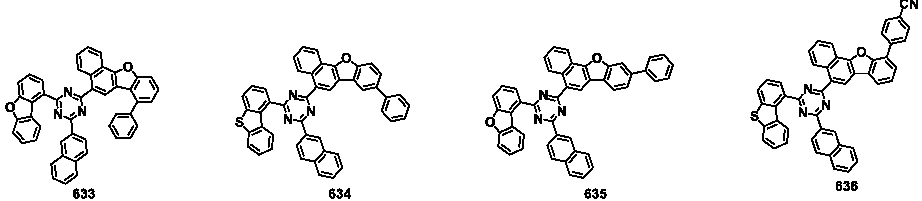

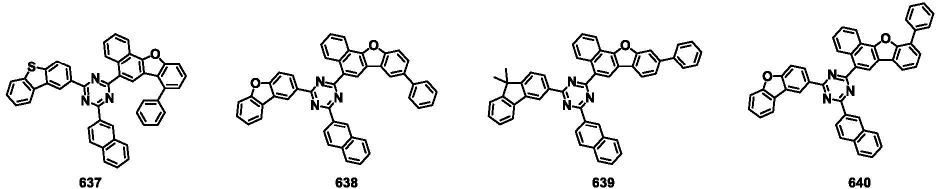

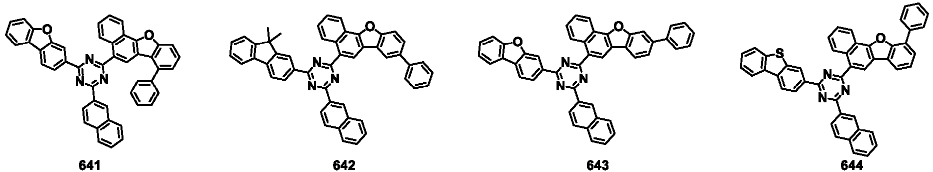

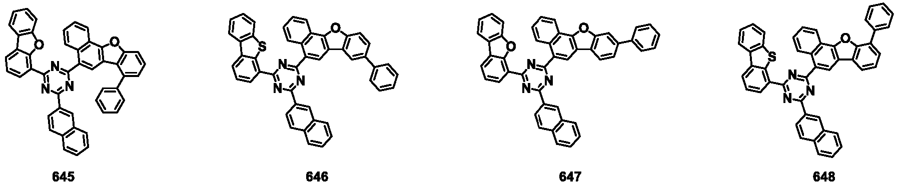

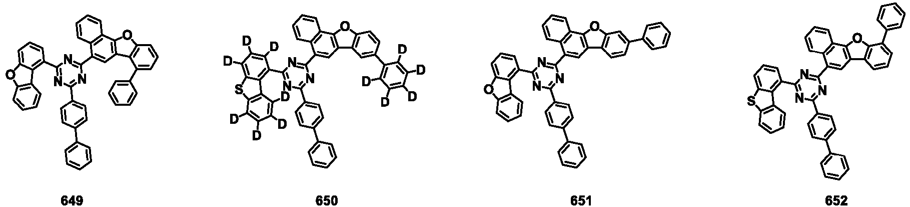

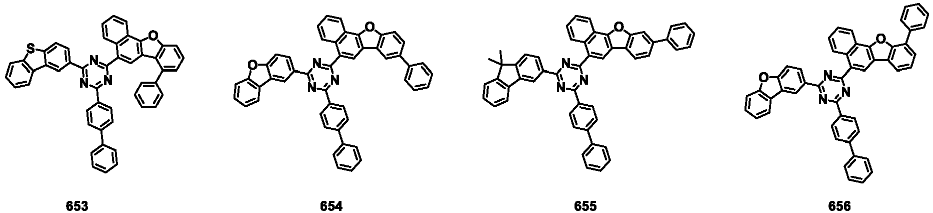

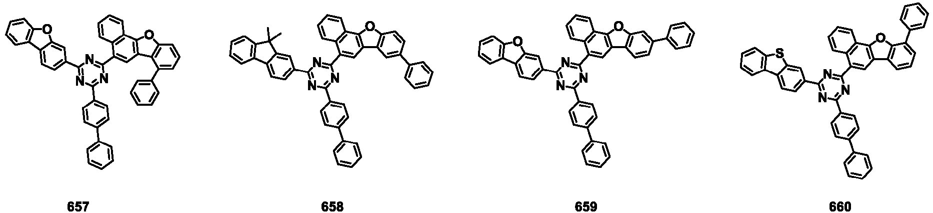

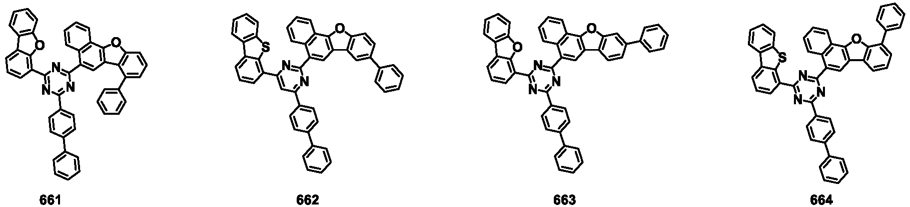

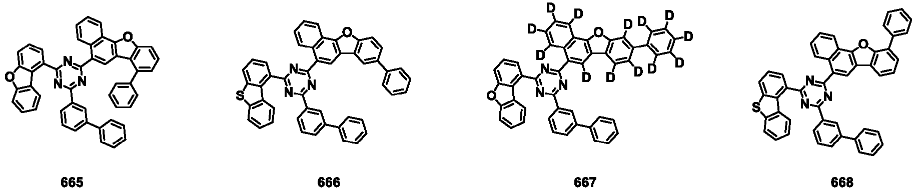

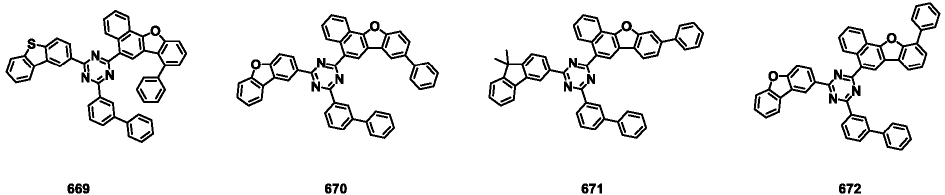

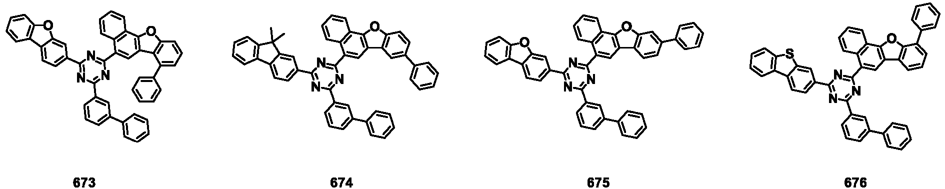

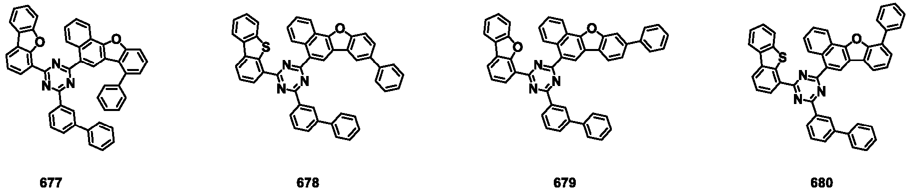

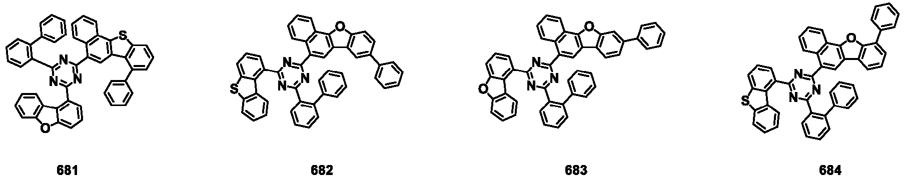

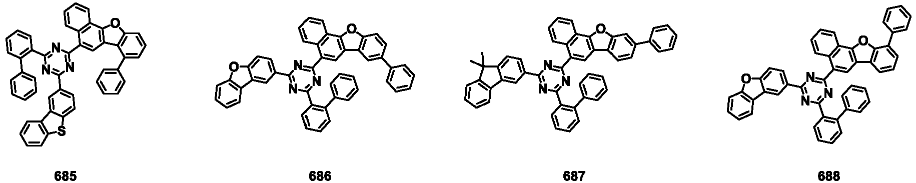

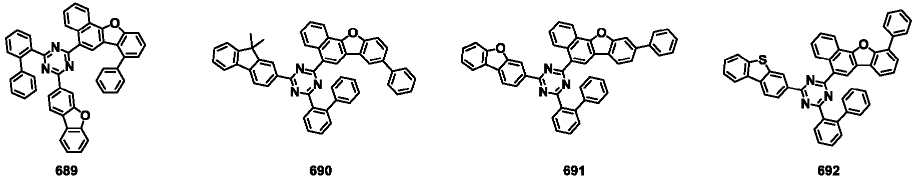

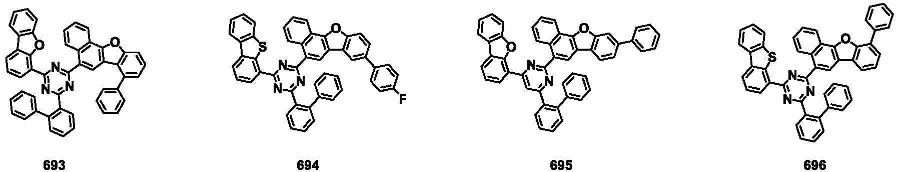

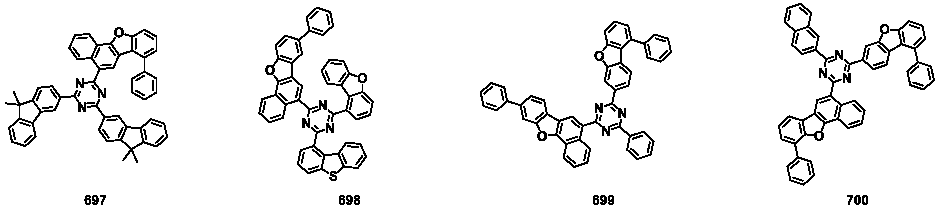

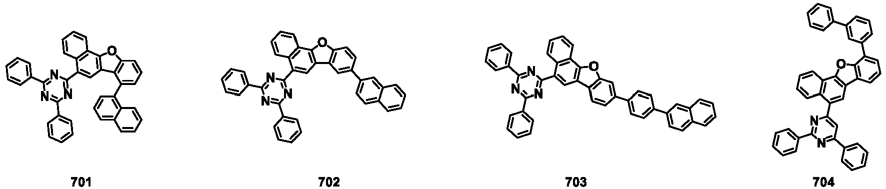

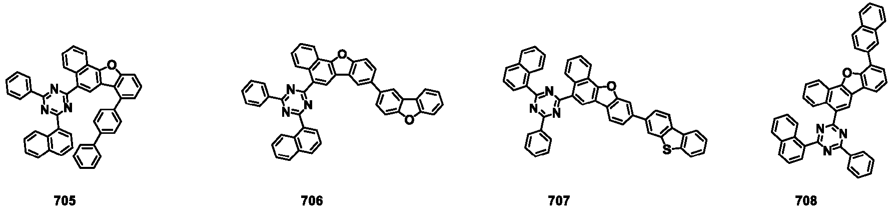

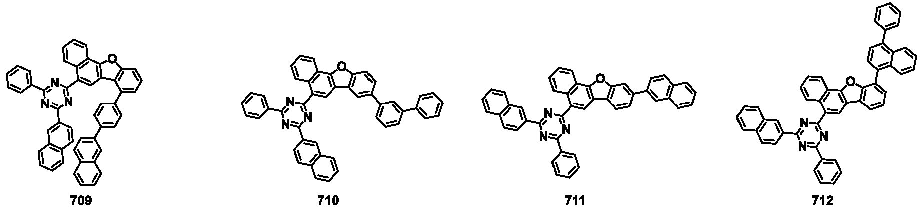

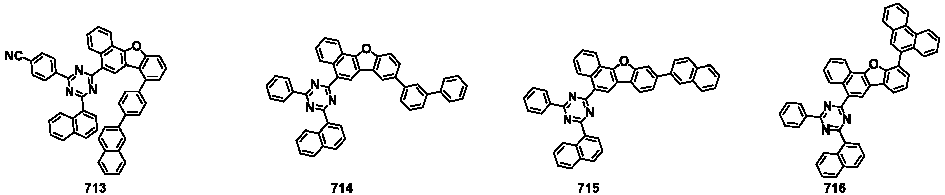

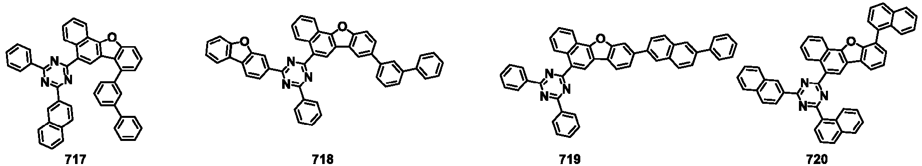

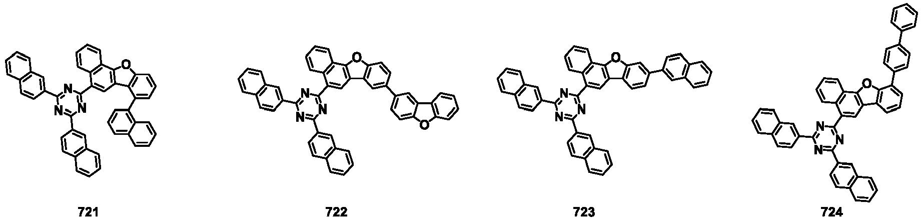

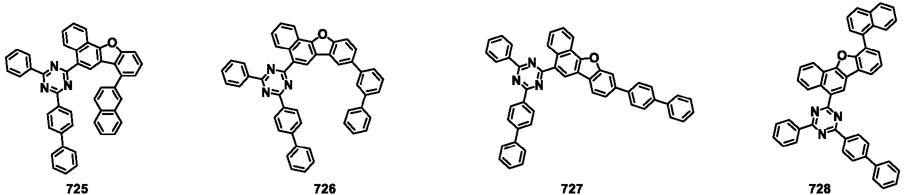

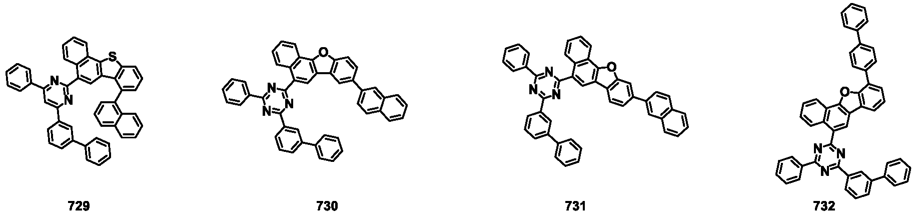

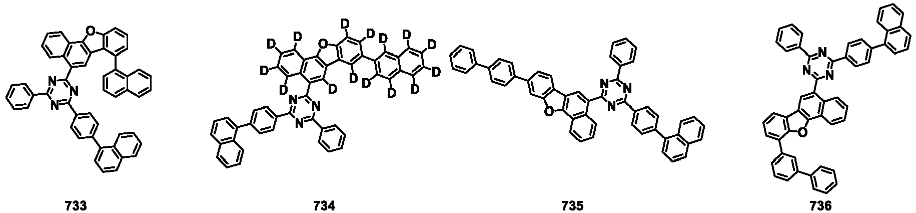

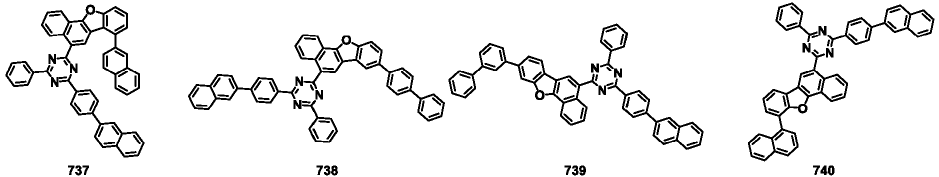

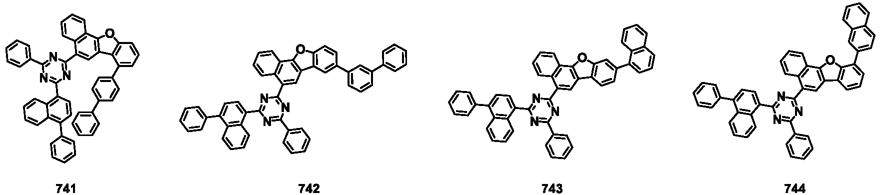

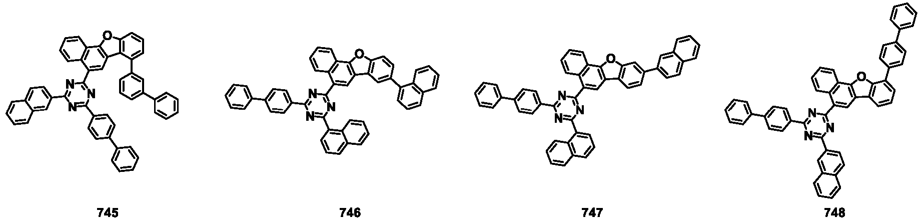

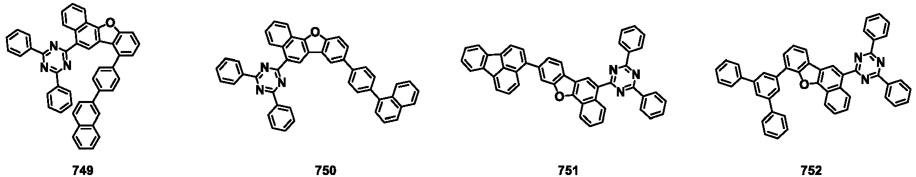

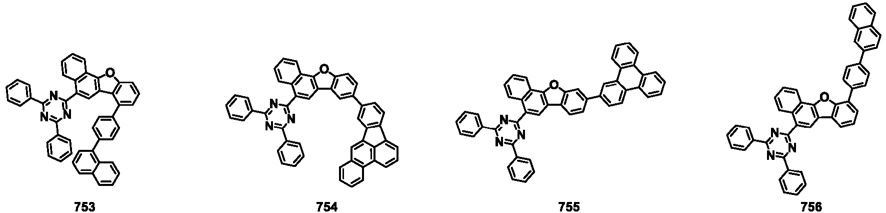

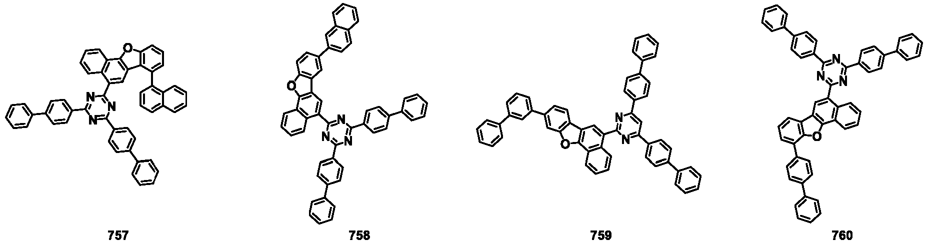

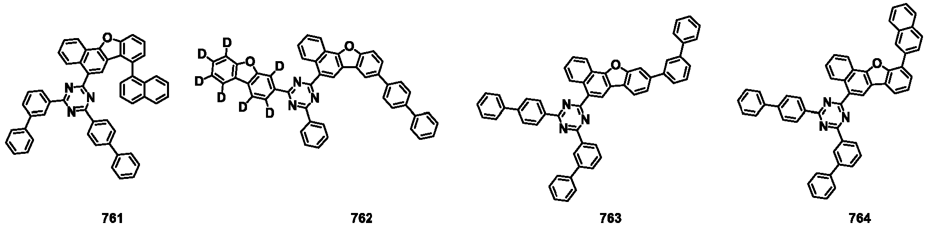

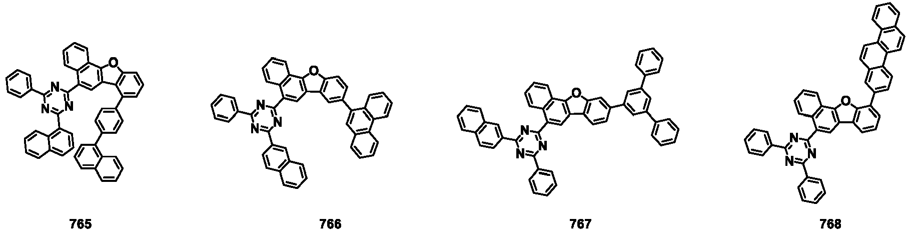

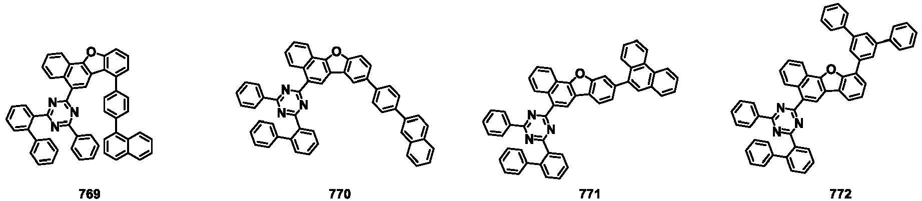

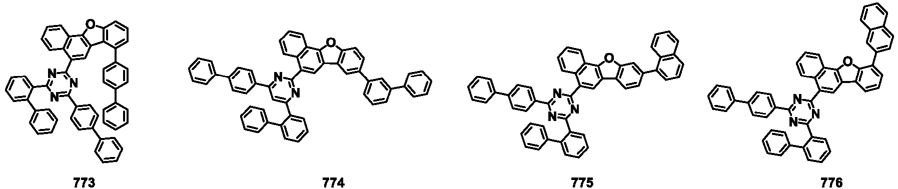

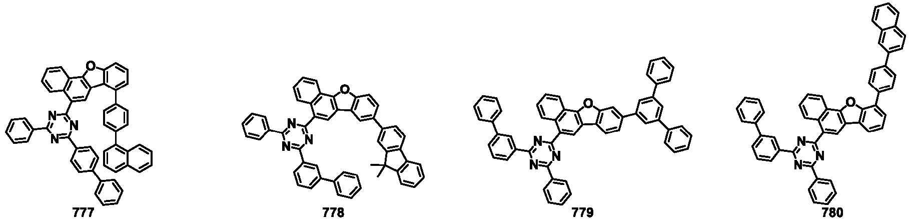

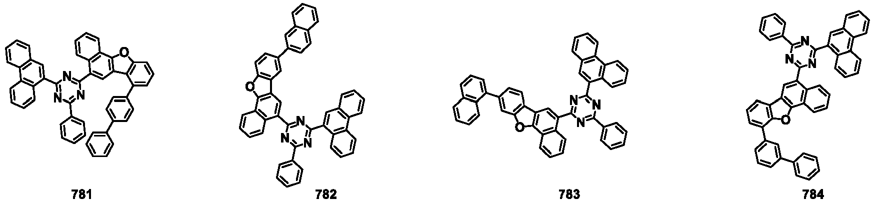

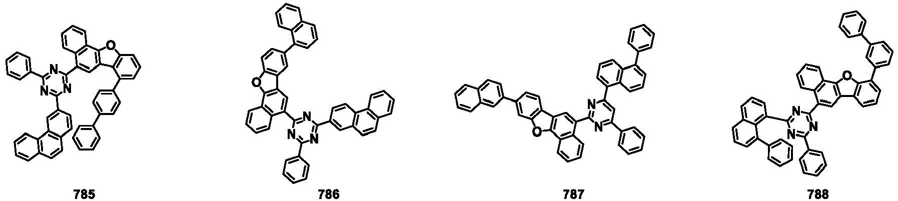

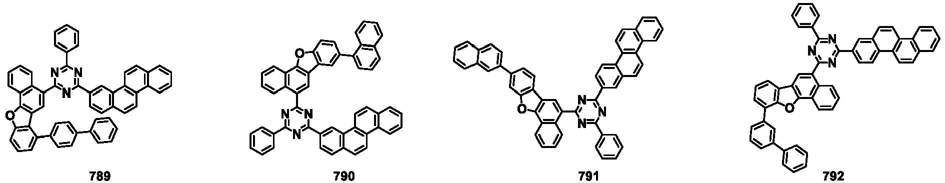

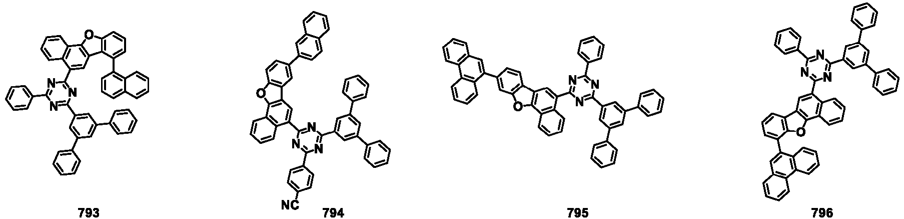

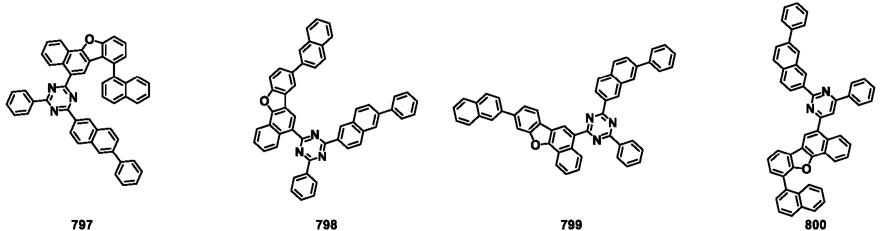

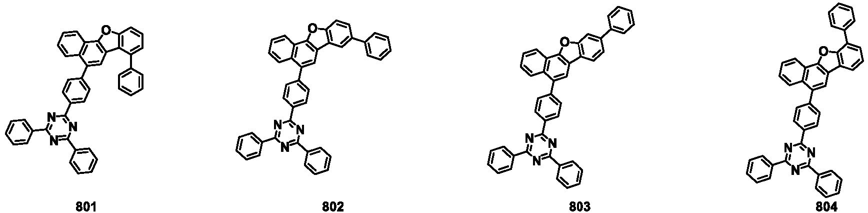

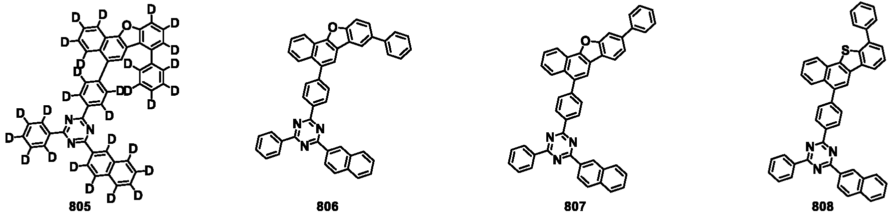

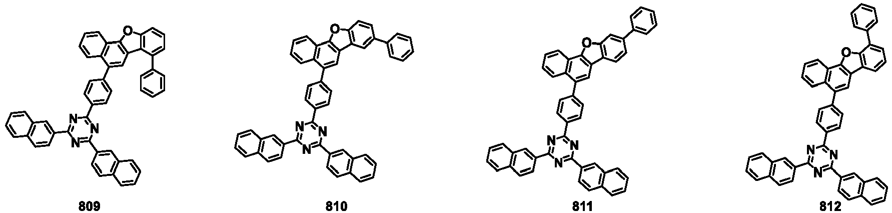

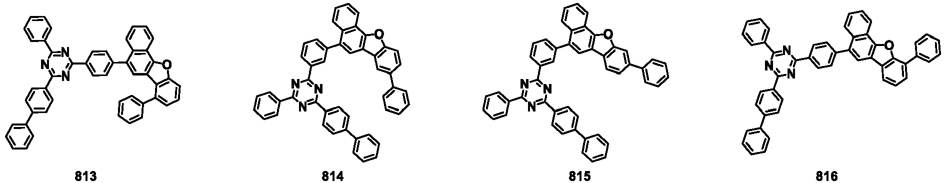

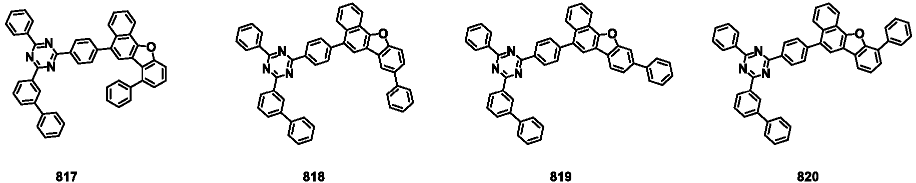

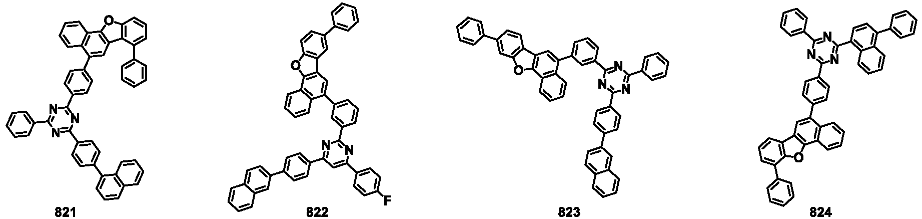

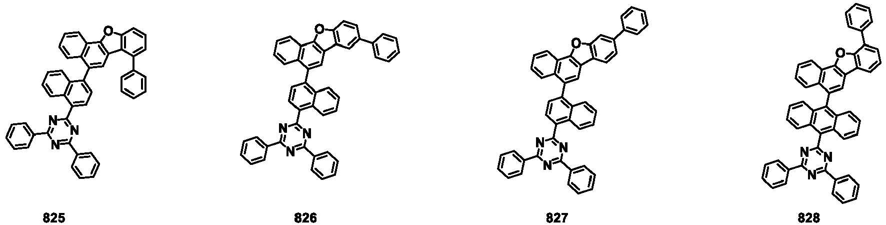

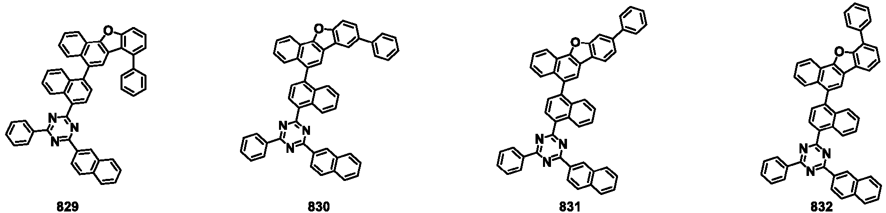

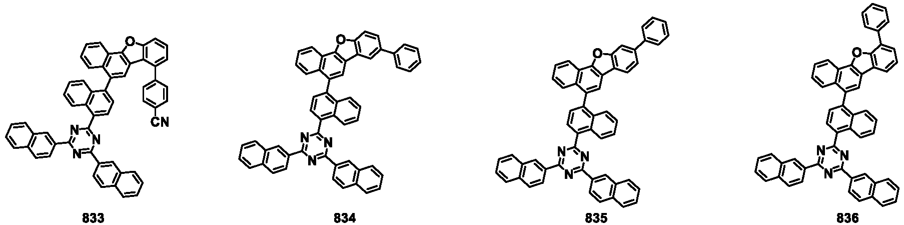

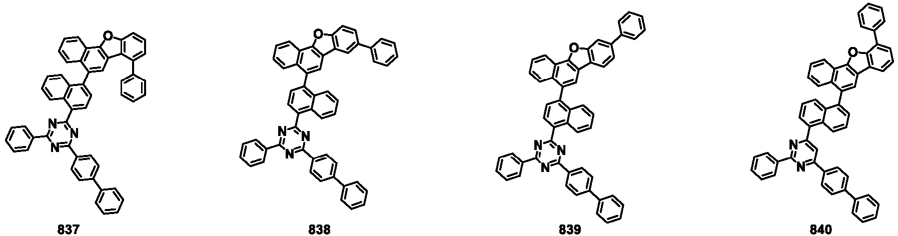

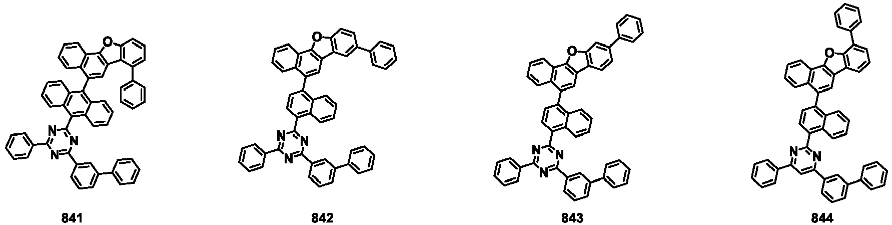

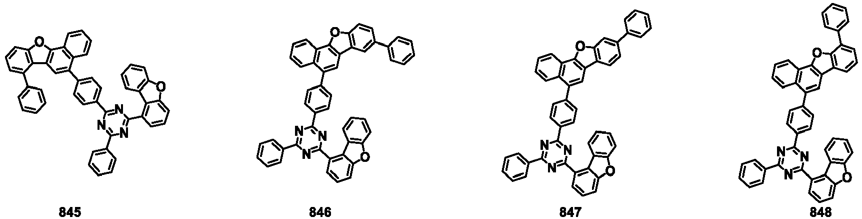

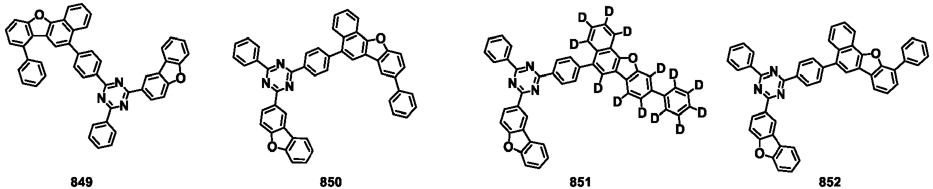

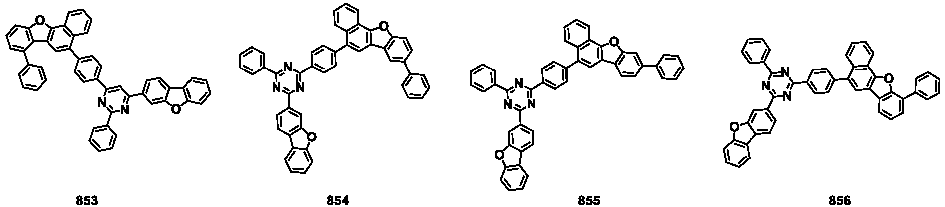

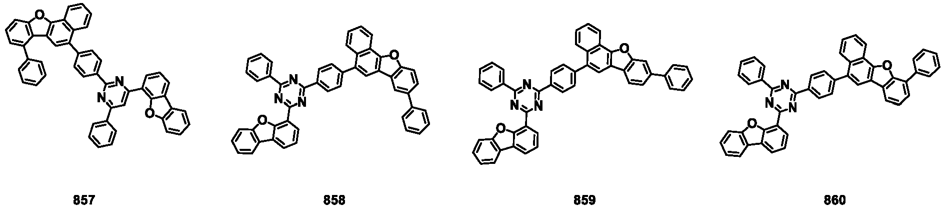

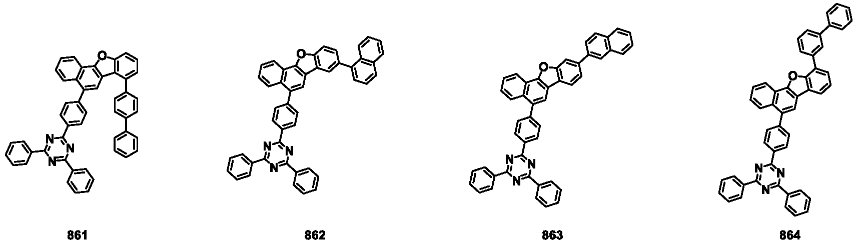

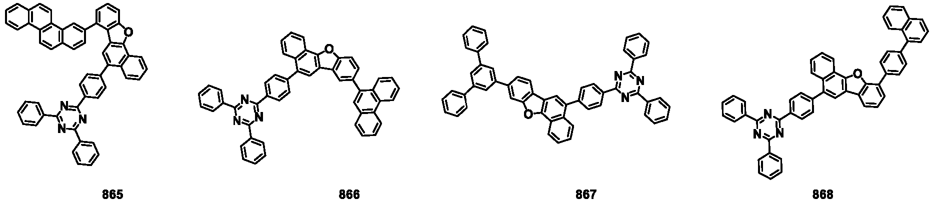

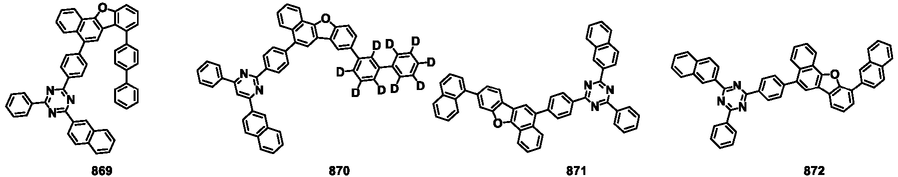

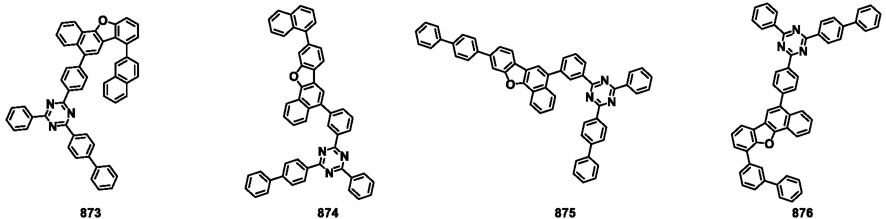

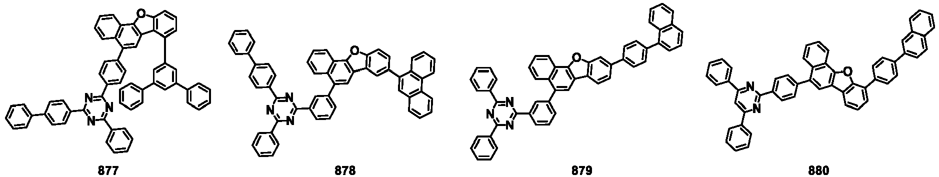

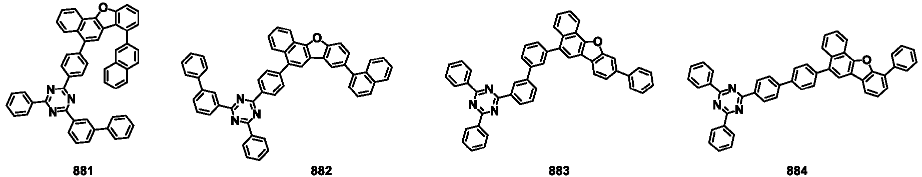

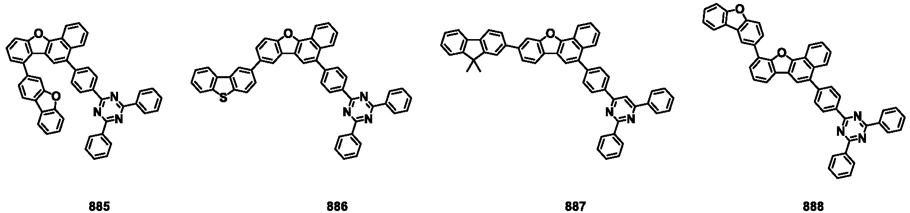

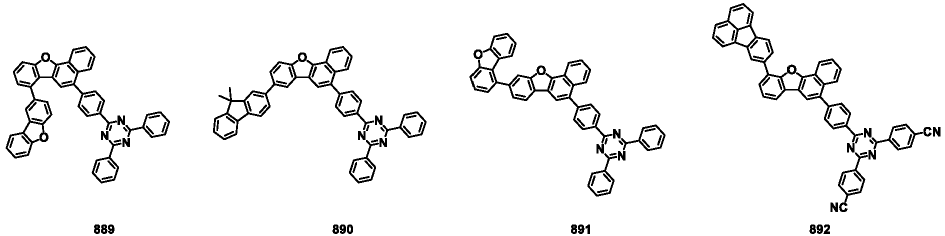

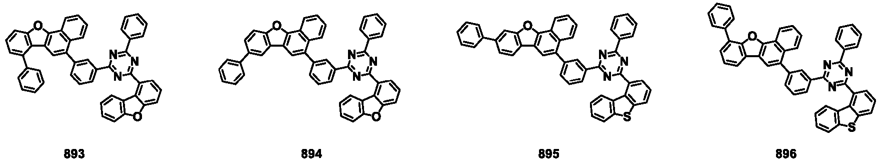

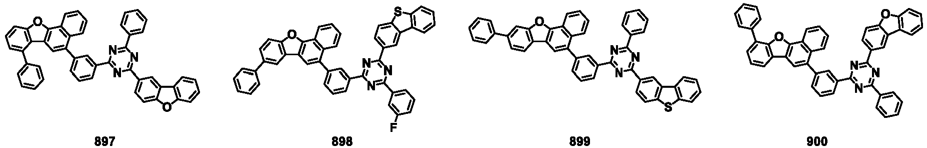

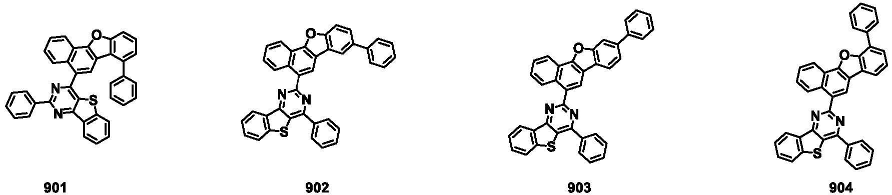

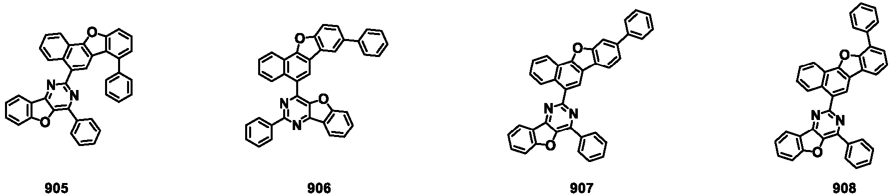

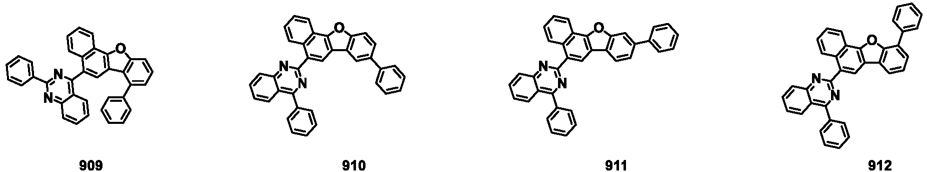

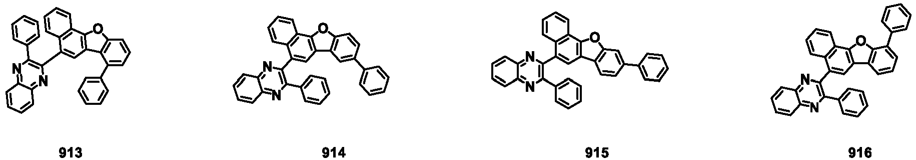

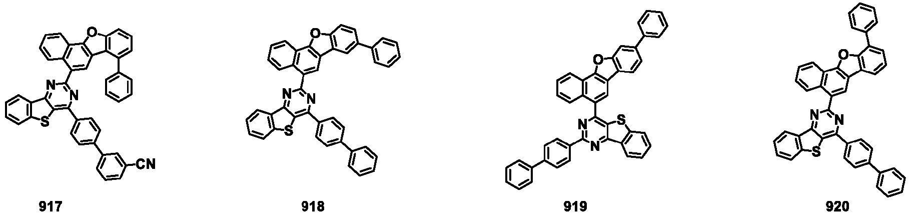

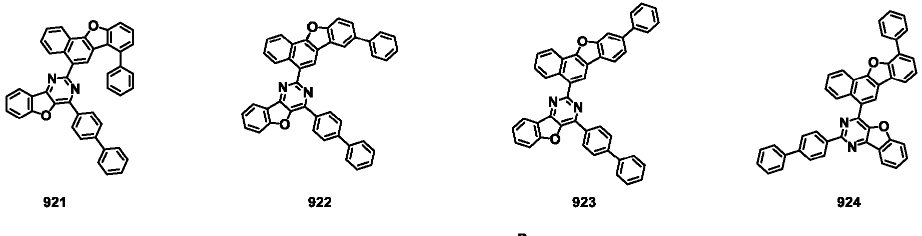

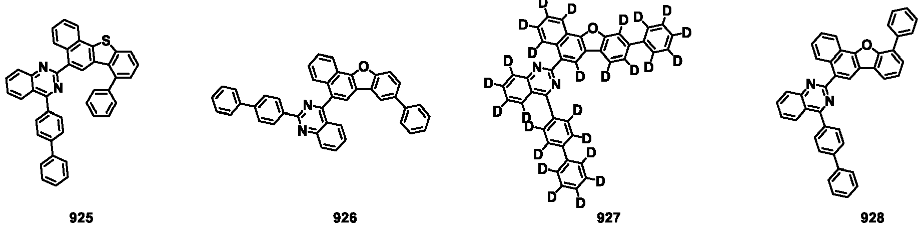

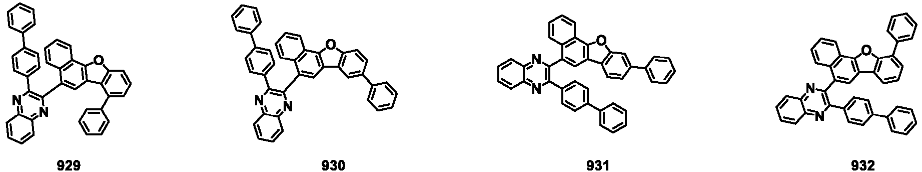

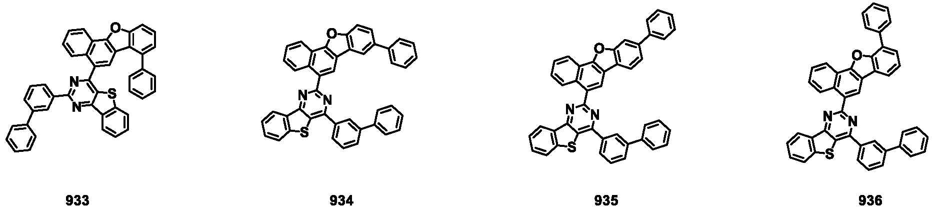

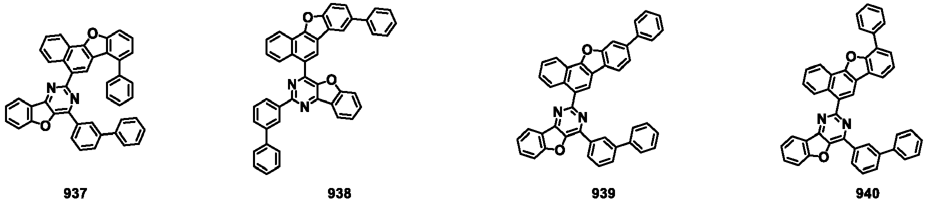

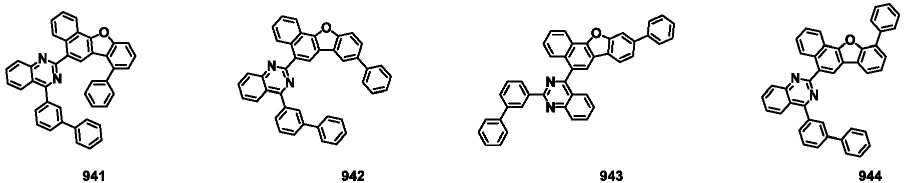

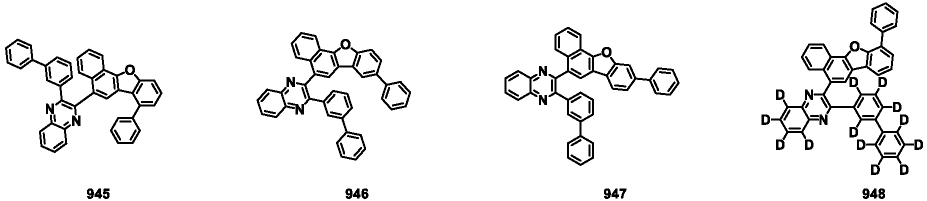

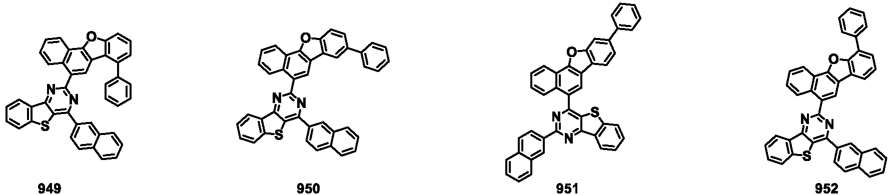

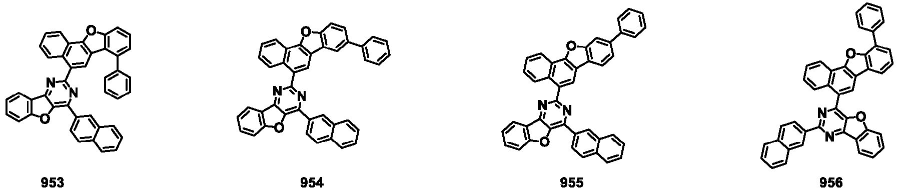

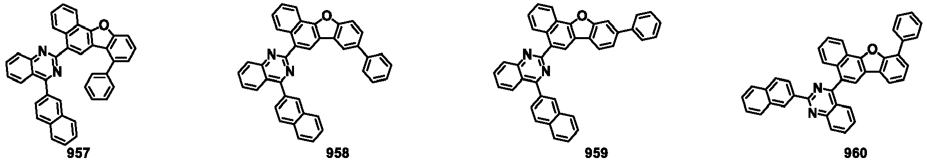

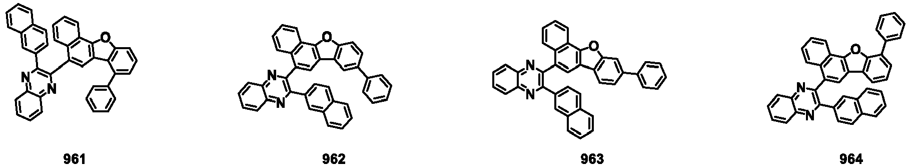

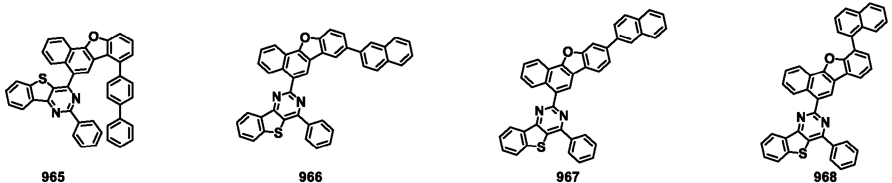

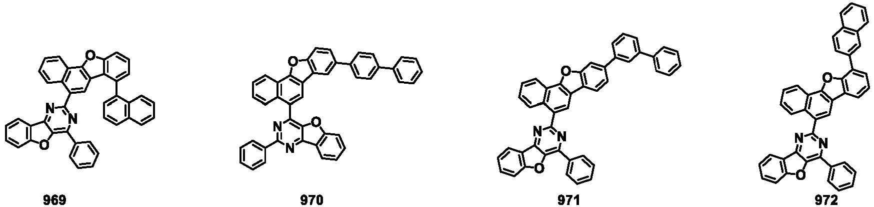

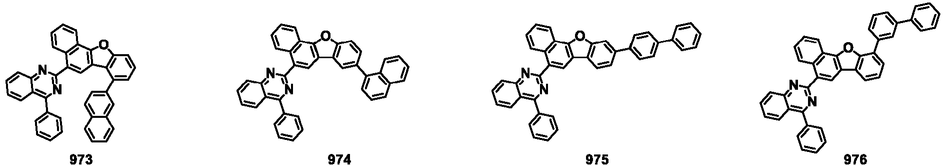

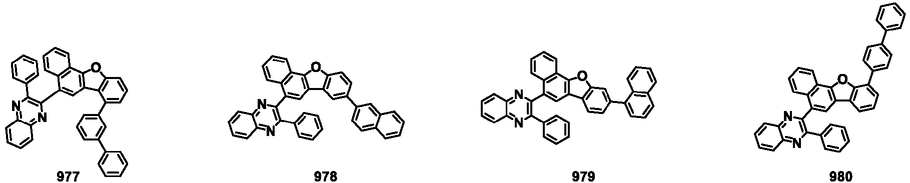

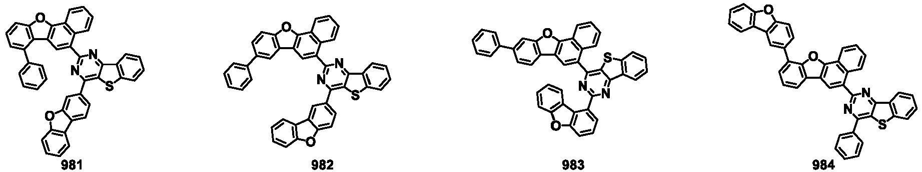

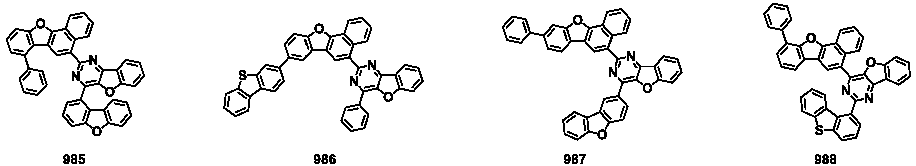

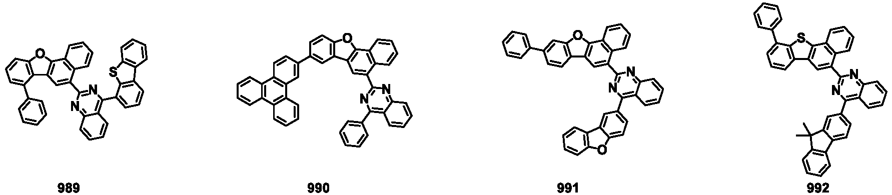

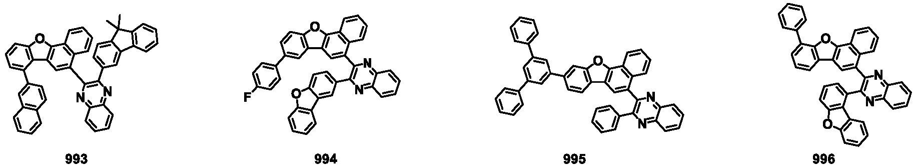

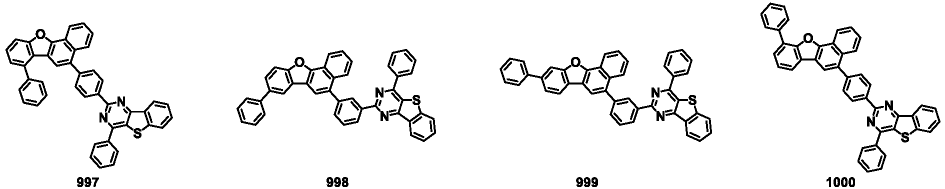

According to an exemplary embodiment of the present application, Chemical Formula 2 may be represented by any one of the following compounds, but is not limited thereto.

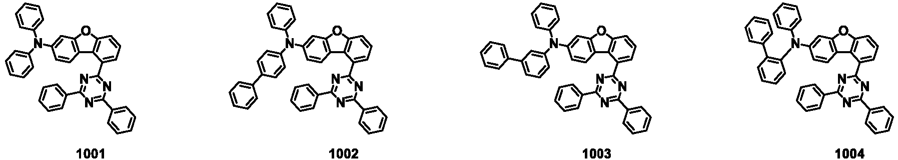

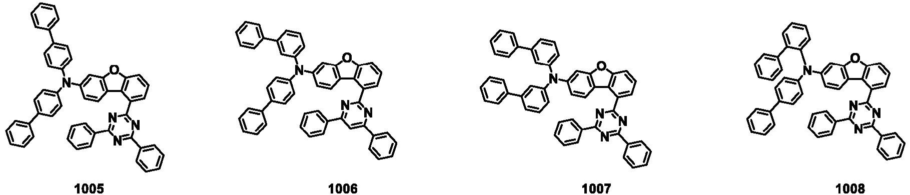

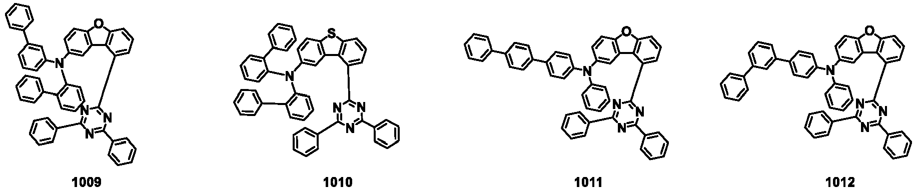

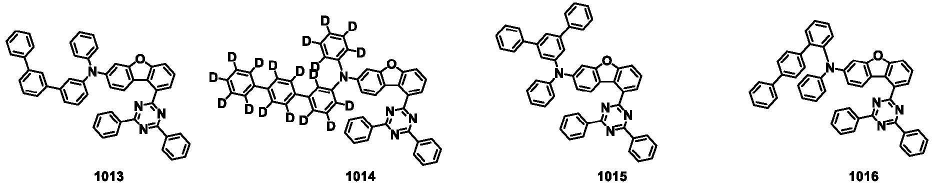

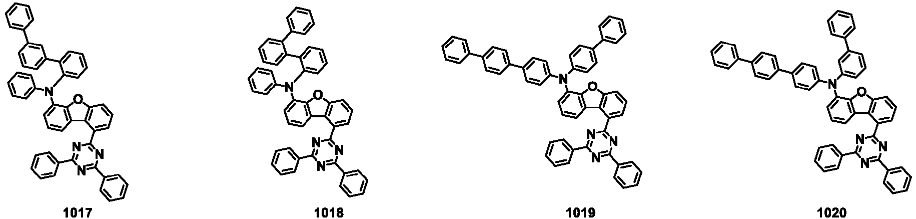

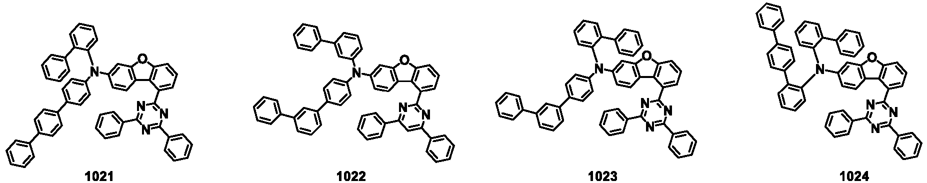

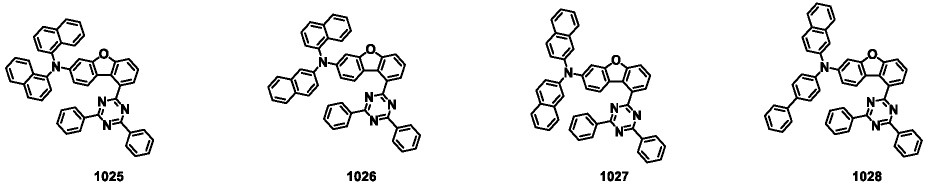

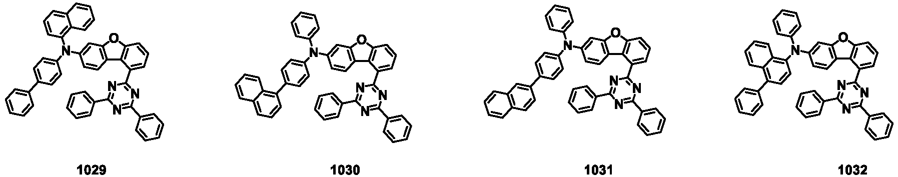

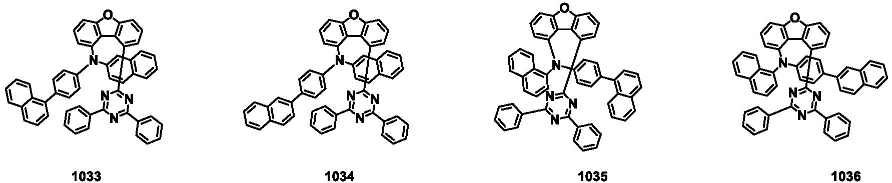

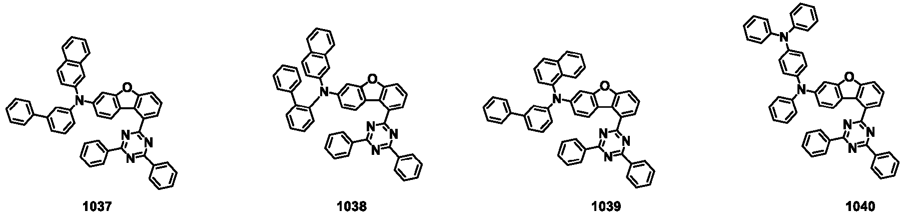

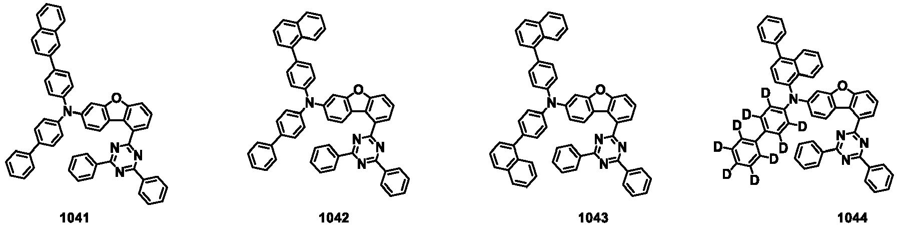

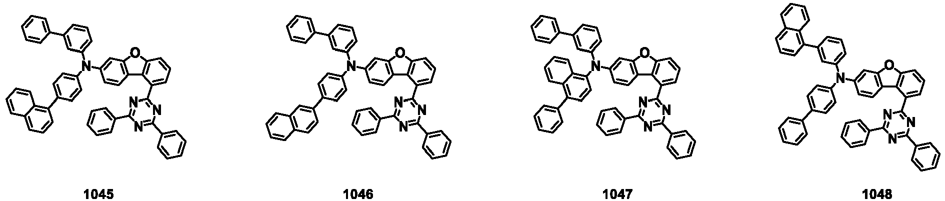

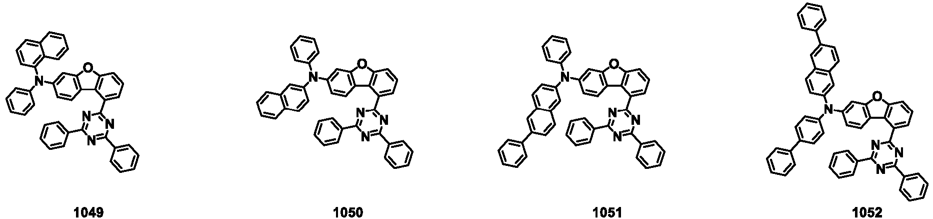

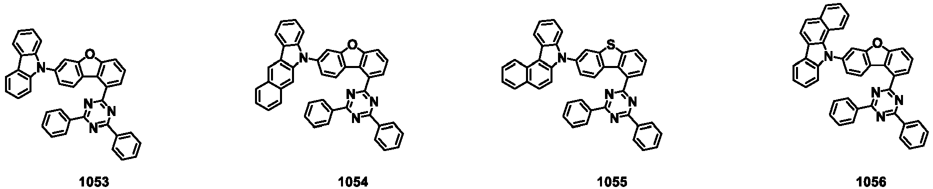

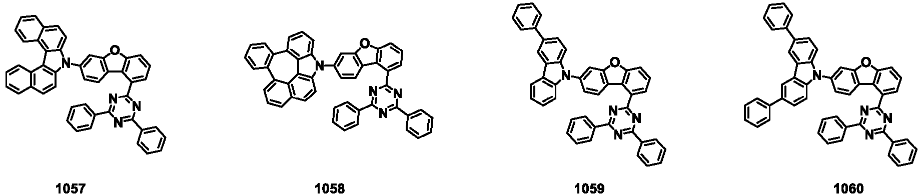

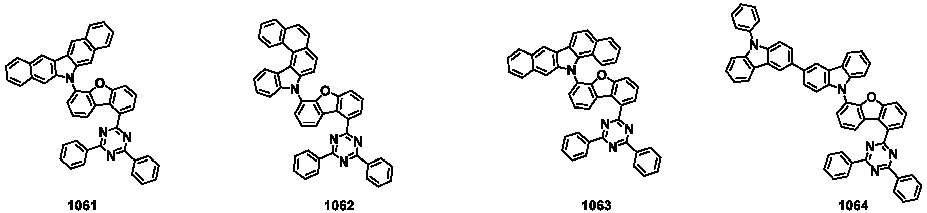

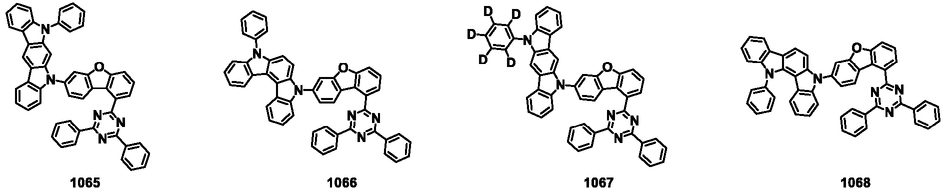

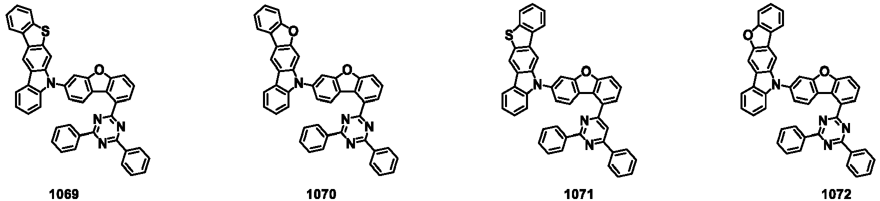

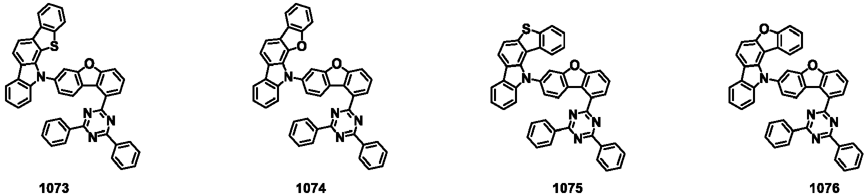

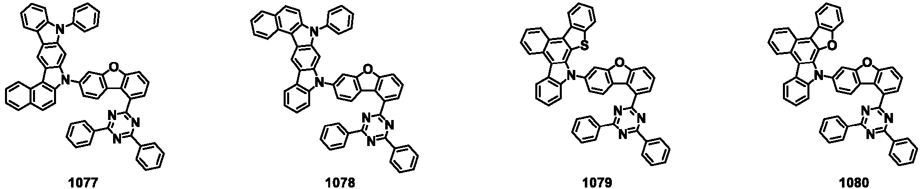

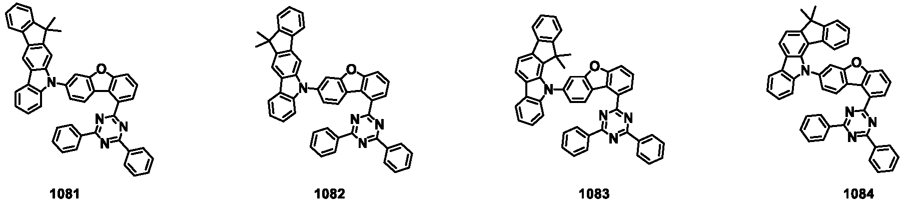

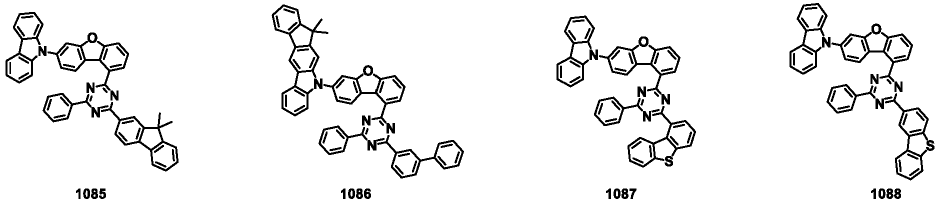

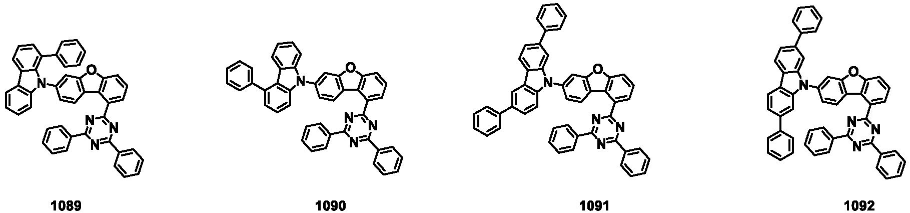

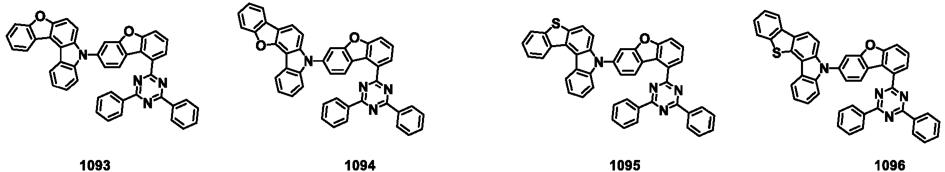

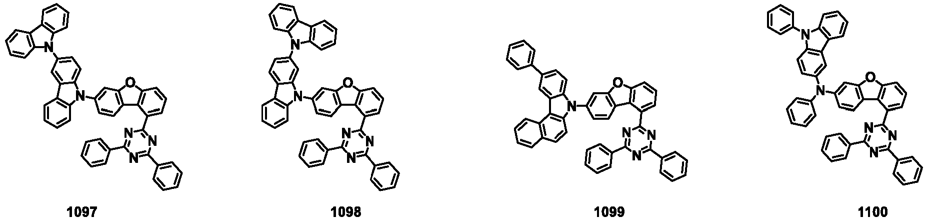

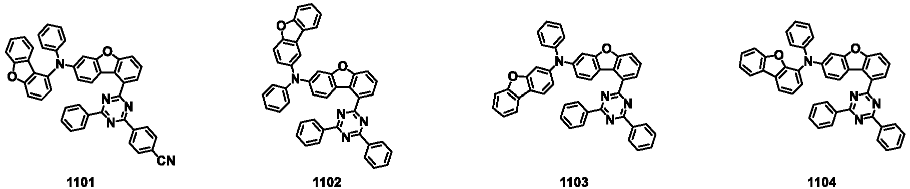

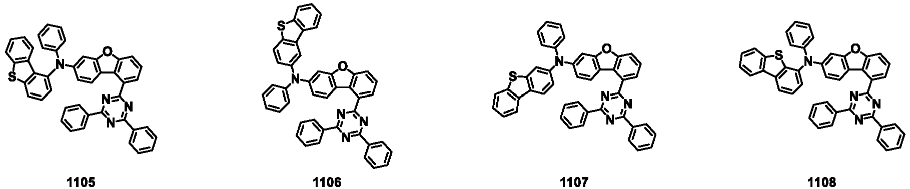

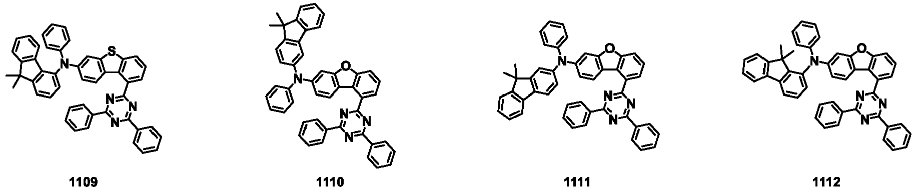

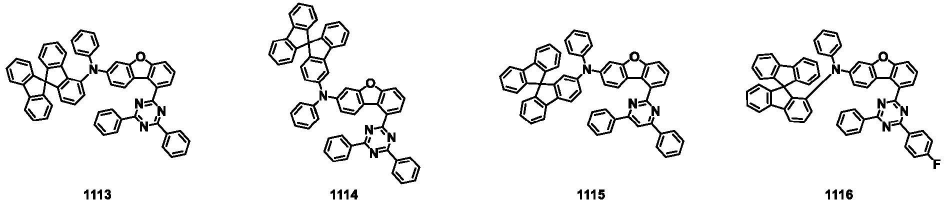

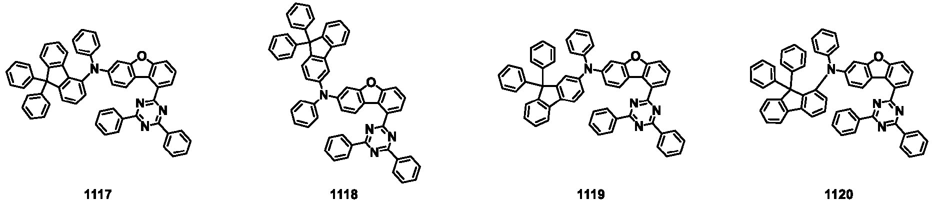

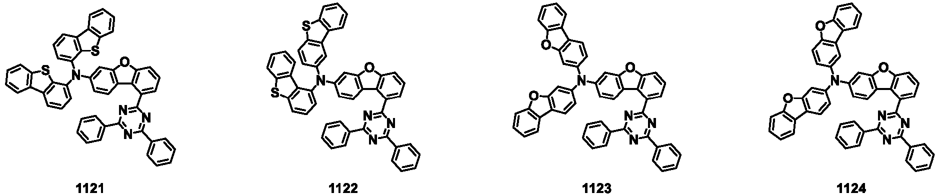

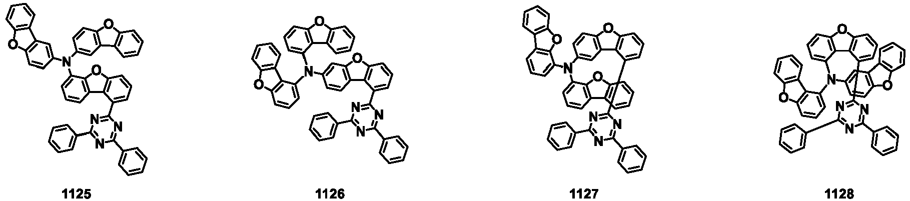

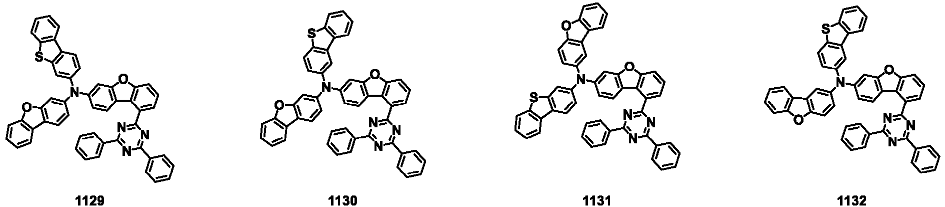

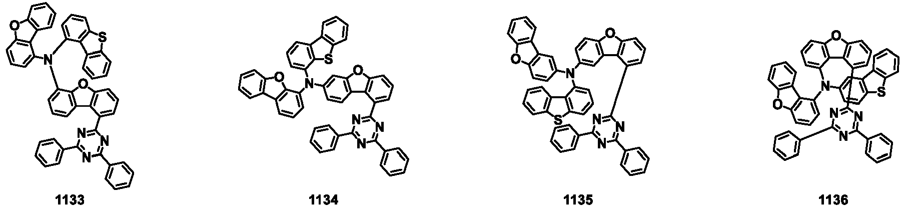

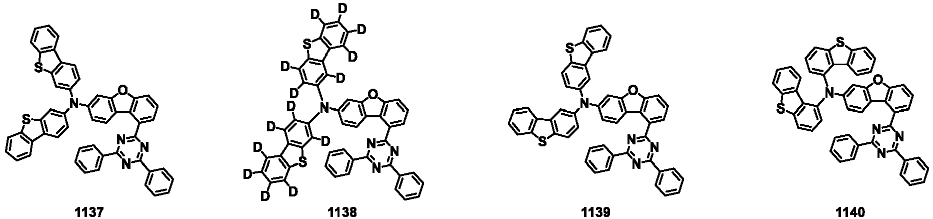

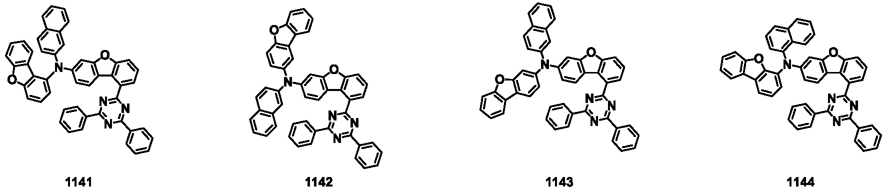

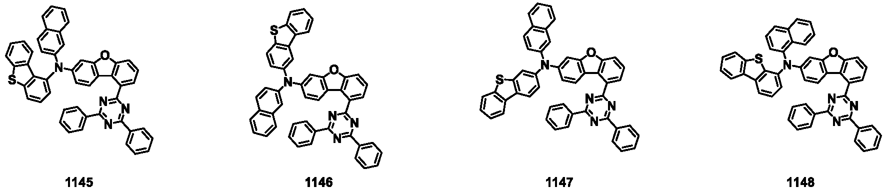

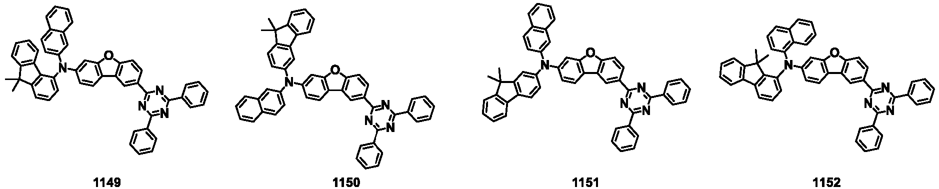

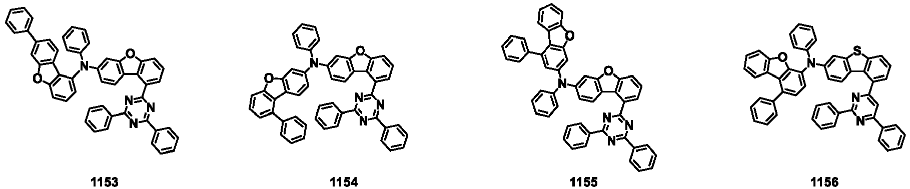

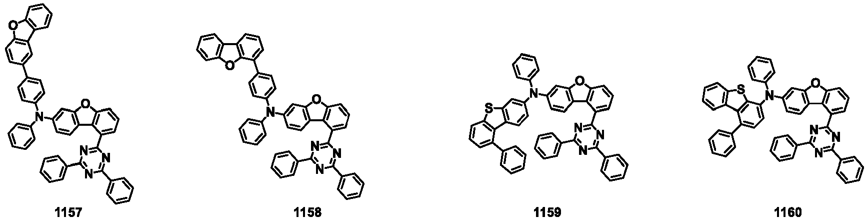

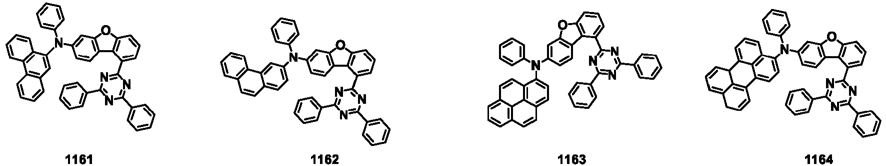

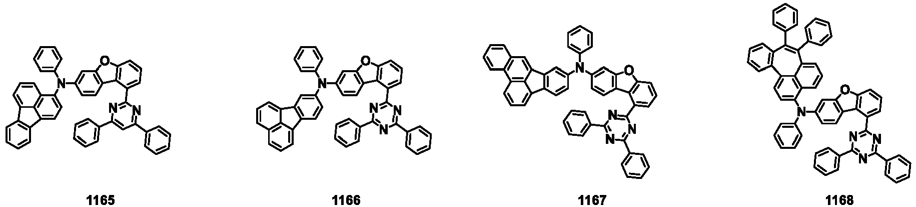

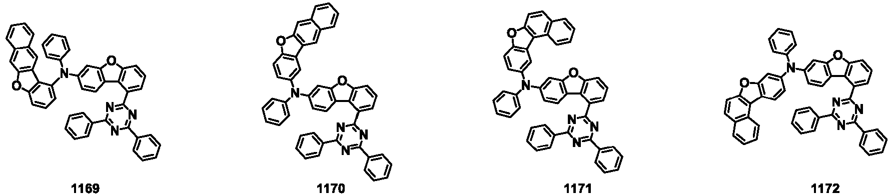

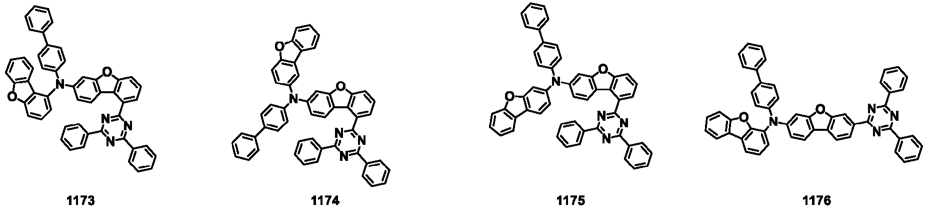

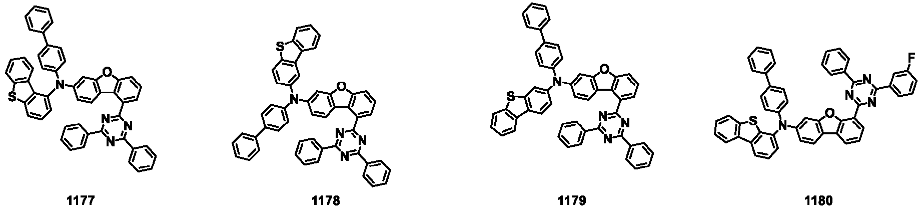

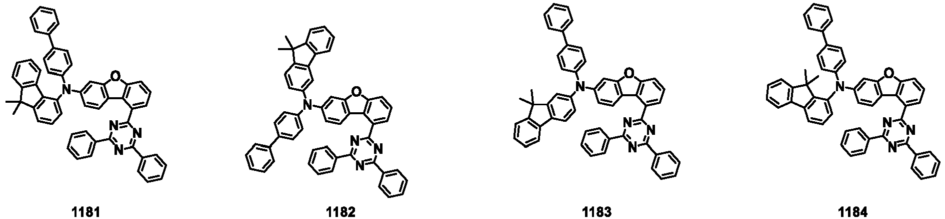

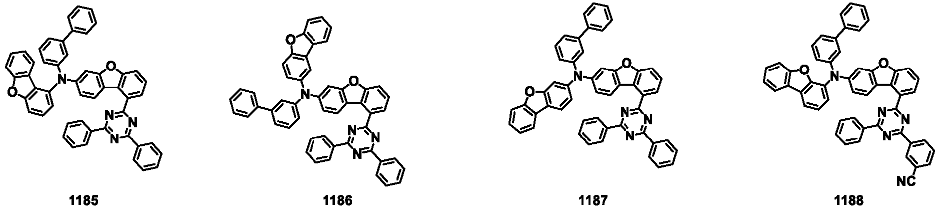

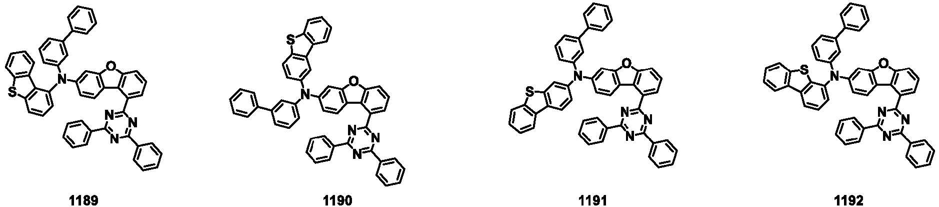

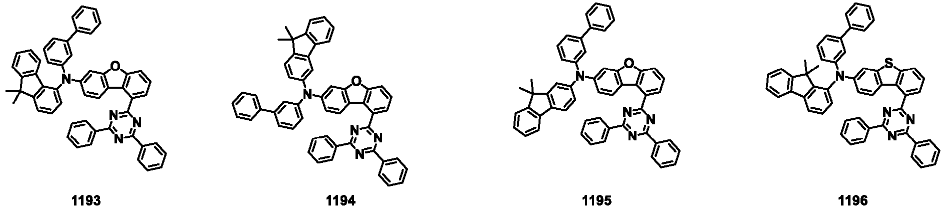

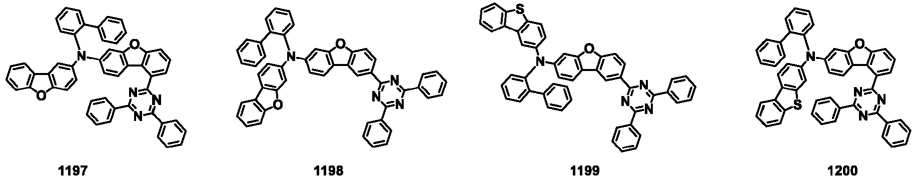

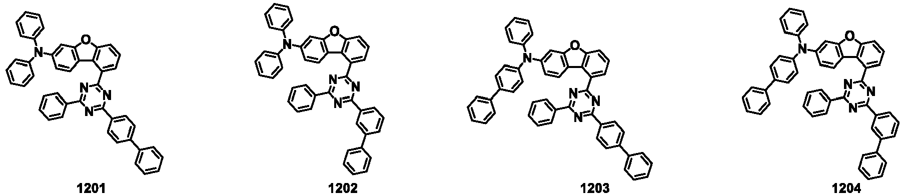

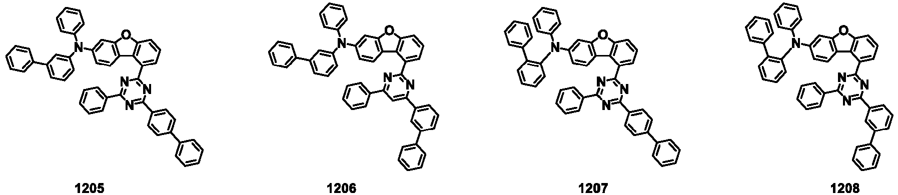

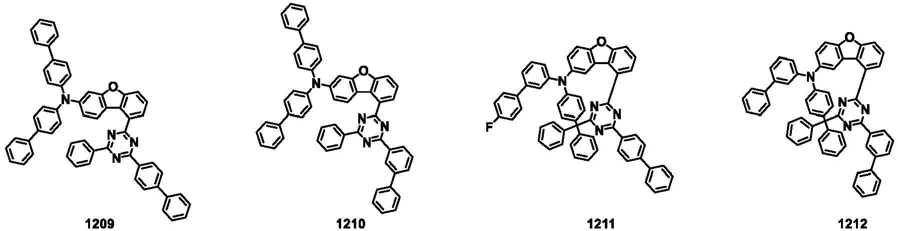

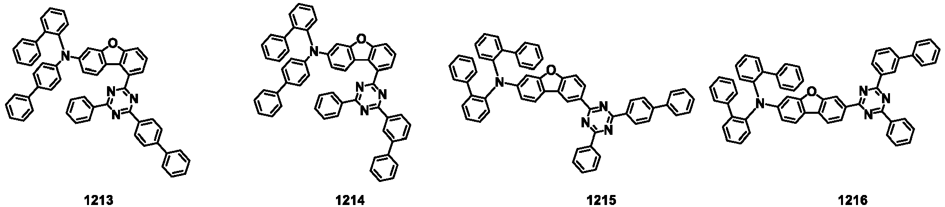

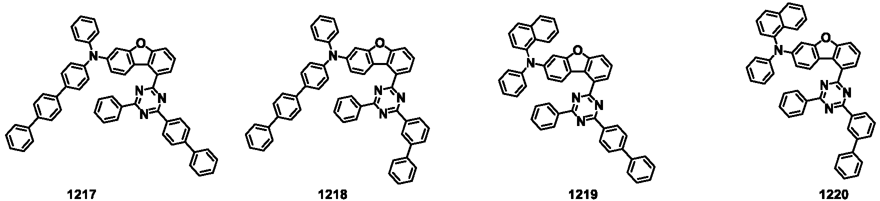

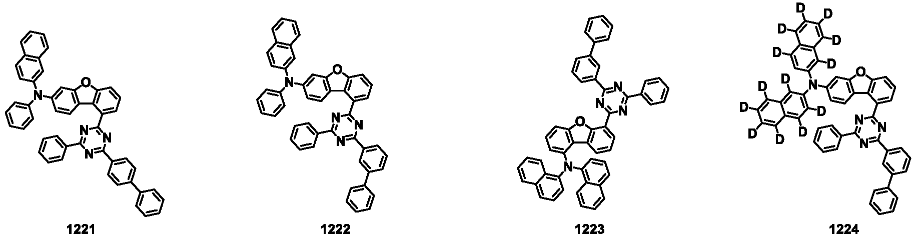

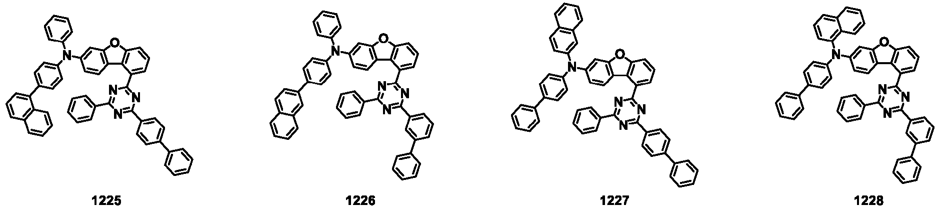

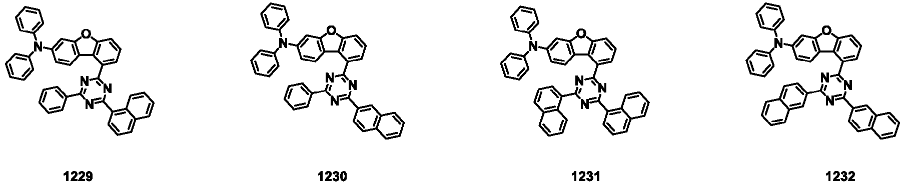

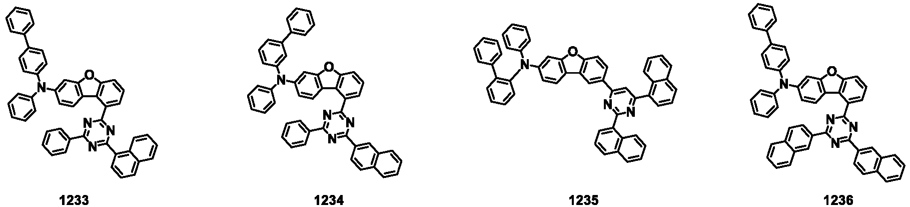

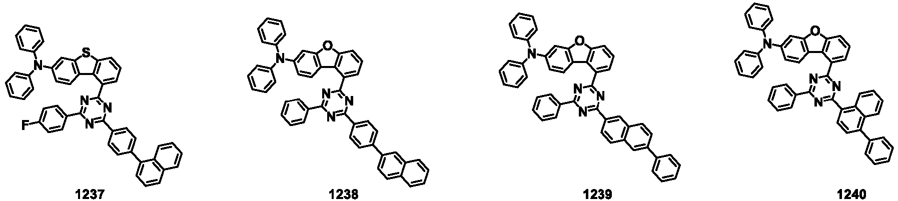

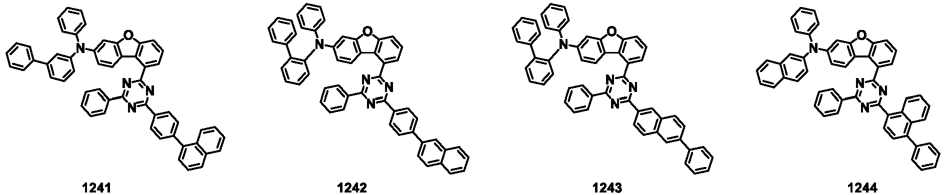

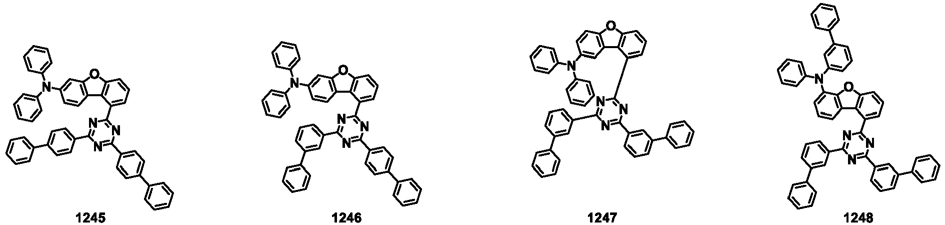

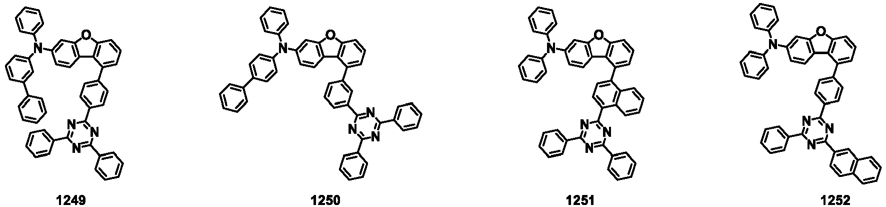

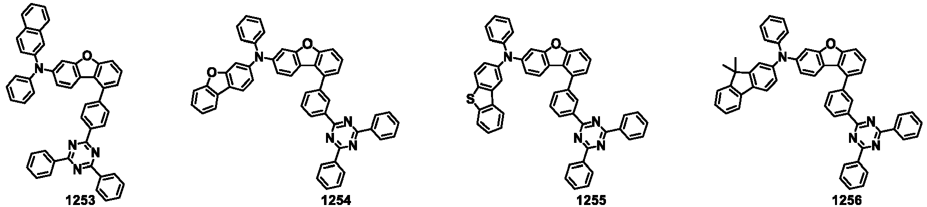

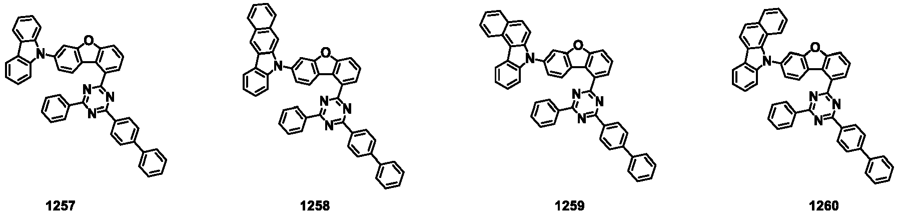

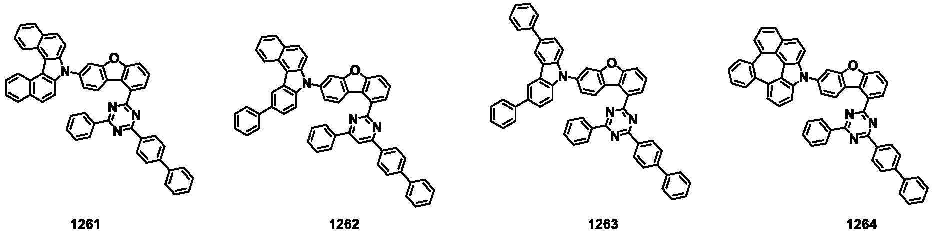

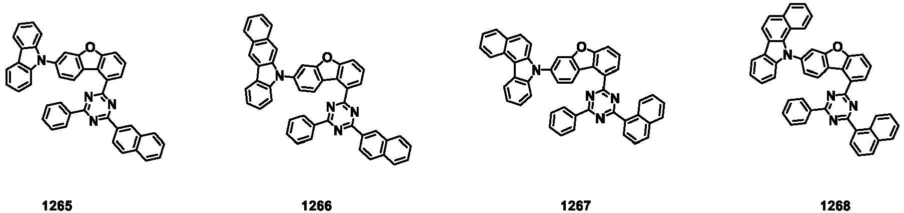

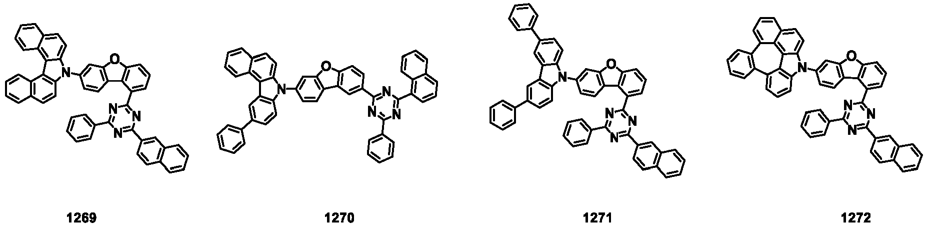

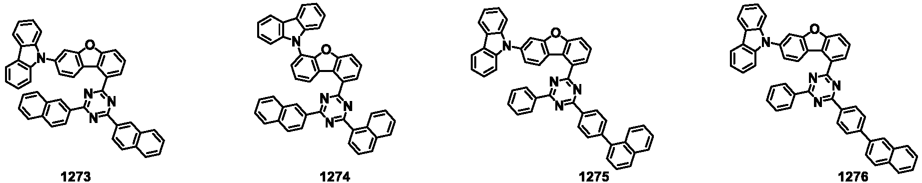

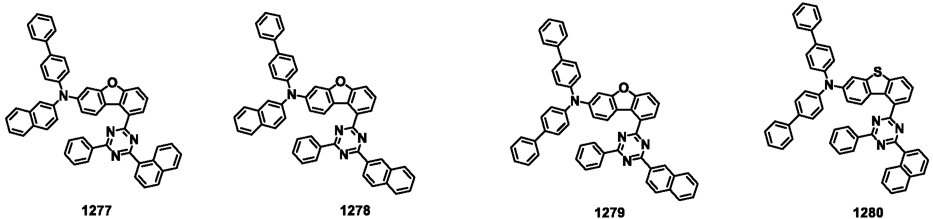

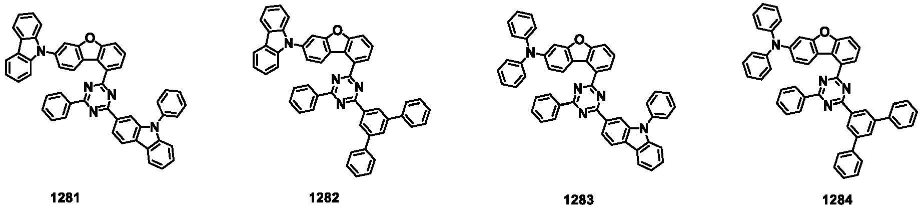

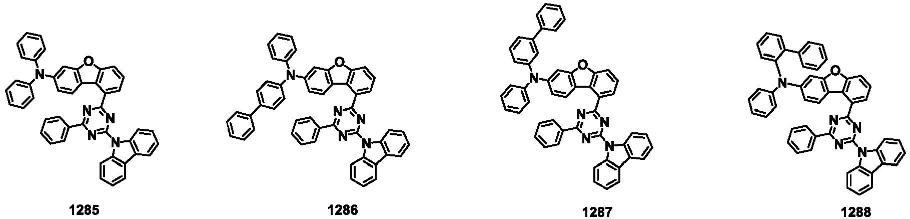

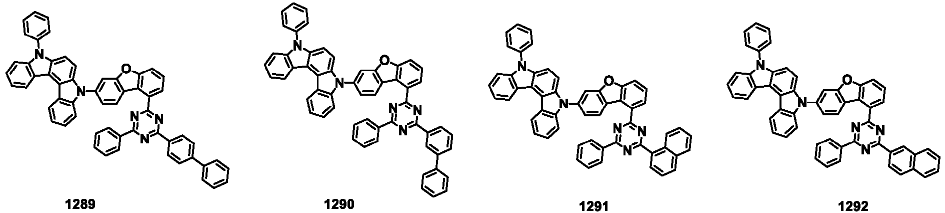

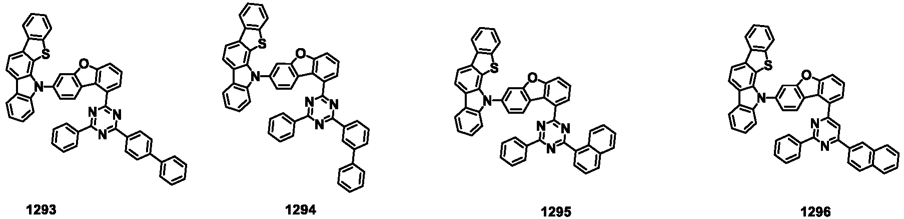

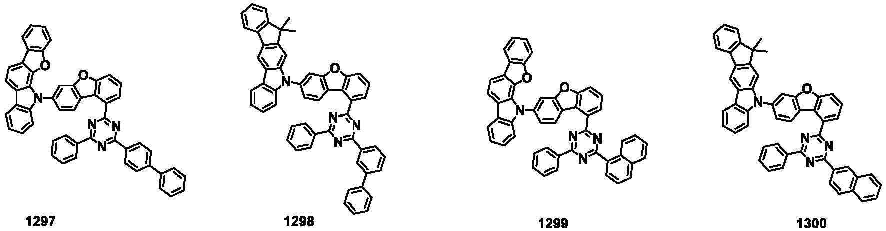

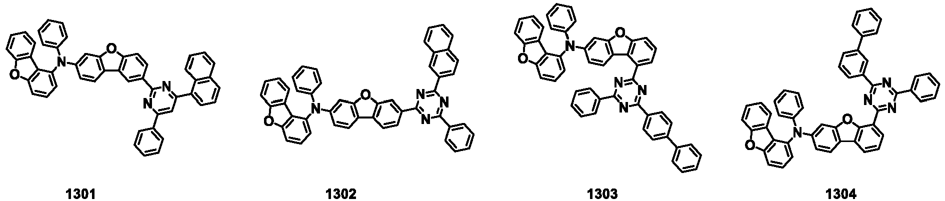

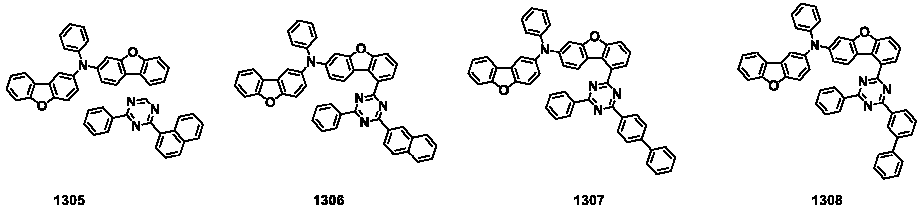

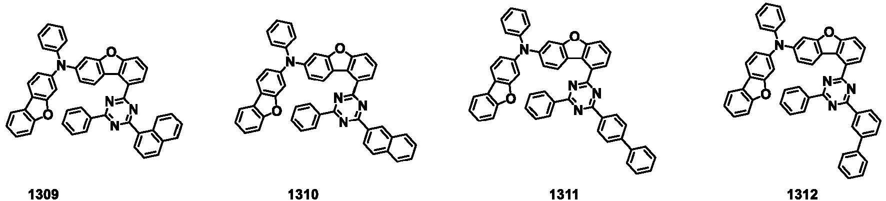

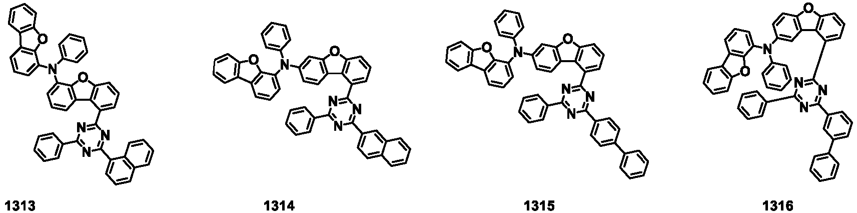

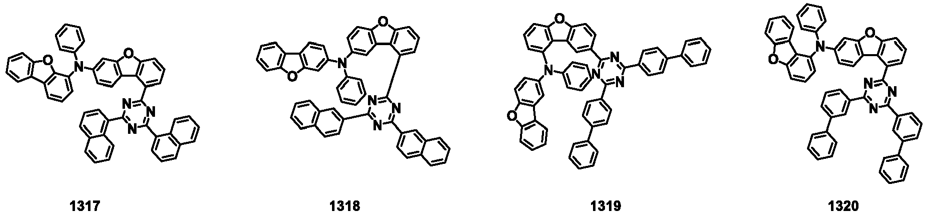

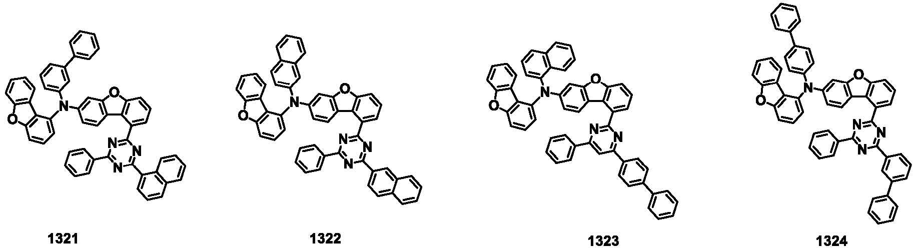

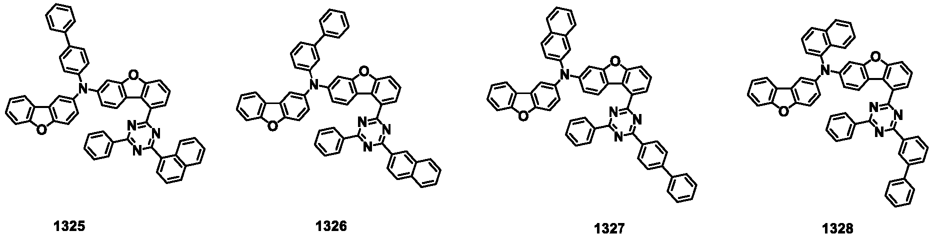

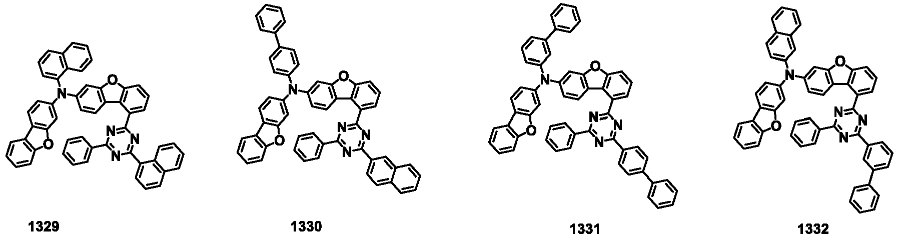

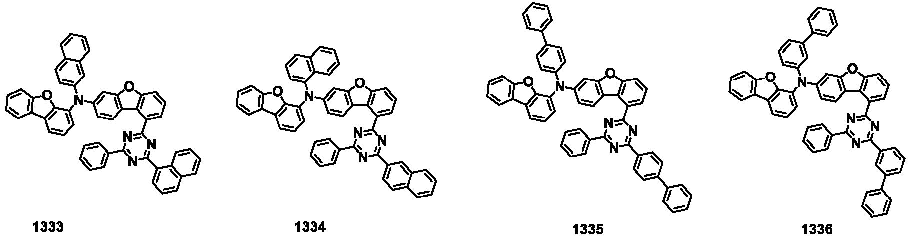

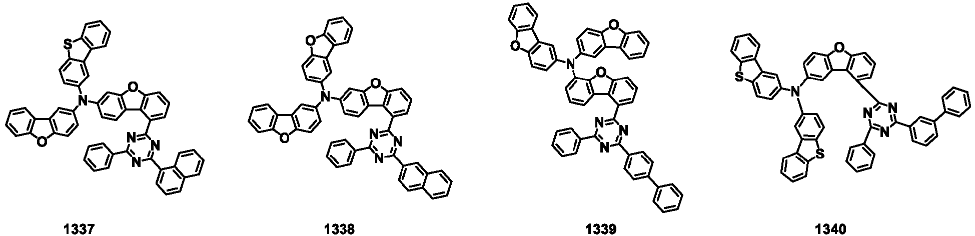

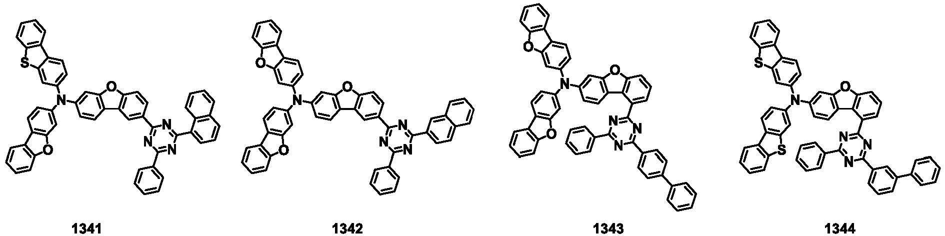

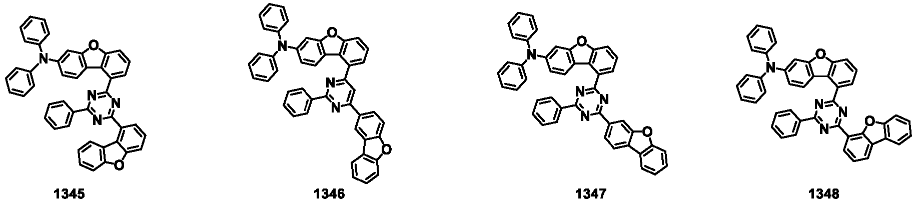

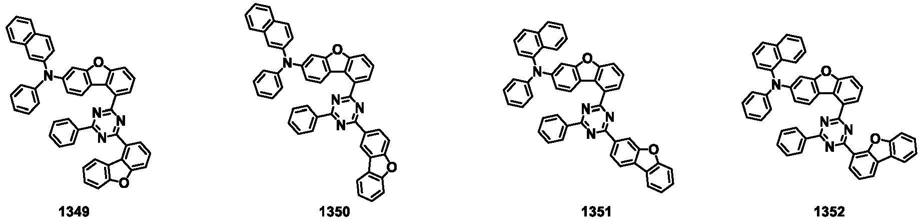

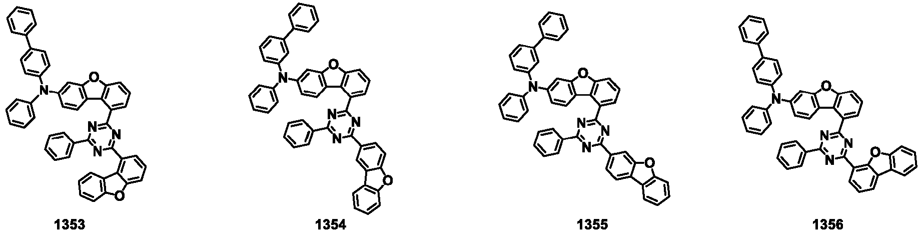

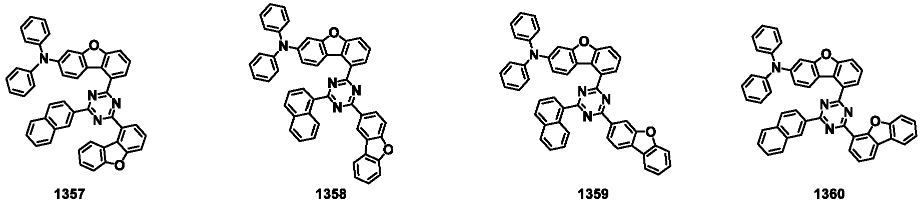

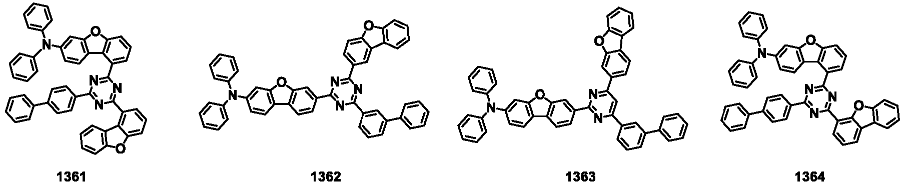

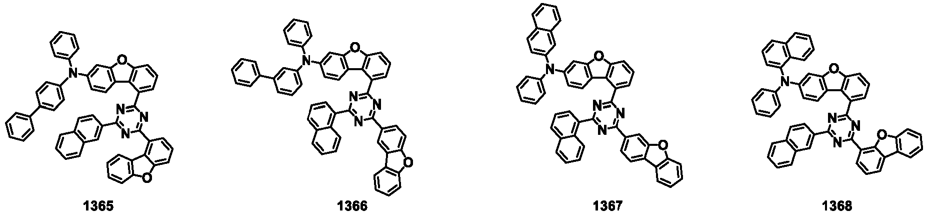

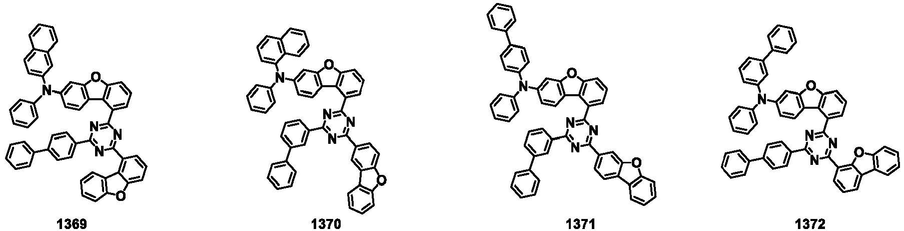

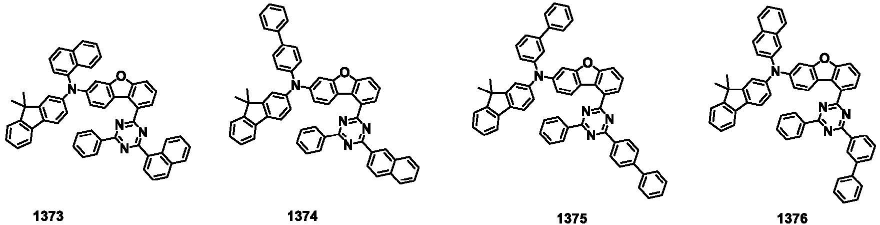

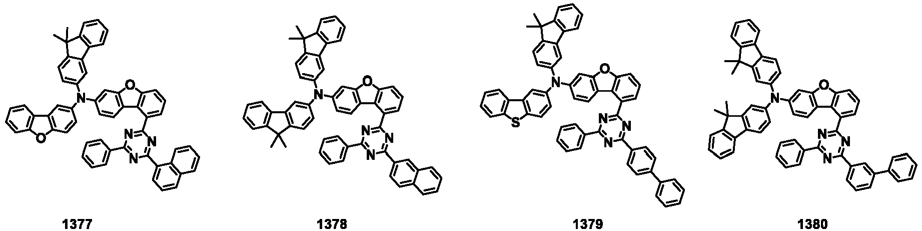

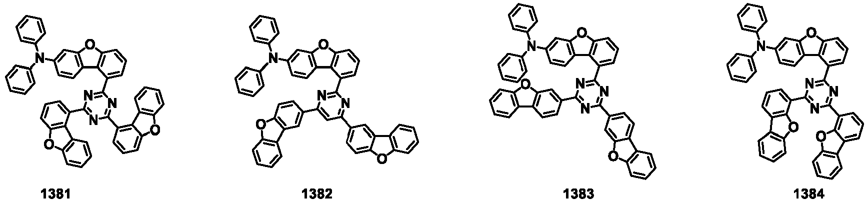

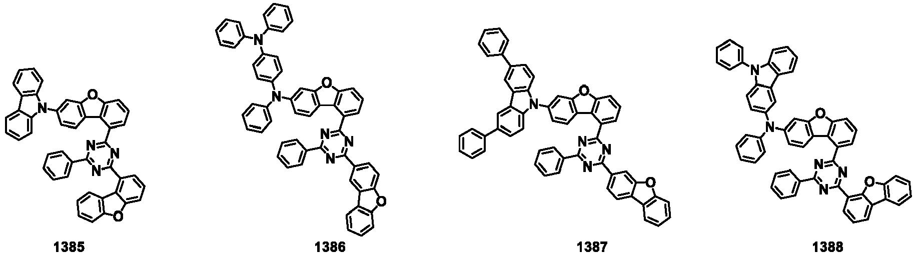

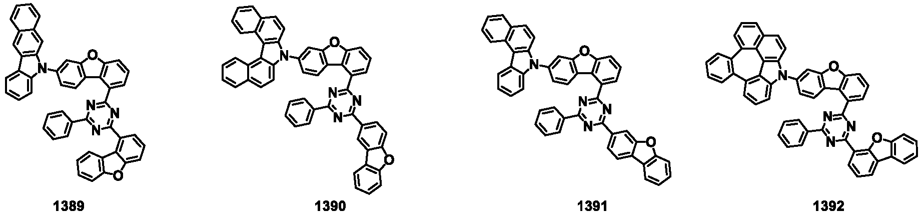

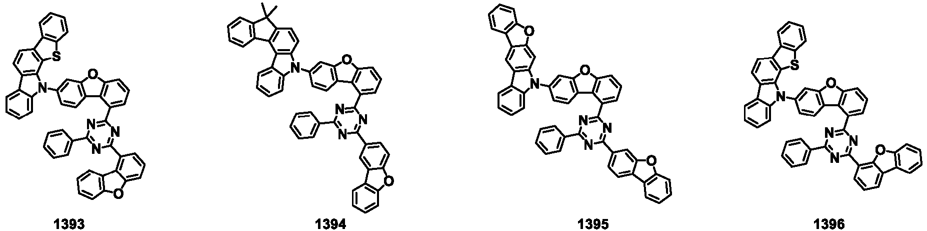

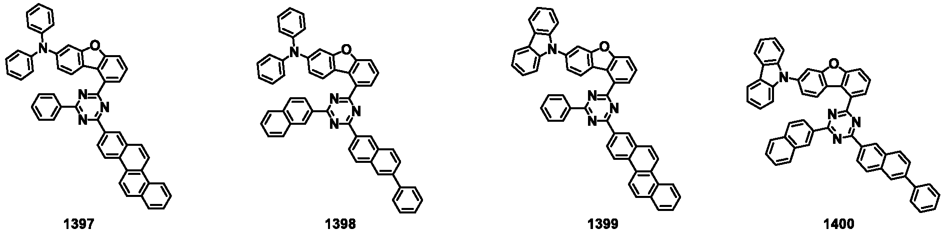

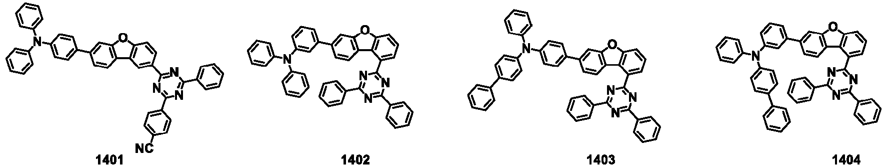

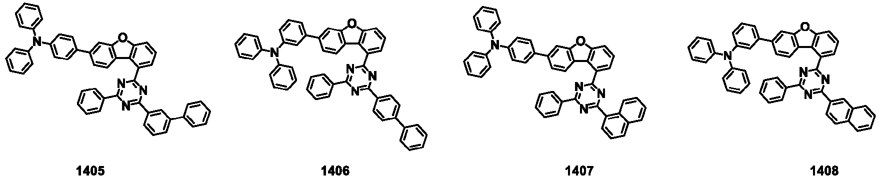

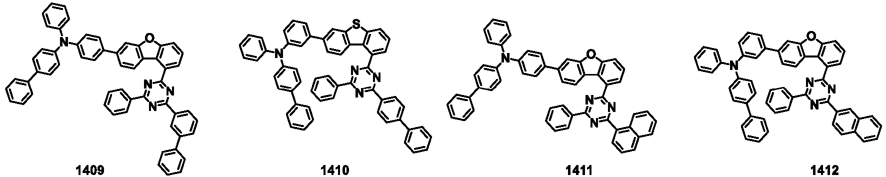

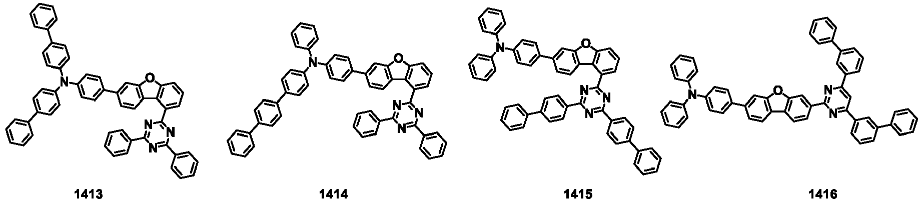

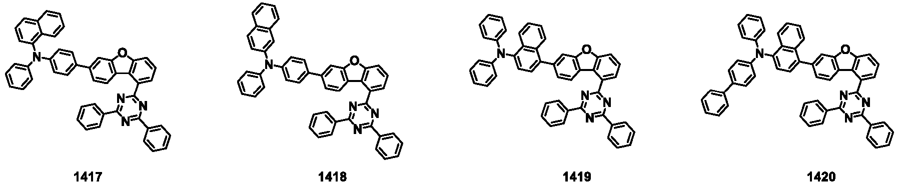

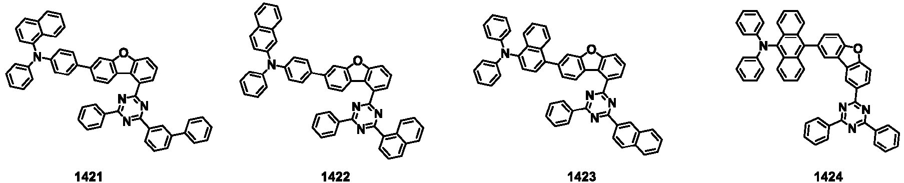

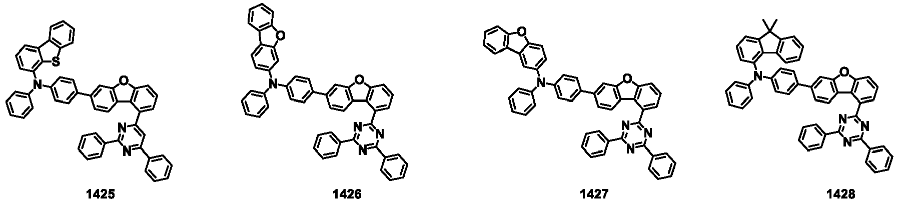

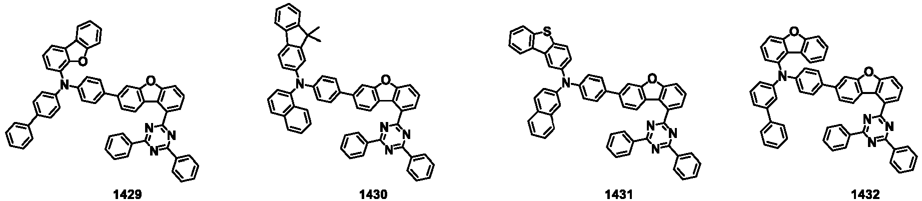

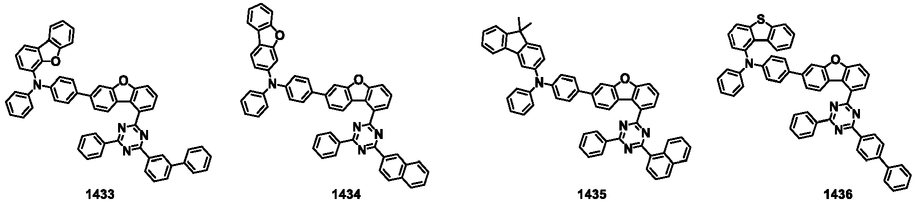

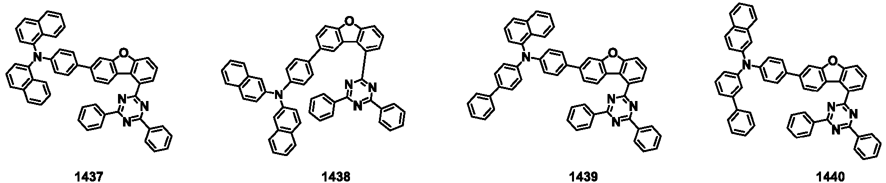

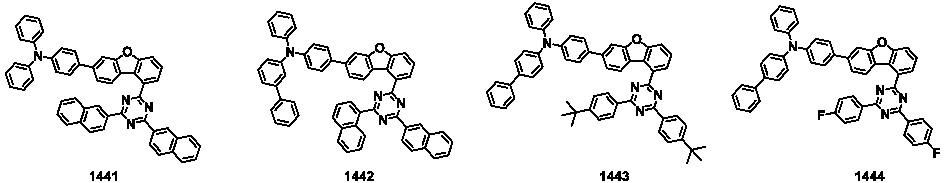

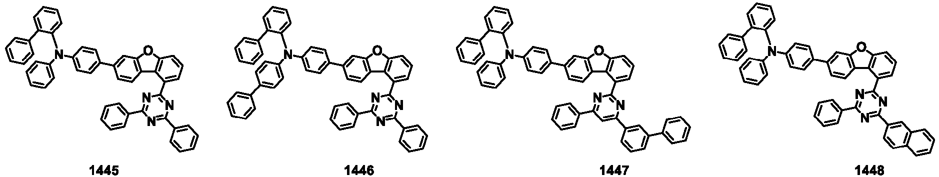

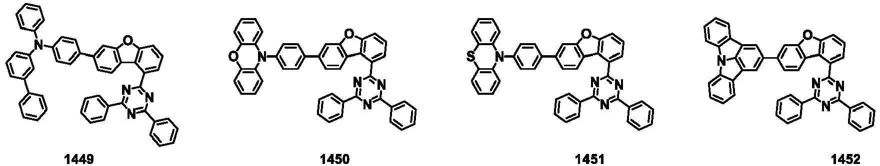

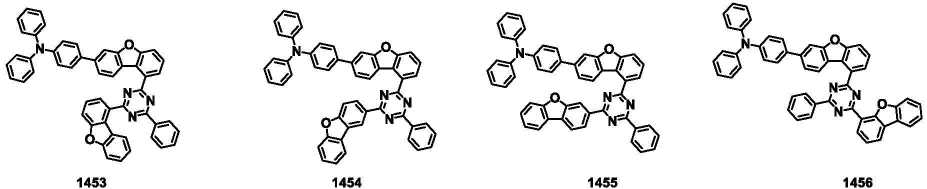

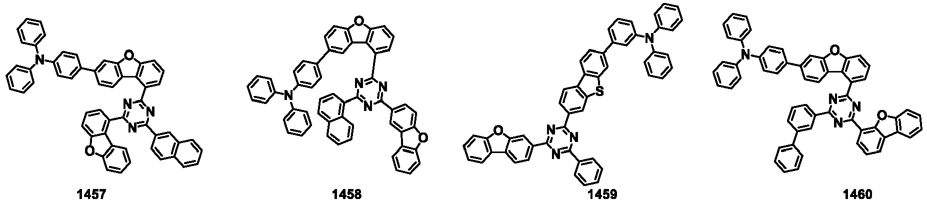

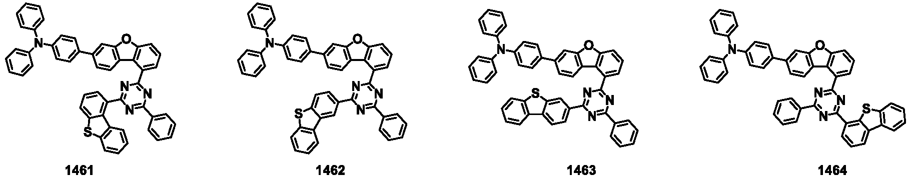

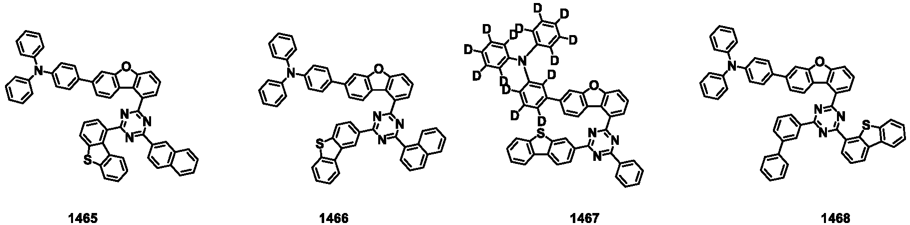

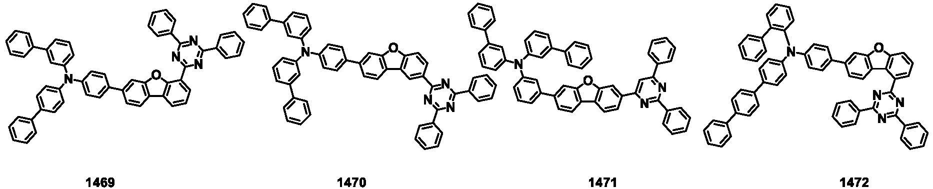

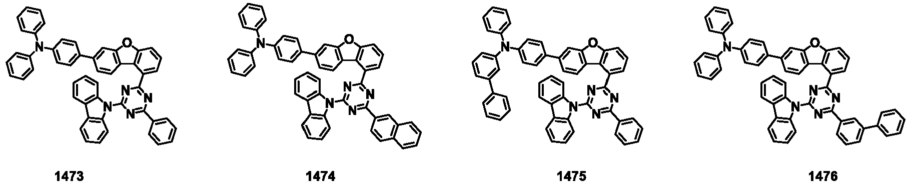

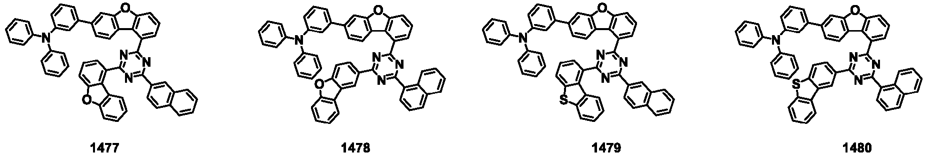

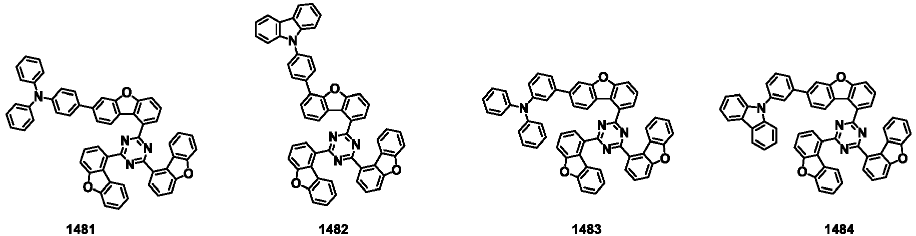

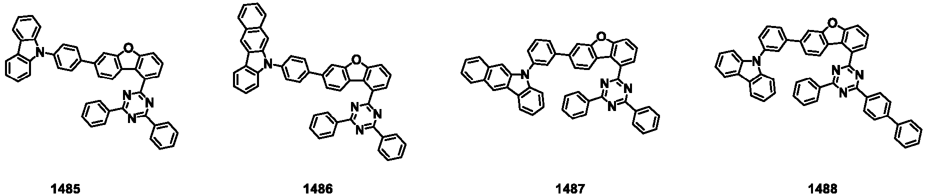

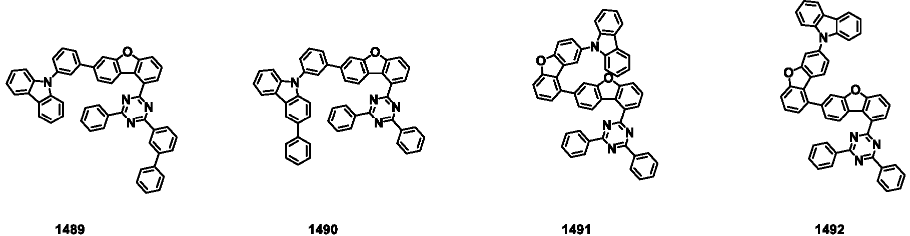

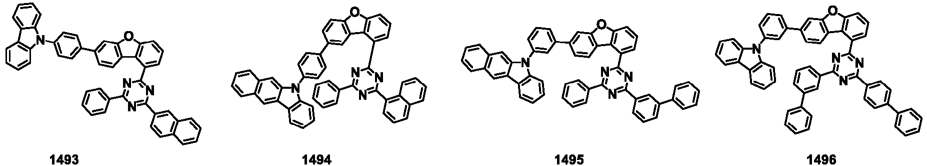

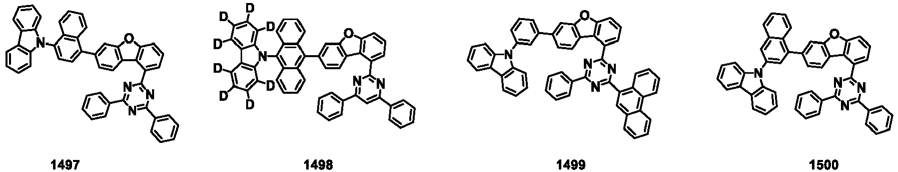

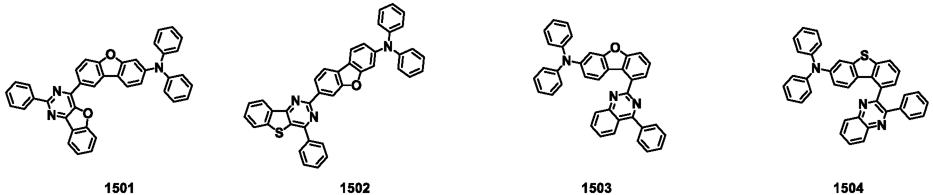

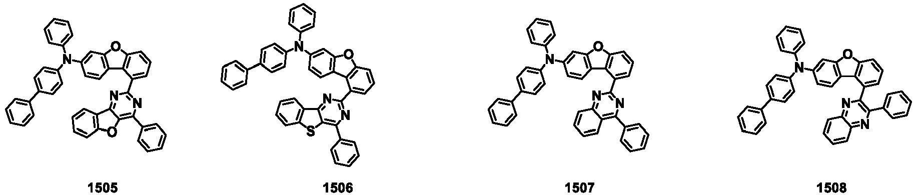

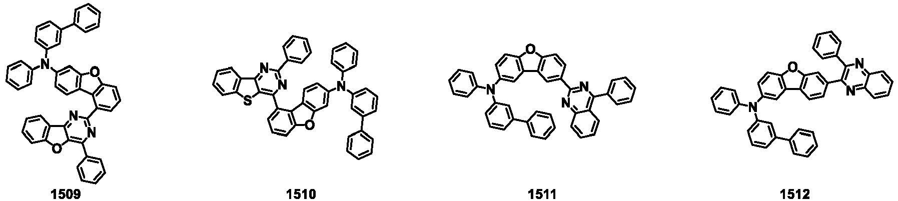

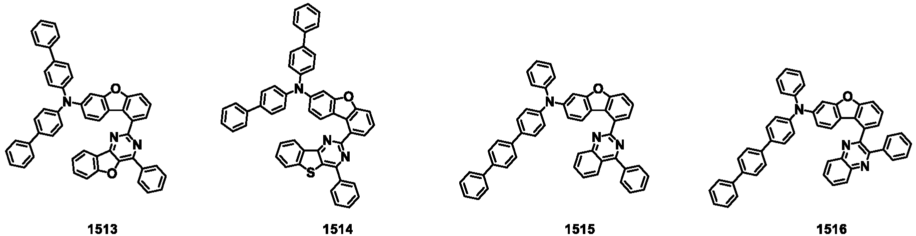

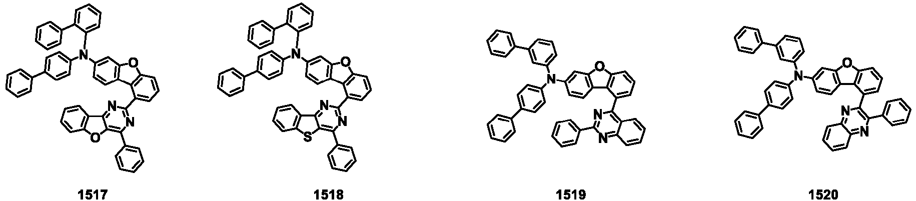

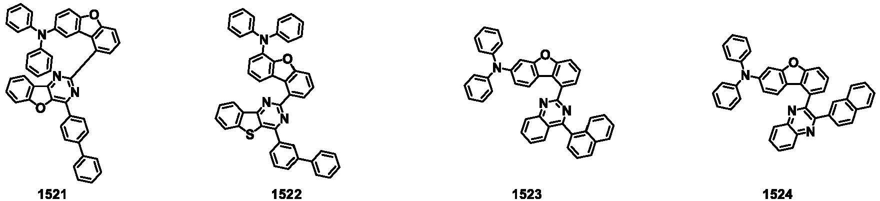

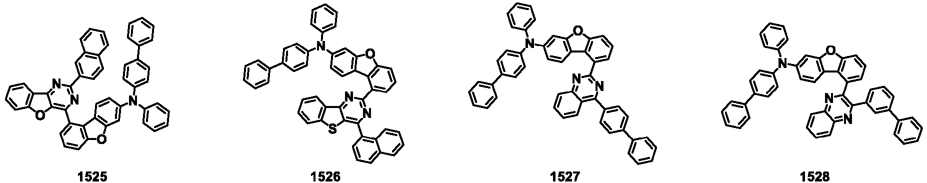

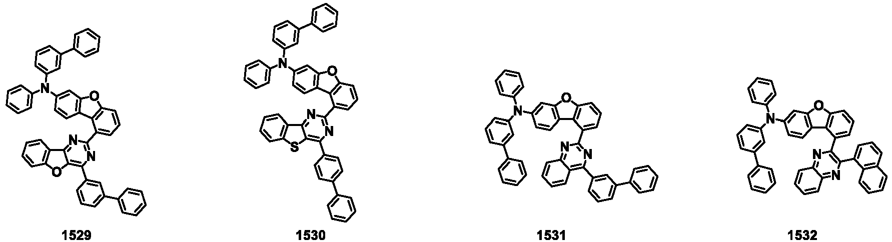

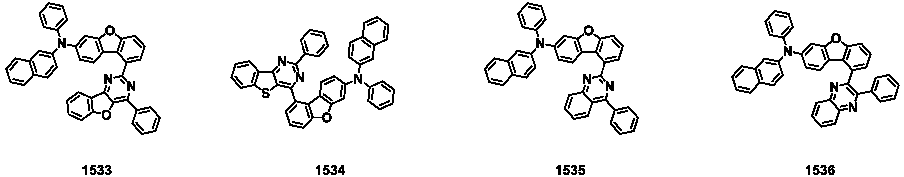

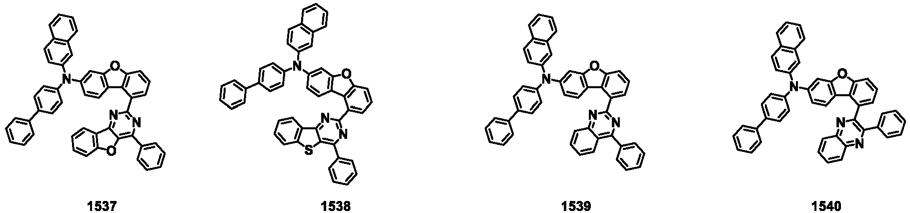

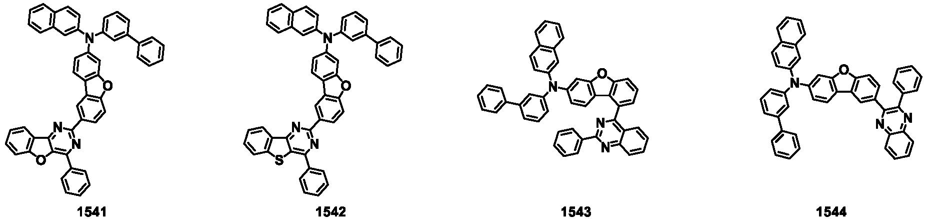

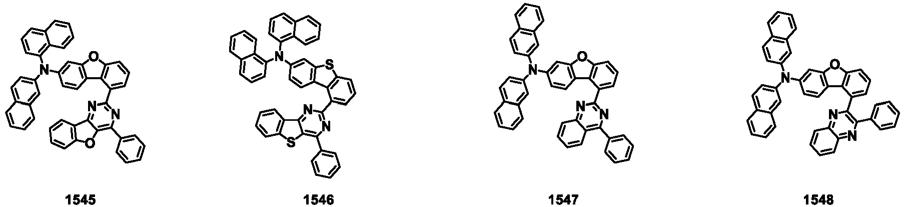

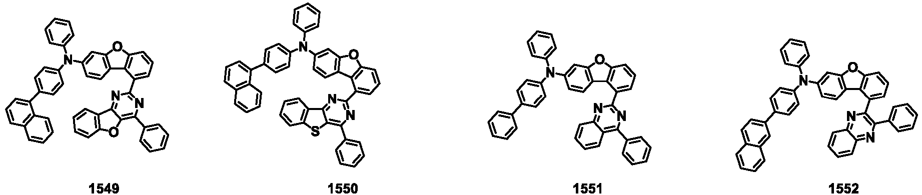

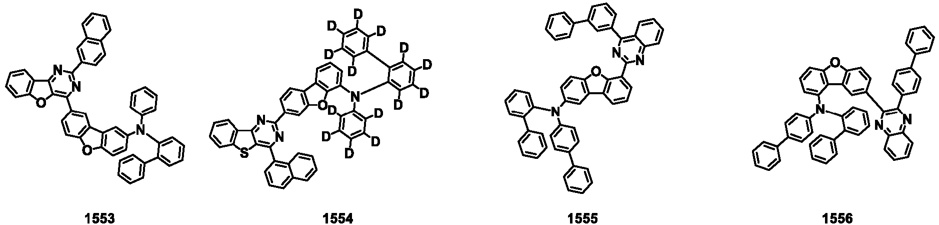

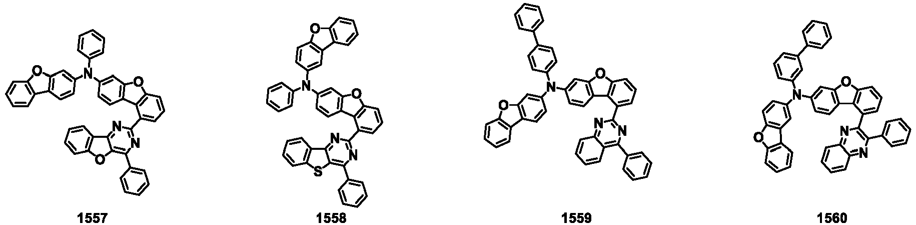

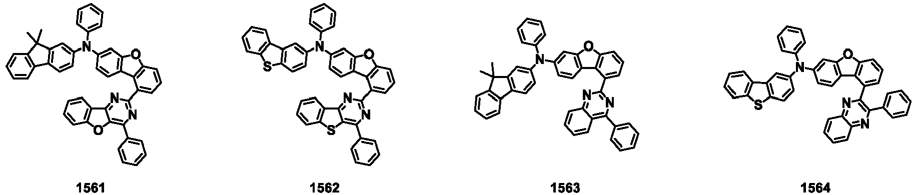

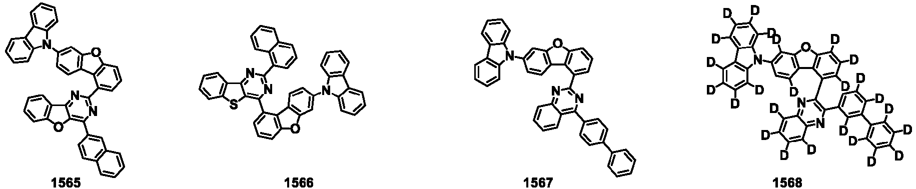

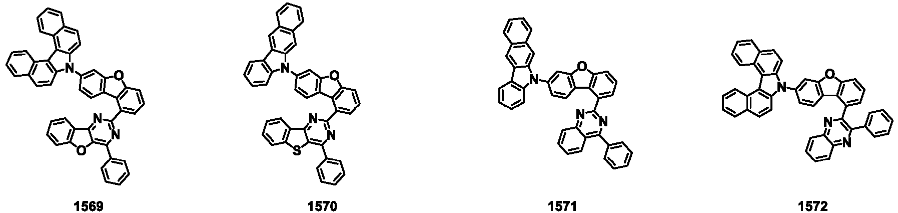

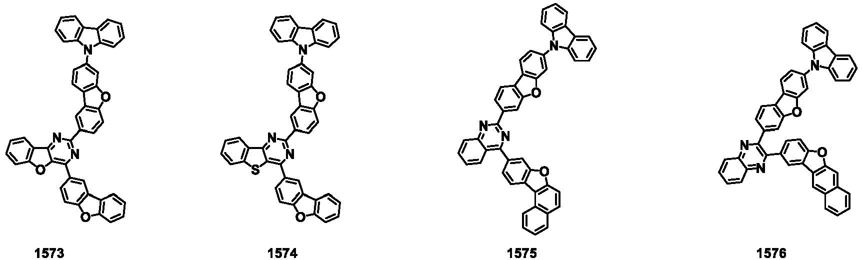

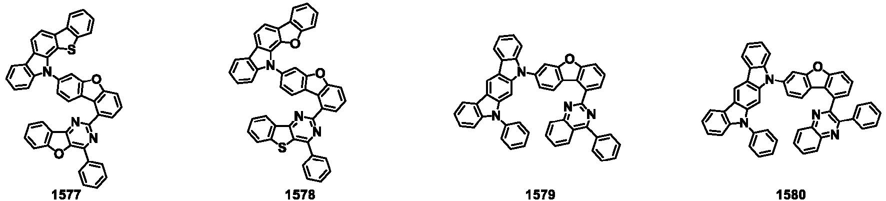

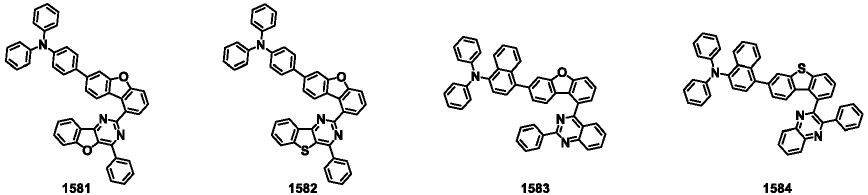

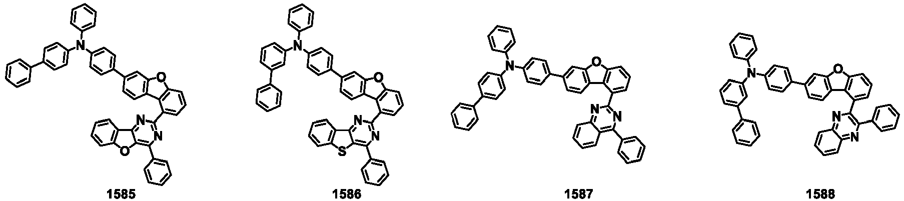

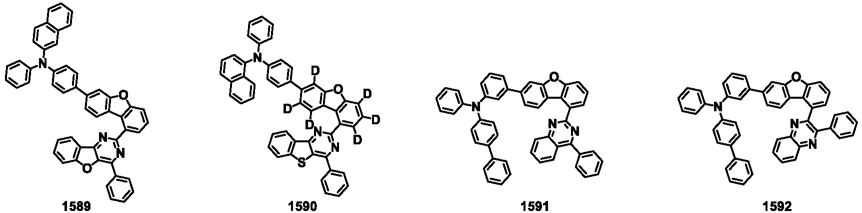

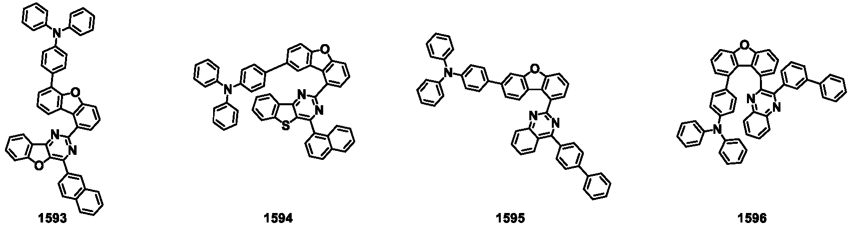

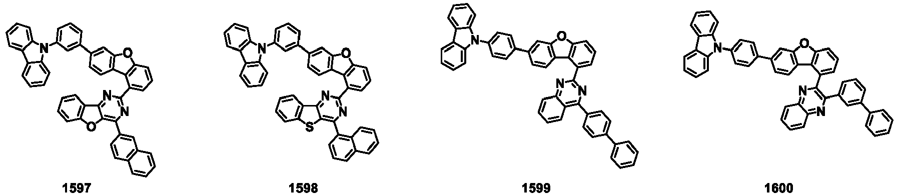

It is possible to synthesize a compound having inherent characteristics of a substituent introduced by introducing various substituents into the structures of Chemical Formulae 1 and 2. For example, it is possible to synthesize a material which satisfies conditions required for each organic material layer by introducing a substituent usually used for a hole injection layer material, a material for transporting holes, a light emitting layer material, an electron transport layer material, and a charge generation layer material, which are used for preparing an organic light emitting device, into the core structure.

In addition, it is possible to finely adjust an energy band gap by introducing various substituents into the structures of Chemical Formulae 1 and 2, and meanwhile, it is possible to improve characteristics at the interface between organic materials and diversify the use of material.

Meanwhile, the compound has a high glass transition temperature (Tg) and thus has excellent thermal stability. The increase in thermal stability becomes an important factor for providing a device with driving stability.

In an exemplary embodiment of the present application, the first electrode may be a positive electrode, and the second electrode may be a negative electrode.

In another exemplary embodiment, the first electrode may be a negative electrode, and the second electrode may be a positive electrode.

In an exemplary embodiment of the present application, the organic light emitting device may be a blue organic light emitting device, and the heterocyclic compound according to Chemical Formula 1 may be used as a material for the blue organic light emitting device.

In an exemplary embodiment of the present application, the organic light emitting device may be a green organic light emitting device, and the heterocyclic compound represented by Chemical Formula 1 may be used as a material for the green organic light emitting device.

In an exemplary embodiment of the present application, the organic light emitting device may be a red organic light emitting device, and the heterocyclic compound represented by Chemical Formula 1 may be used as a material for the red organic light emitting device.

In an exemplary embodiment of the present application, the organic light emitting device may be a blue organic light emitting device, and the heterocyclic compound according to Chemical Formula 1 may be used as a material for a light emitting layer of the blue organic light emitting device.

In an exemplary embodiment of the present application, the organic light emitting device may be a green organic light emitting device, and the heterocyclic compound represented by Chemical Formula 1 may be used as a material for a light emitting layer of the green organic light emitting device.

In an exemplary embodiment of the present application, the organic light emitting device may be a red organic light emitting device, and the heterocyclic compound represented by Chemical Formula 1 may be used as a material for a light emitting layer of the red organic light emitting device.

The organic light emitting device of the present invention may be manufactured using typical manufacturing methods and materials of an organic light emitting device, except that the above-described heterocyclic compound is used to form an organic material layer having one or more layers.

The heterocyclic compound may be formed as an organic material layer by not only a vacuum deposition method, but also a solution application method when an organic light emitting device is manufactured. Here, the solution application method means spin coating, dip coating, inkjet printing, screen printing, a spray method, roll coating, and the like, but is not limited thereto.

The organic material layer of the organic light emitting device of the present invention may be composed of a single-layered structure, but may be composed of a multi-layered structure in which two or more organic material layers are stacked. For example, the organic light emitting device of the present invention may have a structure including a hole injection layer, a hole transport layer, a light emitting layer, an electron transport layer, an electron injection layer, and the like as organic material layers. However, the structure of the organic light emitting device is not limited thereto, and may include a fewer number of organic material layers.

In the organic light emitting device of the present invention, the organic material layer includes a light emitting layer, and the light emitting layer may include the heterocyclic compound represented by Chemical Formula 1 and the heterocyclic compound represented by Chemical Formula 2.

In another exemplary embodiment, the light emitting layer may include a host material, and the host material may include the heterocyclic compound represented by Chemical Formula 1 and the heterocyclic compound represented by Chemical Formula 2.

In the organic light emitting device of the present invention, the organic material layer includes a light emitting layer, and the light emitting layer may include the heterocyclic compound represented by Chemical Formula 1 and the heterocyclic compound represented by Chemical Formula 2 as hosts of the light emitting layer.

In still another exemplary embodiment, the host material may include two or more host materials, and among the two or more host materials, the heterocyclic compound represented by Chemical Formula 1 is an N-type host material, and the heterocyclic compound represented by Chemical Formula 2 may be a P-type host material.

In such a case, the exciplex phenomenon, which is the phenomenon of emission by the difference in energy between the LUMO level of an acceptor (N-type host) and the HOMO level of a donor (P-type host) due to the electron exchange between two molecules, occurs more frequently.

That is, when the heterocyclic compound of Chemical Formula 1 and the heterocyclic compound of Chemical Formula 2 are included in the organic material layer of the organic light emitting device, better efficiency and service life effects are exhibited. From this result, it can be expected that an exciplex phenomenon will occur when both compounds are included.

The exciplex phenomenon is a phenomenon in which energy with a magnitude of the HOMO level of a donor (p-host) and the LUMO level of an acceptor (n-host) is released due to an electron exchange between two molecules. When the exciplex phenomenon between two molecules occurs, a reverse intersystem crossing (RISC) occurs, and the internal quantum efficiency of fluorescence can be increased to 100% due to the RISC. When a donor with a good hole transport capacity (p-host) and an acceptor with a good electron transport capacity (n-host) are used as hosts for the light emitting layer, holes are injected into the p-host and electrons are injected into the n-host, so that the driving voltage can be lowered, which can help to improve the service life.

In the organic light emitting device of the present invention, the host material may include two or more host materials, and the two or more host materials may be pre-mixed and used.

Further, another exemplary embodiment of the present application provides a composition for an organic material layer of an organic light emitting device, including the heterocyclic compound represented by Chemical Formula 1; and the heterocyclic compound represented by Chemical Formula 2.

The specific contents on the heterocyclic compound represented by Chemical Formula 1 and the heterocyclic compound represented by Chemical Formula 2 are the same as those described above.

The weight ratio of the heterocyclic compound represented by Chemical Formula 1 : the heterocyclic compound represented by Chemical Formula 2 in the composition may be 1 : 10 to 10 : 1, 1 : 8 to 8 : 1, 1 : 5 to 5 : 1, and 1 : 2 to 2 : 1, but is not limited thereto.

The composition may be used when an organic material for an organic light emitting device is formed, and particularly, may be more preferably used when a host of a light emitting layer is formed.

In an exemplary embodiment of the present application, the organic material layer includes: the heterocyclic compound represented by Chemical Formula 1; and the heterocyclic compound represented by Chemical Formula 2, and may be used together with a phosphorescent dopant.

In an exemplary embodiment of the present application, the organic material layer includes: the heterocyclic compound represented by Chemical Formula 1; and the heterocyclic compound represented by Chemical Formula 2, and may be used together with an iridium-based dopant.

As a material for the phosphorescent dopant, those known in the art may be used.

For example, phosphorescent dopant materials represented by LL'MX', LL'L"M, LMX'X", L2MX' and L3M may be used, but the scope of the present invention is not limited by these examples.

Here, L, L', L", X' and X" are bidentate ligands different from each other, and M is a metal forming an octahedral complex.

M may be iridium, platinum, osmium, and the like.

L is an anionic, bidentate ligand coordinated on M by the iridium-based dopant by sp2 carbon and a heteroatom, and X may perform a function of trapping electrons or holes. Non-limiting examples of L include 2-(1-naphthyl)benzoxazole, (2-phenylbenzoxazole), (2-phenylbenzothiazole), (2-phenylbenzothiazole), (7,8-benzoquinoline), (thiophene group pyrizine), phenylpyridine, benzothiophene group pyrizine, 3-methoxy-2-phenylpyridine, thiophene group pyrizine, tolylpyridine, and the like. Non-limiting examples of X' and X" include acetylacetonate (acac), hexafluoroacetylacetonate, salicylidene, picolinate, 8-hydroxyquinolinate, and the like.

More specific examples thereof will be shown below, but the present application is not limited only to these examples.

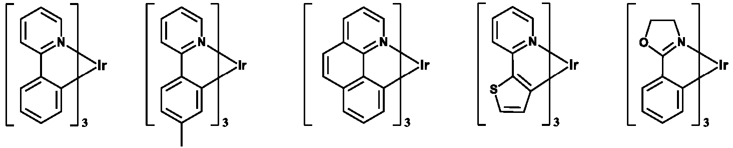

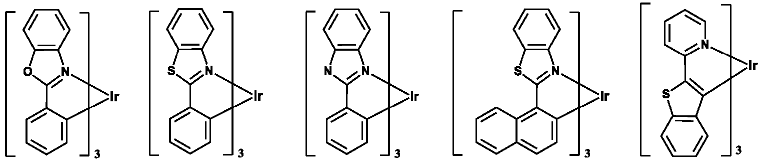

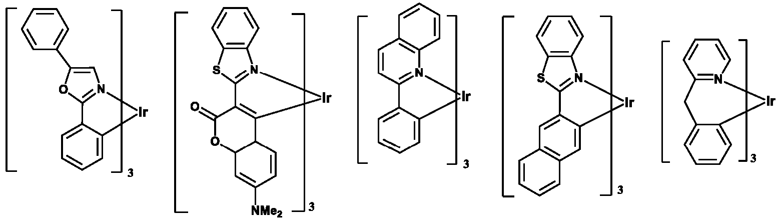

In an exemplary embodiment of the present application, as the iridium-based dopant, Ir(ppy)₃ as a green phosphorescent dopant may be used.

In an exemplary embodiment of the present application, the content of the dopant may be 1% to 15%, preferably 3% to 10%, and more preferably 5% to 10% based on the entire light emitting layer. The content may mean a weight ratio.

The organic light emitting device of the present invention may further include one or two or more layers selected from the group consisting of a light emitting layer, a hole injection layer, a hole transport layer, an electron injection layer, an electron transport layer, an electron blocking layer, and a hole blocking layer.

FIGS. 1 to 4 exemplify the stacking sequence of the electrodes and the organic material layer of the organic light emitting device according to an exemplary embodiment of the present application. However, the scope of the present application is not intended to be limited by these drawings, and the structure of the organic light emitting device known in the art may also be applied to the present application.

According to FIG. 1, an organic light emitting device in which a positive electrode 200, an organic material layer 300, and a negative electrode 400 are sequentially stacked on a substrate 100 is illustrated. However, the organic light emitting device is not limited only to such a structure, and as in FIG. 2, an organic light emitting device in which a negative electrode, an organic material layer, and a positive electrode are sequentially stacked on a substrate may also be implemented.

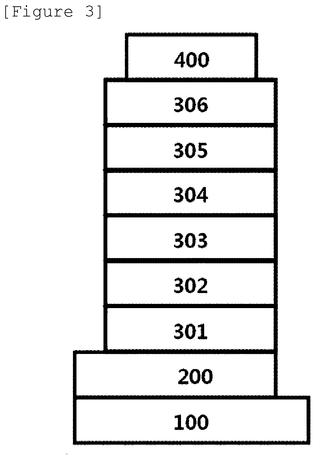

FIG. 3 exemplifies a case where an organic material layer is a multilayer. An organic light emitting device according to FIG. 3 includes a hole injection layer 301, a hole transport layer 302, a light emitting layer 303, a hole blocking layer 304, an electron transport layer 305, and an electron injection layer 306. However, the scope of the present application is not limited by the stacking structure as described above, and if necessary, the other layers except for the light emitting layer may be omitted, and another necessary functional layer may be further added.

In addition, the organic light emitting device according to an exemplary embodiment of the present application includes a first electrode, a first stack provided on the first electrode and including a first light emitting layer, a charge generation layer provided on the first stack, a second stack provided on the charge generation layer and including a second light emitting layer, and a second electrode provided on the second stack.

In an exemplary embodiment of the present application, the first light emitting layer and the second light emitting layer may include the heterocyclic compound represented by Chemical Formula 1 and the heterocyclic compound represented by Chemical Formula 2, respectively.

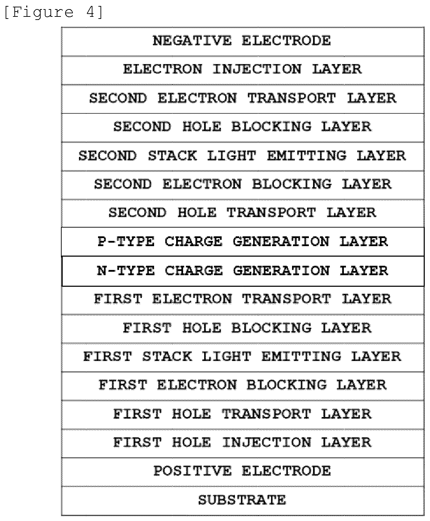

As the organic light emitting device according to an exemplary embodiment of the present application, an organic light emitting device having a 2-stack tandem structure is exemplarily illustrated in the following FIG. 4.

In this case, the first electron blocking layer, the first hole blocking layer, the second hole blocking layer, and the like described in the following FIG. 4 may be omitted depending on the case.

In an exemplary embodiment of the present application, the compound of Chemical Formula 1 may be doped with an alkali metal or an alkaline earth metal. In this case, due to the formation of the gap state, the driving voltage of the organic light emitting device may be lowered and the efficiency and service life may be further improved.

In an exemplary embodiment of the present application, provided is a composition including an alkali metal or an alkaline earth metal in the compound of Chemical Formula 1. The content of the alkali metal or alkaline earth metal of the composition may be 0.01 wt% to 30 wt%, preferably 0.01 wt% to 25 wt%, and more preferably 0.01 wt% to 20 wt%, based on the weight of the entire composition.

In an exemplary embodiment of the present application, the alkali metal or alkaline earth metal may be lithium (Li), rubidium (Rb), cesium (Cs) or magnesium (Mg). However, the alkali metal or alkaline earth metal is not limited thereto.

In an exemplary embodiment of the present application, provided is a method for manufacturing an organic light emitting device, the method including: preparing a substrate; forming a first electrode on the substrate; forming an organic material layer having one or more layers on the first electrode; and forming a second electrode on the organic material layer, in which the forming of the organic material layer includes forming the organic material layer having one or more layers by using the composition for an organic material layer according to an exemplary embodiment of the present application.

In an exemplary embodiment of the present application, provided is a method for manufacturing an organic light emitting device, in which the forming of the organic material layer forms the organic material layer by pre-mixing the heterocyclic compound represented by Chemical Formula 1 and the heterocyclic compound represented by Chemical Formula 2, and using a thermal vacuum deposition method.

The pre-mixing means that before the heterocyclic compound of Chemical Formula 1 and the heterocyclic compound of Chemical Formula 2 are deposited onto an organic material layer, the materials are first mixed and the mixture is contained in one common container and mixed.

The pre-mixed material may be referred to as a composition for an organic material layer according to an exemplary embodiment of the present application.

The organic material layer including the heterocyclic compound represented by Chemical Formula 1; and the heterocyclic compound represented by Chemical Formula 2 may additionally include another material, if necessary.

In the organic light emitting device according to an exemplary embodiment of the present application, materials other than the heterocyclic compound represented by Chemical Formula 1; and the heterocyclic compound represented by Chemical Formula 2 will be exemplified below, but these materials are provided only for exemplification and are not for limiting the scope of the present application, and may be replaced with materials publicly known in the art.

As a positive electrode material, materials having a relatively high work function may be used, and a transparent conductive oxide, a metal or a conductive polymer, and the like may be used. Specific examples of the positive electrode material include: a metal such as vanadium, chromium, copper, zinc, and gold, or an alloy thereof; a metal oxide such as zinc oxide, indium oxide, indium tin oxide (ITO), and indium zinc oxide (IZO); a combination of a metal and an oxide, such as ZnO:Al or SnO₂:Sb; a conductive polymer such as poly(3-methylthiophene), poly[3,4-(ethylene-1,2-dioxy)thiophene] (PEDOT), polypyrrole, and polyaniline; and the like, but are not limited thereto.

As a negative electrode material, materials having a relatively low work function may be used, and a metal, a metal oxide, or a conductive polymer, and the like may be used. Specific examples of the negative electrode material include: a metal such as magnesium, calcium, sodium, potassium, titanium, indium, yttrium, lithium, gadolinium, aluminum, silver, tin, and lead, or an alloy thereof; a multi-layer structured material, such as LiF/Al or LiO₂/Al; and the like, but are not limited thereto.

As a hole injection material, a publicly-known hole injection material may also be used, and it is possible to use, for example, a phthalocyanine compound such as copper phthalocyanine disclosed in US Patent No. 4,356,429 or starburst-type amine derivatives described in the document [Advanced Material, 6, p. 677 (1994)], for example, tris(4-carbazoyl-9-ylphenyl) amine (TCTA), 4,4',4"-tri[phenyl (m-tolyl)amino]triphenylamine (m-MTDATA), 1,3,5-tris[4-(3-methylphenylphenylamino)phenyl]benzene (m-MTDAPB), polyaniline/dodecylbenzenesulfonic acid or poly(3,4-ethylenedioxythiophene)/poly(4-styrenesulfonate), which is a soluble conductive polymer, polyaniline/camphor sulfonic acid or polyaniline/poly(4-styrene-sulfonate), and the like.

As a hole transport material, a pyrazoline derivative, an arylamine-based derivative, a stilbene derivative, a triphenyldiamine derivative, and the like may be used, and a low-molecular weight or polymer material may also be used.

As an electron transport material, it is possible to use an oxadiazole derivative, anthraquinodimethane and a derivative thereof, benzoquinone and a derivative thereof, naphthoquinone and a derivative thereof, anthraquinone and a derivative thereof, tetracyanoanthraquinodimethane and a derivative thereof, a fluorenone derivative, diphenyldicyanoethylene and a derivative thereof, a diphenoquinone derivative, a metal complex of 8-hydroxyquinoline and a derivative thereof, and the like, and a low-molecular weight material and a polymer material may also be used.

As an electron injection material, for example, LiF is representatively used in the art, but the present application is not limited thereto.

As a light emitting material, a red, green, or blue light emitting material may be used, and if necessary, two or more light emitting materials may be mixed and used. In this case, two or more light emitting materials are deposited or used as an individual supply source, or pre-mixed to be deposited and used as one supply source. Further, a fluorescent material may also be used as the light emitting material, but may also be used as a phosphorescent material. As the light emitting material, it is also possible to use alone a material which emits light by combining holes and electrons each injected from a positive electrode and a negative electrode, but materials in which a host material and a dopant material are involved in light emission together may also be used.

When hosts of the light emitting material are mixed and used, the same series of hosts may also be mixed and used, and different series of hosts may also be mixed and used. For example, two or more types of materials selected from n-type host materials or p-type host materials may be used as a host material for a light emitting layer.

The organic light emitting device according to an exemplary embodiment of the present application may be a top emission type, a bottom emission type, or a dual emission type according to the material to be used.

The heterocyclic compound according to an exemplary embodiment of the present application may act even in organic electronic devices including organic solar cells, organic photoconductors, organic transistors, and the like, based on the principle similar to those applied to organic light emitting devices.

### [Mode for Invention]

Hereinafter, the present specification will be described in more detail through Examples, but these Examples are provided only for exemplifying the present application, and are not intended to limit the scope of the present application.

### <Preparation Examples>

### <Preparation Example 1> Preparation of Compound 1

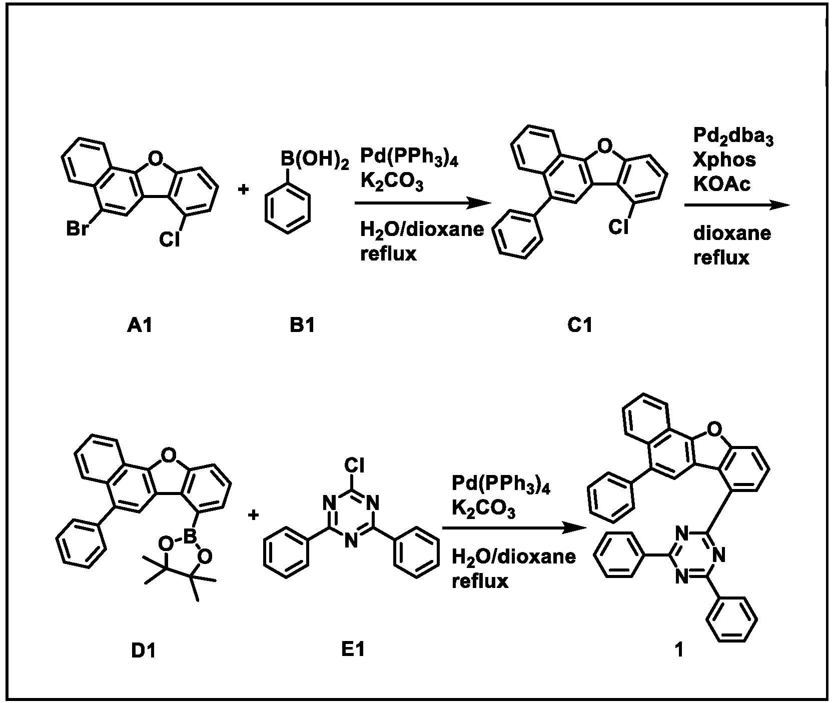

### 1) Preparation of Compound C1

After Compound A1 (50.0 g, 151 mmol), Compound B1 (22.1 g, 181 mmol), Pd(PPh₃)₄ (8.72 g, 7.56 mmol), and K₂CO₃ (41.7 g, 302 mmol) were dissolved in distilled water/1,4-dioxane (H₂O/1,4-dioxane) (150 mL/500 mL), the resulting solution was refluxed for 3 hours. After the reaction was terminated, extraction was performed with dichloromethane/distilled water (dichloromethane/H₂O) at room temperature. The reaction product was purified by column chromatography (DCM : Hex = 1 : 5) and recrystallized with methanol to obtain Compound C1 (45.1 g, 137 mmol, 91%).

The DCM means dichloromethane, and the Hex means hexane.

### 2) Preparation of Compound D1

After Compound C1 (45.1 g, 137 mmol), Pd₂dba₃ (6.27 g, 6.85 mmol), Xphos (6.53 g, 13.7 mmol), and KOAc (26.9 g, 274 mmol) were dissolved in dioxane (450 mL), the resulting solution was refluxed for 4 hours. After the reaction was terminated, the reaction product was filtered under reduced pressure to filter out salts and then concentrated. The concentrated reaction product was purified by column chromatography (DCM : Hex = 1 : 3) and recrystallized with methanol to obtain Compound D1 (36.3 g, 86.4 mmol, 63%).

### 3) Preparation of Compound 1

After Compound D1 (7.0 g, 16.7 mmol), Compound E1 (4.34 g, 16.3 mmol), Pd(PPh₃)₄ (0.96 g, 0.84 mmol), and K₂CO₃ (4.62 g, 33.4 mmol) were dissolved in distilled water/1,4-dioxane (H₂O/1,4-dioxane) (21 mL/70 mL), the resulting solution was refluxed for 2 hours. After the reaction was terminated, the reaction product was washed with water and acetone to obtain a solid. The dried solid was purified by column chromatography (DCB) and recrystallized with DCB to obtain Compound 1 (8.16 g, 15.5 mmol, 93%).

The DCB means dichlorobenzene.

### <Preparation Example 2> Preparation of Compounds 13, 37, 53, 57, 97, 133, 209, 237, 249, 253, 325 and 329

Compounds 13, 37, 53, 57, 97, 133, 209, 237, 249, 253, 325 and 329 were synthesized in the same manner as in the preparation method in Preparation Example 1, except that in Preparation Example 2, Compounds A to E of the following Table 1 were used.

**[Table 1]**

| Compound A | Compound B | Compound C | Compound D | Compound E | P (PRODUCT) | P Yield |
|---|---|---|---|---|---|---|
| 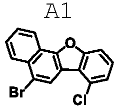 | 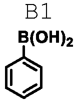 | 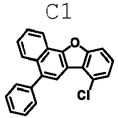 | 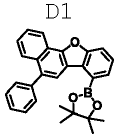 | 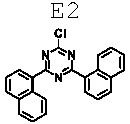 | 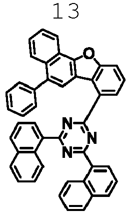 | 49% |
| 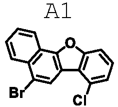 | 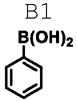 | 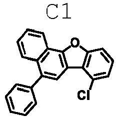 | 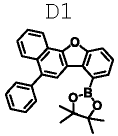 | 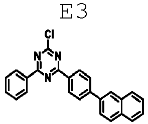 | 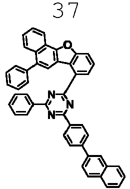 | 54% |
| 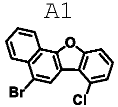 | 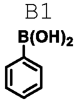 | 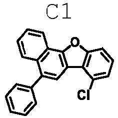 | 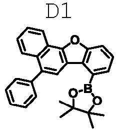 | 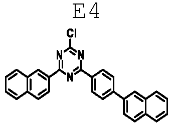 | 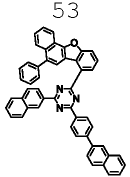 | 55% |
| 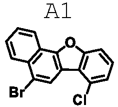 | 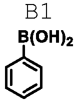 | 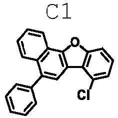 | 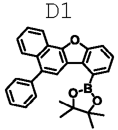 | 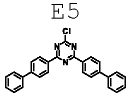 | 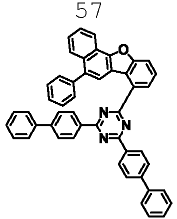 | 51% |
| 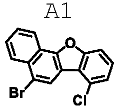 | 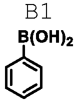 | 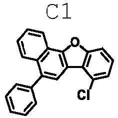 | 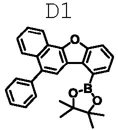 | 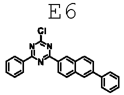 | 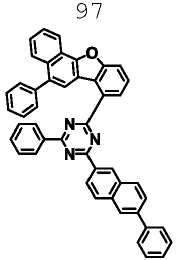 | 55% |
| 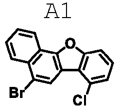 | 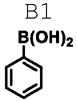 | 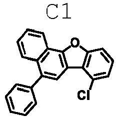 | 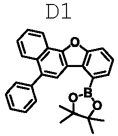 | 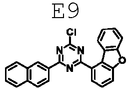 | 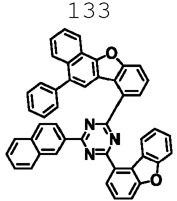 | 50% |
| 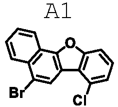 | 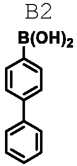 | 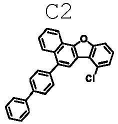 | 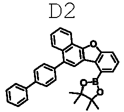 | 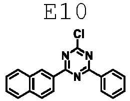 | 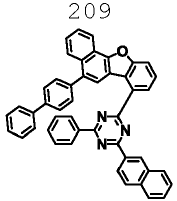 | 52% |
| 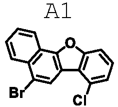 | 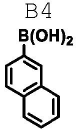 | 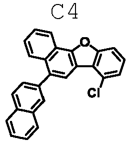 | 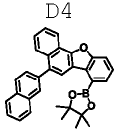 | 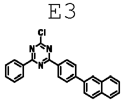 | 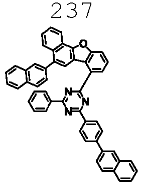 | 54% |
| 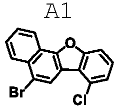 | 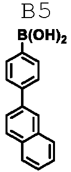 | 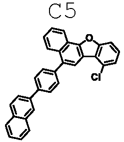 | 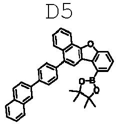 | 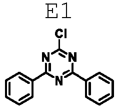 | 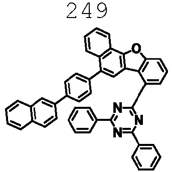 | 49% |
| 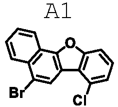 | 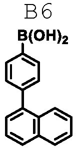 | 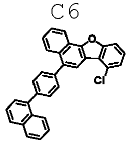 | 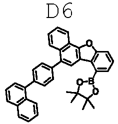 | 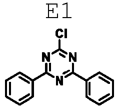 | 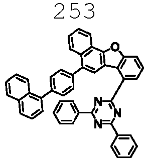 | 48% |
| 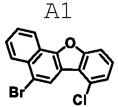 | 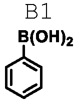 | 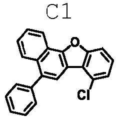 | 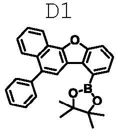 | 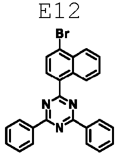 | 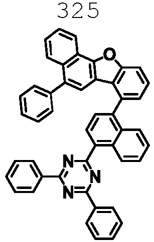 | 51% |
| 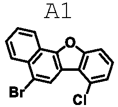 | 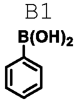 | 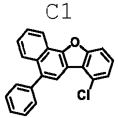 | 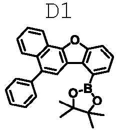 | 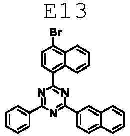 | 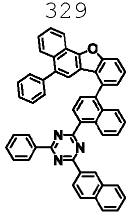 | 53% |

### <Preparation Example 3> Preparation of Compound 22

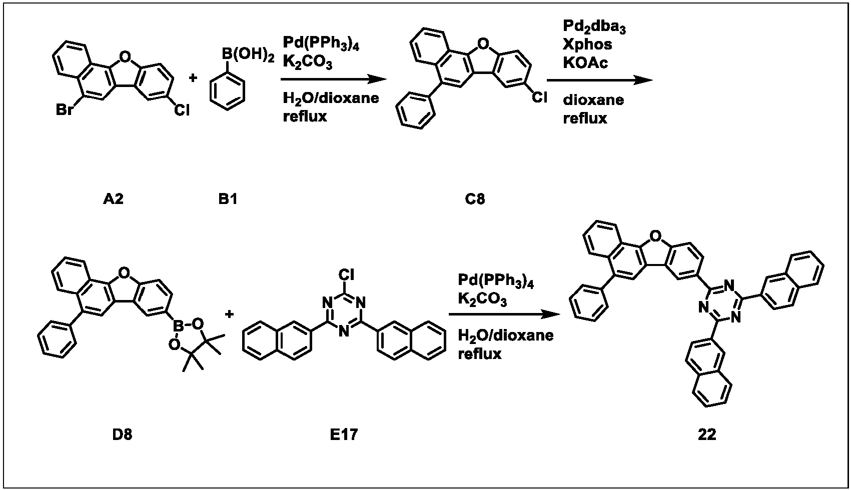

### 1) Preparation of Compound C8

After Compound A2 (50.0 g, 151 mmol), Compound B1 (22.1 g, 181 mmol), Pd(PPh₃)₄ (8.72 g, 7.56 mmol), and K₂CO₃ (41.7 g, 302 mmol) were dissolved in distilled water/1,4-dioxane (H₂O/1,4-dioxane) (150 mL/500 mL), the resulting solution was refluxed for 3 hours. After the reaction was terminated, extraction was performed with dichloromethane/distilled water (dichloromethane/H₂O) at room temperature. The reaction product was purified by column chromatography (DCM : Hex = 1 : 5) and recrystallized with methanol to obtain Compound C8 (44.7 g, 136 mmol, 90%).

### 2) Preparation of Compound D8

After Compound C8 (44.7 g, 136 mmol), Pd₂dba₃ (6.27 g, 6.80 mmol), Xphos (6.48 g, 13.6 mmol), and KOAc (26.7 g, 272 mmol) were dissolved in dioxane (450 mL), the resulting solution was refluxed for 4 hours. After the reaction was terminated, the reaction product was filtered under reduced pressure to filter out salts and then concentrated. The concentrated reaction product was purified by column chromatography (DCM : Hex = 1 : 3) and recrystallized with methanol to obtain Compound D8 (37.2 g, 88.4 mmol, 65%).

### 3) Preparation of Compound 22

After Compound D8 (7.0 g, 16.7 mmol), Compound E17 (6.00 g, 16.3 mmol), Pd(PPh₃)₄ (0.96 g, 0.84 mmol), and K₂CO₃ (4.62 g, 33.4 mmol) were dissolved in distilled water/1,4-dioxane (H₂O/1,4-dioxane) (21 mL/70 mL), the resulting solution was refluxed for 2 hours. After the reaction was terminated, the reaction product was washed with water and acetone to obtain a solid. The dried solid was purified by column chromatography (DCB) and recrystallized with DCB to obtain Compound 22 (10.0 g, 15.6 mmol, 96%).

### <Preparation Example 4> Preparation of Compounds 39, 58, 115, 134, 226, 250 and 327

Compounds 39, 58, 115, 134, 226, 250 and 327 were synthesized in the same manner as in the preparation method in Preparation Example 3, except that in Preparation Example 4, Compounds A to E of the following Table 2 were used.

**[Table 2]**

| Compoun d A | Compoun d B | Compoun d C | Compoun d D | Compoun d E | P | P Yield |
|---|---|---|---|---|---|---|
| 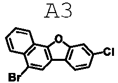 | 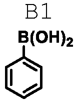 | 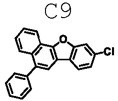 | 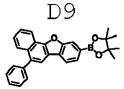 | 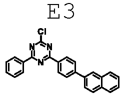 | 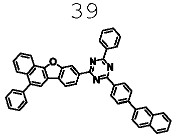 | 58% |
| 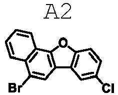 | 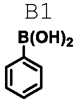 | 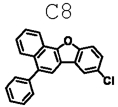 | 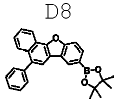 | 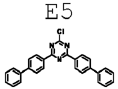 | 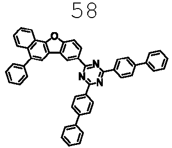 | 55% |
| 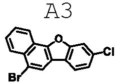 | 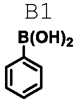 | 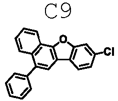 | 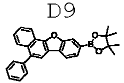 | 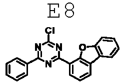 | 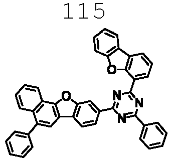 | 56% |
| 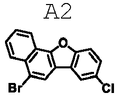 | 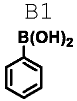 | 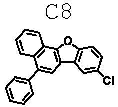 | 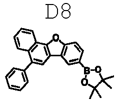 | 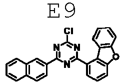 | 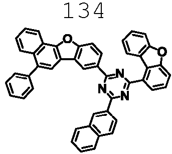 | 53% |
| 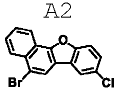 | 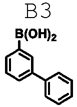 | 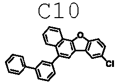 | 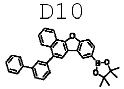 | 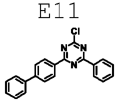 | 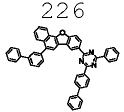 | 51% |
| 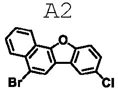 | 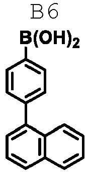 | 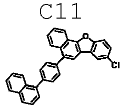 | 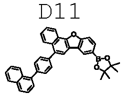 | 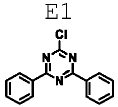 | 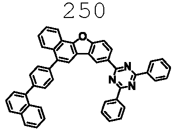 | 54% |
| 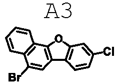 | 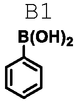 | 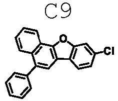 | 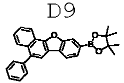 | 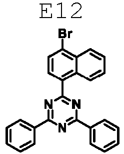 | 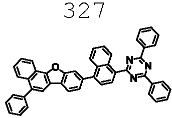 | 56% |

### <Preparation Example 5> Preparation of Compound 511

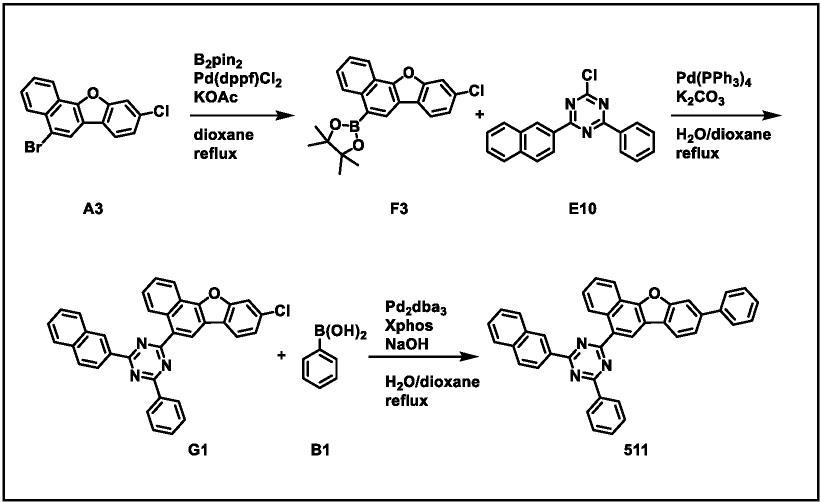

### 1) Preparation of Compound F3

After Compound A3 (50.0 g, 151 mmol), B₂pin₂ (60.0 g, 158 mmol), Pd(dppf)Cl₂ (5.52 g, 7.55 mmol), and KOAc (29.6 g, 302 mmol) were dissolved in dioxane (500 mL), the resulting solution was refluxed for 4 hours. After the reaction was terminated, the reaction product was filtered under reduced pressure to filter out salts and then concentrated. The concentrated reaction product was purified by column chromatography (DCM : Hex = 1 : 4) and recrystallized with methanol to obtain Compound F3 (46.3 g, 122 mmol, 81%).

### 2) Preparation of Compound G1

After Compound F3 (46.3 g, 122 mmol), Compound E10 (38.0 g, 120 mmol), Pd(PPh₃)₄ (7.05 g, 6.10 mmol), and K₂CO₃ (33.7 g, 244 mmol) were dissolved in distilled water/1,4-dioxane (H₂O/1,4-dioxane) (140 mL/460 mL), the resulting solution was refluxed for 2 hours. After the reaction was terminated, the reaction product was washed with water and acetone to obtain a solid. The dried solid was purified by column chromatography (DCB) and recrystallized with DCB to obtain Compound G1 (59.3 g, 111 mmol, 91%).

### 3) Preparation of Compound 511

After Compound G1 (7.0 g, 13.1 mmol), Compound B1 (1.92 g, 15.7 mmol), Pd(PPh₃)₄ (0.76 g, 0.66 mmol), and K₂CO₃ (3.62 g, 26.2 mmol) were dissolved in distilled water/1,4-dioxane (H₂O/1,4-dioxane) (21 mL/70 mL), the resulting solution was refluxed for 4 hours. After the reaction was terminated, the reaction product was washed with water and acetone to obtain a solid. The dried solid was purified by column chromatography (DCB) and recrystallized with DCB to obtain Compound 511 (7.09 g, 12.3 mmol, 94%).

### <Preparation Example 6> Preparation of Compounds 523, 551, 635, 703, 711, 755, 827, 863 and 919

Compounds 523, 551, 635, 703, 711, 755, 827, 863 and 919 were synthesized in the same manner as in the preparation method in Preparation Example 5, except that in Preparation Example 6, Compounds A, F, E, G and B of the following Table 3 were used.

**[Table 3]**

| Compound A | Compound F | Compound E | Compound G | Compound B | P | P Yield |
|---|---|---|---|---|---|---|
| 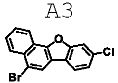 | 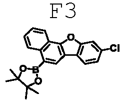 | 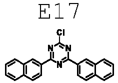 | 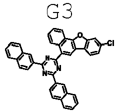 | 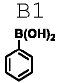 | 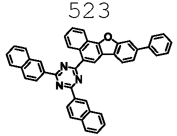 | 70% |
| 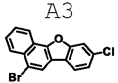 | 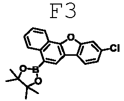 | 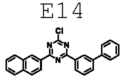 | 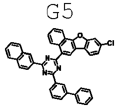 | 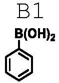 | 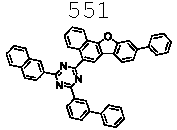 | 66% |
| 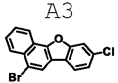 | 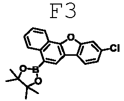 | 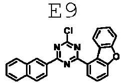 | 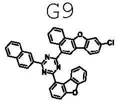 | 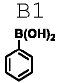 | 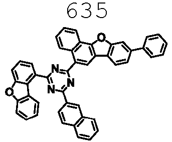 | 69% |
| 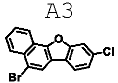 | 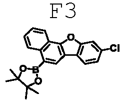 | 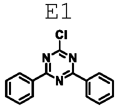 | 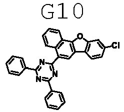 | 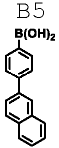 | 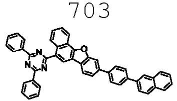 | 71% |
| 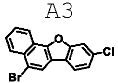 | 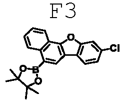 | 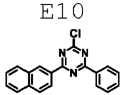 | 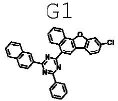 | 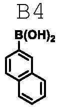 | 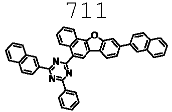 | 73% |
| 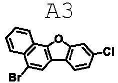 | 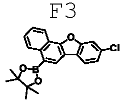 | 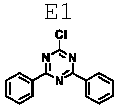 | 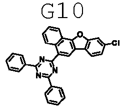 | 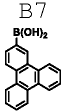 | 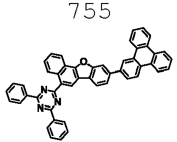 | 74% |
| 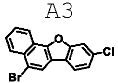 | 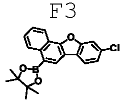 | 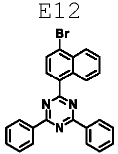 | 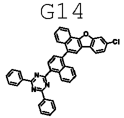 | 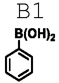 | 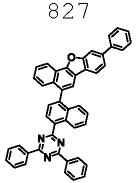 | 68% |
| 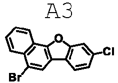 | 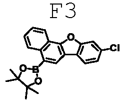 | 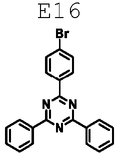 | 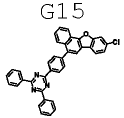 | 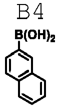 | 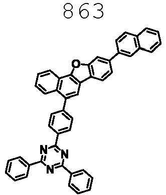 | 69% |
| 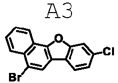 | 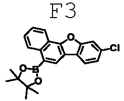 | E18 | 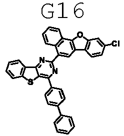 | 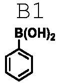 | 919 | 71% |
| | | 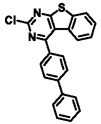 | | | 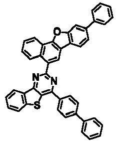 | |

### <Preparation Example 7> Preparation of Compound 521

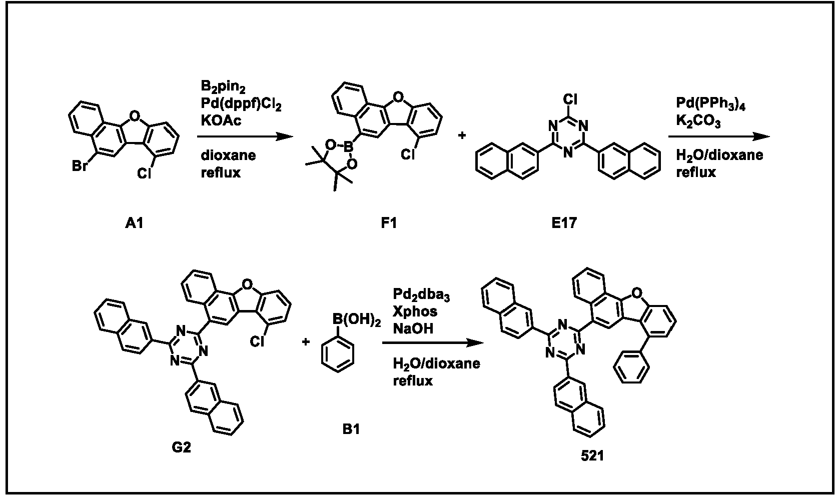

### 1) Preparation of Compound F1

After Compound A1 (50.0 g, 151 mmol), B₂pin₂ (60.0g, 158 mmol), Pd(dppf)Cl₂ (5.52 g, 7.55 mmol), and KOAc (29.6 g, 302 mmol) were dissolved in dioxane (500 mL), the resulting solution was refluxed for 4 hours. After the reaction was terminated, the reaction product was filtered under reduced pressure to filter out salts and then concentrated. The concentrated reaction product was purified by column chromatography (DCM : Hex = 1 : 4) and recrystallized with methanol to obtain Compound F1 (47.5 g, 125 mmol, 83%).

### 2) Preparation of Compound G2

After Compound F1 (7.0 g, 18.5 mmol), Compound E17 (6.66 g, 18.1 mmol), Pd(PPh₃)₄ (1.07 g, 0.93 mmol), and K₂CO₃ (5.11 g, 37.0 mmol) were dissolved in distilled water/1,4-dioxane (H₂O/1,4-dioxane) (21 mL/70 mL), the resulting solution was refluxed for 2 hours. After the reaction was terminated, the reaction product was washed with water and acetone to obtain a solid. The dried solid was purified by column chromatography (DCB) and recrystallized with DCB to obtain Compound G2 (10.1 g, 17.3 mmol, 94%).

### 3) Preparation of Compound 521

After Compound G2 (10.1 g, 17.3 mmol), Compound B1 (2.53 g, 20.8 mmol), Pd(PPh₃)₄ (1.01 g, 0.87 mmol), and K₂CO₃ (4.78 g, 34.6 mmol) were dissolved in distilled water/1,4-dioxane (H₂O/1,4-dioxane) (30 mL/100 mL), the resulting solution was refluxed for 4 hours. After the reaction was terminated, the reaction product was washed with water and acetone to obtain a solid. The dried solid was purified by column chromatography (DCB) and recrystallized with DCB to obtain Compound 521 (9.63 g, 15.4 mmol, 89%) .

### <Preparation Example 8> Preparation of Compounds 524, 597, 598, 633, 708, 724, 749 and 756

Compounds 524, 597, 598, 633, 708, 724, 749 and 756 were synthesized in the same manner as in the preparation method in Preparation Example 7, except that in Preparation Example 8, Compounds A, F, E, G and B of the following Table 4 were used.

**[Table 4]**

| Compoun d A | Compoun d F | Compoun d E | Compoun d G | Compoun d B | P | P Yield |
|---|---|---|---|---|---|---|
| 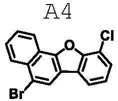 | 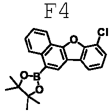 | 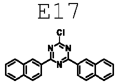 | 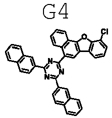 | 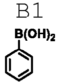 | 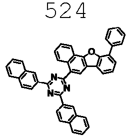 | 68% |
| 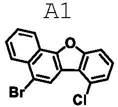 | 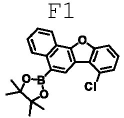 | 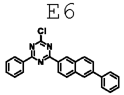 | 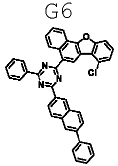 | 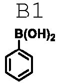 | 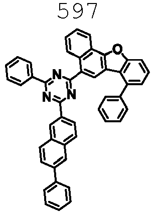 | 65% |
| 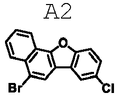 | 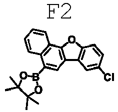 | 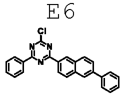 | 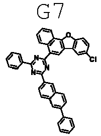 | 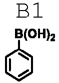 | 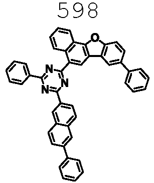 | 64% |
| 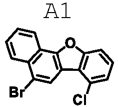 | 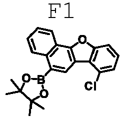 | 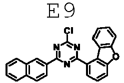 | 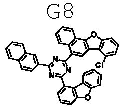 | 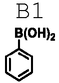 | 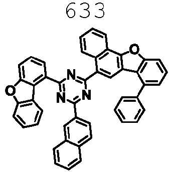 | 69% |
| 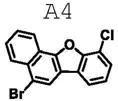 | 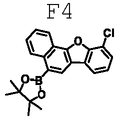 | 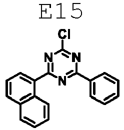 | 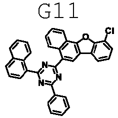 | 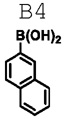 | 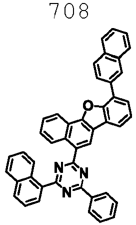 | 65% |
| 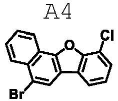 | 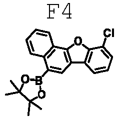 | 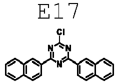 | 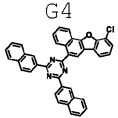 | 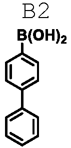 | 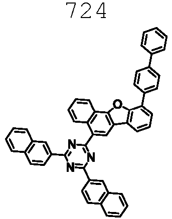 | 66% |
| 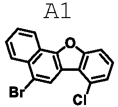 | 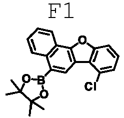 | 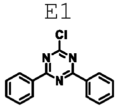 | 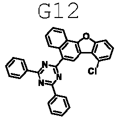 | 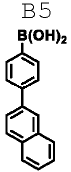 | 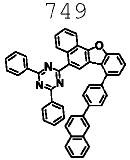 | 70% |
| 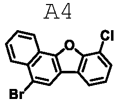 | 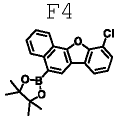 | 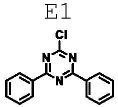 | 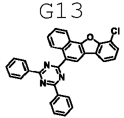 | 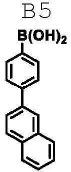 | 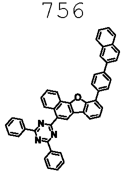 | 65% |

### <Preparation Example 9> Preparation of Compound 1002

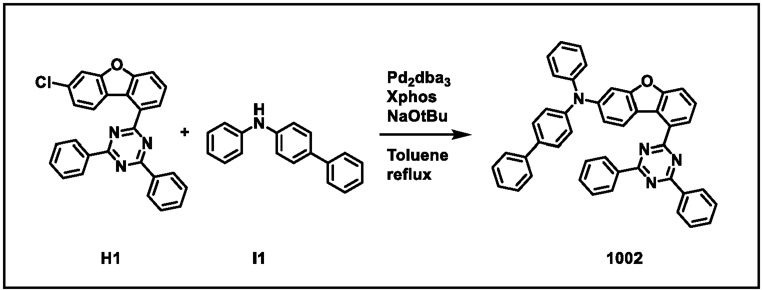

After Compound H1 (7.0 g, 16.1 mmol), Compound I1 (3.96 g, 16.1 mmol), Pd₂dba₃ (0.74 g, 0.81 mmol), Xphos (0.77 g, 1.61 mmol), and NaOtBu (3.10 g, 32.2 mmol) were dissolved in toluene (70 mL), the resulting solution was refluxed for 3 hours. After the reaction was completed, the reaction product was cooled to room temperature and filtered through a Celite filter with DCM. After the filtrate was concentrated, the concentrated filtrate was separated on a column under conditions of DCM : Hex = 1 : 2 to obtain Compound 1002 (9.15 g, 14.7 mmol, 91%).

### <Preparation Example 10> Preparation of Compound 1005, 1011, 1015, 1021, 1050, 1054, 1056, 1057, 1064, 1065, 1073, 1097, 1100, 1123, 1124, 1142, 1146, 1157, 1158, 1174, 1175, 1176, 1186 and 1187

Compounds 1005, 1011, 1015, 1021, 1050, 1054, 1056, 1057, 1064, 1065, 1073, 1097, 1100, 1123, 1124, 1142, 1146, 1157, 1158, 1174, 1175, 1176, 1186 and 1187 were synthesized in the same manner as in the preparation method in Preparation Example 9, except that in Preparation Example 10, Compounds H and I of the following Table 5 were used.

**[Table 5]**

| Compound H | Compound I | P | P Yield |
|---|---|---|---|
| 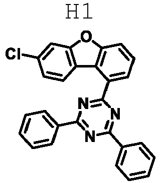 | 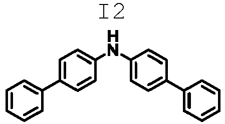 | 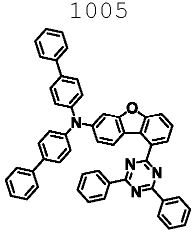 | 89% |
| 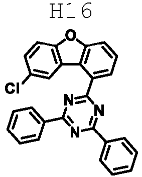 | 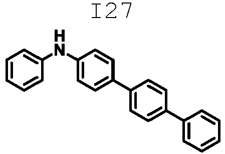 | 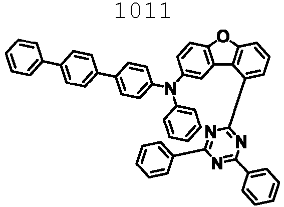 | 80% |
| 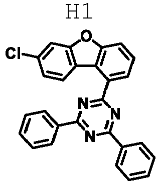 | 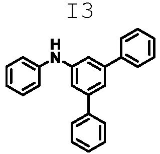 | 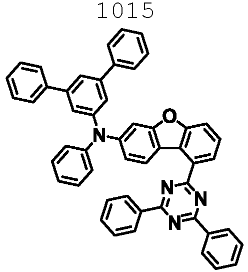 | 85% |
| H1 | I4 | 1021 | 84% |
| 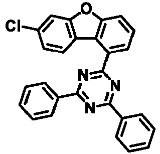 | 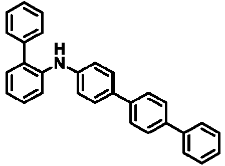 | 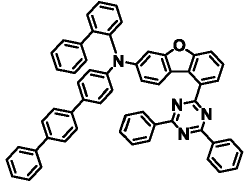 | |
| 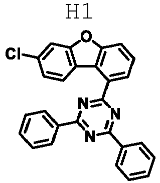 | 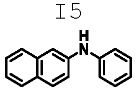 | 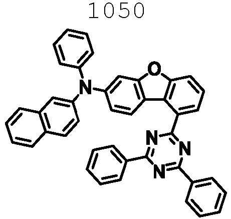 | 85% |
| 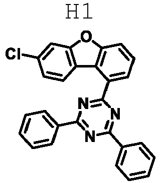 | 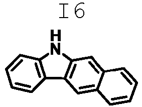 | 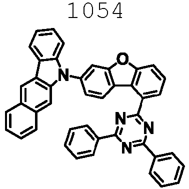 | 88% |
| 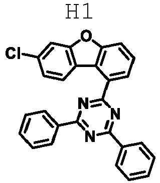 | 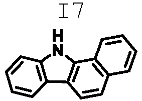 | 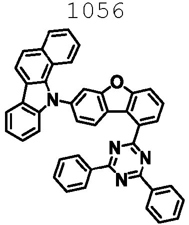 | 86% |
| 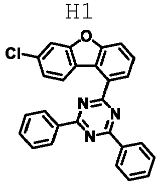 | 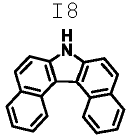 | 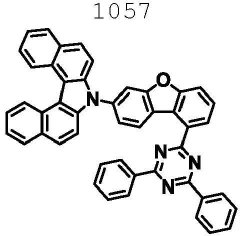 | 89% |
| 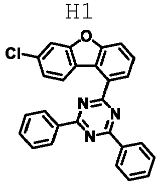 | 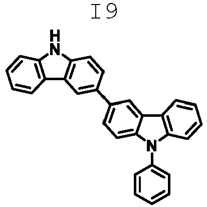 | 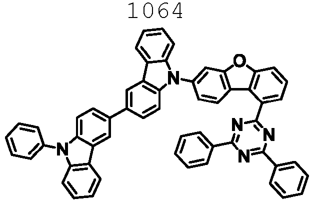 | 91% |
| 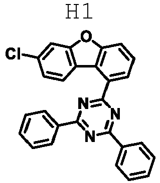 | 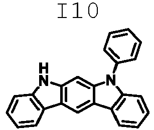 | 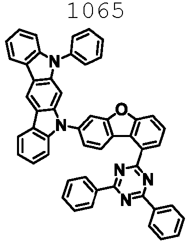 | 92% |
| 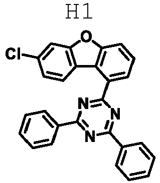 | 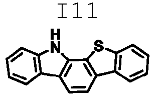 | 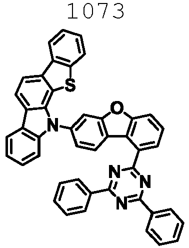 | 87% |
| 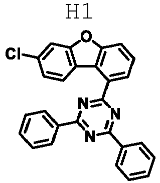 | 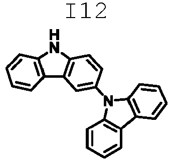 | 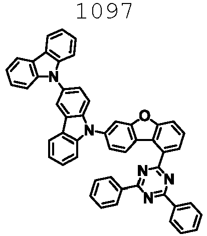 | 83% |
| 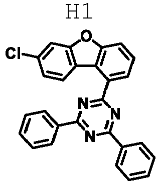 | 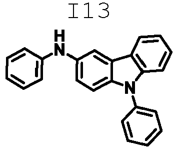 | 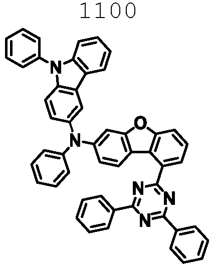 | 81% |
| 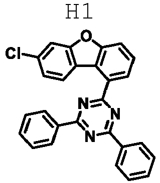 | 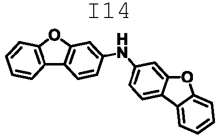 | 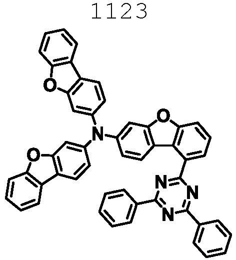 | 79% |
| 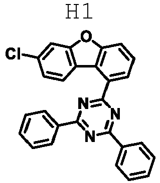 | 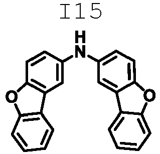 | 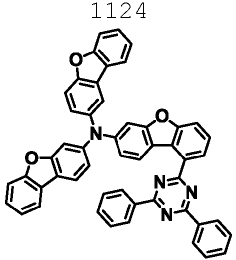 | 82% |
| 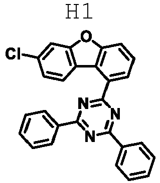 | 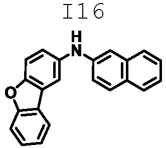 | 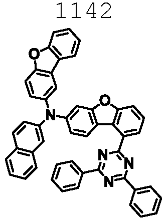 | 86% |
| 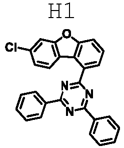 | 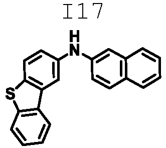 | 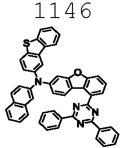 | 79% |
| 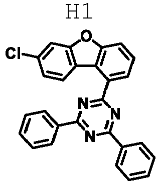 | 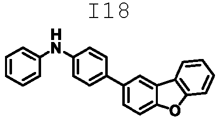 | 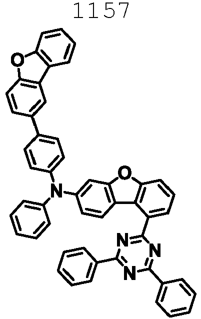 | 82% |
| 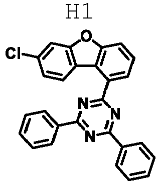 | 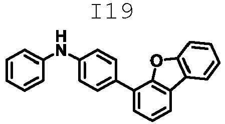 | 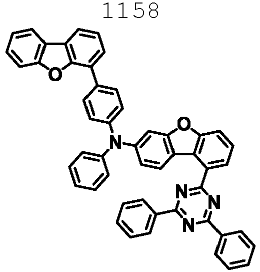 | 86% |
| H1 | 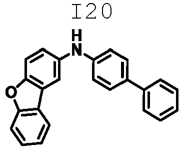 | 1174 | 91% |
| 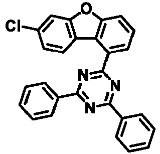 | | 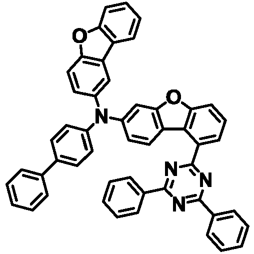 | |
| 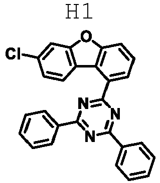 | 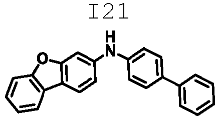 | 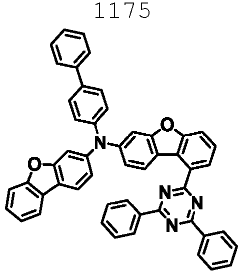 | 85% |
| 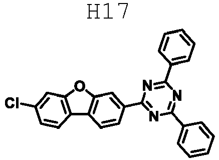 | 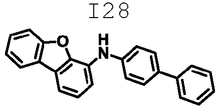 | 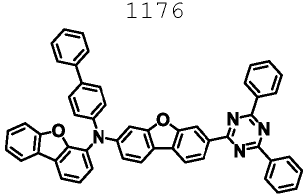 | 83% |
| 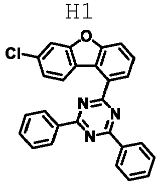 | 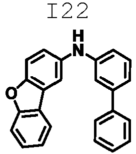 | 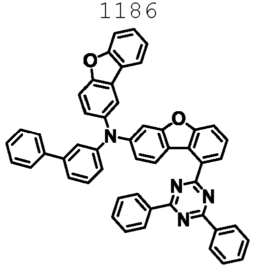 | 81% |
| 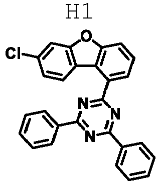 | 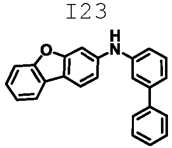 | 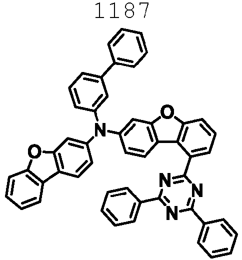 | 84% |

### <Preparation Example 11> Preparation of Compound 1203

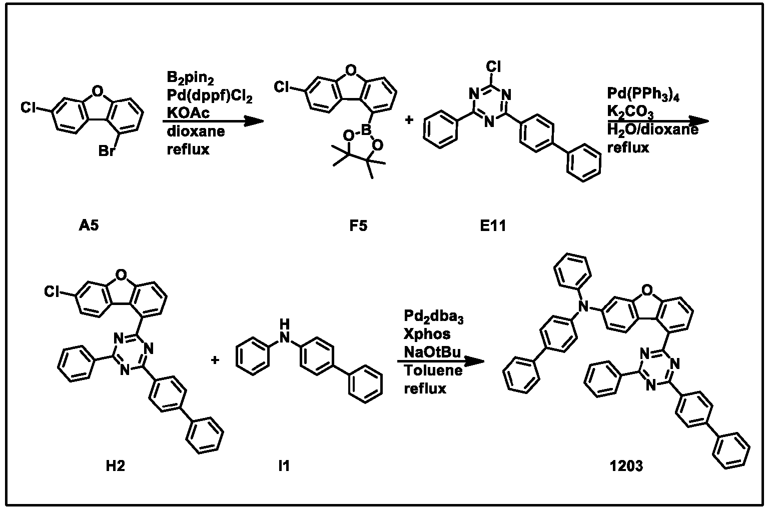

### 1) Preparation of Compound F5

After Compound A5 (50.0 g, 178 mmol), B₂pin₂ (54.1 g, 213 mmol), Pd(dppf)Cl₂ (6.51 g, 8.90 mmol), and KOAc (34.9 g, 356 mmol) were dissolved in dioxane (500 mL), the resulting solution was refluxed for 4 hours. After the reaction was terminated, the reaction product was filtered under reduced pressure to filter out salts and then concentrated. The concentrated reaction product was purified by column chromatography (DCM : Hex = 1 : 4) and recrystallized with methanol to obtain Compound F5 (44.0 g, 134 mmol, 75%).

### 2) Preparation of Compound H2

After Compound F5 (7.0 g, 21.3 mmol), Compound E11 (7.18 g, 20.9 mmol), Pd(PPh₃)₄ (1.23 g, 1.07 mmol), and K₂CO₃ (5.89 g, 42.6 mmol) were dissolved in distilled water/1,4-dioxane (H₂O/1,4-dioxane (21 mL/70 mL), the resulting solution was refluxed for 2 hours. After the reaction was terminated, the reaction product was washed with water and acetone to obtain a solid. The dried solid was purified by column chromatography (DCB) and recrystallized with DCB to obtain Compound H2 (10.4 g, 20.4 mmol, 96%).

### 3) Preparation of Compound 1203

After Compound H2 (10.4 g, 20.4 mmol), Compound I1 (5.00 g, 20.4 mmol), Pd₂dba₃ (0.93 g, 1.02 mmol), Xphos (0.97 g, 2.04 mmol), and NaOtBu (3.92 g, 40.8 mmol) were dissolved in toluene (100 mL), the resulting solution was refluxed for 3 hours. After the reaction was completed, the reaction product was cooled to room temperature and filtered through a Celite filter with DCM. After the filtrate was concentrated, the concentrated filtrate was separated on a column under conditions of DCM : Hex = 1 : 2 to obtain Compound 1203 (11.6 g, 16.1 mmol, 76%).

### <Preparation Example 12> Preparation of Compounds 1257, 1258, 1278, 1279, 1306, 1307 and 1365

Compounds 1257, 1258, 1278, 1279, 1306, 1307 and 1365 were synthesized in the same manner as in the preparation method in Preparation Example 11, except that in Preparation Example 12, Compounds A, F, E, H and I of the following Table 6 were used.

**[Table 6]**

| Compoun d A | Compoun d F | Compoun d E | Compoun d H | Compoun d I | P | P Yiel d |
|---|---|---|---|---|---|---|
| 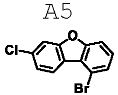 | 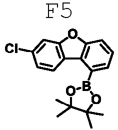 | 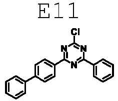 | 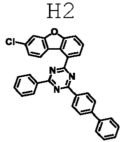 | 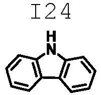 | 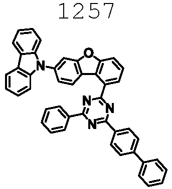 | 55% |
| 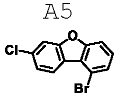 | 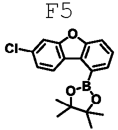 | 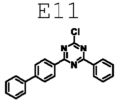 | 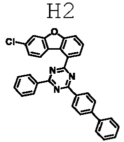 | 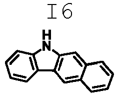 | 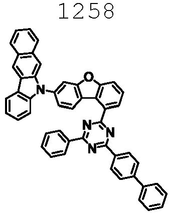 | 57% |
| 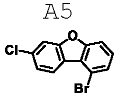 | 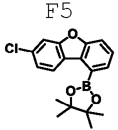 | 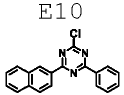 | 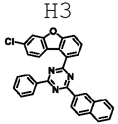 | 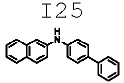 | 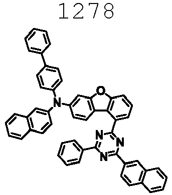 | 51% |
| 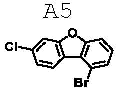 | 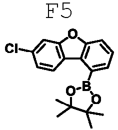 | 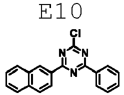 | 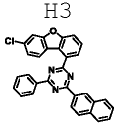 | 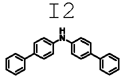 | 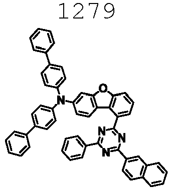 | 53% |
| 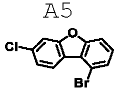 | 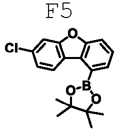 | 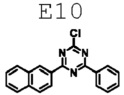 | 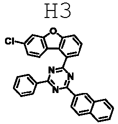 | 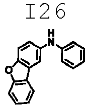 | 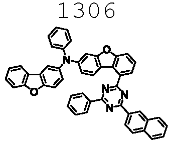 | 54% |
| 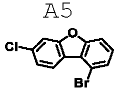 | 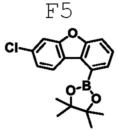 | 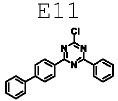 | 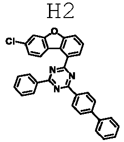 | 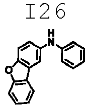 | 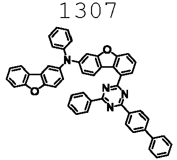 | 56% |
| 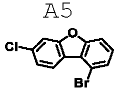 | 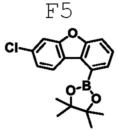 | 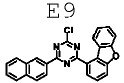 | 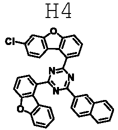 | 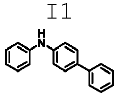 | 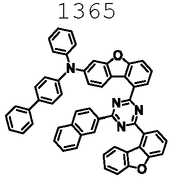 | 49% |

### <Preparation Example 13> Preparation of Compound 1403

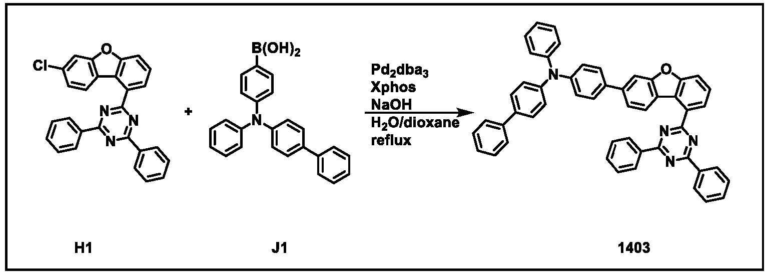

After Compound H1 (7.0 g, 16.1 mmol), Compound J1 (6.50 g, 16.9 mmol), Pd₂dba₃ (0.74 g, 0.81 mmol), Xphos (0.77 g, 1.61 mmol), and NaOH (1.29 g, 32.2 mmol) were dissolved in distilled water/1,4-dioxane (H₂O/1,4-dioxane (21 mL/70 mL), the resulting solution was refluxed for 3 hours. After the reaction was completed, the reaction product was cooled to room temperature and filtered through a Celite filter with DCM. After the filtrate was concentrated, the concentrated filtrate was separated on a column under conditions of DCM : Hex = 1 : 3 to obtain Compound 1403 (9.95 g, 13.8 mmol, 86%).

### <Preparation Example 14> Preparation of Compound 1404, 1413, 1417, 1437 and 1439

Compounds 1404, 1413, 1417, 1437 and 1439 were synthesized in the same manner as in the preparation method in Preparation Example 13, except that in Preparation Example 14, Compounds H and J of the following Table 7 were used.

**[Table 7]**

| Compound H | Compound J | P | P Yield |
|---|---|---|---|
| 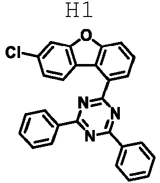 | 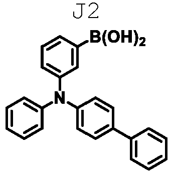 | 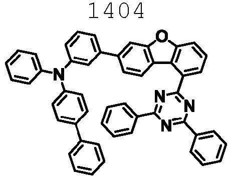 | 85% |
| 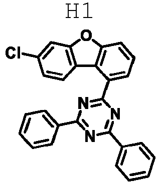 | 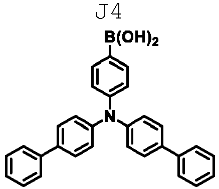 | 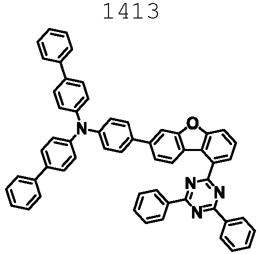 | 81% |
| 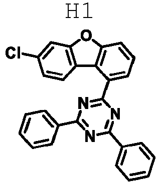 | 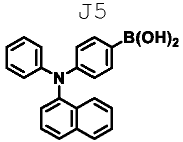 | 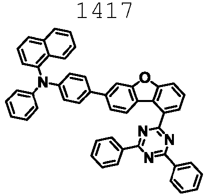 | 80% |
| 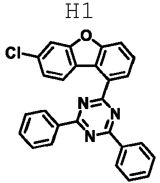 | 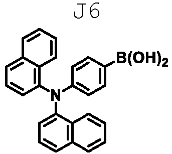 | 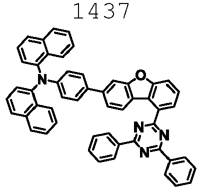 | 82% |
| 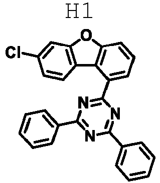 | 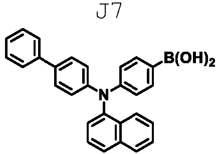 | 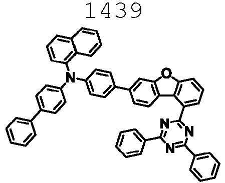 | 86% |

### <Preparation Example 15> Preparation of Compound 1405

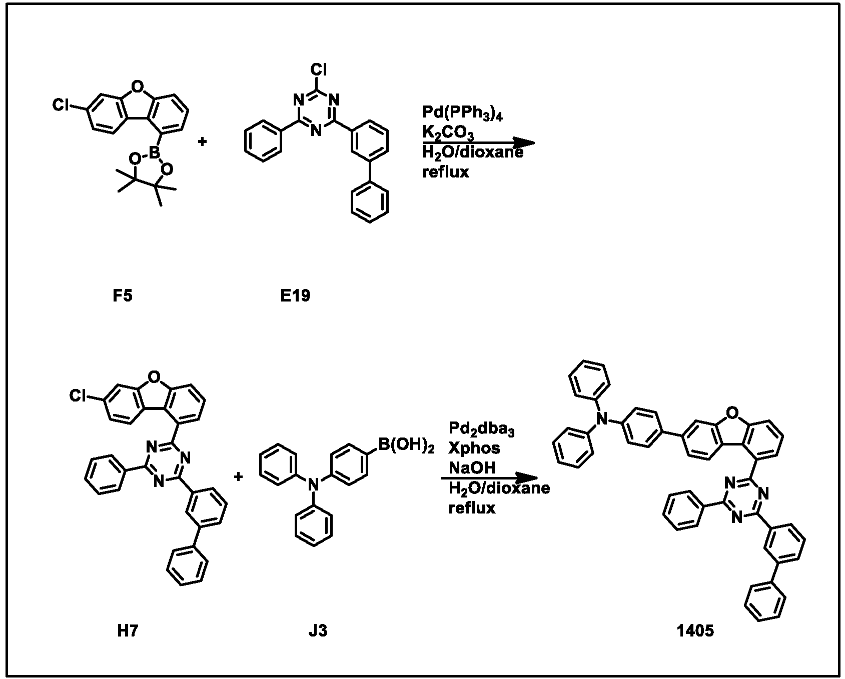

### 1) Preparation of Compound H7

After Compound F5 (7.0 g, 21.3 mmol), Compound E19 (7.18 g, 20.9 mmol), Pd(PPh₃)₄ (1.23 g, 1.07 mmol), and K₂CO₃ (5.89 g, 42.6 mmol) were dissolved in distilled water/1,4-dioxane (H₂O/1,4-dioxane) (21 mL/70 mL), the resulting solution was refluxed for 2 hours. After the reaction was terminated, the reaction product was washed with water and acetone to obtain a solid. The dried solid was purified by column chromatography (DCB) and recrystallized with DCB to obtain Compound H7 (10.2 g, 20.0 mmol, 94%).

### 2) Preparation of Compound 1405

After Compound H7 (10.2 g, 20.0 mmol), Compound J3 (6.07 g, 21.0 mmol), Pd₂dba₃ (0.92 g, 1.00 mmol), Xphos (0.95 g, 2.00 mmol), and NaOH (1.60 g, 40.0 mmol) were dissolved in distilled water/1,4-dioxane (H₂O/1,4-dioxane) (21 mL/70 mL), the resulting solution was refluxed for 3 hours. After the reaction was completed, the reaction product was cooled to room temperature and filtered through a Celite filter with DCM. After the filtrate was concentrated, the concentrated filtrate was separated on a column under conditions of DCM : Hex = 1 : 3 to obtain Compound 1405 (11.8 g, 16.4 mmol, 82%).

### <Preparation Example 16> Preparation of Compounds 1444, 1453, 1488, 1489, 1585, 1587 and 1595

Compounds 1444, 1453, 1488, 1489, 1585, 1587 and 1595 were synthesized in the same manner as in the preparation method in Preparation Example 15, except that in Preparation Example 16, Compounds F, E, H and J of the following Table 8 were used.

**[Table 8]**

| Compoun d F | Compoun d E | Compoun d H | Compoun d J | P | P Yiel d |
|---|---|---|---|---|---|
| 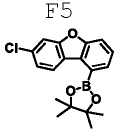 | 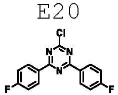 | 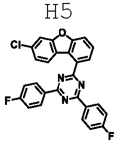 | 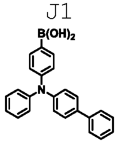 | 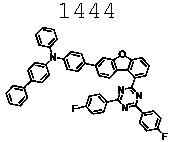 | 72% |
| 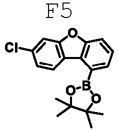 | 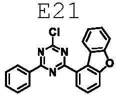 | 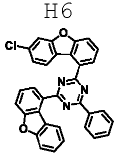 | 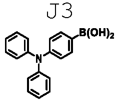 | 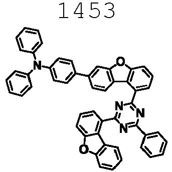 | 75% |
| 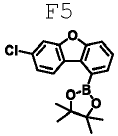 | 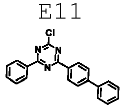 | 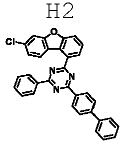 | 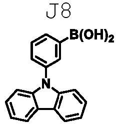 | 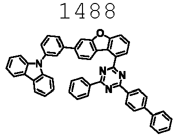 | 79% |
| 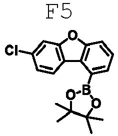 | 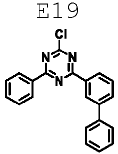 | 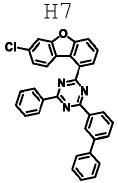 | 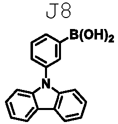 | 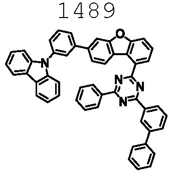 | 76% |
| 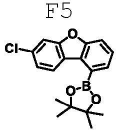 | 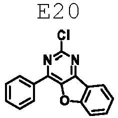 | 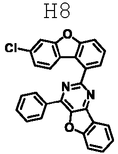 | 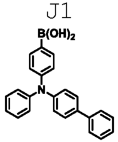 | 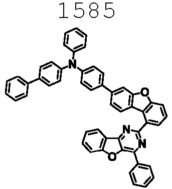 | 73% |
| 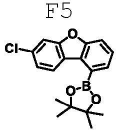 | 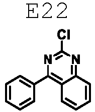 | 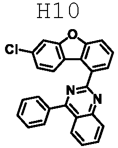 | 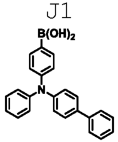 | 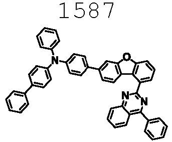 | 74% |
| 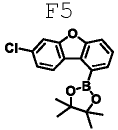 | 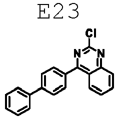 | 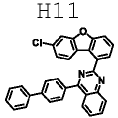 | 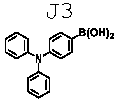 | 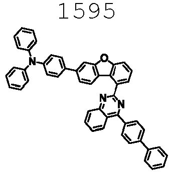 | 77% |

### <Preparation Example 17> Preparation of Compound 1505

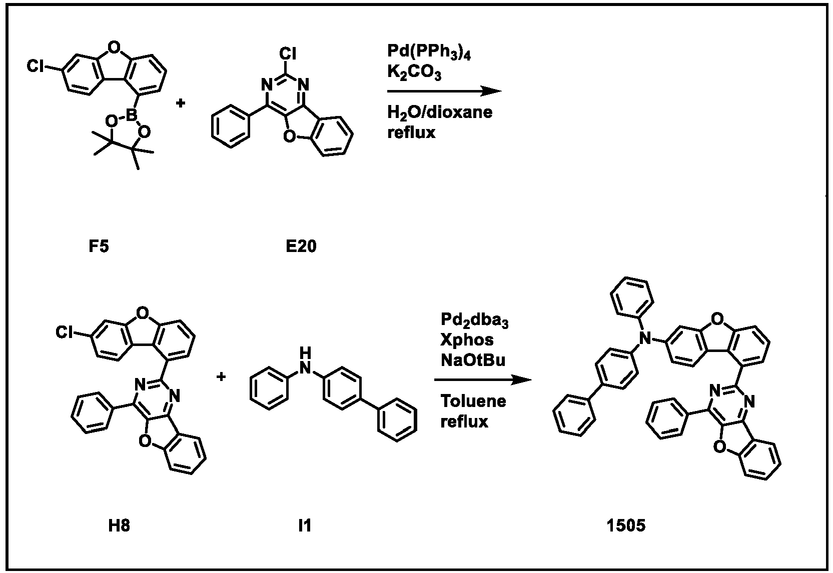

### 1) Preparation of Compound H8

After Compound F5 (7.0 g, 21.3 mmol), Compound E20 (5.86 g, 20.9 mmol), Pd(PPh₃)₄ (1.23 g, 1.07 mmol), and K₂CO₃ (5.89 g, 42.6 mmol) were dissolved in distilled water/1,4-dioxane (H₂O/1,4-dioxane) (21 mL/70 mL), the resulting solution was refluxed for 2 hours. After the reaction was terminated, the reaction product was washed with water and acetone to obtain a solid. The dried solid was purified by column chromatography (DCB) and recrystallized with DCB to obtain Compound H8 (8.47 g, 19.0 mmol, 89%).

### 2) Preparation of Compound 1505

After Compound H8 (8.47 g, 19.0 mmol), Compound I1 (4.66 g, 19.0 mmol), Pd₂dba₃ (0.87 g, 0.95 mmol), Xphos (0.91 g, 1.90 mmol), and NaOH (1.52 g, 38.0 mmol) were dissolved in distilled water/1,4-dioxane (H₂O/1,4-dioxane) (25 mL/85 mL), the resulting solution was refluxed for 3 hours. After the reaction was completed, the reaction product was cooled to room temperature and filtered through a Celite filter with DCM. After the filtrate was concentrated, the concentrated filtrate was separated on a column under conditions of DCM : Hex = 1 : 2 to obtain Compound 1505 (10.1 g, 15.4 mmol, 81%).

### <Preparation Example 18> Preparation of Compounds 1506, 1559, 1570 and 1579

Compounds 1506, 1559, 1570 and 1579 were synthesized in the same manner as in the preparation method in Preparation Example 17, except that in Preparation Example 18, Compounds F, E, H and I of the following Table 9 were used.

**[Table 9]**

| Compoun d F | Compoun d E | Compoun d H | Compoun d I | P | P Yield |
|---|---|---|---|---|---|
| 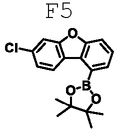 | 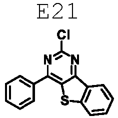 | 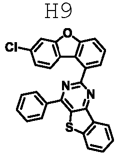 | 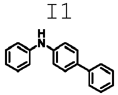 | 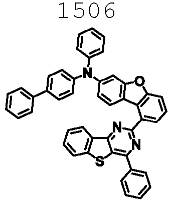 | 71% |
| 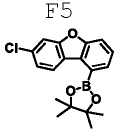 | 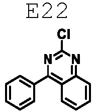 | 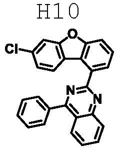 | 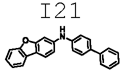 | 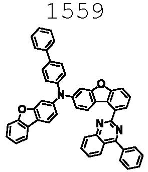 | 73% |
| 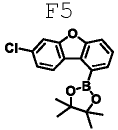 | 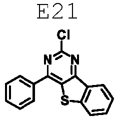 | 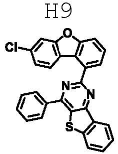 | 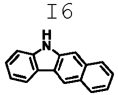 | 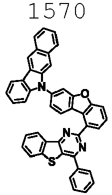 | 69% |
| 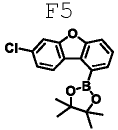 | 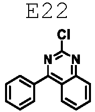 | 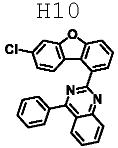 | 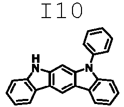 | 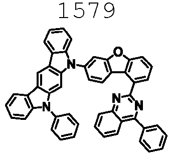 | 72% |

The synthesis results of the compounds described in Preparation Examples 1 to 18 and Tables 1 to 9 are shown in the following Tables 10 and 11. The following Table 10 shows the measured values of ¹H NMR(CDCl₃, 300 MHz), and the following Table 11 shows the measured values of field desorption mass spectrometry (FD-MS).

**[Table 10]**

| Compound | ¹H NMR(CDCl₃, 300MHz) |
|---|---|
| 1 | δ = 8.81~8.79 (d, 4H), 8.65~8.63 (d, 1H), 8.61 (s, 1H), 8.54~8.52 (d, 1H), 8.06~8.03 (m, 2H), 7.98~7.96 (d, 1H), 7.75~7.73 (d, 1H), 7.70~7.67 (t, 1H), 7.61~7.52 (m, 4H), 7.46~7.40 (m, 3H), 7.38~7.34 (m, 2H), 7.24~7.22 (d, 2H) |
| 13 | δ = 9.31 (s, 1H), 9.20~9.18 (d, 1H), 8.78-8.76 (d, 1H), 8.62~8.54 (m, 4H), 8.10~8.08 (d, 1H), 8.03~7.93 (m, 6H), 7.75~7.50 (m, 8H), 7.05-7.01 (m, 3H), 6.86-6.83 (t, 2H) |
| 22 | δ = 9.29 (s, 1H), 9.19~9.17 (d, 1H), 8.77~8.75 (d, 1H), 8.64 (s, 2H), 8.60~8.52 (m, 4H), 8.09~8.07 (d, 1H), 8.02~7.94 (m, 6H), 7.74~7.52 (m, 7H), 7.36~7.32 (m, 2H), 7.24~7.22 (t, 2H) |
| 37 | δ = 8.83~8.81 (d, 4H), 8.65~8.63 (d, 1H), 8.63 (s, 1H), 8.59 (s, 1H), 8.49~8.47 (d, 1H), 8.04~8.00(t, 1H), 7.86~7.74 (m, 9H), 7.56~7.52 (m, 4H), 7.48~7.45 (m, 2H), 7.39~7.37 (d, 2H), 7.21~7.18 (m, 3H) |
| 39 | δ = 9.22 (s, 1H), 8.97-8.95 (d, 1H), 8.94~8.89 (d, 1H), 8.88~8.86 (d, 1H), 8.62~8.60 (d, 1H), 8.20 (s, 1H), 8.19~8.17 (d, 1H), 8.03~7.97 (m, 6H), 7.93~7.91 (d, 1H), 7.90~7.88 (d, 1H), 7.75~7.71 (t, 1H), 7.66~7.50 (m, 13H) |
| 53 | δ = 8.82~8.80 (d, 4H), 8.64~8.62 (d, 1H), 8.62 (s, 1H), 8.51~8.49 (d, 1H), 8.03~7.99 (t, 1H), 7.84~7.72 (m, 10H), 7.58~7.51 (m, 5H), 7.46~7.44 (m, 2H), 7.38~7.37 (d, 2H), 7.16~7.11 (m, 4H) |
| 57 | δ = 8.80~8.78 (d, 4H), 8.64~8.62 (d, 1H), 8.60 (s, 1H), 8.52~8.50 (d, 1H), 8.04~8.02 (m, 2H), 7.99~7.97 (d, 1H), 7.76~7.74 (d, 1H), 7.69~7.65 (t, 1H), 7.62~7.51 (m, 6H), 7.47~7.41 (m, 5H), 7.39~7.35 (m, 3H), 7.25~7.23 (d, 3H) |
| 58 | δ = 9.28 (s, 1H), 9.18~9.16 (d, 1H), 8.78~8.76 (d, 1H), 8.62~8.54 (m, 4H), 8.10~8.08 (d, 1H), 8.03~7.95 (m, 8H), 7.72~7.54 (m, 9H), 7.37~7.30 (m, 3H), 7.23~7.18 (t, 3H) |
| 115 | δ = 9.25 (s, 1H), 8.97~8.95 (d, 1H), 8.94~8.92 (d, 2H), 8.87~8.85 (d, 1H), 8.62~8.60 (d, 1H), 8.23~8.21 (d, 1H), 8.17~8.15 (d, 1H), 8.06~8.04 (d, 1H), 8.02~8.00 (m, 2H), 7.87~8.75 (d, 1H), 7.73~7.70 (t, 1H), 7.66~7.44 (m, 11H), 7.46~7.41 (t, 1H) |
| 133 | δ = 8.81~8.79 (d, 2H), 8.74~8.72 (d, 1H), 8.61 (s, 1H), 8.49~8.47 (d, 1H), 8.01~7.97 (t, 1H), 7.82~7.70 (m, 9H), 7.59~7.50 (m, 4H), 7.47~7.44 (m, 2H), 7.39~7.37 (d, 2H), 7.15~7.10 (m, 4H) |
| 134 | δ = 8.79~8.77 (d, 2H), 8.72~8.70 (d, 1H), 8.58 (s, 1H), 8.47~8.45 (d, 1H), 8.12~7.98 (t, 1H), 7.84~7.75 (m, 9H), 7.62~7.55 (m, 4H), 7.50~7.46 (m, 2H), 7.42~7.38 (d, 2H), 7.25~7.20 (m, 4H) |
| 209 | δ = 9.31 (s, 1H), 8.80~8.78 (d, 3H), 8.65~8.63 (d, 1H), 8.62 (s, 1H), 8.53~8.51 (d, 1H), 8.10~8.08 (d, 1H), 8.05~8.01 (m, 2H), 7.97~7.95 (d, 1H), 7.91~7.88 (d, 1H), 7.76~7.74 (d, 1H), 7.71~7.69 (t, 1H), 7.60~7.50 (m, 6H), 7.45~7.42 (m, 4H), 7.37~7.33 (m, 3H), 7.20~7.18 (d, 2H) |
| 226 | δ = 9.30 (s, 1H), 9.19~9.17 (d, 1H), 8.76~8.74 (d, 1H), 8.64 (s, 1H), 8.61~8.55 (m, 4H), 8.23~8.22 (d, 1H), 8.13~8.01 (m, 8H), 7.75~7.56 (m, 8H), 7.35~7.29 (m, 3H), 7.24~7.19 (t, 3H) |
| 237 | δ = 8.80~8.78 (d, 2H), 8.75~8.72 (m, 3H), 8.65~8.63 (d, 1H), 8.49~8.47 (d, 1H), 8.05~8.01 (m, 2H), 7.99~7.96 (d, 1H), 7.93~7.90 (m, 3H), 7.83 (s, 1H), 7.73~7.65 (m, 7H), 7.58~7.43 (m, 8H), 7.30~7.27 (m, 2H) |
| 249 | δ = 8.76~8.74 (d, 4H), 8.67 (s, 1H), 8.65~8.63 (d, 1H), 8.51~8.49 (d, 1H), 8.16~8.13 (d, 1H), 8.03~7.90 (m, 3H), 7.75~7.70 (m, 4H), 7.62~7.59 (t, 1H), 7.57~7.44 (m, 13H) |
| 250 | δ = 9.20 (s, 1H), 8.92~8.90 (d, 1H), 8.86~8.84 (d, 4H), 8.64~8.62 (d, 1H), 8.21~8.17 (m, 2H), 8.13~8.11 (m, 2H), 8.79~7.96 (d, 1H), 7.94~7.92 (d, 1H), 7.77~7.55 (m, 16H) |
| 253 | δ = 8.78~8.76 (d, 4H), 8.69 (s, 1H), 8.66~8.64 (d, 1H), 8.49~8.47 (d, 1H), 8.18~8.16 (d, 1H), 8.01~7.99 (d, 1H), 7.96~7.94 (d, 1H), 7.92~90 (d, 1H), 7.88~7.85 (d, 2H), 7.75~7.66 (m, 2H), 7.64~7.43 (m, 12H), 7.38~7.36 (d, 2H) |
| 325 | δ = 9.34 (s, 1H), 9.23~9.21 (d, 1H), 8.81~8.79 (d, 1H), 8.65~8.57 (m, 4H), 8.13~8.11 (d, 1H), 8.05~7.91 (m, 7H), 7.76~7.52 (m, 8H), 7.12~7.05 (m, 4H), 6.89~6.85 (t, 2H) |
| 327 | δ = 9.21 (s, 1H), 8.83~8.81 (d, 4H), 8.60~8.58 (d, 2H), 8.17~8.15 (d, 2H), 8.03~8.01 (m, 2H), 7.93 (s, 1H), 7.67~7.45 (m, 17H) |
| 329 | δ = 9.34 (s, 1H), 9.21~9.19 (d, 1H), 8.79~8.77 (d, 1H), 8.66 (s, 1H), 8.63~8.55 (m, 4H), 8.11~8.09 (d, 1H), 8.04~7.92 (m, 8H), 7.74~7.49 (m, 8H), 7.08~7.01 (m, 4H), 6.87~6.84 (t, 2H) |
| 511 | δ = 9.41 (s, 1H), 9.38~9.36 (d, 1H), 9.17 (s, 1H), 8.94~8.92 (d, 2H), 8.66~8.64 (d, 1H), 8.26~8.24 (d, 1H), 8.17~8.15 (d, 2H), 8.11~8.09 (d, 2H), 8.03 (s, 1H), 7.99~7.97 (d, 2H), 7.82~7.74 (m, 4H), 7.64~7.58 (m, 4H), 7.56~7.52 (m, 2H), 7.46~7.42 (t, 1H) |
| 521 | δ = 9.46~9.44 (d, 1H), 9.33 (s, 2H), 8.94 (s, 1H), 8.82~8.80 (d, 2H), 8.66~8.64 (d, 1H), 8.16~8.14 (d, 2H), 8.10~8.08 (d, 2H), 8.00~7.98 (d, 2H), 7.85~7.80 (m, 5H), 7.69~7.59 (m, 7H), 7.48~7.46 (t, 1H), 7.44~7.42 (d, 1H) |
| 523 | δ = 9.42 (s, 2H), 9.39~9.36 (d, 1H), 9.18 (s, 1H), 8.93~8.90 (d, 2H), 8.65~8.63 (d, 1H), 8.24~8.22 (d, 1H), 8.16~8.14 (d, 2H), 8.09~8.07 (d, 2H), 8.01 (s, 1H), 7.98~7.96 (d, 2H), 7.81~7.72 (m, 5H), 7.65~7.59 (m, 4H), 7.55~7.51 (m, 2H), 7.44~7.41 (t, 1H) |
| 524 | δ = 9.41~9.36 (m, 3H), 9.20 (s, 1H), 8.91~8.89 (d, 2H), 8.61~8.60 (d, 1H), 8.17~8.13 (m, 3H), 8.09~8.06 (m, 4H), 7.97~7.95 (d, 2H), 7.77~7.70 (m, 3H), 7.66~7.50 (m, 8H) |
| 551 | δ = 9.43 (s, 1H), 9.39~9.37 (d, 1H), 9.21 (s, 1H), 9.15 (s, 1H), 8.93~8.91 (d, 2H), 8.69~8.67 (d, 1H), 8.31~8.29 (d, 1H), 8.21~8.19 (d, 2H), 8.15~8.11 (d, 2H), 8.04 (s, 1H), 7.98~7.94 (d, 3H), 7.83~7.74 (m, 5H), 7.65~7.56 (m, 5H), 7.54~7.51 (m, 2H), 7.45~7.41 (t, 1H) |
| 597 | δ = 9.42~9.40 (d, 1H), 9.32 (s, 1H), 8.92 (s, 1H), 8.84~8.82 (d, 2H), 8.65~8.63 (d, 1H), 8.15~8.11 (m, 3H), 8.09~8.07 (d, 2H), 8.02~7.99 (d, 2H), 7.87~7.82 (m, 6H), 7.71~7.60 (m, 8H), 7.49~7.45 (t, 1H), 7.43~7.41 (d, 1H) |
| 598 | δ = 9.41~9.39 (d, 1H), 9.31 (s, 1H), 8.91 (s, 1H), 8.82~8.80 (d, 2H), 8.63~8.61 (d, 1H), 8.17~8.12 (m, 3H), 8.08~8.06 (d, 2H), 7.93~7.91 (d, 2H), 7.82~7.70 (m, 6H), 7.65~7.51 (m, 8H), 7.43~7.41 (t, 1H), 7.23~7.21 (d, 1H) |
| 633 | δ = 9.38~9.36 (d, 2H), 9.28 (s, 1H), 8.84~8.82 (d, 1H), 8.64 (s, 1H), 8.58~8.56 (d, 1H), 8.15~8.11 (t, 1H), 7.92~7.80 (m, 8H), 7.65~7.58 (m, 4H), 7.48~7.44 (m, 2H), 7.38~7.36 (d, 2H), 7.18~7.11 (m, 4H) |
| 635 | δ = 9.39~9.37 (d, 2H), 9.29 (s, 1H), 8.83~8.81 (d, 1H), 8.62 (s, 1H), 8.59~8.57 (d, 1H), 8.24~8.20 (t, 1H), 7.98~7.82 (m, 8H), 7.67~7.59 (m, 4H), 7.51~7.47 (m, 2H), 7.42~7.40 (d, 2H), 7.35~7.28 (m, 4H) |
| 703 | δ = 9.35~9.33 (d, 1H), 9.15 (s, 1H), 8.86~8.84 (d, 4H), 8.64~8.62 (d, 1H), 8.23~8.21 (d, 1H), 8.15 (s, 1H), 8.07 (s, 1H), 7.98~7.84 (m, 8H), 7.80~7.69 (m, 3H), 7.69~7.61 (m, 6H), 7.56~7.49 (m, 2H) |
| 708 | δ = 9.39~9.35 (m, 2H), 9.21~9.19 (d, 1H), 8.88~8.86 (d, 3H), 8.60~8.58 (d, 1H), 8.55 (s, 1H), 8.19~8.17 (m, 2H), 8.13~8.05 (m, 4H), 7.97~7.95 (m, 2H), 7.83~7.81 (d, 1H), 7.75~7.73 (m, 2H), 7.66~7.59 (m, 8H) |
| 711 | δ = 9.40 (s, 1H), 9.37~9.35 (d, 1H), 9.17 (s, 1H), 8.90~8.88 (d, 3H), 8.66~8.64 (d, 1H), 8.27~8.25 (d, 1H), 8.21 (s, 1H), 8.13~8.11 (m, 2H), 8.08~8.06 (d, 2H), 8.07~7.96 (m, 3H), 7.90~7.87 (m, 2H), 7.85~7.83 (d, 1H), 7.79~7.77 (m, 2H), 7.67~7.53 (m, 6H) |
| 724 | δ = 9.37~9.35 (d, 1H), 9.20 (s, 1H), 8.87~8.85 (d, 3H), 8.81~8.79 (d, 1H), 8.65~8.63 (d, 1H), 8.25~8.23 (m, 3H), 8.19~8.17 (d, 1H), 8.05~7.99 (m, 3H), 7.94~7.92 (m, 2H), 7.81~7.75 (m, 3H), 7.68~7.54 (m, 8H) |
| 749 | δ = 9.44~9.42 (d, 1H), 9.31 (s, 1H), 8.93 (s, 1H), 8.86~8.84 (d, 2H), 8.63~8.61 (d, 1H), 8.17~8.13 (m, 3H), 8.08~8.06 (d, 2H), 8.03~7.98 (d, 2H), 7.88~7.77 (m, 6H), 7.73~7.62 (m, 8H), 7.51~7.47 (t, 1H), 7.44~7.42 (d, 1H) |
| 755 | Not measurable due to poor solubility |
| 756 | δ = 9.36~9.33 (d, 1H), 9.19 (s, 1H), 8.86~8.84 (d, 4H), 8.66~8.64 (d, 1H), 8.23~8.21 (m, 3H), 8.18~8.16 (d, 1H), 8.12~7.99 (m, 4H), 7.92~7.90 (m, 2H), 7.79~7.77 (m, 3H), 7.69~7.53 (m, 9H) |
| 827 | δ = 9.38~9.36 (d, 1H), 9.18 (s, 1H), 8.91~8.89 (d, 4H), 8.64~8.62 (d, 1H), 8.25~8.23 (d, 1H), 8.19 (s, 1H), 8.14~8.12 (m, 2H), 8.09~8.07 (d, 2H), 8.05~7.99 (m, 3H), 7.91~7.86 (m, 2H), 7.82~7.80 (d, 2H), 7.77~7.74 (m, 3H), 7.68~7.56 (m, 6H) |
| 863 | δ = 9.37~9.35 (d, 1H), 9.20 (s, 1H), 8.92~8.90 (d, 4H), 8.66 (s, 1H), 8.65~8.63 (d, 1H), 8.27~8.25 (d, 1H), 8.21 (s, 1H), 8.16~8.14 (m, 2H), 8.10~8.08 (d, 2H), 8.04~7.98 (m, 3H), 7.92~7.89 (m, 2H), 7.86~7.81 (d, 2H), 7.78~7.75 (m, 2H), 7.66~7.54 (m, 6H) |
| 919 | δ = 9.21~9.19 (d, 1H), 8.52~8.50 (d, 1H), 8.48~8.46 (d, 1H), 8.42~8.40 (d, 1H), 8.22~8.20 (d, 1H), 8.18~8.16 (d, 1H), 8.10~8.08 (d, 1H), 8.03~8.01 (d, 1H), 7.92~7.86 (m, 9H), 7.80~7.75 (m, 9H) |
| 1002 | δ = 8.80~8.78 (d, 4H), 8.51~8.49 (d, 1H), 8.44~8.42 (d, 1H), 7.77~7.75 (d, 1H), 7.64~7.55 (m, 13H), 7.47~7.40 (m, 4H), 7.36~7.34 (d, 1H), 7.32~7.27 (m, 5H) |
| 1005 | δ = 8.81~8.79 (d, 4H), 8.50~8.48 (d, 1H), 8.42~8.40 (d, 1H), 7.75~7.73 (d, 1H), 7.65~7.53 (m, 15H), 7.46~7.42 (m, 4H), 7.37~7.35 (d, 1H), 7.33~7.26 (m, 7H) |
| 1011 | δ = 8.81~8.79 (d, 4H), 8.49~8.46 (d, 1H), 8.41~8.39 (d, 1H), 7.74~7.72 (d, 1H), 7.67~7.55 (m, 15H), 7.48~7.44 (t, 2H), 7.37~7.30 (m, 4H), 7.26~7.24(m, 4H), 7.12~7.08 (t, 1H), 7.03~7.00 (d, 1H) |
| 1015 | δ = 8.77~8.75 (d, 4H), 8.48~8.46 (s, 2H), 8.40~8.38 (d, 1H), 7.86~7.84 (d, 4H), 7.63~7.61 (m, 6H), 7.48~7.42 (m, 6H), 7.35~7.33 (d, 2H), 7.30~7.15 (m, 8H), 7.13~7.09 (t, 1H) |
| 1021 | δ = 8.79~8.77 (d, 4H), 8.37~8.35 (d, 1H), 8.38~8.25 (d, 1H), 7.69~7.51 (m, 14H), 7.47~7.33 (m, 9H), 7.22~7.20 (m, 2H), 7.13~7.04 (m, 6H), 6.80~6.78 (d, 1H) |
| 1050 | δ = 8.81~8.79 (d, 4H), 8.65 (s, 1H), 8.49~8.47 (d, 1H), 8.42~8.40 (d, 1H), 7.79~7.77 (d, 1H), 7.66~7.48 (m, 11H), 7.45~7.39 (m, 4H), 7.37~7.35 (d, 1H), 7.33~7.26 (m, 4H) |
| 1054 | δ = 8.93~8.91 (d, 1H), 8.86~8.84 (d, 4H), 8.64 (s, 1H), 8.55~8.53 (d, 1H), 8.30~8.28 (d, 1H), 8.09~8.07 (d, 1H), 7.97 (s, 1H), 7.91~7.85 (m, 3H), 7.76~7.72 (t, 1H), 7.66~7.54 (m, 8H), 7.52~7.41 (m, 3H), 7.37~7.33 (t, 1H) |
| 1056 | δ = 8.90~8.88 (d, 1H), 8.83~8.81 (d, 4H), 8.56~8.54 (d, 1H), 8.26~8.24 (d, 1H), 8.23~8.21 (d, 1H), 8.01~7.99 (d, 1H), 7.93~7.91 (d, 1H), 7.91 (s, 1H), 7.79~7.74 (t, 2H), 7.63~7.54 (m, 6H), 7.52~7.50 (d, 1H), 7.45~7.33 (m, 5H), 7.22~7.18 (t, 1H) |
| 1057 | δ = 9.28~9.26 (d, 2H), 8.95~8.93 (d, 1H), 8.85~8.83 (d, 4H), 8.56~8.54 (d, 1H), 8.07~8.05 (d, 1H), 7.93~7.87 (m, 4H), 7.78~7.69 (m, 5H), 7.64~7.50 (m, 9H), 7.49~7.47 (d, 1H) |
| 1064 | δ = 8.91~8.89 (d, 1H), 8.85~8.83 (d, 4H), 8.54~8.52 (d, 1H), 8.47 (s, 2H), 8.27~8.24 (m, 2H), 7.93 (s, 1H), 7.90~7.88 (d, 1H), 7.82~7.78 (m, 2H), 7.75~7.71 (t, 1H), 7.64~7.54 (m, 12H), 7.53~7.43 (m, 6H), 7.37~7.30 (m, 2H) |
| 1065 | δ = 8.85 (s, 1H), 8.82~8.80 (d, 5H), 8.51~8.49 (d, 1H), 8.28~8.25 (d, 2H), 7.87 (s, 1H), 7.87~7.85 (d, 1H), 7.72~7.68 (t, 1H), 7.63~7.51 (m, 10H), 7.48~7.25 (m, 9H) |
| 1073 | δ = 8.96~8.94 (d, 1H), 8.87~8.85 (d, 4H), 8.58~8.56 (d, 1H), 8.29~8.24 (m, 3H), 8.16~8.14 (d, 1H), 7.94~7.92 (d, 1H), 7.92 (s, 1H), 7.80~7.76 (t, 1H), 7.70~7.68 (d, 1H), 7.61~7.55 (m, 6H), 7.49~7.45 (m, 4H), 7.39~7.36 (t, 2H) |
| 1097 | δ = 8.81~8.79 (d, 4H), 8.44~8.41 (m, 2H), 8.12~8.10 (d, 1H), 8.09~8.07 (d, 1H), 7.73~7.71 (d, 1H), 7.65~7.49 (m, 13H), 7.36~7.30 (m, 3H), 7.28~7.23 (m, 3H), 7.20~7.18 (d, 2H), 7.15~7.13 (d, 1H), 7.07~7.03 (t, 1H), 6.99~6.97 (d, 1H) |
| 1100 | δ = 8.79~8.77 (d, 4H), 8.42~8.37 (m, 2H), 8.09~8.07 (d, 1H), 8.06~8.04 (d, 1H), 7.71~7.69 (d, 1H), 7.63~7.47 (m, 13H), 7.37~7.34 (m, 3H), 7.30~7.25 (m, 3H), 7.21~7.19 (d, 2H), 7.13~7.11 (d, 1H), 7.05~7.02 (t, 1H), 6.98~6.96 (d, 1H) |
| 1123 | δ = 8.79~8.77 (d, 4H), 8.46~8.44 (d, 1H), 8.41~8.39 (d, 1H), 7.83~7.81 (m, 4H), 7.51~7.49 (d, 1H), 7.48~7.42 (m, 11H), 7.36~7.34 (m, 2H), 7.29~7.27 (d, 2H), 7.25~7.23 (m, 2H), 7.22 (s, 1H), 7.00~6.98 (d, 1H) |
| 1124 | δ = 8.80~8.78 (d, 4H), 8.45~8.43 (d, 1H), 8.39~8.37 (d, 1H), 7.82~7.80 (m, 4H), 7.53~7.51 (d, 1H), 7.49~7.43 (m, 11H), 7.38~7.35 (m, 2H), 7.30~7.28 (d, 2H), 7.26~7.24 (m, 2H), 7.22~7.20 (d, 1H), 6.99~6.97 (d, 1H) |
| 1142 | δ = 8.81~8.79 (d, 4H), 8.45~8.43 (d, 1H), 8.41~8.39 (d, 1H), 7.83 (s, 1H), 7.81~7.76 (m, 3H), 7.73~7.71 (d, 1H), 7.62~7.51 (m, 11H), 7.48~7.33 (m, 5H), 7.30~7.25 (m, 2H), 7.05~7.03 (d, 1H) |
| 1146 | δ = 8.80~8.78 (d, 4H), 8.51~8.49 (d, 1H), 8.43~8.41 (d, 1H), 8.03 (s, 1H), 7.97~7.95 (d, 1H), 7.86~7.84 (d, 1H), 7.81~7.74 (m, 3H), 7.72~7.70 (d, 1H), 7.63~7.53 (m, 9H), 7.46~7.26 (m, 7H), 7.09~7.06 (d, 1H) |
| 1157 | δ = 8.81~8.79 (d, 4H), 8.51~8.49 (d, 1H), 8.42~8.40 (d, 1H), 8.00~7.98 (d, 1H), 7.93~7.91 (d, 1H), 7.88~7.86 (d, 2H), 7.75~7.73 (d, 1H), 7.64~7.56 (m, 9H), 7.49~7.40 (m, 2H), 7.38~7.28 (m, 8H), 7.14~7.10 (t, 1H), 7.07~7.05 (d, 1H) |
| 1158 | δ = 8.82~8.80 (d, 4H), 8.49~8.47 (d, 1H), 8.42~8.40 (d, 1H), 8.14 (s, 1H), 8.01~7.99 (d, 1H), 7.75~7.73 (d, 1H), 7.69~7.57 (m, 10H), 7.50~7.46 (t, 1H), 7.39~7.26 (m, 10H), 7.13~7.09 (t, 1H), 7.04~7.02 (d, 1H) |
| 1174 | δ = 8.80~8.78 (d, 4H), 8.49~8.46 (d, 1H), 8.41~8.39 (d, 1H), 7.85~7.83 (m, 2H), 7.73~7.71 (d, 1H), 7.61~7.52 (m, 13H), 7.48~7.42 (m, 3H), 7.39~7.26 (m, 6H), 7.04~7.02 (d, 1H) |
| 1175 | δ = 8.81~8.79 (d, 4H), 8.52~8.50 (d, 1H), 8.43~8.41 (d, 1H), 7.90~7.88 (d, 1H), 7.85~7.83 (d, 1H), 7.75~7.73 (d, 1H), 7.62~7.51 (m, 11H), 7.46~7.41 (m, 4H), 7.39~7.29 (m, 6H), 7.24~7.22 (d, 1H), 7.08~7.06 (d, 1H) |
| 1176 | δ = 9.40 (s, 1H), 8.94~8.92 (d, 1H), 8.85~8.83 (d, 4H), 8.28~8.26 (d, 1H), 8.22~8.18 (m, 3H), 7.88 (s, 1H), 7.68~7.60 (m, 9H), 7.56~7.54 (d, 2H), 7.48~7.44 (m, 5H), 7.37~7.32 (m, 4H), 7.23~7.21 (d, 1H) |
| 1186 | δ = 8.79~8.77 (d, 4H), 8.47~8.44 (d, 1H), 8.41~8.39 (d, 1H), 7.86~7.83 (m, 2H), 7.72~7.70 (d, 1H), 7.60~7.44 (m, 13H), 7.41~7.28 (m, 8H), 7.18~7.16 (d, 1H), 7.06~7.03 (d, 1H) |
| 1187 | δ = 8.80~8.78 (d, 4H), 8.50~8.47 (d, 1H), 8.42~8.40 (d, 1H), 7.90~7.88 (d, 1H), 7.85~7.83 (d, 1H), 7.74~7.72 (d, 1H), 7.60~7.52 (m, 10H), 7.48 (s, 1H), 7.42~7.79 (m, 9H), 7.26~7.24 (d, 1H), 7.21~7.19 (d, 1H), 7.08~7.06 (d, 1H) |
| 1203 | δ = 8.82~8.80 (d, 4H), 8.51~8.49 (d, 1H), 8.43~8.41 (d, 1H), 7.78~7.76 (d, 1H), 7.62~7.57 (m, 13H), 7.48~7.39 (m, 6H), 7.36~7.34 (d, 2H), 7.31~7.25 (m, 6H) |
| 1257 | δ = 8.91~8.89 (d, 1H), 8.85~8.83 (d, 4H), 8.53~8.51 (d, 1H), 8.32~8.30 (d, 1H), 8.11~8.09 (d, 1H), 7.98 (s, 1H), 7.92~7.85 (m, 4H), 7.77~7.73 (t, 1H), 7.68~7.52 (m, 9H), 7.50~7.42 (m, 4H), 7.38~7.34 (t, 1H) |
| 1258 | δ = 8.90~8.88 (d, 1H), 8.84~8.82 (d, 4H), 8.54~8.53 (d, 1H), 8.31~8.29 (d, 1H), 8.10~8.08 (d, 1H), 7.97 (s, 1H), 7.91~7.82 (m, 5H), 7.79~7.75 (t, 1H), 7.69~7.53 (m, 9H), 7.51~7.43 (m, 5H), 7.40~7.36 (t, 1H) |
| 1278 | δ = 9.35 (s, 1H), 8.86~8.84 (m, 3H), 8.59~8.57 (d, 1H), 8.48~8.46 (d, 1H), 8.02~8.00 (d, 2H), 7.92~7.90 (d, 1H), 7.80~7.75 (m, 3H), 7.66~7.53 (m, 11H), 7.48~7.40 (m, 7H), 7.35~7.28 (m, 3H), 7.08~7.06 (d, 1H) |
| 1279 | δ = 9.36 (s, 1H), 8.86~8.84 (m, 3H), 8.57~8.55 (d, 1H), 8.48~8.46 (d, 1H), 8.05~8.01 (m, 2H), 7.93~7.91 (d, 1H), 7.77~7.75 (d, 1H), 7.65~7.50 (m, 14H), 7.46~7.42 (m, 5H), 7.35~7.29 (m, 6H), 7.06~7.04 (d, 1H) |
| 1306 | δ = 9.34 (s, 1H), 8.84~8.82 (m, 3H), 8.53~8.51 (d, 1H), 8.46~8.44 (d, 1H), 8.00~7.98 (d, 2H), 7.89~7.87 (d, 1H), 7.84~7.82 (d, 1H), 7.81 (s, 1H), 7.74~7.72 (d, 1H), 7.60~7.51 (m, 7H), 7.47~7.43 (t, 2H), 7.36~7.28 (m, 5H), 7.23~7.21 (m, 2H), 7.08~7.04 (t, 1H), 6.99~6.96 (d, 1H) |
| 1307 | δ = 8.86~8.84 (d, 2H), 8.81~8.79 (d, 2H), 8.47~8.45 (d, 1H), 8.42~8.40 (d, 1H), 7.84~7.82 (d, 2H), 7.79~7.77 (d, 2H), 7.73~7.71 (d, 1H), 7.67~7.65 (d, 2H), 7.60~7.53 (m, 5H), 7.51~7.39 (m, 5H), 7.35~7.22 (m, 7H), 7.08~7.05 (t, 1H), 7.01~6.96 (d, 1H) |
| 1365 | δ = 9.40 (s, 1H), 8.86~8.84 (d, 1H), 8.75~8.73 (d, 1H), 8.65~8.63 (d, 1H), 8.57~8.54 (t, 2H), 8.04~8.02 (d, 1H), 8.00~7.98 (d, 1H), 7.96~7.94 (d, 1H), 7.87~7.85 (d, 1H), 7.79~7.77 (d, 1H), 7.68~7.65 (m, 2H), 7.62~7.49 (m, 8H), 7.45~7.42 (t, 2H), 7.35~7.29 (m, 4H), 7.22~7.20 (d, 4H), 7.16~7.12 (t, 1H), 7.11~7.07 (t, 1H), 6.93~6.90 (d, 1H) |
| 1403 | δ = 8.83~8.81 (d, 4H), 8.63~8.60 (d, 1H), 8.44~8.42 (d, 1H), 7.84~7.82 (d, 1H), 7.79~7.77 (d, 1H), 7.69~7.58 (m, 9H), 7.53~7.49 (m, 3H), 7.45~7.40 (m, 3H), 7.38~7.36 (m, 2H), 7.34~7.29 (m, 3H), 7.25~7.23 (d, 4H), 7.21~7.17 (t, 1H), 7.15~7.11 (t, 1H) |
| 1404 | δ = 8.82~8.80 (d, 4H), 8.61~8.59 (d, 1H), 8.42~8.40 (d, 1H), 7.82~7.80 (d, 1H), 7.77 (s, 1H), 7.67~7.56 (m, 9H), 7.52~7.48 (m, 3H), 7.44~7.39 (m, 3H), 7.37~7.36 (m, 2H), 7.33~7.29 (m, 3H), 7.23~7.21 (d, 4H), 7.15~7.13 (t, 1H), 7.09~7.05 (t, 1H) |
| 1405 | δ = 9.01 (s, 1H), 8.80~8.78 (d, 2H), 8.75~8.73 (d, 1H), 8.70~8.68 (d, 1H), 8.49~8.47 (d, 1H), 8.15~8.13 (d, 2H), 7.92 (s, 1H), 7.84~7.80 (m, 4H), 7.78~7.76 (d, 1H), 7.74~7.56 (m, 9H), 7.52~7.43 (m, 10H), 7.35~7.31 (t, 1H) |
| 1413 | δ = 8.85~8.83 (d, 4H), 8.64~8.62 (d, 1H), 8.45~8.43 (d, 1H), 7.83~7.81 (d, 1H), 7.78~7.76 (d, 1H), 7.70~7.54 (m, 9H), 7.52~7.44 (m, 4H), 7.41~7.35 (m, 3H), 7.33~7.30 (m, 3H), 7.28~7.22 (m, 4H), 7.20~7.12 (d, 5H), 7.10~7.08 (t, 2H) |
| 1417 | δ = 8.84~8.82 (d, 4H), 8.61~8.59 (d, 1H), 8.44~8.42 (d, 1H), 7.82~7.80 (d, 1H), 7.77~7.74 (d, 1H), 7.68~7.53 (m, 8H), 7.51~7.46 (m, 4H), 7.44~7.40 (m, 3H), 7.38~7.35 (m, 2H), 7.33~7.30 (m, 2H), 7.27~7.23 (d, 3H), 7.21~7.17 (t, 1H) |
| 1437 | δ = 8.86~8.84 (d, 4H), 8.62~8.60 (d, 1H), 8.45~8.43 (d, 1H), 7.84~7.82 (d, 1H), 7.76~7.74 (d, 1H), 7.69~7.54 (m, 8H), 7.49~7.47 (m, 4H), 7.43~7.39 (m, 3H), 7.37~7.34 (m, 2H), 7.32~7.29 (m, 3H), 7.26~7.22 (m, 4H), 7.20~7.16 (t, 1H) |
| 1439 | δ = 8.84~8.82 (d, 4H), 8.63~8.61 (d, 1H), 8.43~8.41 (d, 1H), 7.83~7.81 (d, 1H), 7.78~7.76 (d, 1H), 7.67~7.52 (m, 8H), 7.50~7.47 (m, 5H), 7.44~7.39 (m, 4H), 7.37~7.34 (m, 2H), 7.31~7.28 (m, 2H), 7.26~7.22 (d, 3H), 7.19~7.15 (t, 1H) |
| 1444 | δ = 8.83~8.80 (d, 4H), 8.55~8.53 (d, 1H), 8.39~8.37 (d, 1H), 7.84 (s, 1H), 7.83~7.81 (d, 1H), 7.66~7.58 (m, 5H), 7.53~7.51 (d, 2H), 7.48~7.41 (m, 3H), 7.34~7.20 (m, 13H), 7.10~7.07 (t, 1H) |
| 1453 | δ = 8.85~8.84 (d, 2H), 8.75~8.73 (d, 1H), 8.72~8.70 (d, 1H), 8.55~8.53 (d, 1H), 8.52~8.50 (d, 1H), 7.87~7.83 (m, 3H), 7.69~7.56 (m, 9H), 7.52~7.48 (t, 1H), 7.42~7.40 (d, 1H), 7.31~7.29 (m, 3H), 7.18~7.15 (m, 7H), 7.07~7.03 (t, 2H) |
| 1488 | δ = 8.86~8.84 (d, 2H), 8.82~8.80 (d, 2H), 8.69~8.67 (d, 1H), 8.43~8.41 (d, 1H), 8.17~8.15 (d, 2H), 7.91~7.89 (d, 2H), 7.82~7.78 (m, 4H), 7.70~7.58 (m, 8H), 7.56~7.46 (m, 5H), 7.44~7.38 (m, 3H), 7.31~7.28 (t, 2H) |
| 1489 | δ = 9.05 (s, 1H), 8.84~8.82 (d, 2H), 8.81~8.79 (d, 1H), 8.74~8.72 (d, 1H), 8.48~8.46 (d, 1H), 8.19~8.17 (d, 2H), 7.91 (s, 1H), 7.86~7.82 (m, 3H), 7.78~7.76 (d, 1H), 7.72~7.58 (m, 9H), 7.50~7.30 (m, 9H), 7.25~7.23 (t, 1H) |
| 1505 | δ = 8.79~8.77 (d, 2H), 8.48~8.46 (d, 1H), 8.40~8.38 (d, 1H), 8.25~8.23 (d, 1H), 7.80~7.75 (m, 2H), 7.68~7.48 (m, 8H), 7.46~7.42 (t, 2H), 7.37~7.20 (m, 10H), 7.09~7.00 (m, 2H) |
| 1506 | δ = 8.67~8.65 (d, 2H), 8.42~8.40 (d, 1H), 8.35~8.33 (d, 1H), 8.21~8.19 (d, 1H), 7.71~7.68 (m, 2H), 7.63~7.47 (m, 8H), 7.43~7.39 (t, 2H), 7.36~7.18 (m, 10H), 7.05~7.02 (m, 2H) |
| 1559 | δ = 8.58~5.56 (d, 1H), 8.34~8.32 (d, 1H), 8.25~8.23 (d, 1H), 8.21~8.19 (d, 1H), 7.96~7.91 (m, 3H), 7.85~7.83 (d, 1H), 7.83 (s, 1H), 7.65~7.51 (m, 12H), 7.48~7.43 (m, 3H), 7.41~7.29 (m, 4H), 7.26~7.24 (d, 2H), 7.09~7.07 (d, 1H) |
| 1570 | δ = 9.03~8.99 (t, 1H), 8.79~8.75 (t, 1H), 8.65~8.63 (d, 1H), 8.53~8.44 (m, 3H), 8.32~8.38 (t, 1H), 8.11~8.07 (t, 1H), 8.04~7.99 (t, 1H), 7.97~7.95 (d, 1H), 7.88~7.82 (m, 2H), 7.77~7.60 (m, 6H), 7.53~7.40 (m, 5H), 7.38~7.32 (t, 1H), 7.26~7.24 (d, 1H) |
| 1579 | δ = 8.79~8.77 (d, 1H), 8.65 (s, 1H), 8.60 (s, 1H), 8.84~8.82 (d, 1H), 8.27~8.25 (d, 1H), 8.06~7.98 (m, 4H), 7.95~7.93 (d, 1H), 7.87 (s, 1H), 7.79~7.65 (m, 7H), 7.62~7.37 (m, 8H), 7.33~7.23 (m, 4H) |
| 1585 | δ = 8.80~8.78 (d, 2H), 8.48 (s, 1H), 8.43~8.41 (d, 1H), 7.92 (s, 1H), 7.84~7.77 (m, 2H), 7.72~7.70 (d, 2H), 7.64~7.60 (m, 5H), 7.59~7.55(t, 1H), 7.49~7.45 (m, 2H), 7.31~7.19 (m, 14H), 7.07~7.04 (t, 2H) |
| 1587 | δ = 8.56~8.54 (m, 2H), 8.30~8.28 (d, 1H), 8.26~8.24 (d, 1H), 8.03~7.99 (t, 1H), 7.96~7.93 (m, 3H), 7.72~7.67 (m, 3H), 7.62~7.59 (m, 6H), 7.53~7.48 (m, 2H), 7.45~7.42 (m, 3H), 7.34~7.30 (m, 3H), 7.26~7.21 (m, 7H), 7.10~7.06 (t, 1H) |
| 1595 | δ = 8.57~8.55 (m, 2H), 8.31~8.29 (d, 1H), 8.27~8.25 (d, 1H), 8.04~8.00 (t, 1H), 7.97~7.94 (m, 2H), 7.73~7.68 (m, 3H), 7.63~7.61 (m, 5H), 7.52~7.47 (m, 2H), 7.44~7.41 (m, 4H), 7.35~7.29 (m, 4H), 7.25~7.19 (m, 7H), 7.12~7.08 (t, 1H) |

**[Table 11]**

| Compoun d | FD-Mass | Compoun d | FD-Mass |
|---|---|---|---|
| 1 | m/z=525.2012 (C37H23N3O, 525.1841) | 1054 | m/z=614.2082 (C43H26N4O, 614.2107) |
| 13 | m/z=625.2178 (C45H27N3O, 625.2154) | 1056 | m/z=614.2074 (C43H26N4O, 614.2107) |
| 22 | m/z=625.2146(C45H27N3O, 625.2154) | 1057 | m/z=664.2318 (C47H28N4O, 664.2263) |
| 37 | m/z=651.2102(C47H29N3O, 651.2311) | 1064 | m/z=805.2941 (C57H35N5O, 805.2842) |
| 39 | m/z=651.2183(C47H29N3O, 651.2311) | 1065 | m/z=729.2518 (C51H31NSO, 729.2529) |
| 53 | m/z=701.2589(C51H31N3O, 701.2467) | 1073 | m/z=670.1769(C45H26N4OS, 670.1827) |
| 57 | m/z=677.2515(C49H31N3O, 677.2467) | 1097 | m/z=729.2615(C51H31N5O, 729.2529) |
| 58 | m/z=677.3152 (C49H31N3O, 677.2467) | 1100 | m/z=731.2721 (C51H33NSO, 731.2685) |
| 97 | m/z=651.2279(C47H29N3O, 651.2311) | 1123 | m/z=746.2348 (C51H30N4O3, 746.2318) |
| 115 | m/z=615.1824 (C43H25N3O2, 615.1947) | 1124 | m/z=746.2482 (C51H30N4O3, 746.2318) |
| 133 | m/z=655.2200(C47H27N3O2, 665.2103) | 1142 | m/z=706.2417(C49H30N4O2, 706.2369) |
| 134 | m/z=665.2021 (C47H27N3O2, 665.2103) | 1146 | m/z=722.2153(C49H30N4OS, 722.2140) |
| 209 | m/z=651.2284 (C47H29N3O, 651.2311) | 1157 | m/z=732.2671 (C51H32N4O2, 732.2525) |
| 226 | m/z=677.2551 (C49H31N3O, 677.2467) | 1158 | m/z=732.2715(C51H32N4O2, 732.2525) |
| 237 | m/z=701.2569(C51H31N3O, 701.2467) | 1174 | m/z=732.2618 (C51H32N4O2, 732.2525) |
| 249 | m/z=651.2137 (C47H29N3O, 651.2311) | 1175 | m/z=732.2639(C51H32N4O2, 732.2525) |
| 250 | m/z=651.2154 (C47H29N3O, 651.2311) | 1176 | m/z=732.1952 (C51H32N4O2, 732.2525) |
| 253 | m/z=651.2318 (C47H29N3O, 651.2311) | 1186 | m/z=732.2617 (C51H32N4O2, 732.2525) |
| 325 | m/z=651.2513(C47H29N3O, 651.2311) | 1187 | m/z=732.2492 (C51H32N4O2, 732.2525) |
| 327 | m/z=651.2317 (C47H29N3O, 651.2311) | 1203 | m/z=718.2489(C51H34N4O, 718.2733) |
| 329 | m/z=701.2514 (C51H31N3O, 701.2467) | 1257 | m/z=640.2671 (C45H28N4O, 640.2263) |
| 511 | m/z=575.1958 (C41H25N3O, 575.1998) | 1258 | m/z=690.2418 (C49H30N4O, 690.2420) |
| 521 | m/z=625.2155(C45H27N3O, 625.2154) | 1278 | m/z=742.2715(C53H34N4O, 742.2733) |
| 523 | m/z=625.2192 (C45H27N3O, 625.2154) | 1279 | m/z=768.2781 (C55H36N4O, 768.2889) |
| 524 | m/z=625.1986(C45H27N3O, 625.2154) | 1306 | m/z=706.2446(C49H30N4O2, 706.2369) |
| 551 | m/z=651.2417 (C47H29N3O, 651.2311) | 1307 | m/z=732.2413(C51H32N4O2, 732.2525) |
| 597 | m/z=651.2318 (C47H29N3O, 651.2311) | 1365 | m/z=782.2649(C55H34N4O2, 782.2682) |
| 598 | m/z=651.2183(C47H29N3O, 651.2311) | 1403 | m/z=718.2731 (C51H34N4O, 718.2733) |
| 633 | m/z=665.2095(C47H27N3O2, 665.2103) | 1404 | m/z=718.2492 (C51H34N4O, 718.2733) |
| 635 | m/z=665.2069(C47H27N3O2, 665.2103) | 1405 | m/z=718.2519(C51H34N4O, 718.2733) |
| 703 | m/z=651.2182 (C47H29N3O, 651.2311) | 1413 | m/z=794.3186(C57H38N4O, 794.3046) |
| 708 | m/z=625.2217 (C45H27N3O, 625.2154) | 1417 | m/z=692.1964 (C49H32N4O, 692.2576) |
| 711 | m/z=625.2133 (C45H27N3O, 625.2154) | 1437 | m/z=742.2485(C53H34N4O, 742.2733) |
| 724 | m/z=701.2518 (C51H31N3O, 701.2467) | 1439 | m/z=768.2945(C55H36N4O, 768.2889) |
| 749 | m/z=651.2178 (C47H29N3O, 651.2311) | 1444 | m/z=754.2468 (C51H32F2N4O, 754.2544) |
| 755 | m/z=675.2347 (C49H29N3O, 675.2311) | 1453 | m/z=732.2429(C51H32N4O2, 732.2525) |
| 756 | m/z=651.2129(C47H29N3O, 651.2311) | 1488 | m/z=716.2558 (C51H32N4O, 716.2576) |
| 827 | m/z=651.2354 (C47H29N3O, 651.2311) | 1489 | m/z=716.2514 (C51H32N4O, 716.2576) |
| 863 | m/z=651.2316(C47H29N3O, 651.2311) | 1505 | m/z=655.2182 (C46H29N3O2, 655.2260) |
| 919 | m/z=630.1842 (C44H26N2OS, 630.1766) | 1506 | m/z=671.1956(C46H29N3OS, 671.2031) |
| 1002 | m/z=642.2408(C45H30N4O, 642.2420) | 1559 | m/z=705.2408(C50H31N3O2, 705.2416) |
| 1005 | m/z=718.2185(C51H34N4O, 718.2733) | 1570 | m/z=643.1682 (C44H25N3OS, 643.1718) |
| 1011 | m/z=718.1583(C51H34N4O, 718.2733) | 1579 | m/z=702.2183(C50H30N4O, 702.2420) |
| 1015 | m/z=718.2463(C51H34N4O, 718.2733) | 1585 | m/z=731.2427 (C52H33N3O2, 731.2573) |
| 1021 | m/z=794.3152 (C57H38N4O, 794.3046) | 1587 | m/z=691.2716(C50H33N3O, 691.2624) |
| 1050 | m/z=616.2315(C43H28N4O, 616.2263) | 1595 | m/z=691.2820(C50H33N3O, 691.2624) |

### <Experimental Example 1>

### 1) Manufacture of organic light emitting device (red host, single)

A glass substrate, in which ITO was thinly coated to have a thickness of 1,500 Å, was ultrasonically washed with distilled water. When the washing with distilled water was finished, the glass substrate was ultrasonically washed with a solvent such as acetone, methanol, and isopropyl alcohol, dried and then was subjected to UVO treatment for 5 minutes using UV in a UV cleaning machine. Thereafter, the substrate was transferred to a plasma washing machine (PT), and then was subjected to plasma treatment in a vacuum state for an ITO surface treatment and in order to remove a residual film, and was transferred to a thermal deposition apparatus for organic deposition.

The hole injection layer 4,4',4"-tris[2-naphthyl (phenyl) amino] triphenylamine (2-TNATA) and the hole transport layer N,N'-diphenyl-(1,1'-biphenyl)-4,4'-diamine (NPB), which are common layers, were formed on the ITO transparent electrode (positive electrode).

A light emitting layer was thermally vacuum deposited thereon as follows. The light emitting layer was deposited to have a thickness of 400 Å by depositing the compounds described in the following Table 12 as a red host from a single supply source and doping the host with an Ir compound at 3 wt% using (piq)₂(Ir) (acac) as a red phosphorescent dopant. Thereafter, bathophenanthroline (hereinafter, referred to as Bphen) as a hole blocking layer was deposited to have a thickness of 30 Å, and Alq₃ as an electron transport layer was deposited to have a thickness of 250 Å thereon. Finally, an organic electroluminescence device was manufactured by depositing lithium fluoride (LiF) to have a thickness of 10 Å on the electron transport layer to form an electron injection layer, and then depositing an aluminum (Al) negative electrode to have a thickness of 1,200 Å on the electron injection layer to form a negative electrode.

Meanwhile, all the organic compounds required for manufacturing an OLED device were subjected to vacuum sublimed purification under 10⁻⁶ to 10⁻⁸ torr for each material, and used for the manufacture of OLED.

### 2) Performance evaluation of organic light emitting device (red host, single)

For the organic electroluminescence device manufactured as described above, electroluminescence (EL) characteristics were measured by M7000 manufactured by McScience Inc., and based on the measurement result thereof, T₉₀ was measured by a service life measurement device (M6000) manufactured by McScience Inc., when the reference luminance was 6,000 cd/m².

The measurement results are shown in the following Table 12.

**[Table 12]**

| No. | Light emitting layer | Driving voltage (V) | efficiency (cd/A) | Color coordinate (x, y) | Service life (T₉₀) |
|---|---|---|---|---|---|
| Comparative Example 1 | A | 5.90 | 31.5 | (0.685, 0.315) | 21 |
| Comparative Example 2 | B | 5.49 | 29.5 | (0.685, 0.315) | 25 |
| Comparative Example 3 | C | 5.32 | 35.1 | (0.685, 0.315) | 11 |
| Comparative Example 4 | D | 5.94 | 21.9 | (0.685, 0.315) | 10 |
| Comparative Example 5 | E | 5.90 | 20.8 | (0.685, 0.315) | 15 |
| Comparative Example 6 | F | 5.91 | 28.8 | (0.685, 0.315) | 18 |
| Comparative Example 7 | G | 5.81 | 33.5 | (0.685, 0.315) | 20 |
| Comparative Example 8 | H | 5.75 | 32.7 | (0.685, 0.315) | 25 |
| Comparative Example 9 | I | 5.33 | 31.1 | (0.685, 0.315) | 19 |
| Comparative Example 10 | 1 | 3.87 | 34.9 | (0.685, 0.315) | 27 |
| Comparative Example 11 | 13 | 3.91 | 35.5 | (0.685, 0.315) | 20 |
| Comparative Example 12 | 22 | 3.79 | 40.3 | (0.685, 0.315) | 15 |
| Comparative Example 13 | 30 | 3.85 | 32.2 | (0.685, 0.315) | 19 |
| Comparative Example 14 | 37 | 3.75 | 34.7 | (0.685, 0.315) | 29 |
| Comparative Example 15 | 39 | 3.81 | 34.8 | (0.685, 0.315) | 21 |
| Comparative Example 16 | 48 | 3.72 | 34. 6 | (0.685, 0.315) | 20 |
| Comparative Example 17 | 53 | 3.64 | 32.7 | (0.685, 0.315) | 26 |
| Comparative Example 18 | 57 | 3.78 | 33. 6 | (0.685, 0.315) | 27 |
| Comparative Example 19 | 58 | 4.09 | 39.8 | (0.685, 0.315) | 16 |
| Comparative Example 20 | 97 | 4.02 | 32.4 | (0.685, 0.315) | 19 |
| Comparative Example 21 | 115 | 4.14 | 32.5 | (0.685, 0.315) | 22 |
| Comparative Example 22 | 133 | 3.80 | 34.4 | (0.685, 0.315) | 10 |
| Comparative Example 23 | 134 | 3.85 | 35.3 | (0.685, 0.315) | 24 |
| Comparative Example 24 | 206 | 3.84 | 36.2 | (0.685, 0.315) | 25 |
| Comparative Example 25 | 209 | 3.38 | 43.2 | (0.685, 0.315) | 38 |
| Comparative Example 26 | 215 | 3.56 | 33.8 | (0.685, 0.315) | 30 |
| Comparative Example 27 | 226 | 3.75 | 36.1 | (0.685, 0.315) | 13 |
| Comparative Example 28 | 237 | 3.71 | 35.2 | (0.685, 0.315) | 16 |
| Comparative Example 29 | 239 | 3.82 | 36.1 | (0.685, 0.315) | 21 |
| Comparative Example 30 | 249 | 3.33 | 48.7 | (0.685, 0.315) | 41 |
| Comparative Example 31 | 250 | 4.26 | 24.6 | (0.685, 0.315) | 22 |
| Comparative Example 32 | 253 | 4.13 | 27.6 | (0.685, 0.315) | 20 |
| Comparative Example 33 | 280 | 4.01 | 32.5 | (0.685, 0.315) | 25 |
| Comparative Example 34 | 316 | 3.92 | 35.2 | (0.685, 0.315) | 32 |
| Comparative Example 35 | 325 | 3.41 | 49.9 | (0.685, 0.315) | 22 |
| Comparative Example 36 | 327 | 4.02 | 30.8 | (0.685, 0.315) | 25 |
| Comparative Example 37 | 329 | 3.34 | 48.2 | (0.685, 0.315) | 30 |
| Comparative Example 38 | 438 | 3.65 | 39.5 | (0.685, 0.315) | 10 |
| Comparative Example 39 | 447 | 3.75 | 38.7 | (0.685, 0.315) | 15 |
| Comparative Example 40 | 505 | 3.60 | 40.2 | (0.685, 0.315) | 16 |
| Comparative Example 41 | 511 | 3.74 | 49.8 | (0.685, 0.315) | 36 |
| Comparative Example 42 | 521 | 3.61 | 48.7 | (0.685, 0.315) | 29 |
| Comparative Example 43 | 523 | 3.62 | 50.8 | (0.685, 0.315) | 30 |
| Comparative Example 44 | 524 | 3.96 | 49.3 | (0.685, 0.315) | 35 |
| Comparative Example 45 | 551 | 3.84 | 47.7 | (0.685, 0.315) | 35 |
| Comparative Example 46 | 597 | 3.75 | 47.1 | (0.685, 0.315) | 28 |
| Comparative Example 47 | 598 | 3.70 | 45.2 | (0.685, 0.315) | 31 |
| Comparative Example 48 | 633 | 3.89 | 41.3 | (0.685, 0.315) | 25 |
| Comparative Example 49 | 635 | 3.65 | 49.8 | (0.685, 0.315) | 21 |
| Comparative Example 50 | 681 | 3.71 | 49.2 | (0.685, 0.315) | 25 |
| Comparative Example 51 | 703 | 3.86 | 47.5 | (0.685, 0.315) | 20 |
| Comparative Example 52 | 708 | 3.61 | 38.4 | (0.685, 0.315) | 19 |
| Comparative Example 53 | 711 | 3.65 | 49.0 | (0.685, 0.315) | 30 |
| Comparative Example 54 | 724 | 3.74 | 39.8 | (0.685, 0.315) | 23 |
| Comparative Example 55 | 749 | 3.68 | 40.1 | (0.685, 0.315) | 20 |
| Comparative Example 56 | 755 | 3.65 | 49.5 | (0.685, 0.315) | 26 |
| Comparative Example 57 | 756 | 3.74 | 37.4 | (0.685, 0.315) | 23 |
| Comparative Example 58 | 827 | 3.61 | 49.3 | (0.685, 0.315) | 35 |
| Comparative Example 59 | 863 | 3.62 | 50.2 | (0.685, 0.315) | 26 |
| Comparative Example 60 | 919 | 3.73 | 45.1 | (0.685, 0.315) | 27 |
| Comparative Example 61 | 942 | 3.85 | 39.6 | (0.685, 0.315) | 35 |
| Comparative Example 62 | 1002 | 4.14 | 34.8 | (0.685, 0.315) | 49 |
| Comparative Example 63 | 1005 | 4.13 | 35.7 | (0.685, 0.315) | 50 |
| Comparative Example 64 | 1011 | 4.34 | 21.6 | (0.685, 0.315) | 38 |
| Comparative Example 65 | 1015 | 4.01 | 32.0 | (0.685, 0.315) | 63 |
| Comparative Example 66 | 1021 | 4.05 | 48.2 | (0.685, 0.315) | 87 |
| Comparative Example 67 | 1050 | 3.91 | 37.9 | (0.685, 0.315) | 45 |
| Comparative Example 68 | 1054 | 3.85 | 33.5 | (0.685, 0.315) | 86 |
| Comparative Example 69 | 1056 | 3.81 | 31.4 | (0.685, 0.315) | 81 |
| Comparative Example 70 | 1057 | 3.91 | 30.9 | (0.685, 0.315) | 97 |
| Comparative Example 71 | 1064 | 4.05 | 23.5 | (0.685, 0.315) | 81 |
| Comparative Example 72 | 1065 | 4.12 | 39.4 | (0.685, 0.315) | 85 |
| Comparative Example 73 | 1073 | 4.03 | 34.8 | (0.685, 0.315) | 99 |
| Comparative Example 74 | 1097 | 3.84 | 38.7 | (0.685, 0.315) | 90 |
| Comparative Example 75 | 1100 | 3.68 | 34.6 | (0.685, 0.315) | 92 |
| Comparative Example 76 | 1123 | 3.59 | 42.3 | (0.685, 0.315) | 91 |
| Comparative Example 77 | 1124 | 3.65 | 43.5 | (0.685, 0.315) | 84 |
| Comparative Example 78 | 1142 | 3.71 | 40.4 | (0.685, 0.315) | 86 |
| Comparative Example 79 | 1146 | 3.82 | 41.5 | (0.685, 0.315) | 78 |
| Comparative Example 80 | 1157 | 3.77 | 35.2 | (0.685, 0.315) | 56 |
| Comparative Example 81 | 1158 | 3.79 | 35.9 | (0.685, 0.315) | 64 |
| Comparative Example 82 | 1174 | 3.64 | 48.5 | (0.685, 0.315) | 80 |
| Comparative Example 83 | 1175 | 3.73 | 45.4 | (0.685, 0.315) | 90 |
| Comparative Example 84 | 1176 | 4.35 | 23.6 | (0.685, 0.315) | 41 |
| Comparative Example 85 | 1186 | 4.10 | 46.8 | (0.685, 0.315) | 94 |
| Comparative Example 86 | 1187 | 4.01 | 45.7 | (0.685, 0.315) | 92 |
| Comparative Example 87 | 1203 | 3.65 | 44.1 | (0.685, 0.315) | 89 |
| Comparative Example 88 | 1257 | 3.64 | 35.5 | (0.685, 0.315) | 70 |
| Comparative Example 89 | 1258 | 3.78 | 37.3 | (0.685, 0.315) | 75 |
| Comparative Example 90 | 1278 | 3.87 | 38.4 | (0.685, 0.315) | 81 |
| Comparative Example 91 | 1279 | 3.69 | 35.6 | (0.685, 0.315) | 72 |
| Comparative Example 92 | 1306 | 4.12 | 41.7 | (0.685, 0.315) | 125 |
| Comparative Example 93 | 1307 | 4.01 | 43.8 | (0.685, 0.315) | 115 |
| Comparative Example 94 | 1365 | 3.42 | 48.9 | (0.685, 0.315) | 123 |
| Comparative Example 95 | 1403 | 3.21 | 50.4 | (0.685, 0.315) | 100 |
| Comparative Example 96 | 1404 | 3.85 | 47.5 | (0.685, 0.315) | 90 |
| Comparative Example 97 | 1405 | 3.64 | 48.7 | (0.685, 0.315) | 135 |
| Comparative Example 98 | 1413 | 3.76 | 49.8 | (0.685, 0.315) | 120 |
| Comparative Example 99 | 1417 | 3.55 | 46.0 | (0.685, 0.315) | 115 |
| Comparative Example 100 | 1437 | 3.74 | 41.2 | (0.685, 0.315) | 101 |
| Comparative Example 101 | 1439 | 3.65 | 39.6 | (0.685, 0.315) | 125 |
| Comparative Example 102 | 1444 | 3.69 | 45.7 | (0.685, 0.315) | 132 |
| Comparative Example 103 | 1453 | 3.67 | 47.8 | (0.685, 0.315) | 104 |
| Comparative Example 104 | 1488 | 3.52 | 35.6 | (0.685, 0.315) | 96 |
| Comparative Example 105 | 1489 | 3.61 | 38.4 | (0.685, 0.315) | 85 |
| Comparative Example 106 | 1505 | 4.04 | 35.9 | (0.685, 0.315) | 71 |
| Comparative Example 107 | 1506 | 3.90 | 36.7 | (0.685, 0.315) | 98 |
| Comparative Example 108 | 1559 | 3.81 | 37.5 | (0.685, 0.315) | 104 |
| Comparative Example 109 | 1570 | 3.59 | 35.1 | (0.685, 0.315) | 77 |
| Comparative Example 110 | 1579 | 3.65 | 37.2 | (0.685, 0.315) | 88 |
| Comparative Example 111 | 1585 | 3.74 | 35.3 | (0.685, 0.315) | 90 |
| Comparative Example 112 | 1587 | 3.65 | 35.8 | (0.685, 0.315) | 74 |
| Comparative Example 113 | 1595 | 3.86 | 21.4 | (0.685, 0.315) | 68 |

Compounds A to I in Table 12 are as follows.

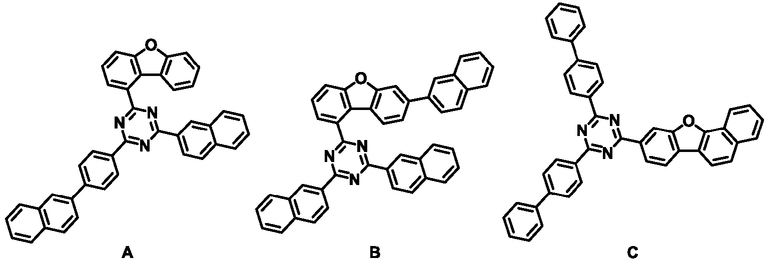

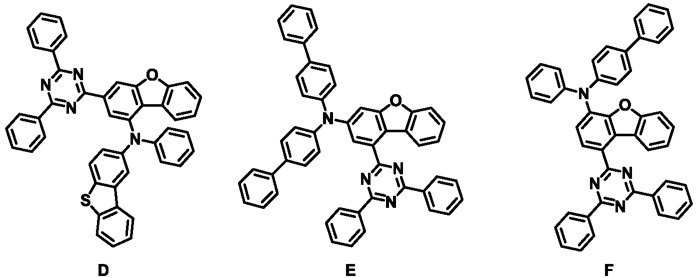

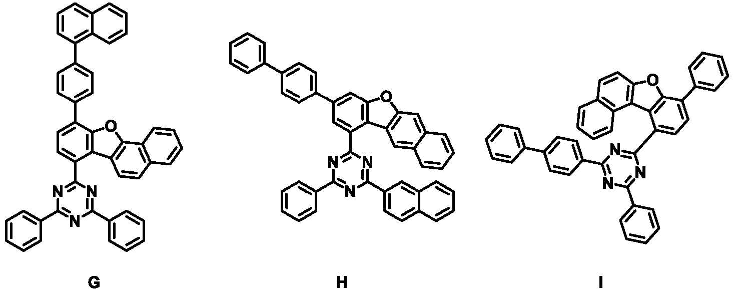

### <Experimental Example 2>

### 1) Manufacture of organic light emitting device (pre-mixed, red host)

A glass substrate, in which ITO was thinly coated to have a thickness of 1,500 Å, was ultrasonically washed with distilled water. When the washing with distilled water was finished, the glass substrate was ultrasonically washed with a solvent such as acetone, methanol, and isopropyl alcohol, dried and then was subjected to UVO treatment for 5 minutes using UV in a UV cleaning machine. Thereafter, the substrate was transferred to a plasma washing machine (PT), and then was subjected to plasma treatment in a vacuum state for an ITO work function and in order to remove a residual film, and was transferred to a thermal deposition apparatus for organic deposition.

A hole injection layer 4,4',4"-tris[2-naphthyl(phenyl)amino]triphenylamine (2-TNATA), a hole transport layer N,N'-diphenyl-(1,1'-biphenyl)-4,4'-diamine (NPB) and an electron blocking layer cyclohexylidenebis[N,N-bis(4-methylphenyl)benzenamine] (TAPC) or an exciton blocking layer tris(4-carbazoyl-9-ylphenyl)amine (TCTA), which are common layers, were formed on the ITO transparent electrode (positive electrode).
A light emitting layer was thermally vacuum deposited thereon as follows. The light emitting layer was deposited to have a thickness of 400 Å by depositing two types of the compounds described in the following Table 13 as a red host from a single supply source and doping the host with an Ir compound at 3 wt% using (piq)₂(Ir) (acac) as a red phosphorescent dopant. Thereafter, Bphen as a hole blocking layer was deposited to have a thickness of 30 Å, and 1,3,5-tris(N-phenylbenzimidazole-2-yl)benzene (TPBI) as an electron transport layer was deposited to have a thickness of 250 Å thereon. Finally, an organic electroluminescence device was manufactured by depositing lithium fluoride (LiF) to have a thickness of 10 Å on the electron transport layer to form an electron injection layer, and then depositing an aluminum (Al) negative electrode to have a thickness of 1,200 Å on the electron injection layer to form a negative electrode.

Meanwhile, all the organic compounds required for manufacturing an OLED device were subjected to vacuum sublimed purification under 10⁻⁶ to 10⁻⁸ torr for each material, and used for the manufacture of OLED.

### 2) Performance evaluation of manufacture of organic light emitting device (pre-mixed, red host)

For the organic electroluminescence device manufactured as described above, electroluminescence (EL) characteristics were measured by M7000 manufactured by McScience Inc., and based on the measurement result thereof, T₉₀ was measured by a service life measurement device (M6000) manufactured by McScience Inc., when the reference luminance was 6,000 cd/m².

The measurement results are shown in the following Table 13.

**[Table 13]**

| No. | Light emittin g layer | Rati o (P:N ) | Drivin g voltag e (V) | efficienc y (cd/A) | Color coordinat e (x, y) | Servic e life (T₉₀) |
|---|---|---|---|---|---|---|
| Comparativ e Example 114 | A:D | 1:2 | 4.56 | 38.7 | (0.685, 0.315) | 59 |
| Comparativ e Example 115 | | 1:1 | 4.72 | 39.9 | (0.685, 0.315) | 64 |
| Comparativ e Example 116 | | 2:1 | 4.91 | 37.1 | (0.685, 0.315) | 49 |
| Comparativ e Example 117 | G:E | 1:2 | 3.91 | 48.7 | (0.685, 0.315) | 56 |
| Comparativ e Example 118 | | 1:1 | 3.89 | 46.8 | (0.685, 0.315) | 52 |
| Comparativ e Example 119 | | 2:1 | 3.88 | 46.6 | (0.685, 0.315) | 49 |
| Comparativ e Example 120 | 22:D | 1:2 | 4.34 | 45.1 | (0.685, 0.315) | 40 |
| Comparativ e Example 121 | | 1:1 | 4.21 | 48.4 | (0.685, 0.315) | 51 |
| Comparativ e Example 122 | | 2:1 | 4.45 | 46.8 | (0.685, 0.315) | 39 |
| Comparativ e Example 123 | A:1005 | 1:2 | 3.98 | 44.7 | (0.685, 0.315) | 76 |
| Comparativ e Example 124 | | 1:1 | 3.92 | 42.9 | (0.685, 0.315) | 87 |
| Comparativ e Example 125 | | 2:1 | 4.02 | 39.1 | (0.685, 0.315) | 68 |
| Comparativ e Example 126 | H:1203 | 1:2 | 3.86 | 48.6 | (0.685, 0.315) | 50 |
| Comparativ e Example 127 | | 1:1 | 3.87 | 49.1 | (0.685, 0.315) | 61 |
| Comparativ e Example 128 | | 2:1 | 3.90 | 49.8 | (0.685, 0.315) | 73 |
| Example 1 | 30:1002 | 1:2 | 3.61 | 53.5 | (0.685, 0.315) | 91 |
| Example 2 | | 1:1 | 3.62 | 58.9 | (0.685, 0.315) | 88 |
| Example 3 | | 2:1 | 3.65 | 61.3 | (0.685, 0.315) | 82 |
| Example 4 | 37:1005 | 1:2 | 3.56 | 52.8 | (0.685, 0.315) | 79 |
| Example 5 | | 1:1 | 3.51 | 61.2 | (0.685, 0.315) | 88 |
| Example 6 | | 2:1 | 3.69 | 63.9 | (0.685, 0.315) | 87 |
| Example 7 | 58:1021 | 1:8 | 3.79 | 67.8 | (0.685, 0.315) | 102 |
| Example 8 | | 1:5 | 3.85 | 69.3 | (0.685, 0.315) | 121 |
| Example 9 | | 1:2 | 3.77 | 72.9 | (0.685, 0.315) | 119 |
| Example 10 | | 1:1 | 3.68 | 68.5 | (0.685, 0.315) | 130 |
| Example 11 | | 2:1 | 3.59 | 71.8 | (0.685, 0.315) | 134 |
| Example 12 | | 5:1 | 3.76 | 75.9 | (0.685, 0.315) | 123 |
| Example 13 | | 8:1 | 3.81 | 71.2 | (0.685, 0.315) | 105 |
| Example 14 | 97:1054 | 1:2 | 3.25 | 74.9 | (0.685, 0.315) | 248 |
| Example 15 | | 1:1 | 3.40 | 75.7 | (0.685, 0.315) | 224 |
| Example 16 | | 2:1 | 3.45 | 78.6 | (0.685, 0.315) | 181 |
| Example 17 | 133:112 4 | 1:8 | 3.51 | 80.8 | (0.685, 0.315) | 155 |
| Example 18 | | 1:5 | 3.83 | 76.0 | (0.685, 0.315) | 138 |
| Example 19 | | 1:2 | 3.89 | 73.3 | (0.685, 0.315) | 169 |
| Example 20 | | 1:1 | 3.63 | 81.8 | (0.685, 0.315) | 154 |
| Example 21 | | 2:1 | 3.77 | 85.5 | (0.685, 0.315) | 135 |
| Example 22 | | 5:1 | 3.78 | 90.7 | (0.685, 0.315) | 113 |
| Example 23 | | 8:1 | 3.87 | 61.1 | (0.685, 0.315) | 109 |
| Example 24 | 206:114 2 | 1:2 | 3.61 | 62.3 | (0.685, 0.315) | 125 |
| Example 25 | | 1:1 | 3.66 | 64.8 | (0.685, 0.315) | 140 |
| Example 26 | | 2:1 | 3.68 | 65.4 | (0.685, 0.315) | 156 |
| Example 27 | 249:117 5 | 1:2 | 3.59 | 69.5 | (0.685, | 183 |
| Example 28 | | 1:1 | 3.62 | 74.1 | (0.685, 0.315) | 204 |
| Example 29 | | 2:1 | 3.78 | 79.9 | (0.685, 0.315) | 195 |
| Example 30 | 280:110 0 | 1:2 | 3.60 | 66.8 | (0.685, 0.315) | 135 |
| Example 31 | | 1:1 | 3.58 | 67.9 | (0.685, 0.315) | 146 |
| Example 32 | | 2:1 | 3.55 | 68.1 | (0.685, 0.315) | 151 |
| Example 33 | 316:118 6 | 1:2 | 3.61 | 62.8 | (0.685, 0.315) | 162 |
| Example 34 | | 1:1 | 3.63 | 63.7 | (0.685, 0.315) | 167 |
| Example 35 | | 2:1 | 3.64 | 64.1 | (0.685, 0.315) | 145 |
| Example 36 | 325:118 7 | 1:2 | 3.77 | 81.7 | (0.685, 0.315) | 173 |
| Example 37 | | 1:1 | 3.75 | 84.4 | (0.685, 0.315) | 144 |
| Example 38 | | 2:1 | 3.86 | 70.6 | (0.685, 0.315) | 128 |
| Example 39 | 438:127 8 | 1:2 | 3.69 | 65.1 | (0.685, 0.315) | 154 |
| Example 40 | | 1:1 | 3.71 | 67.5 | (0.685, 0.315) | 160 |
| Example 41 | | 2:1 | 3.74 | 67.9 | (0.685, 0.315) | 135 |
| Example 42 | 447:130 7 | 1:2 | 3.70 | 61.2 | (0.685, 0.315) | 128 |
| Example 43 | | 1:1 | 3.68 | 63.5 | (0.685, 0.315) | 134 |
| Example 44 | | 2:1 | 3.63 | 64.8 | (0.685, 0.315) | 149 |
| Example 45 | 505:136 5 | 1:2 | 3.75 | 65.1 | (0.685, 0.315) | 172 |
| Example 46 | | 1:1 | 3.72 | 62.8 | (0.685, 0.315) | 183 |
| Example 47 | | 2:1 | 3.69 | 61.5 | (0.685, 0.315) | 149 |
| Example 48 | 523:120 3 | 1:8 | 3.65 | 69.8 | (0.685, 0.315) | 187 |
| Example 49 | | 1:5 | 3.78 | 74.7 | (0.685, 0.315) | 203 |
| Example 50 | | 1:2 | 3.79 | 77.4 | (0.685, 0.315) | 189 |
| Example 51 | | 1:1 | 3.82 | 78.5 | (0.685, 0.315) | 195 |
| Example 52 | | 2:1 | 3.85 | 82.6 | (0.685, 0.315) | 143 |
| Example 53 | | 5:1 | 3.87 | 84.9 | (0.685, 0.315) | 135 |
| Example 54 | | 8:1 | 3.91 | 86.2 | (0.685, 0.315) | 129 |
| Example 55 | 597:145 3 | 1:8 | 3.52 | 74.7 | (0.685, 0.315) | 261 |
| Example 56 | | 1:5 | 3.66 | 73.6 | (0.685, 0.315) | 252 |
| Example 57 | | 1:2 | 3.79 | 77.2 | (0.685, 0.315) | 229 |
| Example 58 | | 1:1 | 3.40 | 70.1 | (0.685, 0.315) | 279 |
| Example 59 | | 2:1 | 3.33 | 71.0 | (0.685, 0.315) | 278 |
| Example 60 | | 5:1 | 3.35 | 60.0 | (0.685, 0.315) | 267 |
| Example 61 | | 8:1 | 3.45 | 57.5 | (0.685, 0.315) | 231 |
| Example 62 | 635:148 8 | 1:2 | 3.35 | 63.1 | (0.685, 0.315) | 225 |
| Example 63 | | 1:1 | 3.55 | 55.5 | (0.685, 0.315) | 219 |
| Example 64 | | 2:1 | 3.30 | 60.8 | (0.685, 0.315) | 229 |
| Example 65 | 703:140 4 | 1:2 | 3.25 | 68.3 | (0.685, 0.315) | 235 |
| Example 66 | | 1:1 | 3.40 | 58.1 | (0.685, 0.315) | 225 |
| Example 67 | | 2:1 | 3.32 | 65.0 | (0.685, 0.315) | 261 |
| Example 68 | 711:150 6 | 1:8 | 3.45 | 63.1 | (0.685, 0.315) | 324 |
| Example 69 | | 1:5 | 3.36 | 67.0 | (0.685, 0.315) | 348 |
| Example 70 | | 1:2 | 3.35 | 71.1 | (0.685, 0.315) | 352 |
| Example 71 | | 1:1 | 3.35 | 71.0 | (0.685, 0.315) | 366 |
| Example 72 | | 2:1 | 3.20 | 71.9 | (0.685, 0.315) | 409 |
| Example 73 | | 5:1 | 3.35 | 71.5 | (0.685, 0.315) | 325 |
| Example 74 | | 8:1 | 3.48 | 71.0 | (0.685, 0.315) | 281 |
| Example 75 | 827:158 5 | 1:2 | 3.34 | 70.6 | (0.685, 0.315) | 236 |
| Example 76 | | 1:1 | 3.55 | 58.7 | (0.685, 0.315) | 212 |
| Example 77 | | 2:1 | 3.35 | 70.9 | (0.685, 0.315) | 184 |
| Example 78 | 863:150 5 | 1:2 | 3.88 | 65.5 | (0.685, 0.315) | 282 |
| Example 79 | | 1:1 | 3.90 | 70.1 | (0.685, 0.315) | 205 |
| Example 80 | | 2:1 | 3.95 | 74.9 | (0.685, 0.315) | 251 |
| Example 81 | 919:155 9 | 1:2 | 3.41 | 68.1 | (0.685, 0.315) | 273 |
| Example 82 | | 1:1 | 3.50 | 67.5 | (0.685, 0.315) | 246 |
| Example 83 | | 2:1 | 3.55 | 60.4 | (0.685, 0.315) | 227 |
| Example 84 | 942:158 7 | 1:2 | 3.62 | 62.1 | (0.685, 0.315) | 154 |
| Example 85 | | 1:1 | 3.60 | 63.8 | (0.685, 0.315) | 138 |
| Example 86 | | 2:1 | 3.59 | 62.7 | (0.685, 0.315) | 129 |

As can be seen from the results of Tables 12 and 13, it could be confirmed that in the case of Examples 1 to 86 in which the heterocyclic compound represented by Chemical Formula 1 and the heterocyclic compound represented by Chemical Formula 2 in the present invention were used as hosts for an organic material layer of an organic light emitting device, particularly a light emitting layer, the driving voltage, efficiency and service life were improved compared to the organic light emitting devices of the Comparative Examples.

The heterocyclic compound of Chemical Formula 1 of the present invention has high thermal stability and appropriate molecular weight and band-gap. Such an appropriate band-gap of the light emitting layer has good hole transport ability, and prevents the loss of electrons to aid in the effective formation of a recombination zone.

It could be confirmed that by including the compound represented by Chemical Formula 2 of the present invention in the organic material layer of the organic light emitting device, the driving voltage and service life can be remarkably improved due to the increase in hole mobility. Furthermore, it could be confirmed that the efficiency is also improved by decrease in current leakage through electron block and electron confinement.

In the case of the combination of Chemical Formula 1 and Chemical Formula 2 in the light emitting layer, driving voltage, efficiency and service life are improved. When a donor with good hole transport ability (p-host, the heterocyclic compound represented by Chemical Formula 2) and an acceptor with good electron transport ability (n-host, the heterocyclic compound represented by Chemical Formula 1) are used as the hosts of the light emitting layer, the driving voltage at which electrons and holes are injected can be lowered, and the efficiency and service life are improved through the effective formation of a recombination zone.

These result from the more frequent occurrence of the exciplex phenomenon, which is the phenomenon of emission by the difference in energy between the LUMO level of an acceptor (N-type host) and the HOMO level of a donor (P-type host) due to the electron exchange between two molecules. When a donor with good hole transport ability (P-type host) and an acceptor with good electron transport ability (N-type host) are used as the hosts of the light emitting layer by the exciplex phenomenon, holes are injected into the P-type host and electrons are injected into the N-type host, so that the combination of electrons and holes in the light emitting layer is facilitated.

## Claims

1. An organic light emitting device comprising a first electrode, a second electrode and an organic material layer having one or more layers provided between the first electrode and the second electrode, wherein the organic material layer comprises a heterocyclic compound represented by the following Chemical Formula 1 and a heterocyclic compound represented by the following Chemical Formula 2: 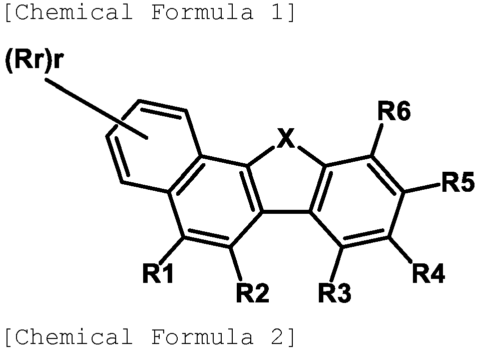 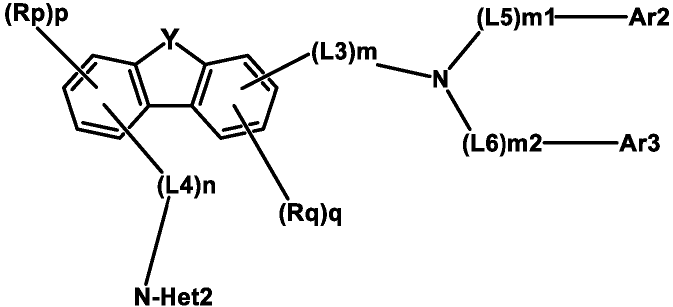 wherein, in Chemical Formulae 1 and 2,
X is O; or S,
one of R1 to R6 is 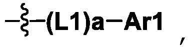 one of the others is 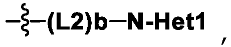 and the others are the same as or different from each other, and are each independently selected from the group consisting of hydrogen; deuterium; a halogen; a cyano group; a substituted or unsubstituted C1 to C60 alkyl group; a substituted or unsubstituted C2 to C60 alkenyl group; a substituted or unsubstituted C2 to C60 alkynyl group; a substituted or unsubstituted C1 to C60 alkoxy group; a substituted or unsubstituted C3 to C60 cycloalkyl group; a substituted or unsubstituted C2 to C60 heterocycloalkyl group; a substituted or unsubstituted C6 to C60 aryl group; a substituted or unsubstituted C2 to C60 heteroaryl group; - P(=O)RR'; -SiRR'R" and -NRR', 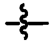
is a position which is each bonded to R1 to R6,
L1 to L6 are the same as or different from each other, and are each independently a direct bond; a substituted or unsubstituted C6 to C60 arylene group; or a substituted or unsubstituted C2 to C60 heteroarylene group, a, b, m, n, m1 and m2 are each an integer from 0 to 3, and when a, b, m, n, m1 and m2 are each 2 or higher, substituents in the parenthesis are the same as or different from each other,
N-Het1 and N-Het2 are each independently a monocyclic or polycyclic heterocyclic group which is substituted or unsubstituted and includes one or more N's,
Ar1 is a substituted or unsubstituted C6 to C60 aryl group; or a substituted or unsubstituted C2 to C60 heteroaryl group,
Y is O; or S,
Ar2 and Ar3 are the same as or different from each other, and are each independently a substituted or unsubstituted C6 to C60 aryl group; a substituted or unsubstituted C2 to C60 heteroaryl group; or -NRR',
adjacent substituents of L3, L5, L6, Ar2 and Ar3 may be bonded to each other to form a substituted or unsubstituted aliphatic or aromatic hydrocarbon ring or a substituted or unsubstituted aliphatic or aromatic hetero ring,
Rr, Rp and Rq are the same as or different from each other, and are each independently selected from the group consisting of hydrogen; deuterium; a halogen; a cyano group; a substituted or unsubstituted C1 to C60 alkyl group; a substituted or unsubstituted C2 to C60 alkenyl group; a substituted or unsubstituted C2 to C60 alkynyl group; a substituted or unsubstituted C1 to C60 alkoxy group; a substituted or unsubstituted C3 to C60 cycloalkyl group; a substituted or unsubstituted C2 to C60 heterocycloalkyl group; a substituted or unsubstituted C6 to C60 aryl group; a substituted or unsubstituted C2 to C60 heteroaryl group; - P(=O)RR'; -SiRR'R" and -NRR', r is an integer from 0 to 4, p and q are each an integer from 0 to 3, and when r, p and q are each 2 or higher, substituents in the parenthesis are the same as or different from each other, and
R, R' and R" are the same as or different from each other, and are each independently hydrogen; deuterium; a substituted or unsubstituted C1 to C60 alkyl group; a substituted or unsubstituted C6 to C60 aryl group; or a substituted or unsubstituted C2 to C60 heteroaryl group.

2. The organic light emitting device of claim 1, wherein the N-Het1 and the N-Het2 are each independently represented by the following Chemical Formula 3: 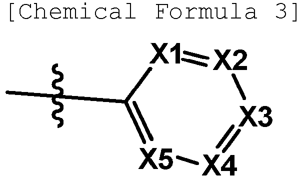 in Chemical Formula 3,
X1 is CR101 or N, X2 is CR102 or N, X3 is CR103 or N, X4 is CR104 or N, X5 is CR105 or N, and at least one of X1 to X5 is N, and
R101 to R105 are the same as or different from each other, and are each independently selected from the group consisting of hydrogen; deuterium; a halogen; a cyano group; a substituted or unsubstituted C1 to C60 alkyl group; a substituted or unsubstituted C2 to C60 alkenyl group; a substituted or unsubstituted C2 to C60 alkynyl group; a substituted or unsubstituted C1 to C20 alkoxy group; a substituted or unsubstituted C3 to C60 cycloalkyl group; a substituted or unsubstituted C2 to C60 heterocycloalkyl group; a substituted or unsubstituted C6 to C60 aryl group; a substituted or unsubstituted C2 to C60 heteroaryl group; a substituted or unsubstituted phosphine oxide group; and a substituted or unsubstituted amine group, or two or more adjacent groups are bonded to each other to form a substituted or unsubstituted aliphatic or aromatic hydrocarbon ring or hetero ring, and here, 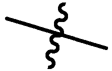 is a moiety linked to Chemical Formula 1 or 2.

3. The organic light emitting device of claim 1, wherein Chemical Formula 1 is a heterocyclic compound represented by the following Chemical Formula 1-1 or 1-2: 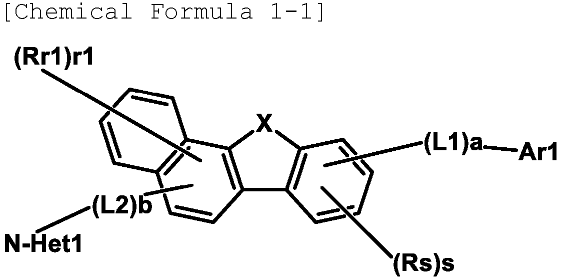 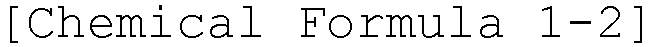 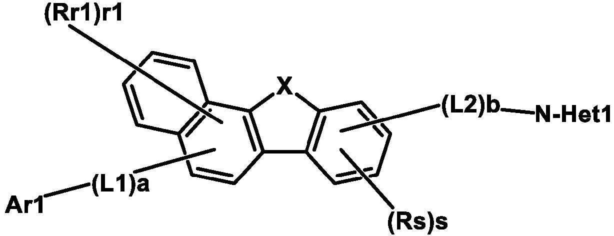 in Chemical Formulae 1-1 and 1-2,
Rr1 and Rs are the same as or different from each other, and are each independently hydrogen; deuterium; a cyano group; a halogen group; or a substituted or unsubstituted C1 to C60 alkyl group,
r1 is an integer from 0 to 5, and when r1 is 2 or higher, Rr1's in the parenthesis are the same as or different from each other,
s is an integer from 0 to 3, and when s is 2 or higher, Rs's in the parenthesis are the same as or different from each other, and
the definitions of X, L1, L2, Ar1, a, b and N-Het1 are the same as the definitions in Chemical Formula 1.

4. The organic light emitting device of claim 3, wherein Chemical Formula 1-1 is represented by any one of the following Chemical Formulae 1-1-1 to 1-1-4: 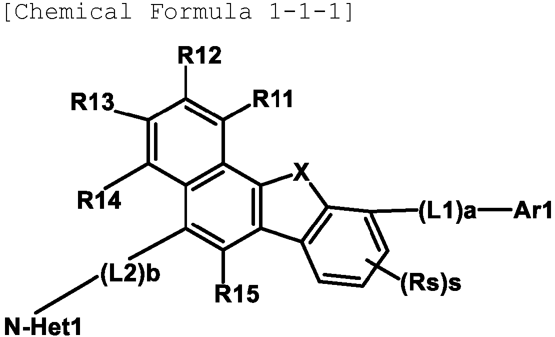 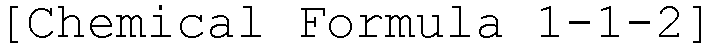 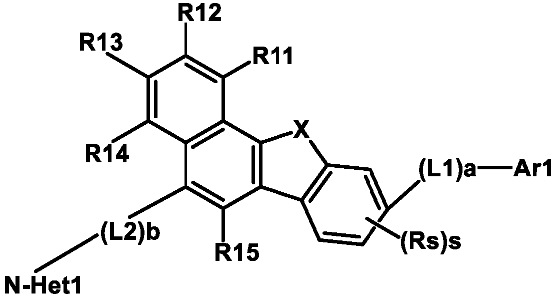 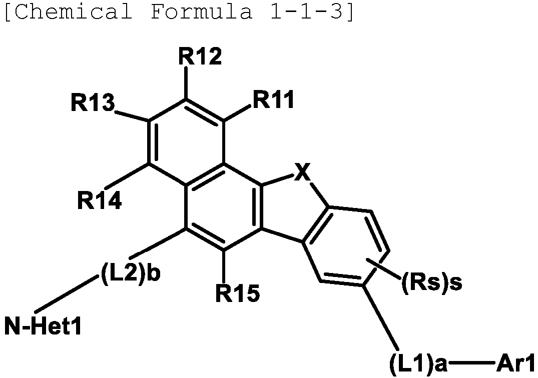 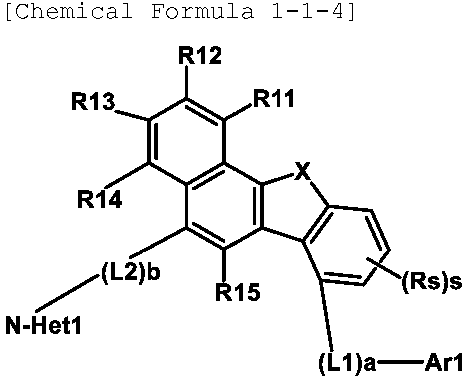 in Chemical Formulae 1-1-1 to 1-1-4,
R11 to R15 are the same as or different from each other, and are each independently hydrogen; deuterium; a cyano group; a halogen group; or a substituted or unsubstituted C1 to C60 alkyl group, and
the definitions of X, Rs, L1, L2, Ar1, a, b, s and N-Het1 are the same as the definitions in Chemical Formula 1-1.

5. The organic light emitting device of claim 3, wherein Chemical Formula 1-2 is represented by any one of the following Chemical Formulae 1-2-1 to 1-2-4: 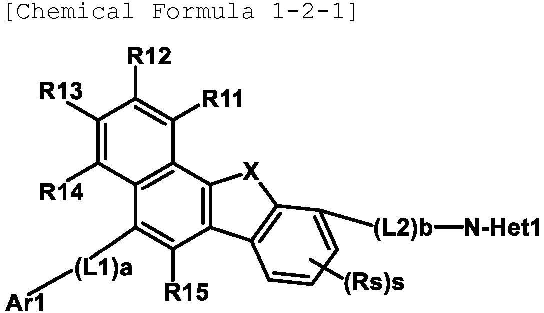 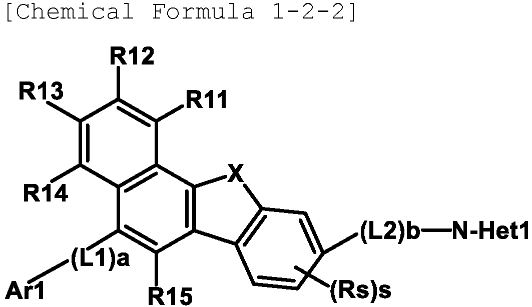 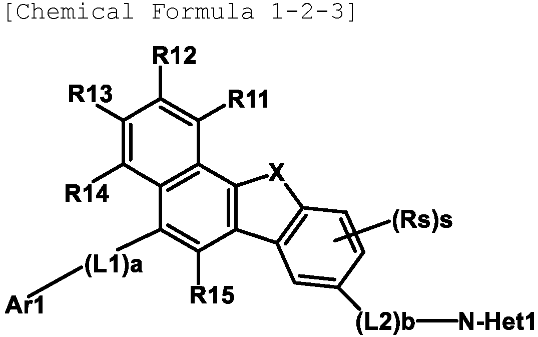 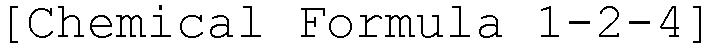 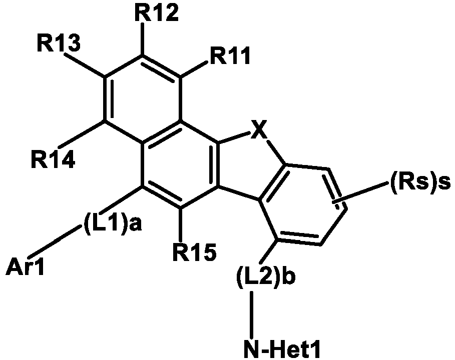 in Chemical Formulae 1-2-1 to 1-2-4,
R11 to R15 are the same as or different from each other, and are each independently hydrogen; deuterium; a cyano group; a halogen group; or a substituted or unsubstituted C1 to C60 alkyl group, and
the definitions of X, Rs, L1, L2, Ar1, a, b, s and N-Het1 are the same as the definitions in Chemical Formula 1-2.

6. The organic light emitting device of claim 1, wherein 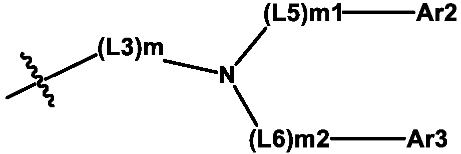 is represented by any one of the following Chemical Formulae A-1 to A-12: 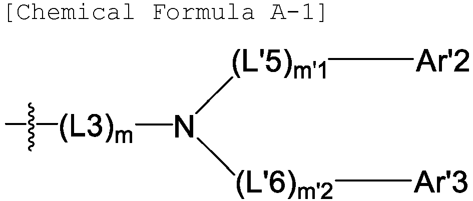 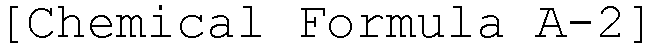 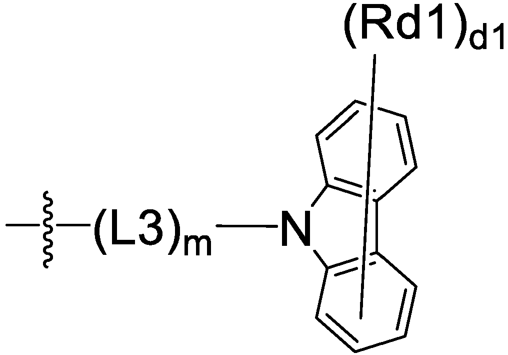 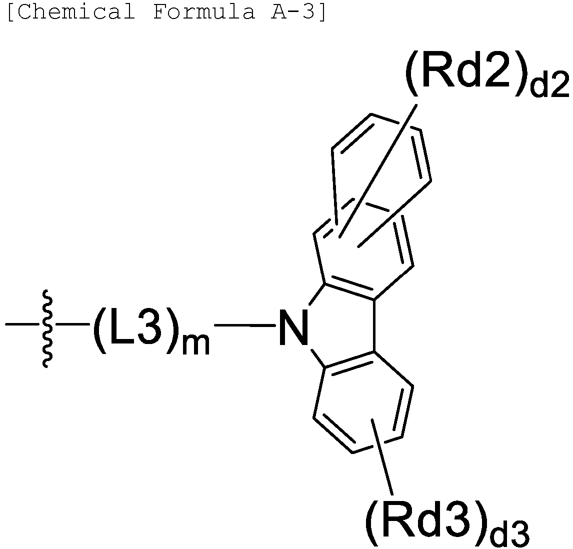 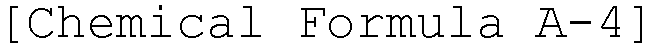 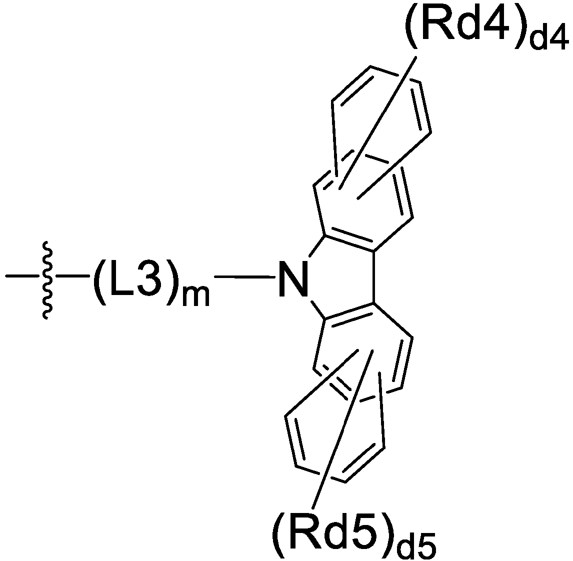 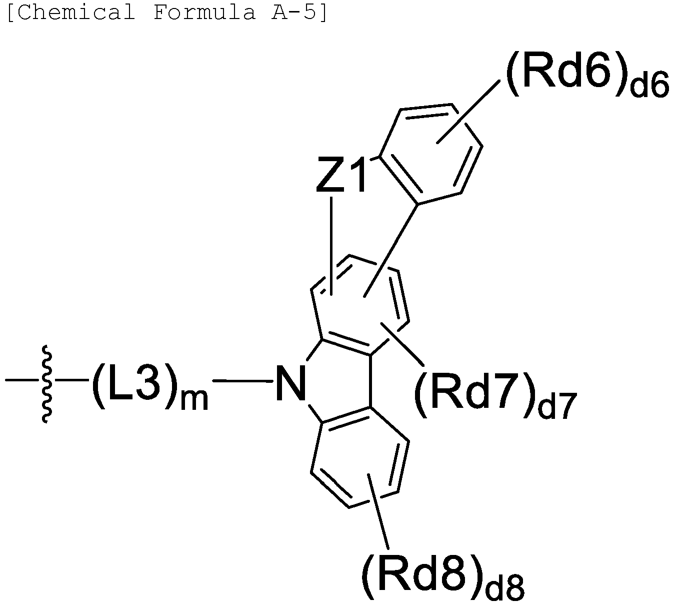 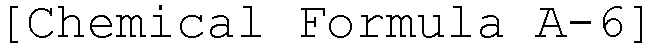 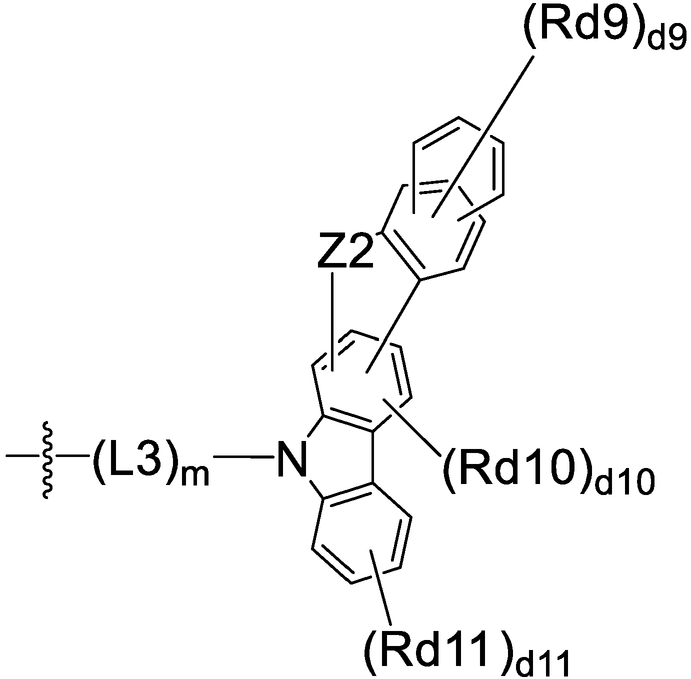 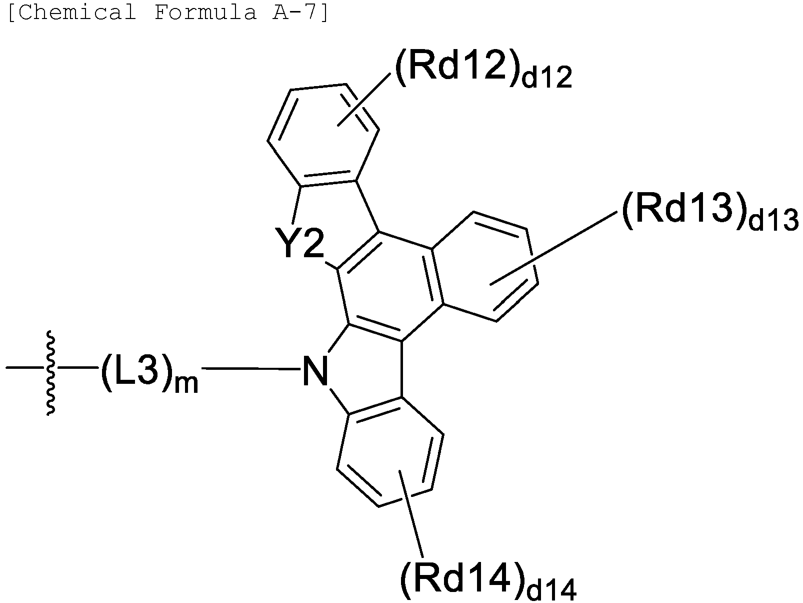 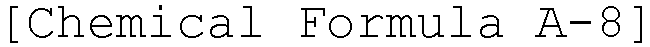 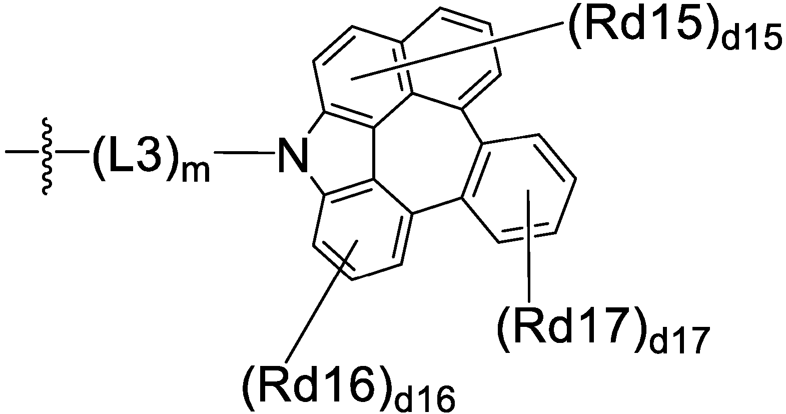 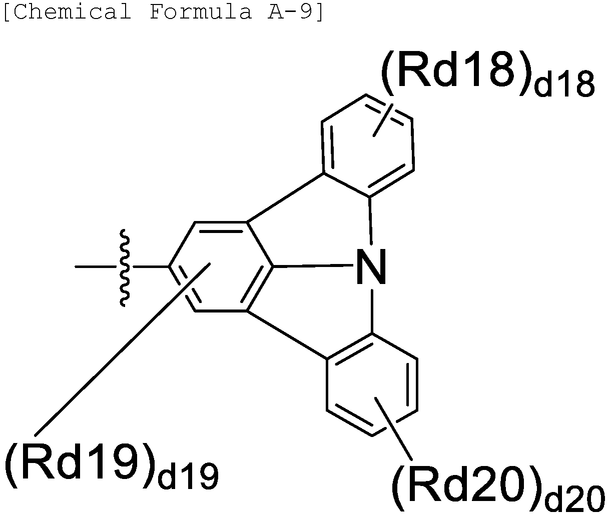 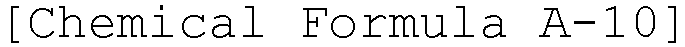 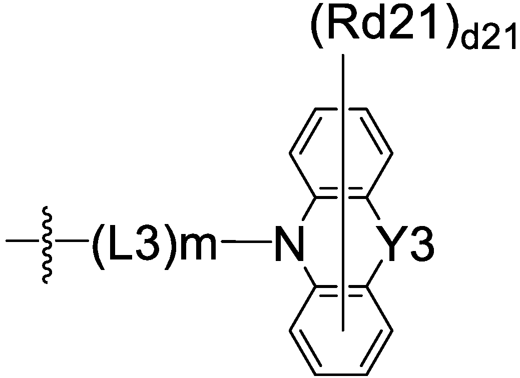 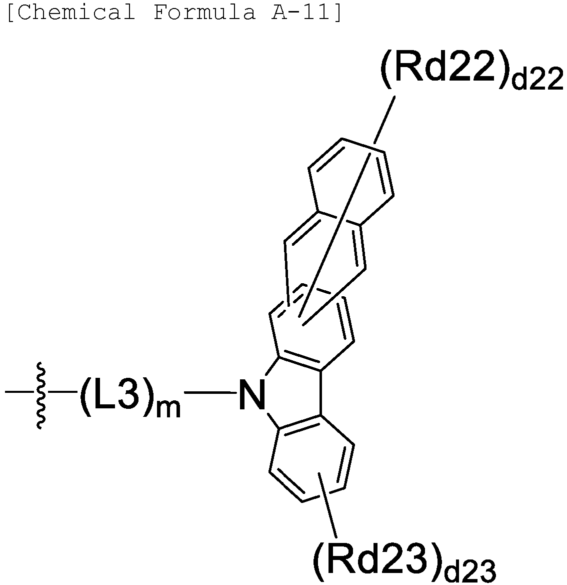 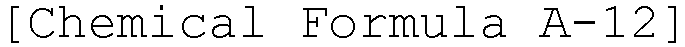 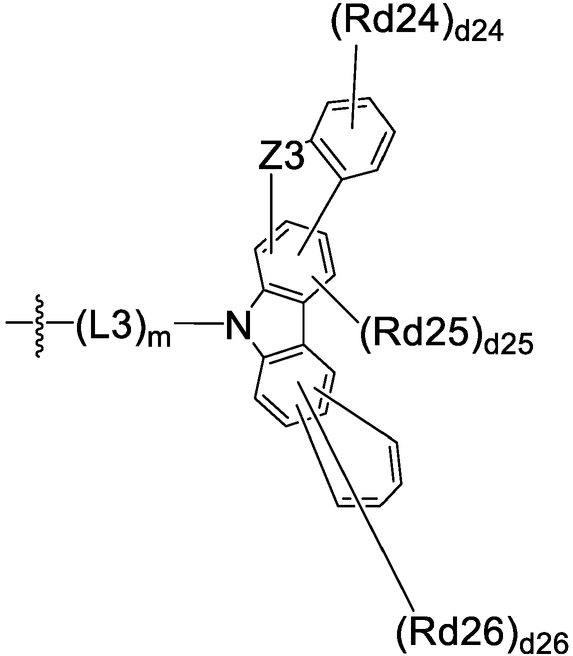 in Chemical Formulae A-1 to A-12,
the definitions of L3 and m are the same as the definitions in Chemical Formula 2,
L'5 and L'6 are the same as or different from eachy other, and are each independently a direct bond; a substituted or unsubstituted C6 to C60 arylene group; or a substituted or unsubstituted C2 to C60 heteroarylene group, m'1 and m'2 are each independently an integer from 0 to 3, and when m'1 and m'2 are each 2 or higher, substituents in the parenthesis are the same as or different from each other,
Ar'2 and Ar'3 are the same as or different from each other, and are each independently NRR'; a substituted or unsubstituted C6 to C60 aryl group; or a substituted or unsubstituted C2 to C60 heteroaryl group,
Z1 to Z3 are each independently O; S; CRaRb; or NRc,
Y2 and Y3 are each independently O; or S,
R, R', Ra, Rb, Rc and Rd1 to Rd26 are each independently hydrogen; deuterium; a halogen group; a cyano group; a substituted or unsubstituted C1 to C60 alkyl group; a substituted or unsubstituted C6 to C60 aryl group; or a substituted or unsubstituted C2 to C60 heteroaryl group,
d1, d21 and d22 are each independently an integer from 0 to 8,
d2, d4, d5, d9 and d26 are each independently an integer from 0 to 6,
d3, d6, d8, d11, d12 to d14, d17, d18, d20, d23 and d24 are each independently an integer from 0 to 4,
d7, d10, d19 and d25 are each independently an integer from 0 to 2,
d15 is an integer from 0 to 5,
d16 is an integer from 0 to 3, and
when d1 to d26 are each 2 or higher, substituents in the parenthesis are the same as or different from each other.

7. The organic light emitting device of claim 1, wherein Chemical Formula 1 is represented by any one of the following compounds:

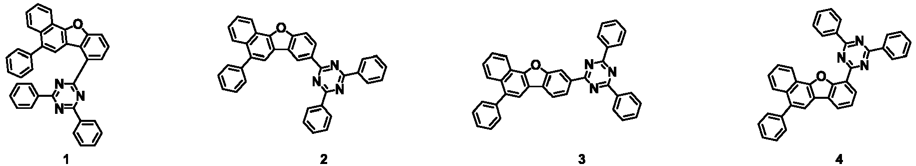

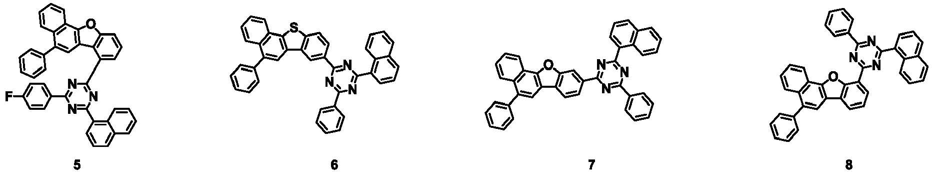

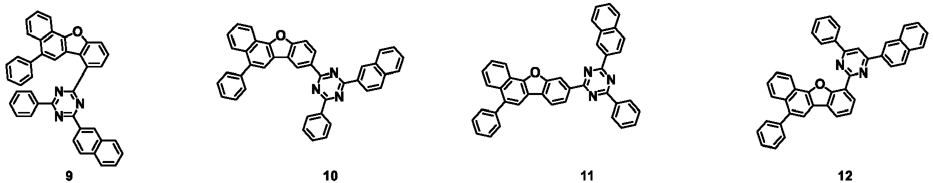

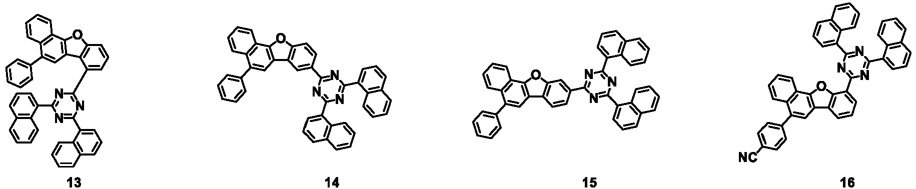

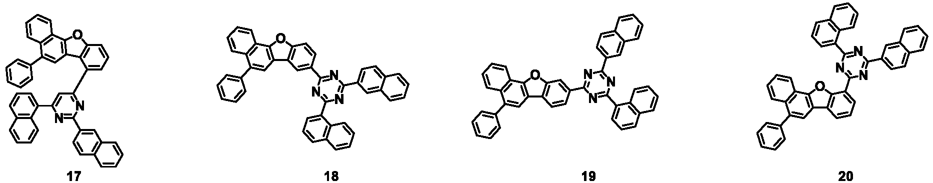

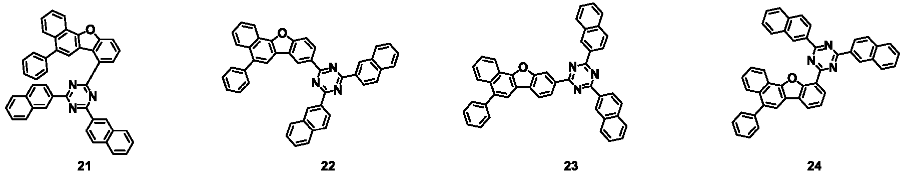

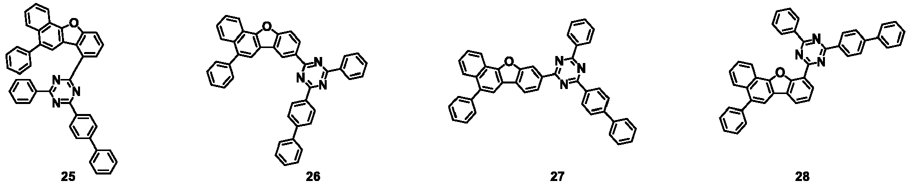

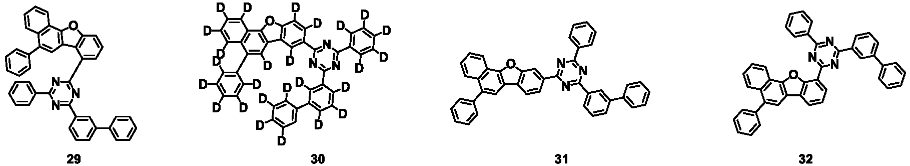

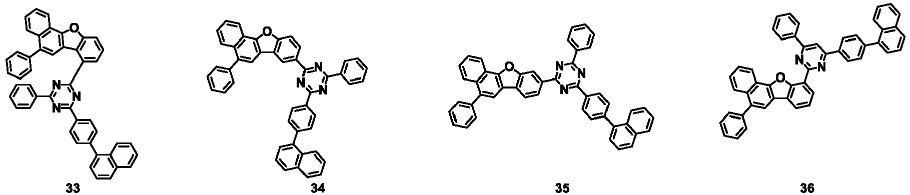

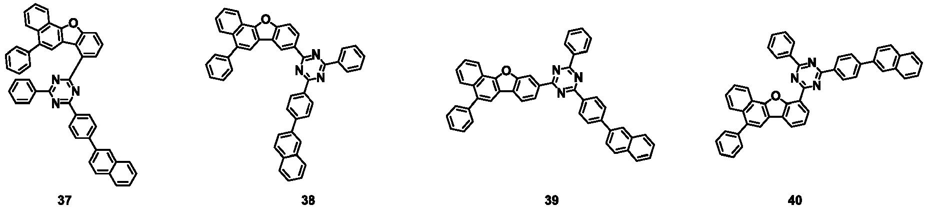

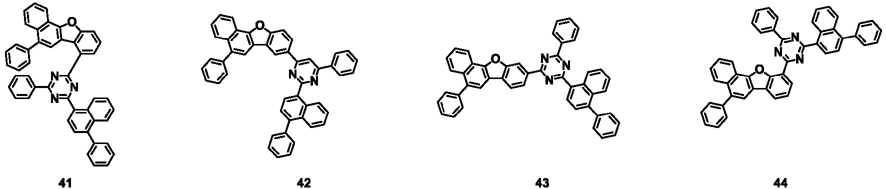

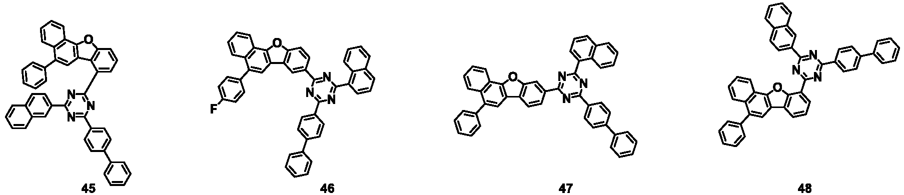

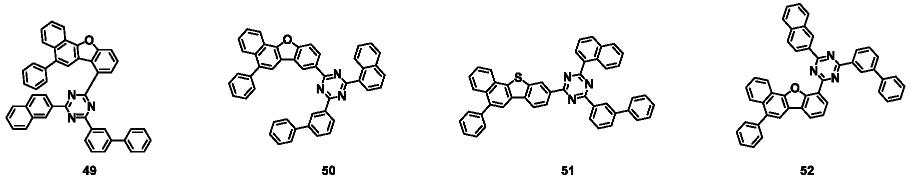

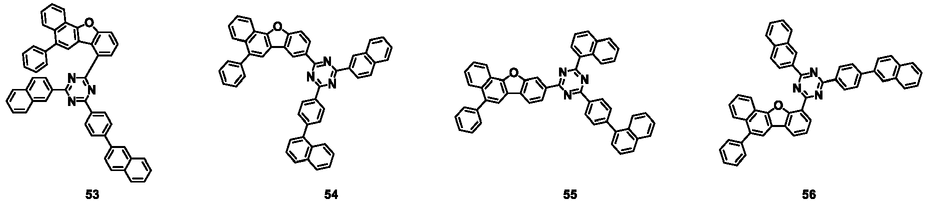

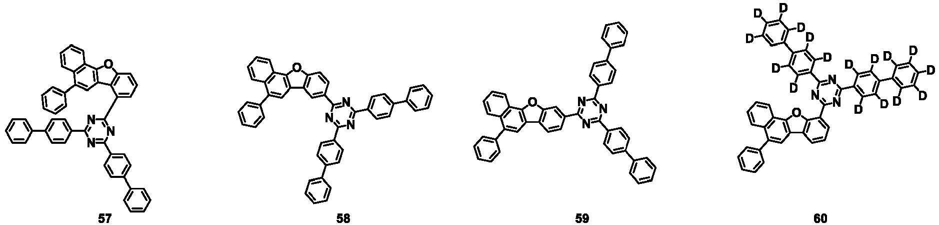

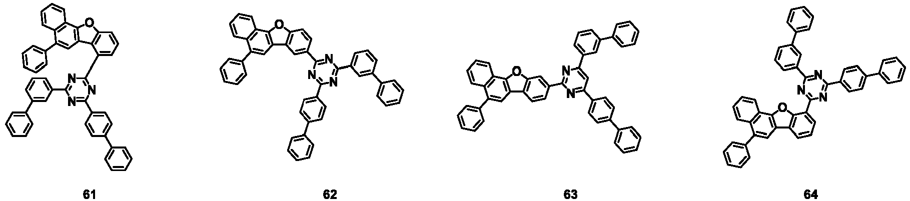

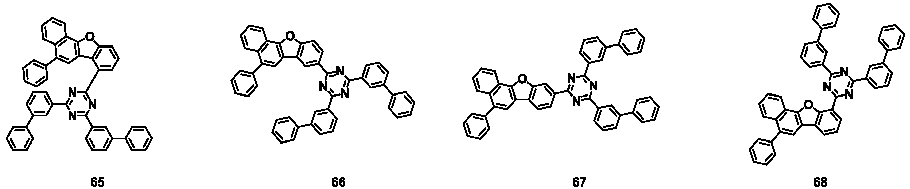

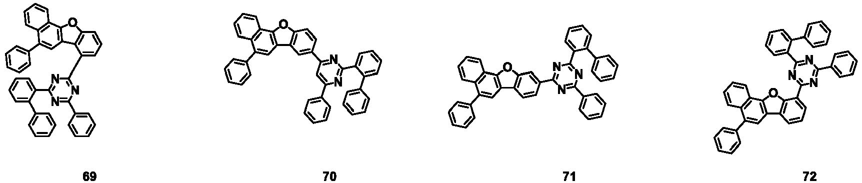

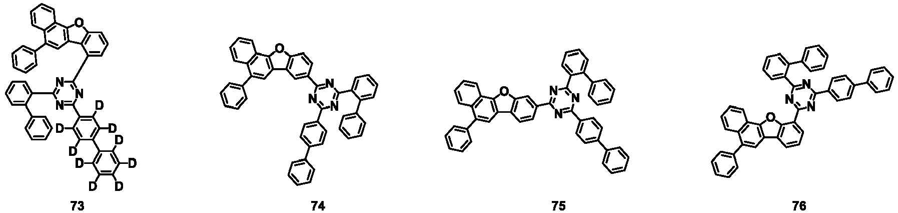

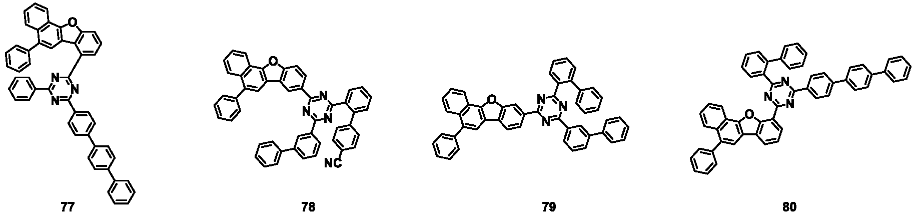

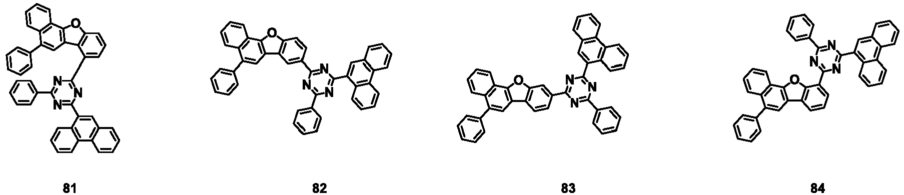

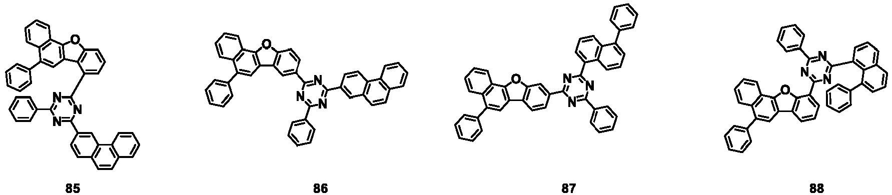

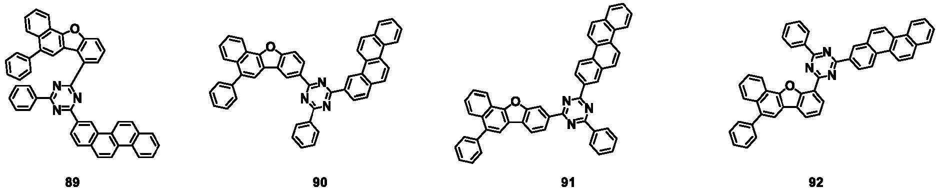

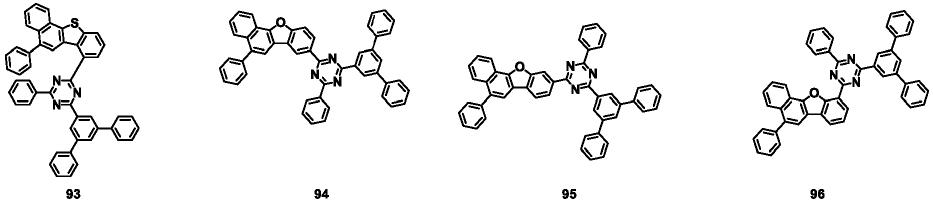

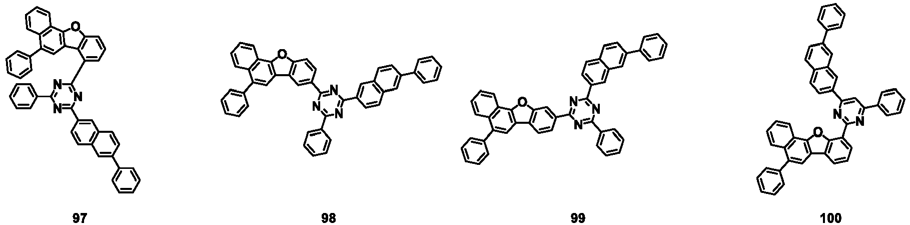

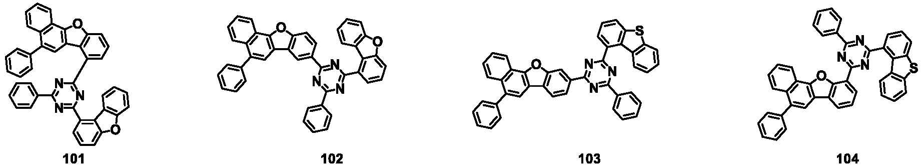

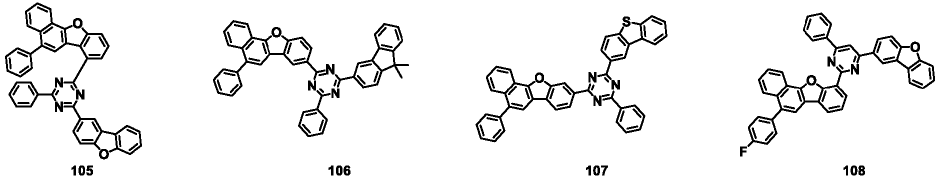

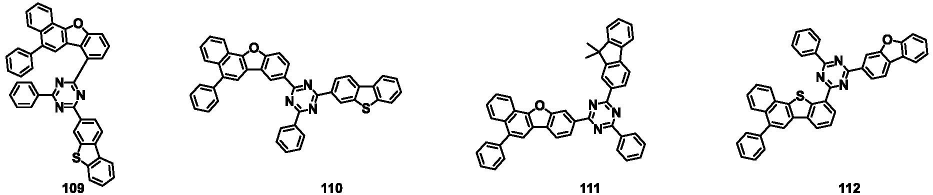

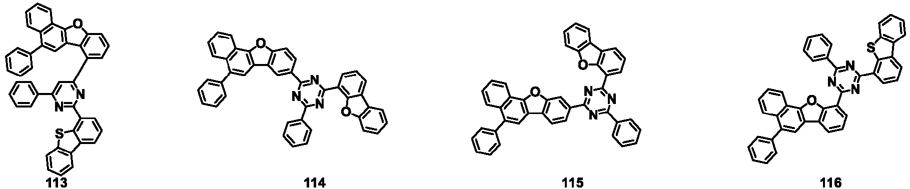

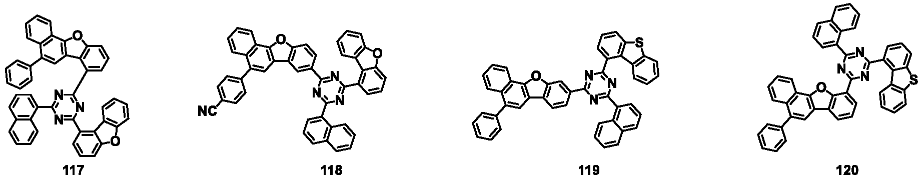

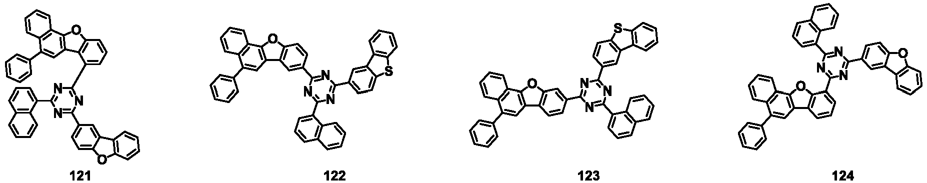

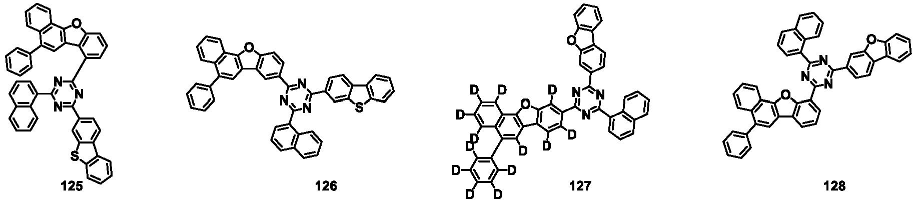

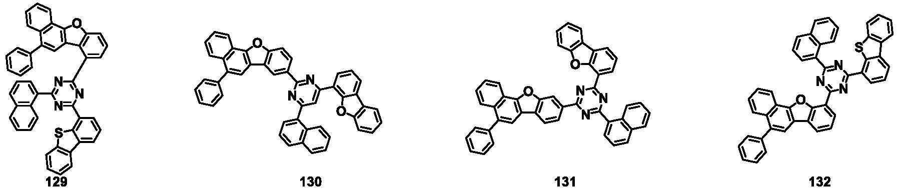

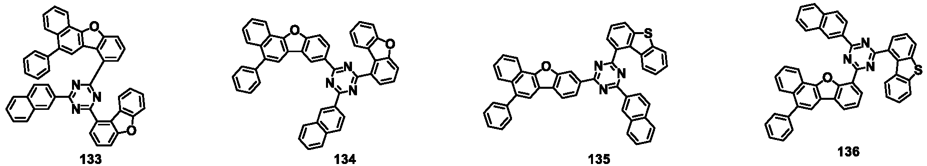

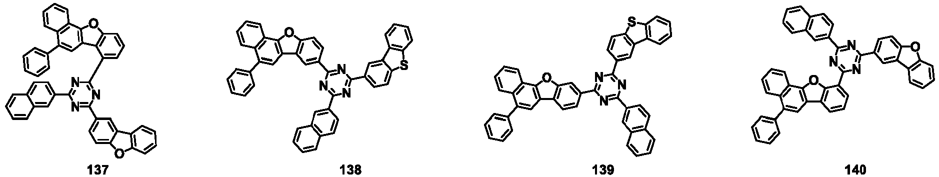

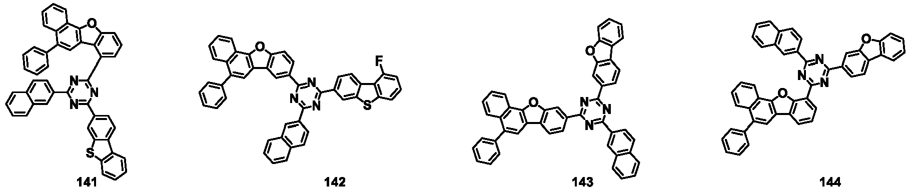

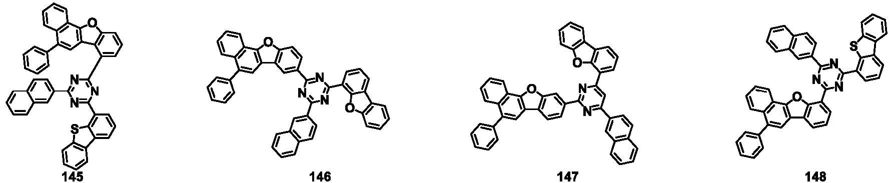

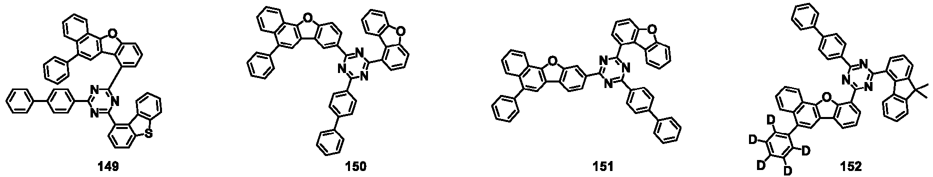

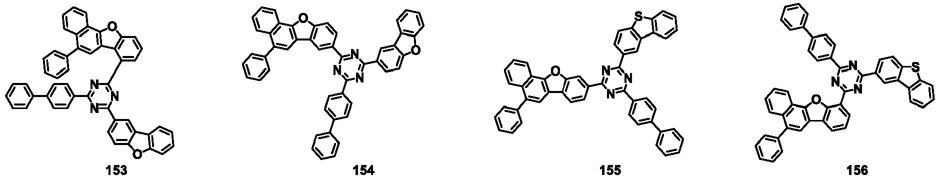

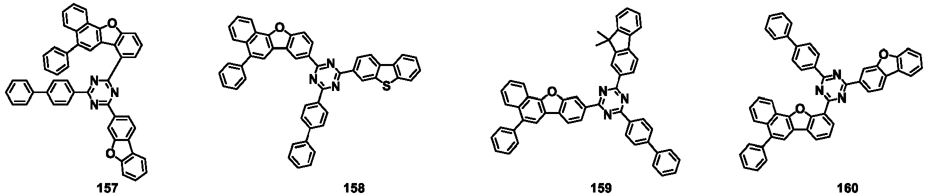

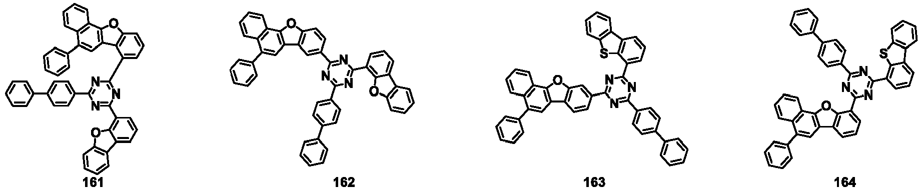

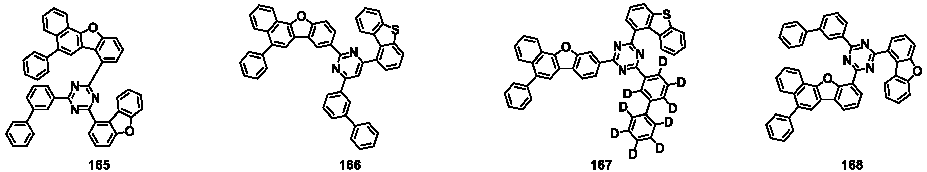

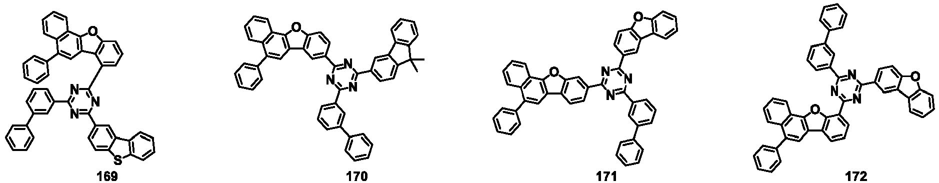

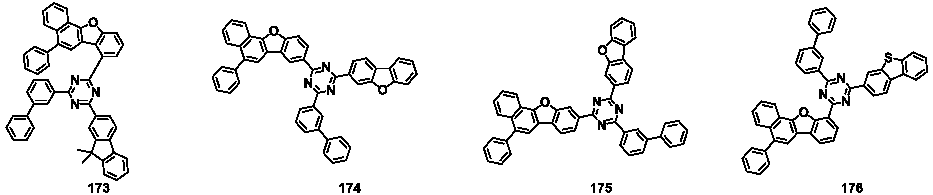

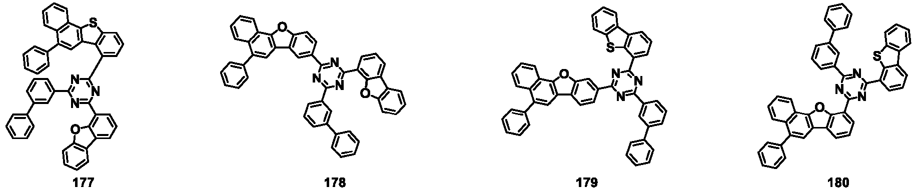

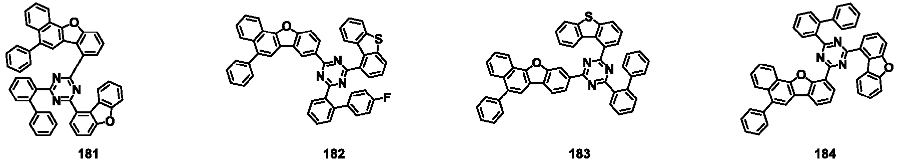

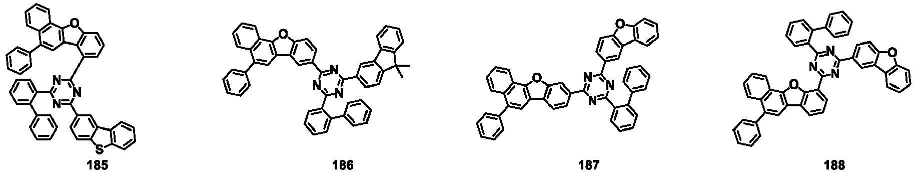

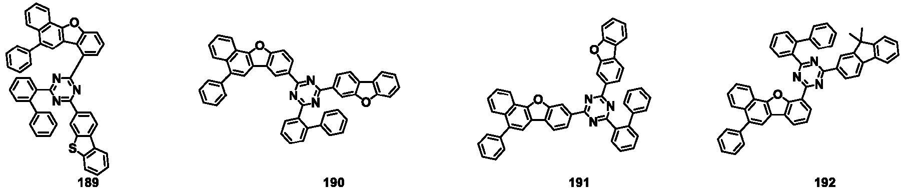

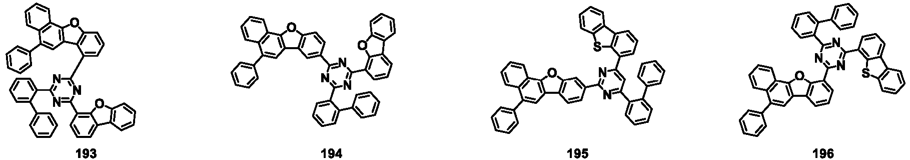

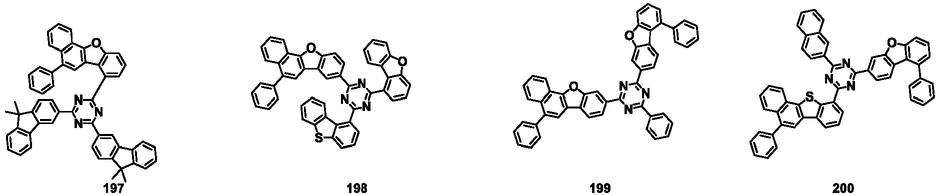

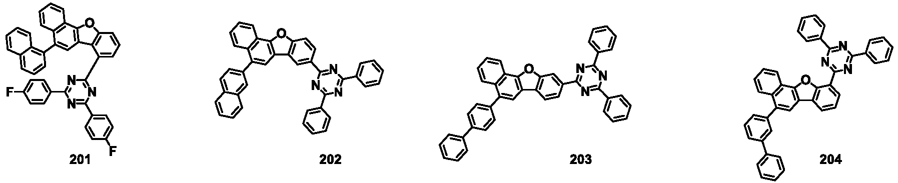

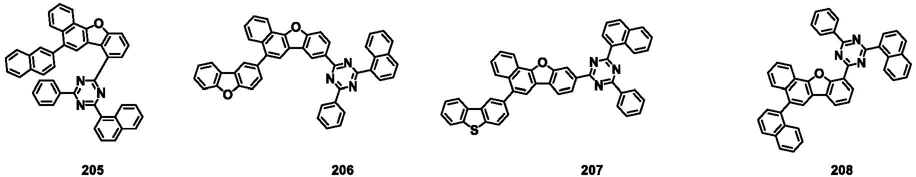

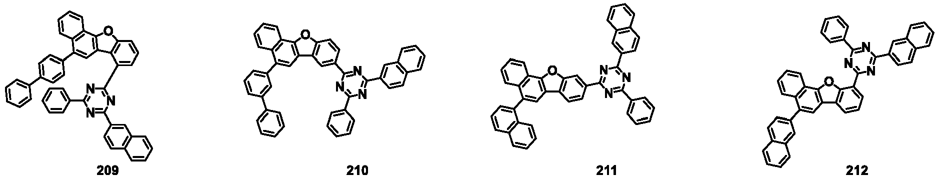

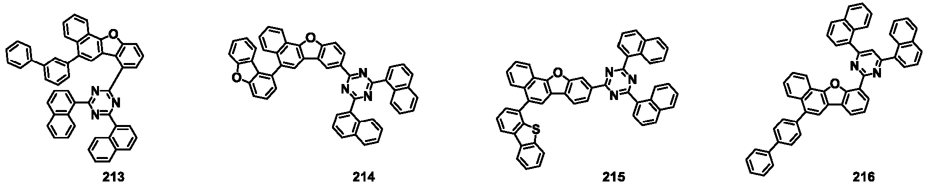

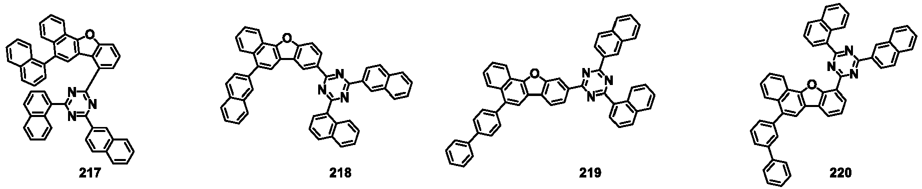

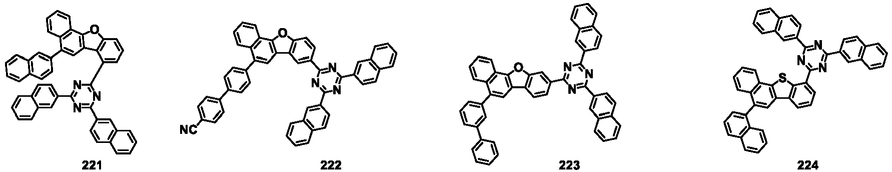

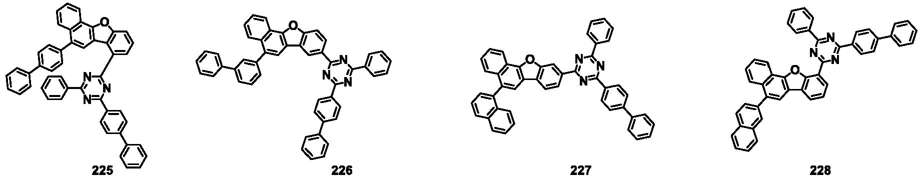

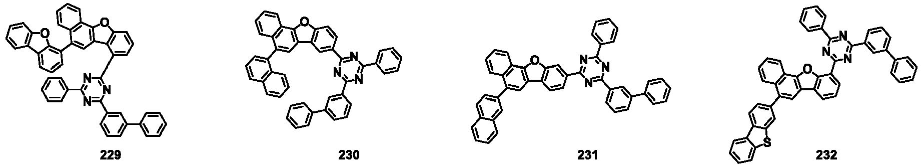

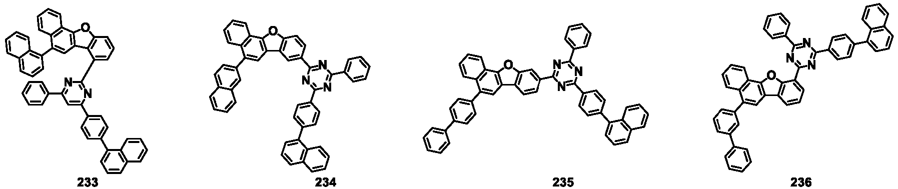

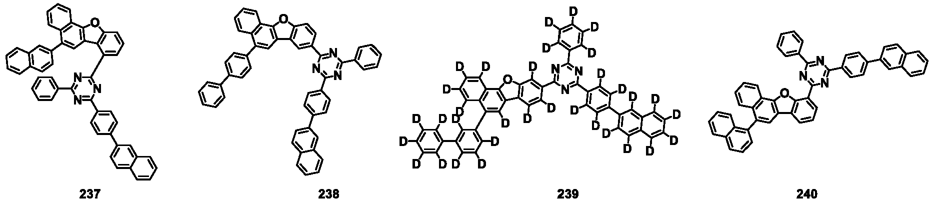

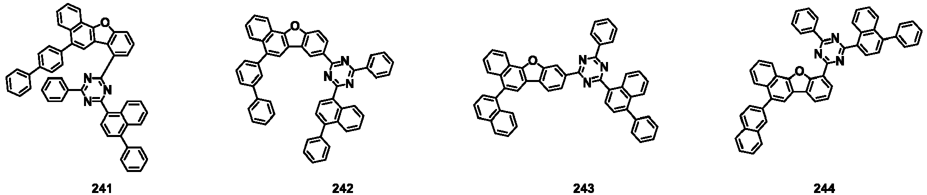

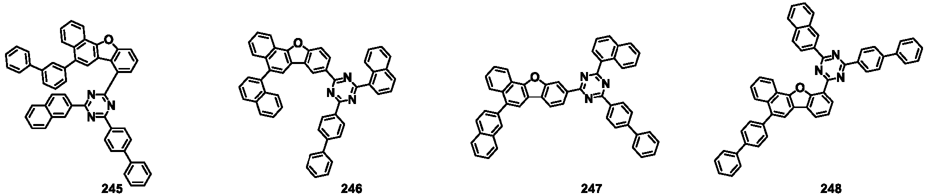

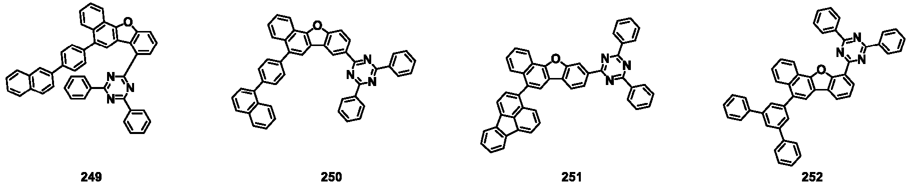

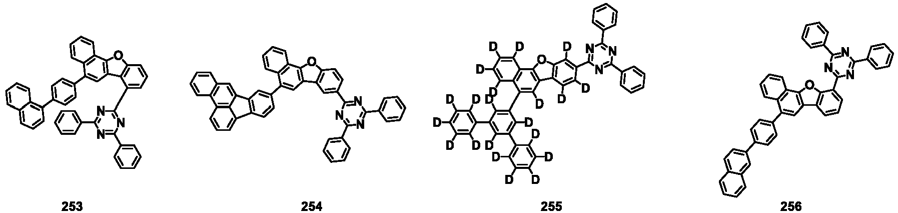

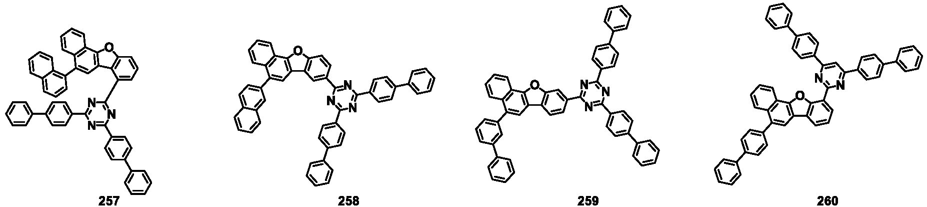

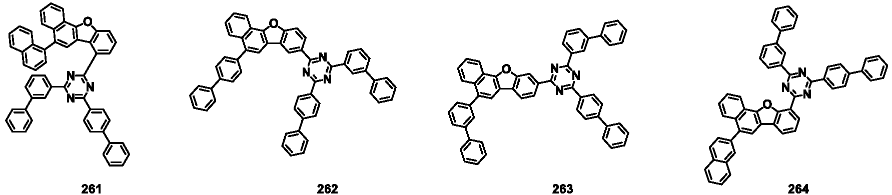

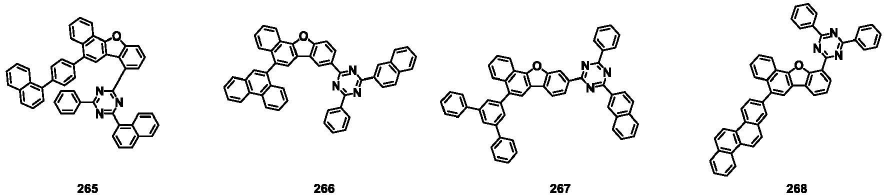

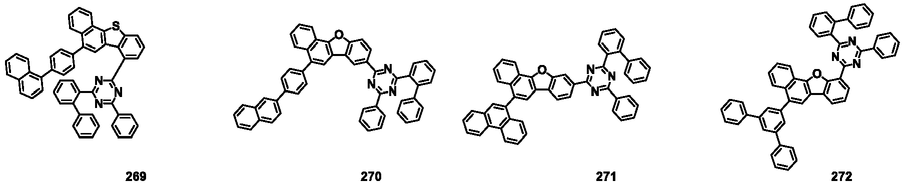

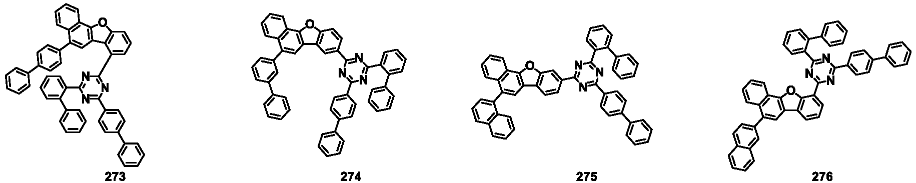

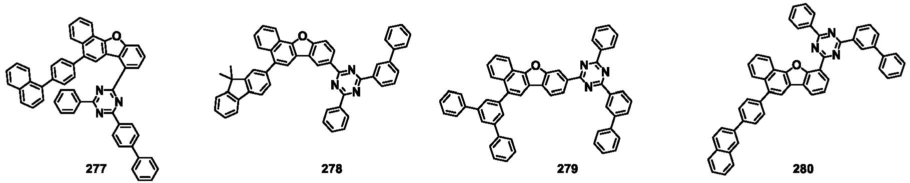

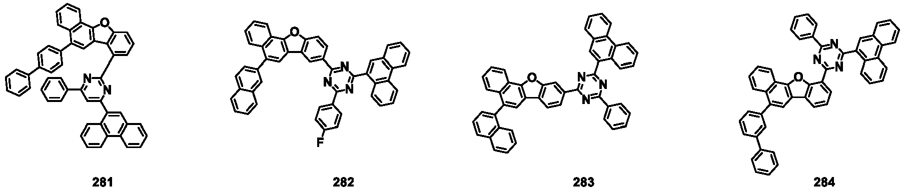

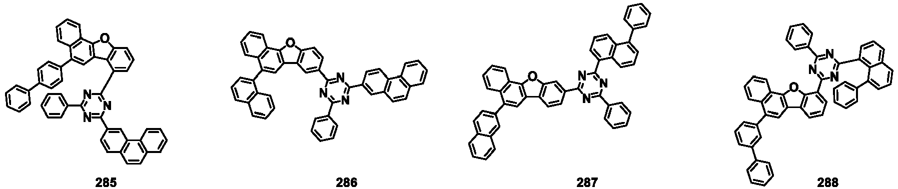

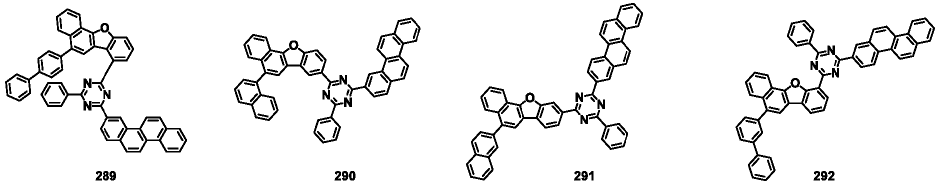

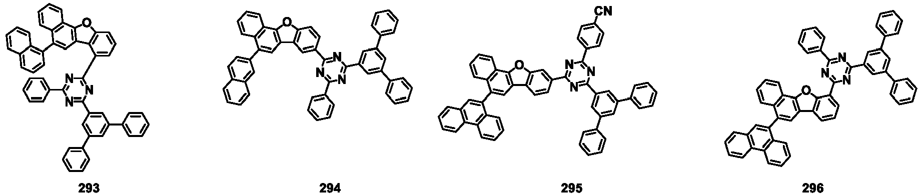

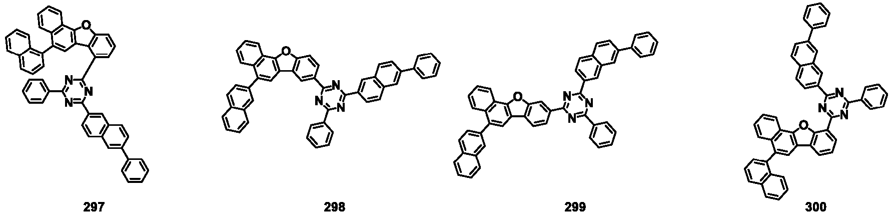

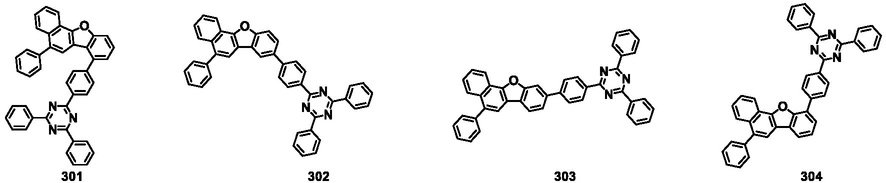

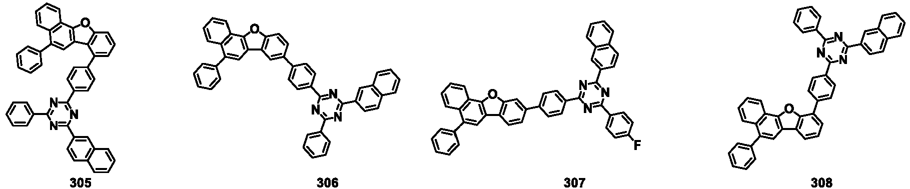

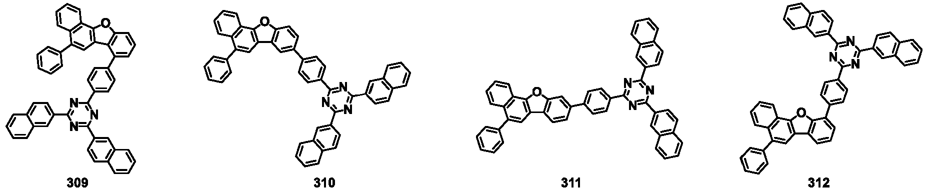

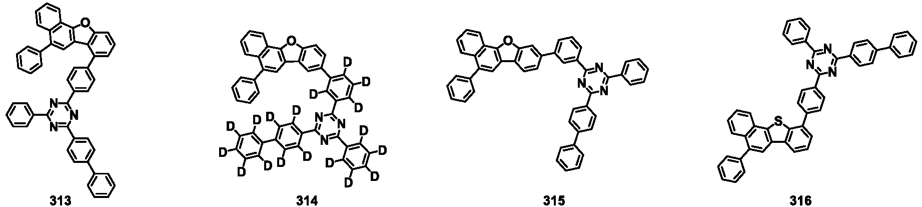

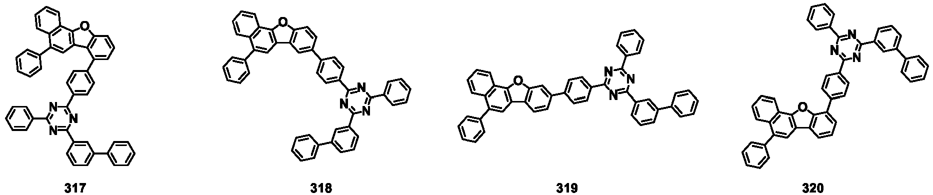

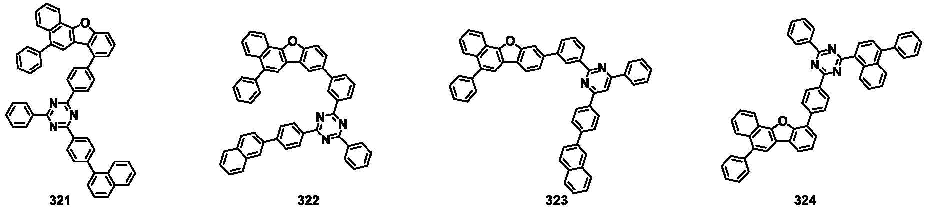

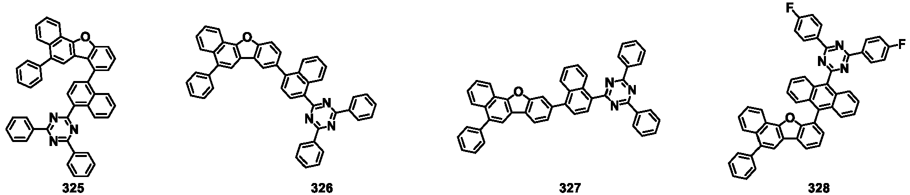

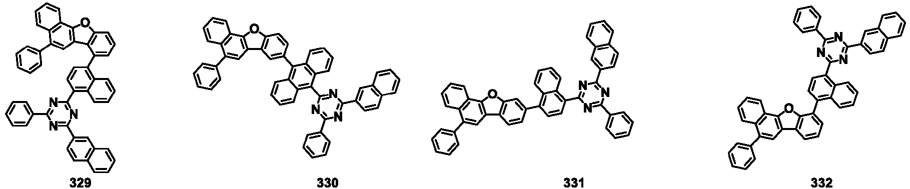

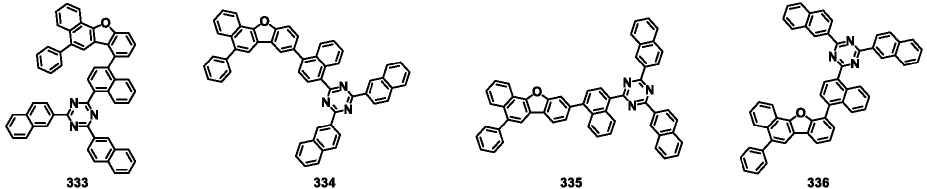

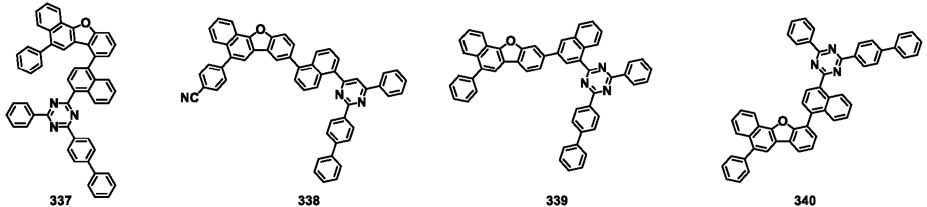

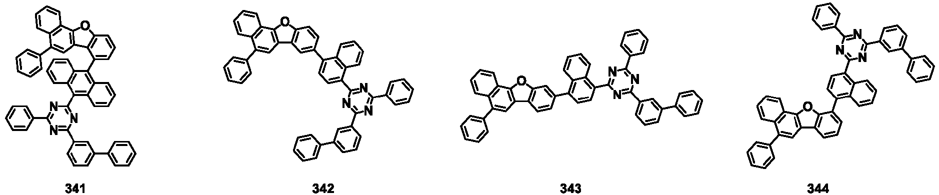

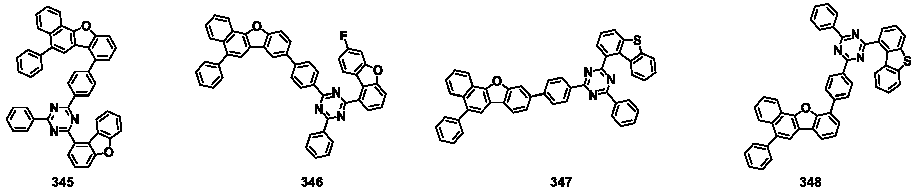

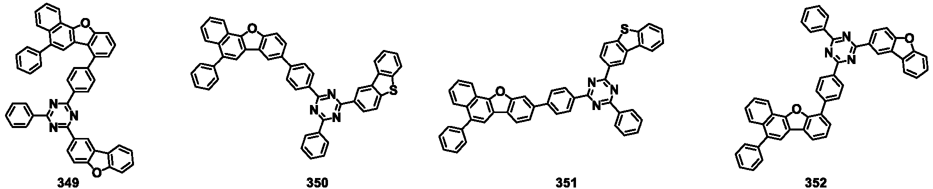

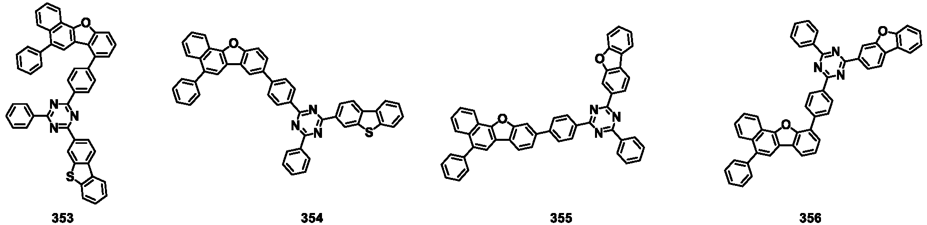

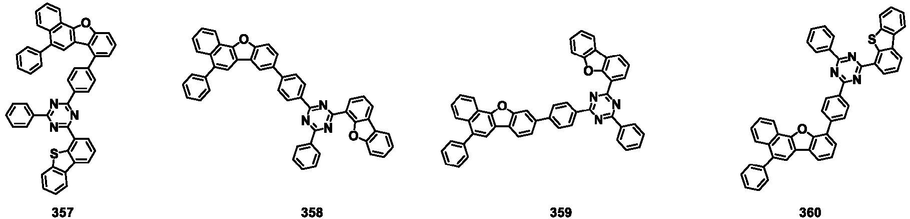

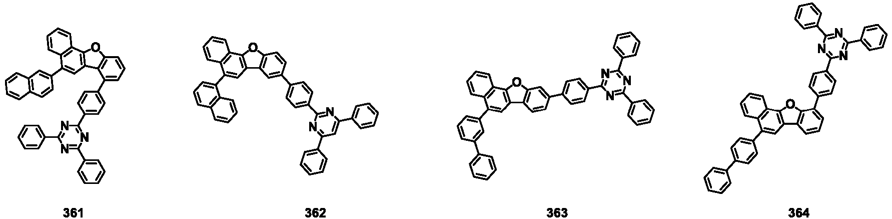

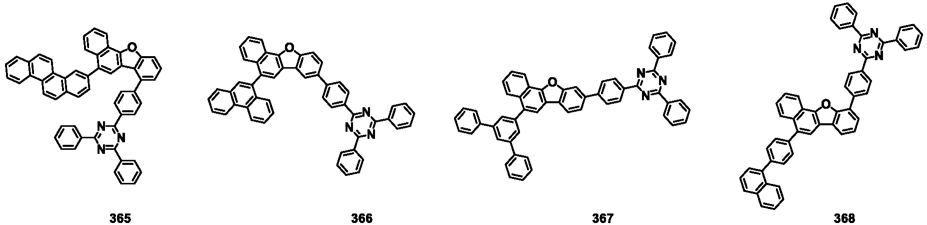

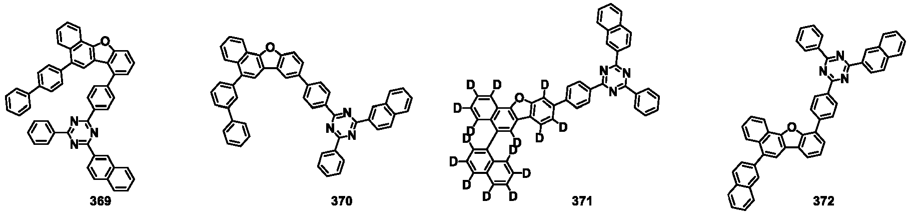

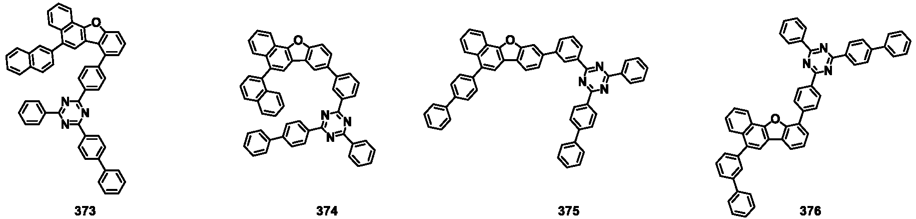

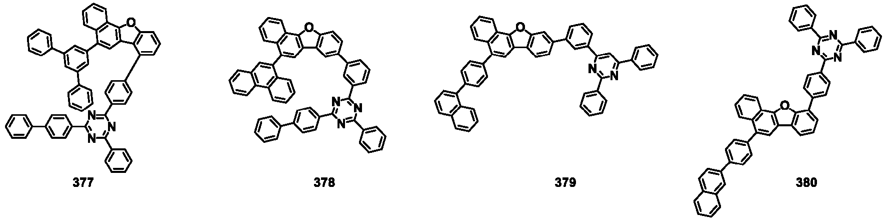

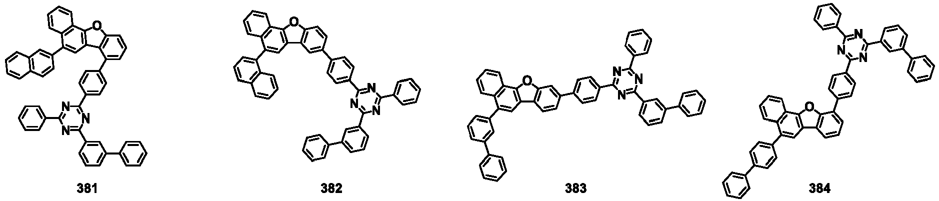

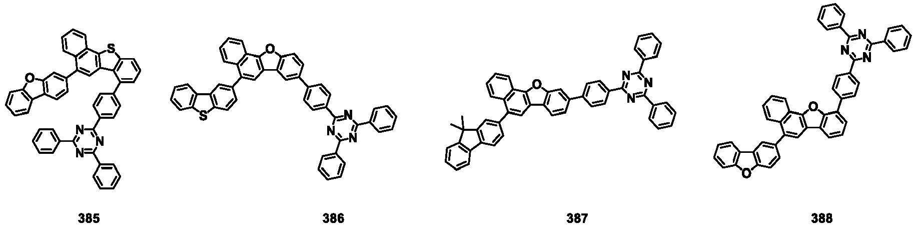

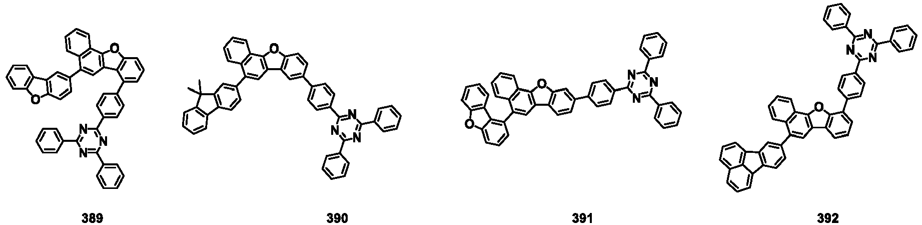

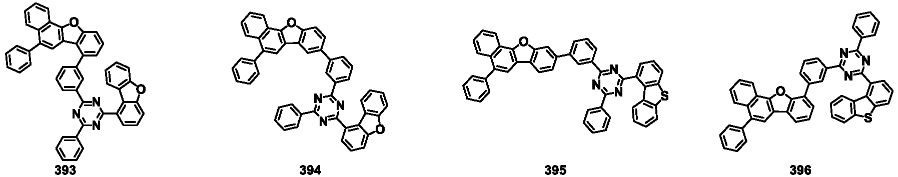

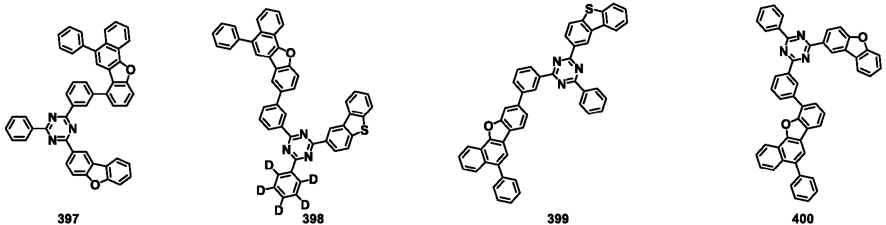

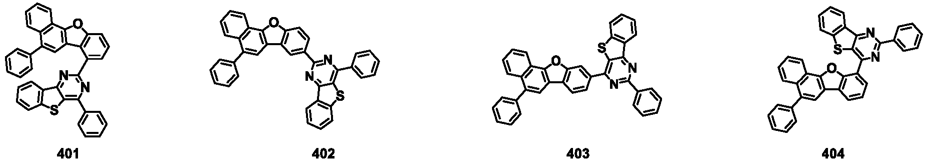

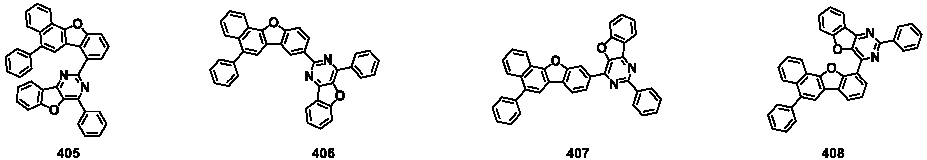

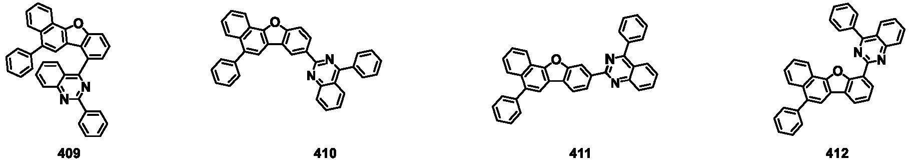

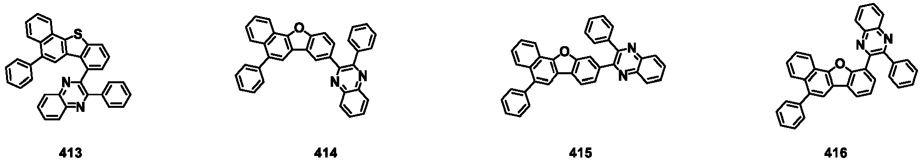

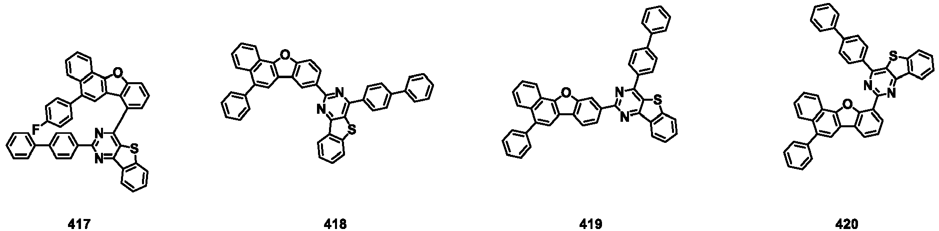

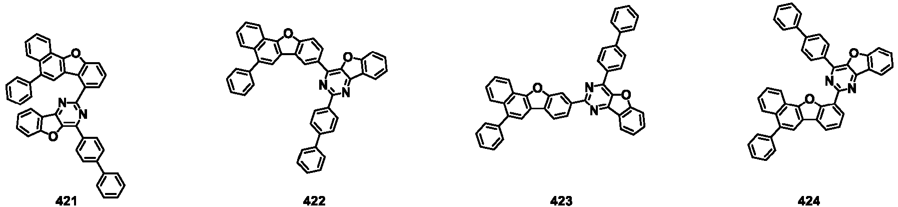

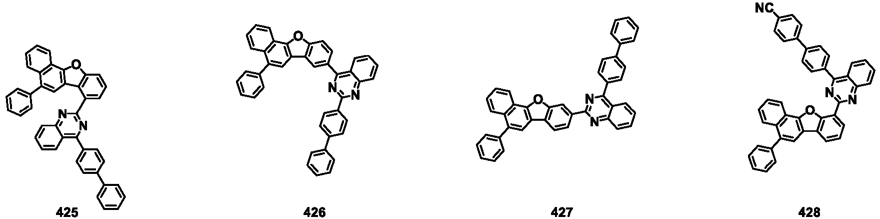

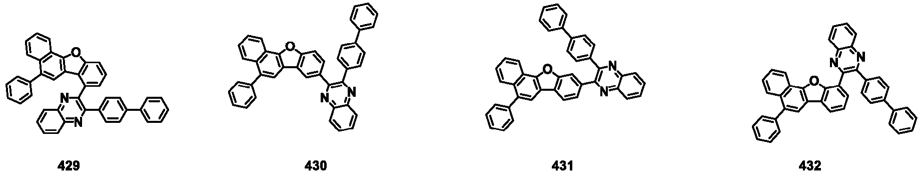

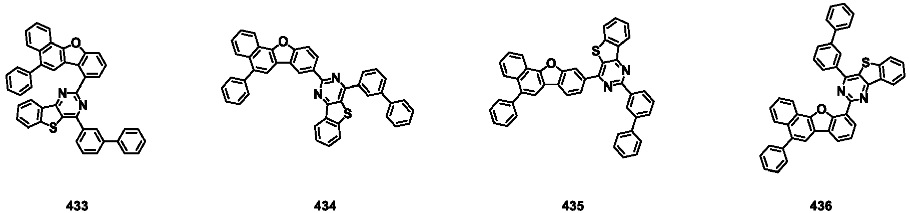

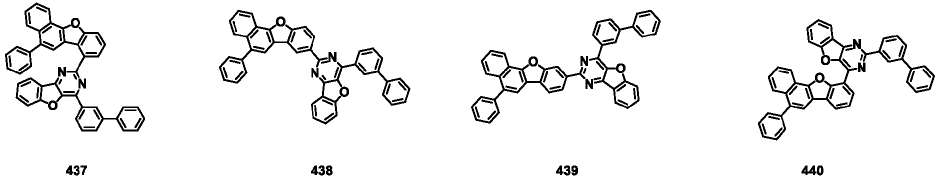

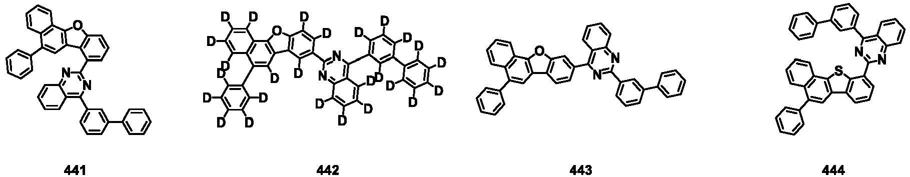

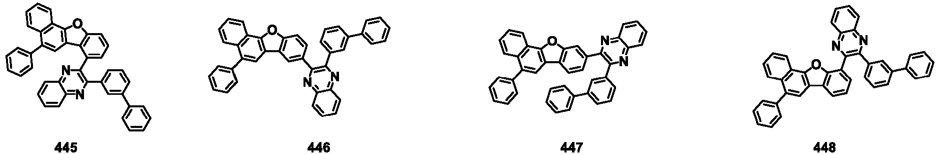

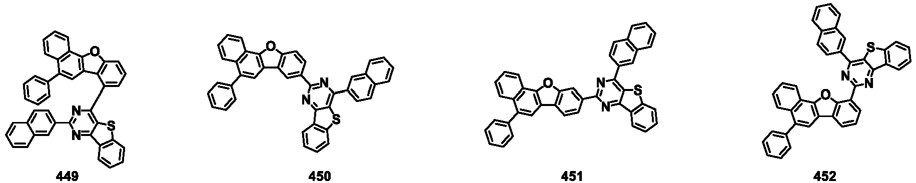

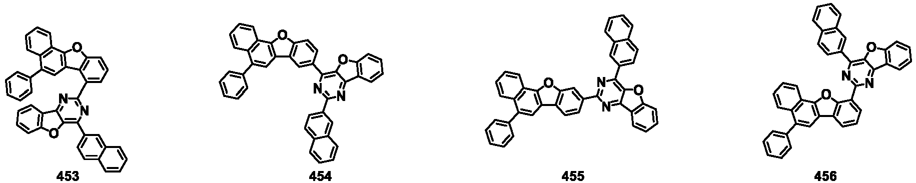

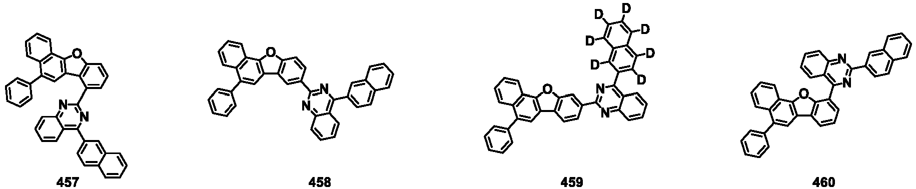

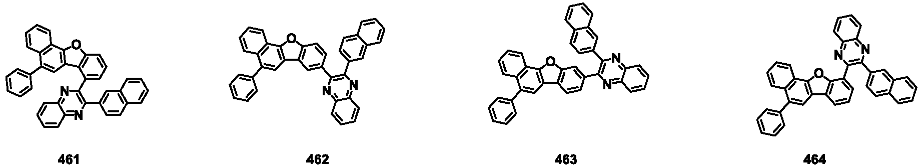

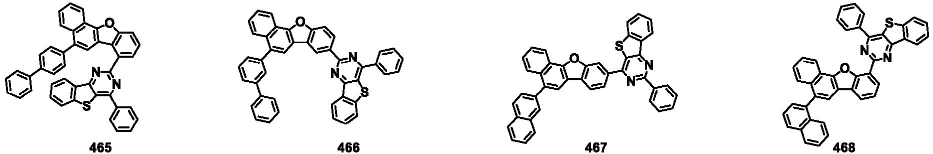

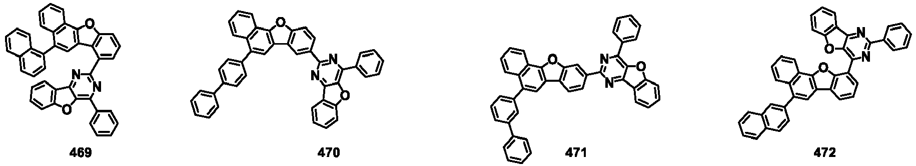

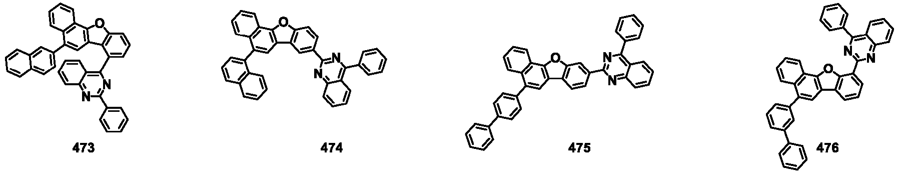

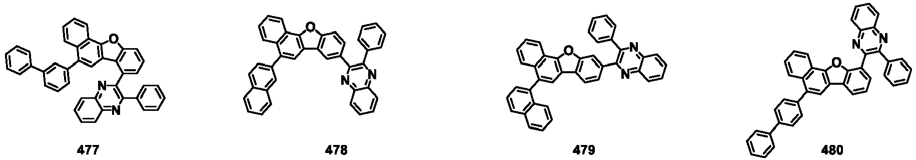

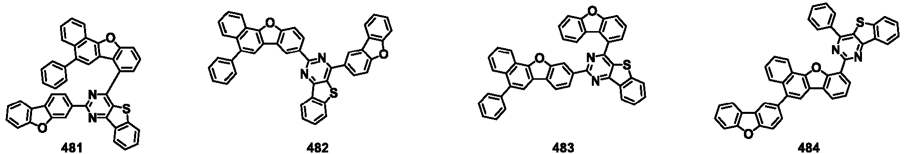

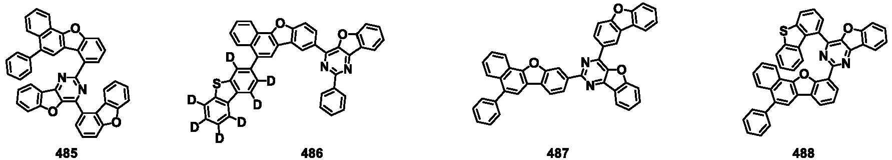

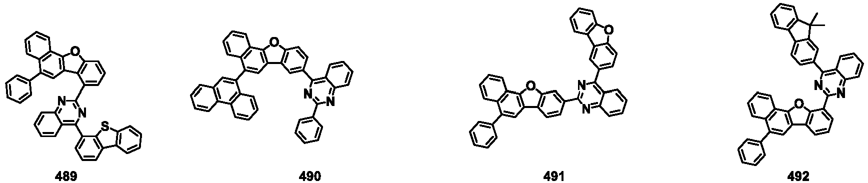

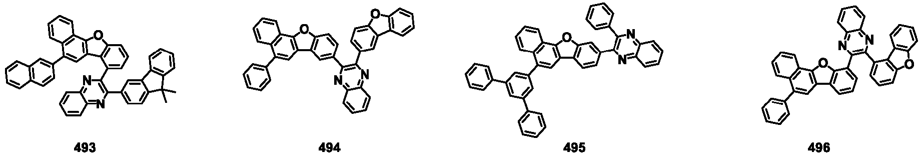

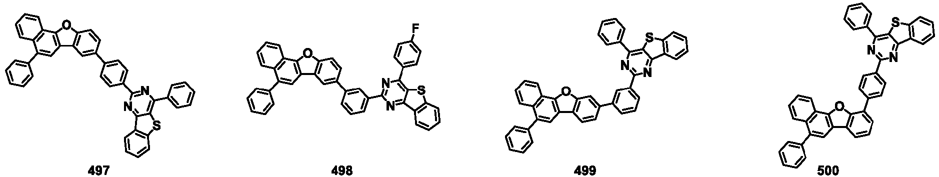

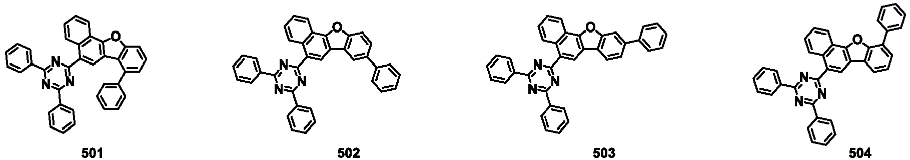

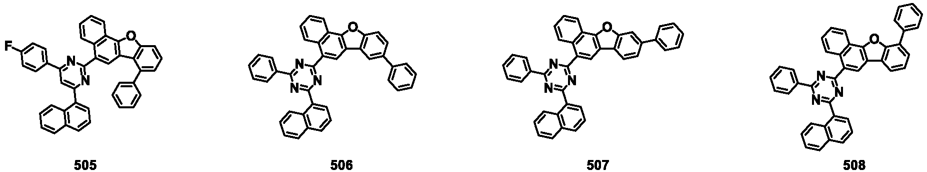

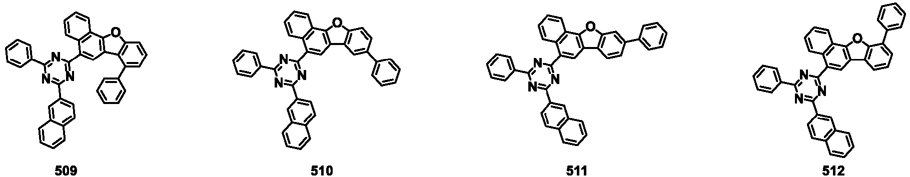

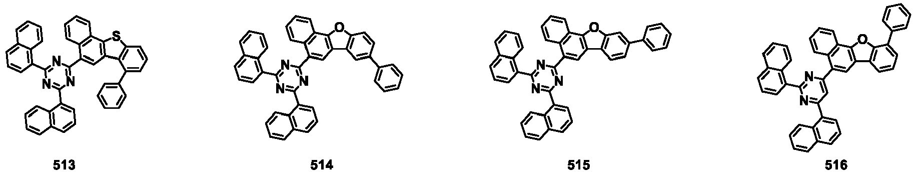

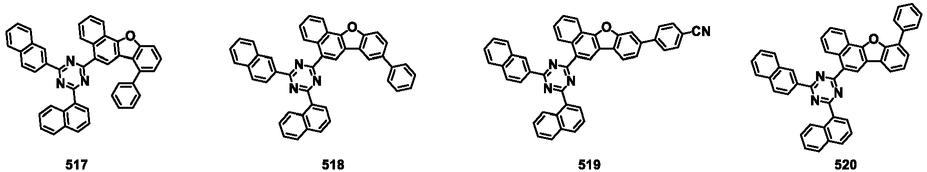

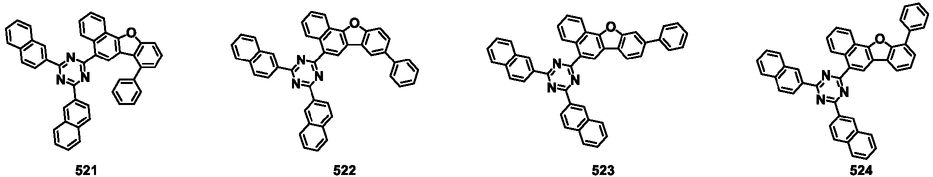

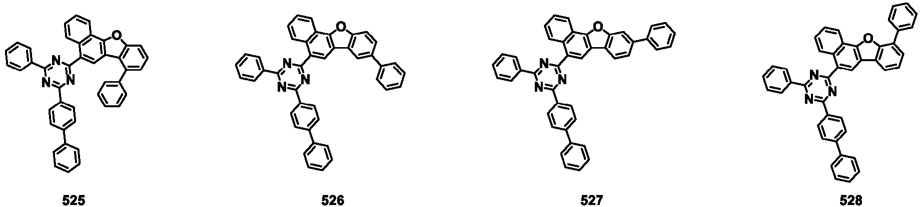

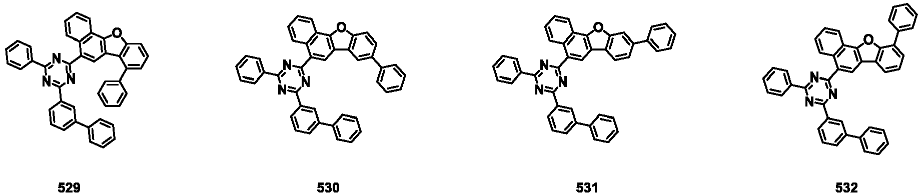

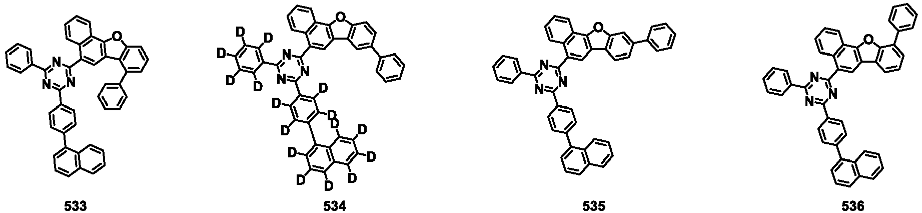

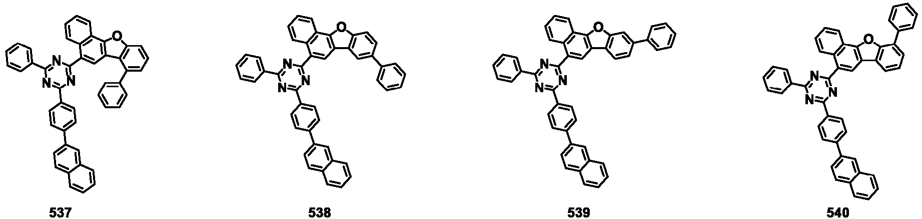

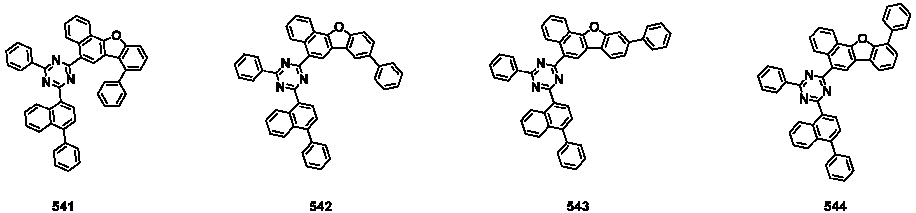

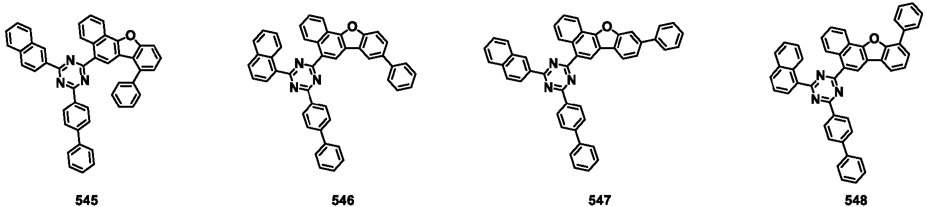

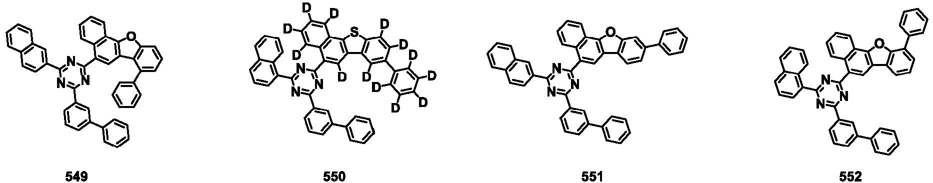

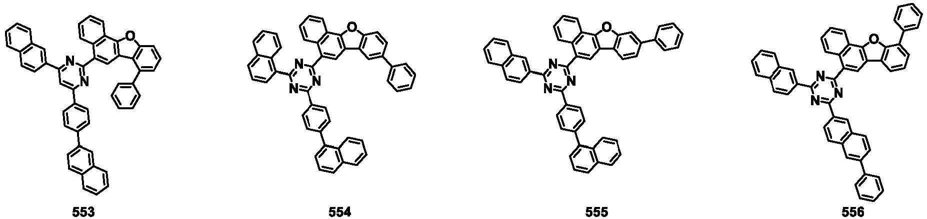

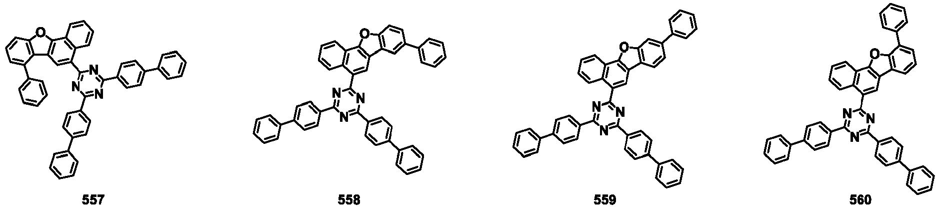

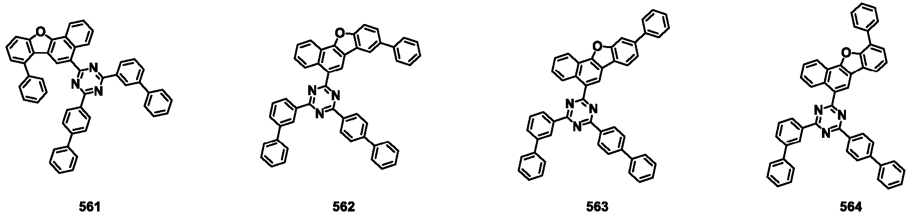

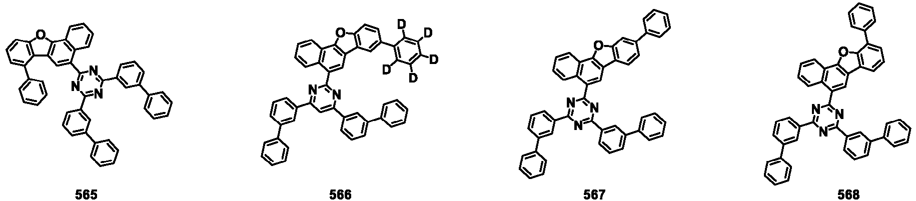

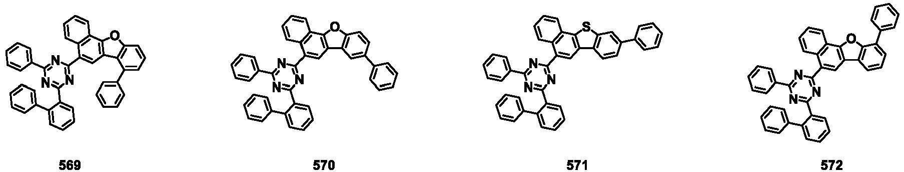

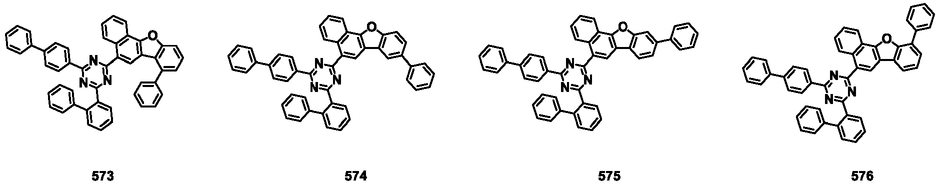

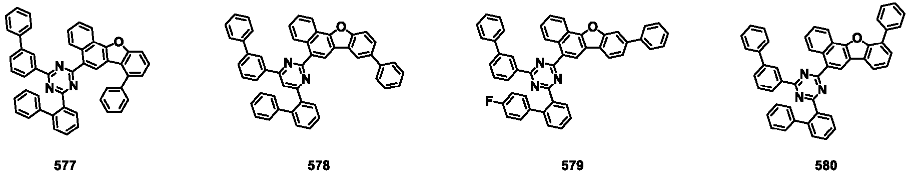

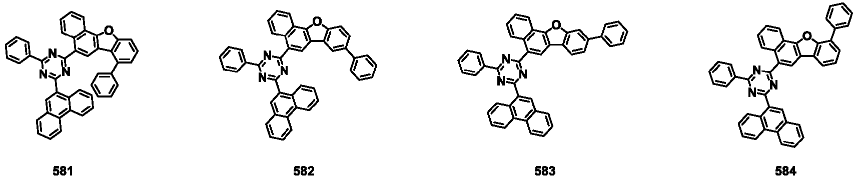

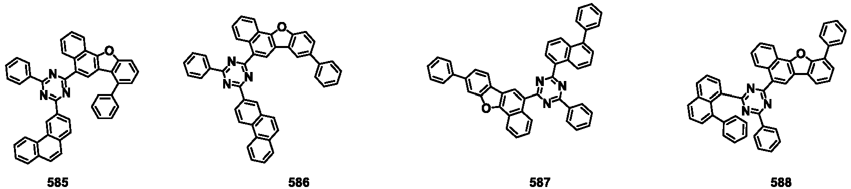

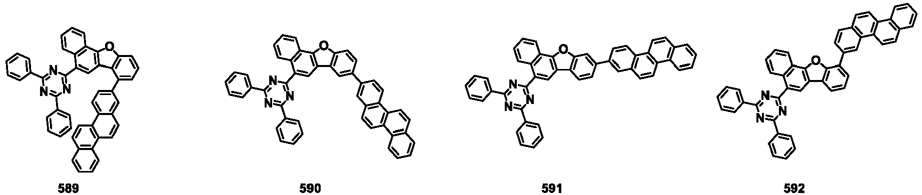

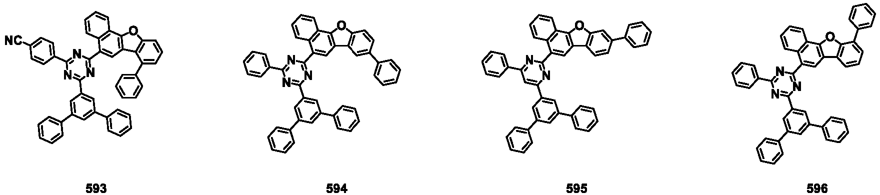

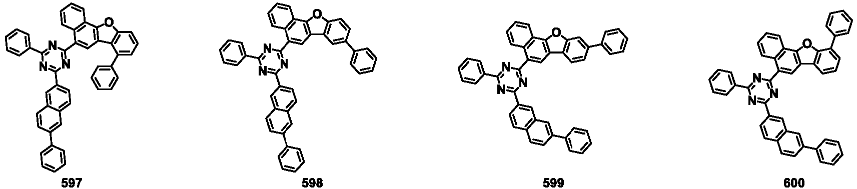

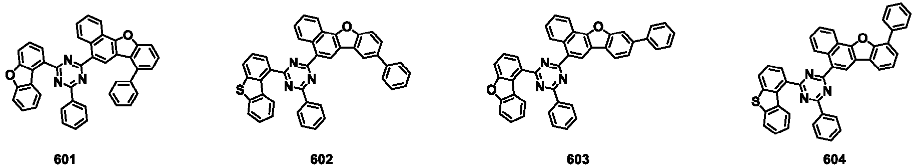

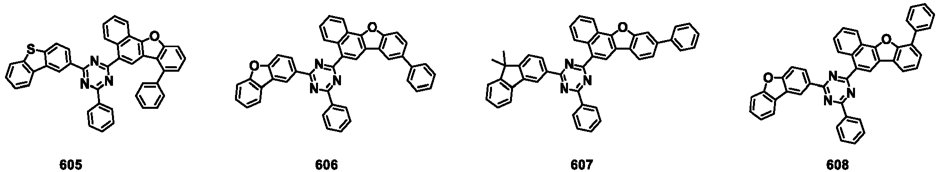

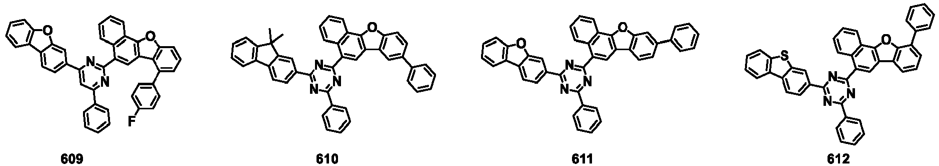

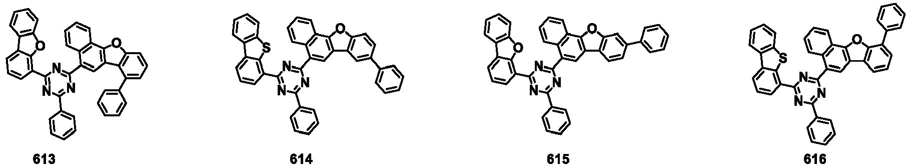

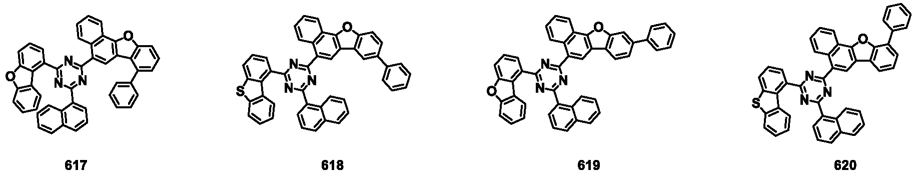

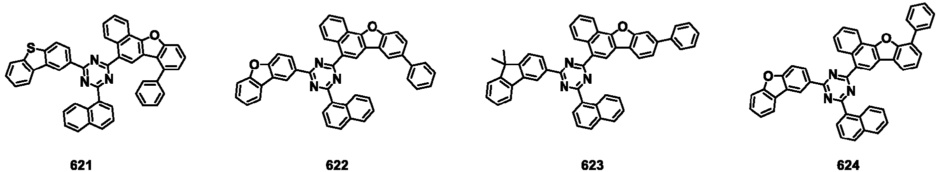

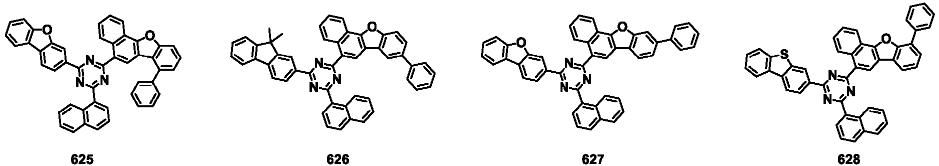

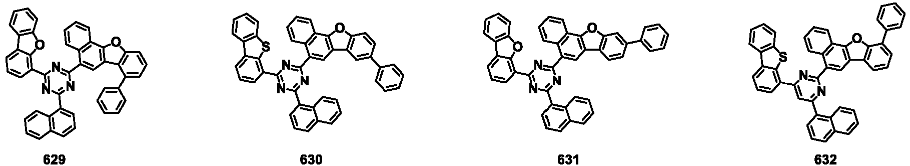

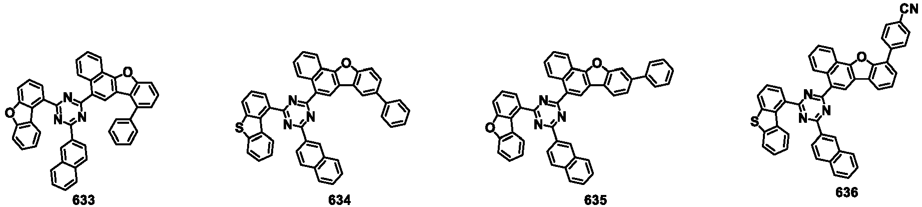

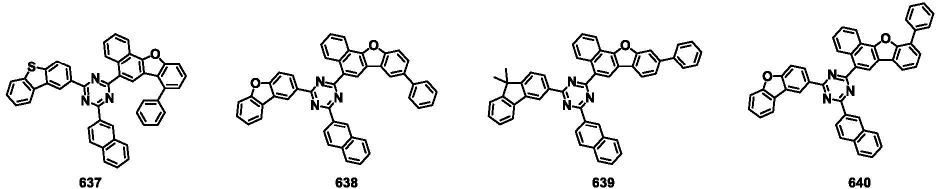

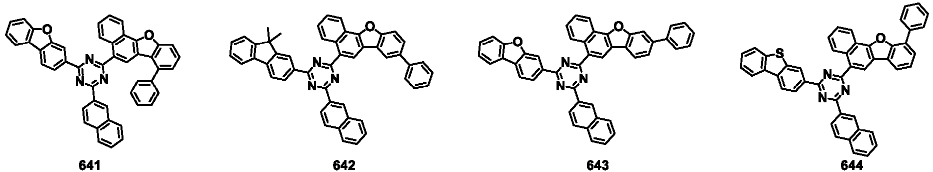

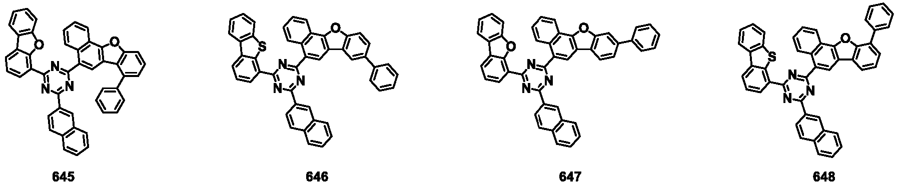

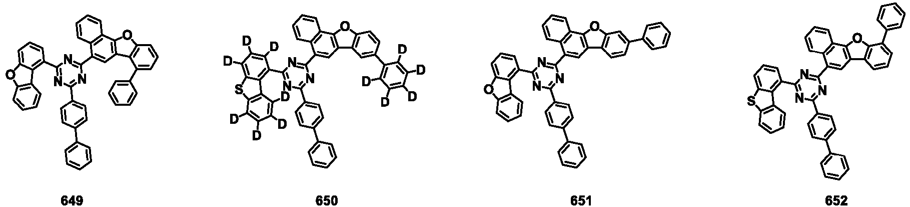

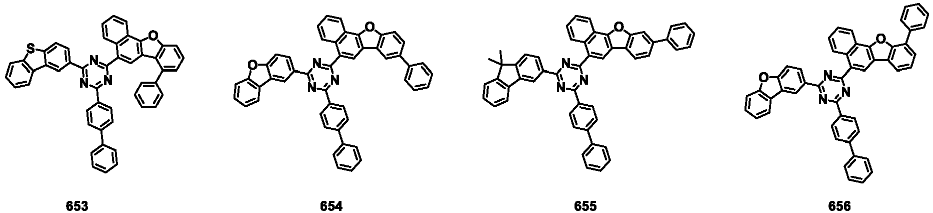

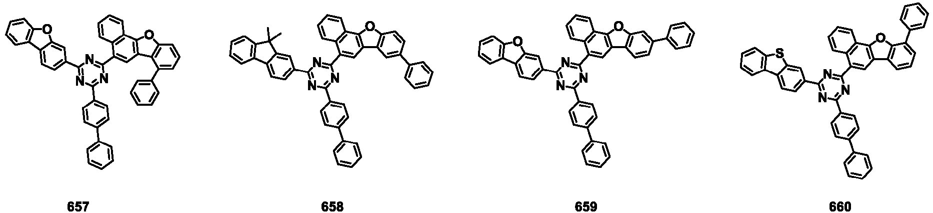

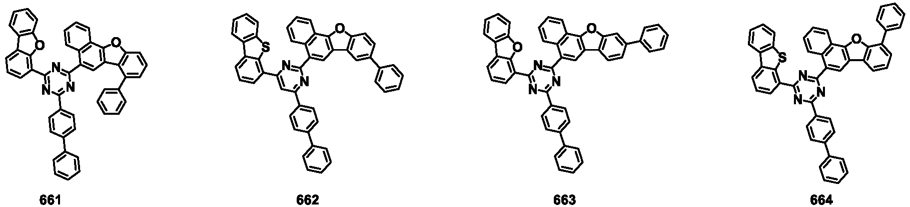

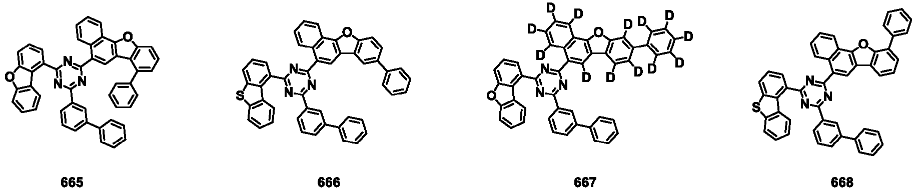

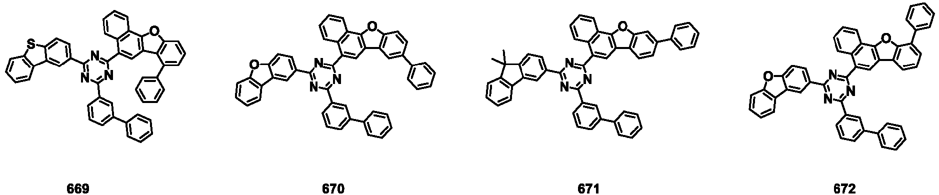

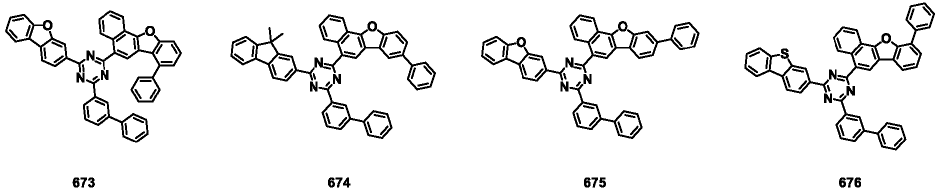

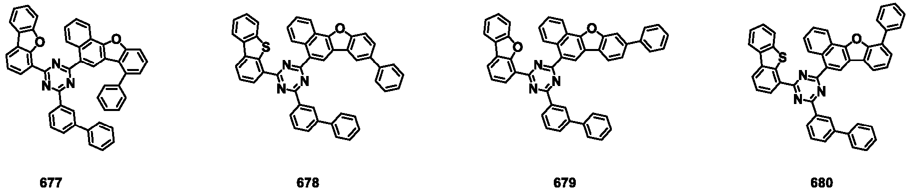

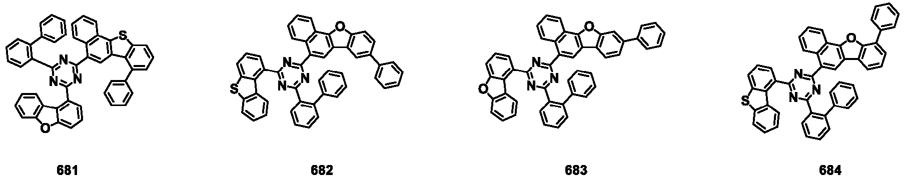

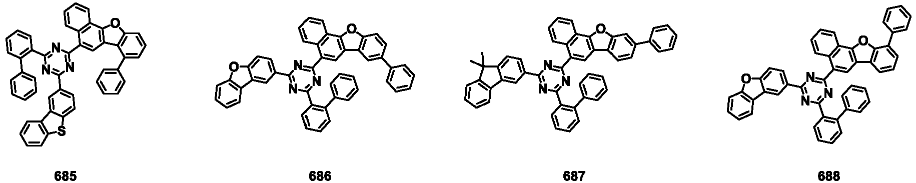

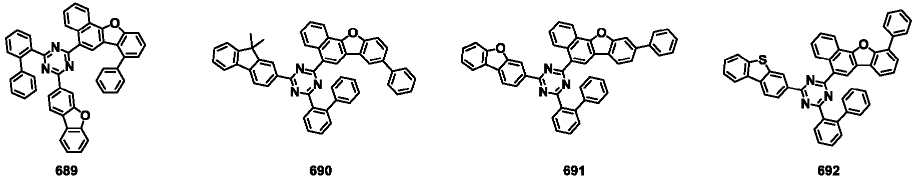

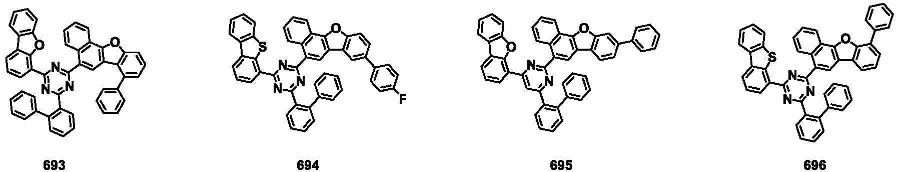

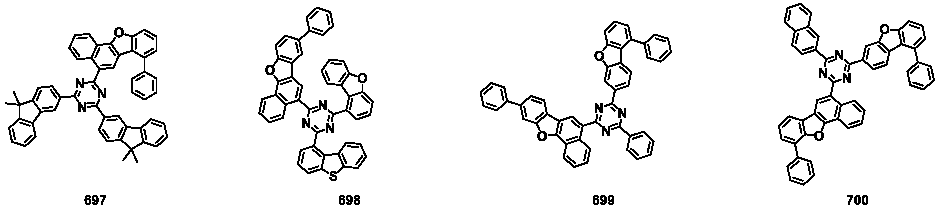

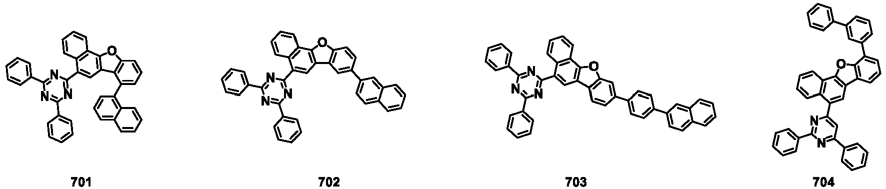

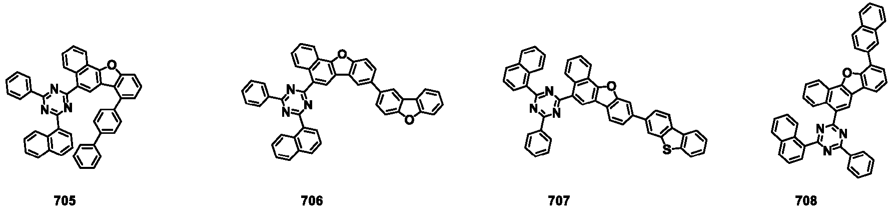

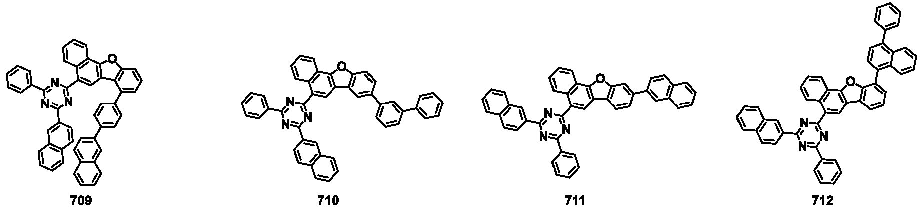

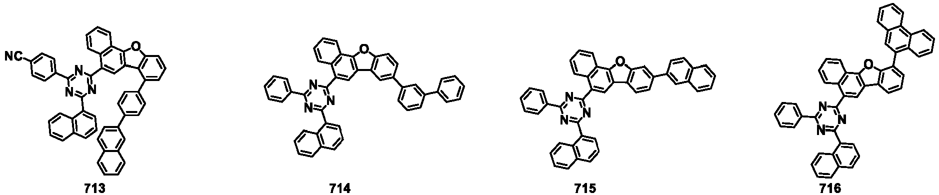

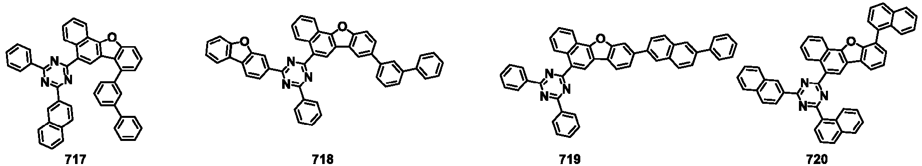

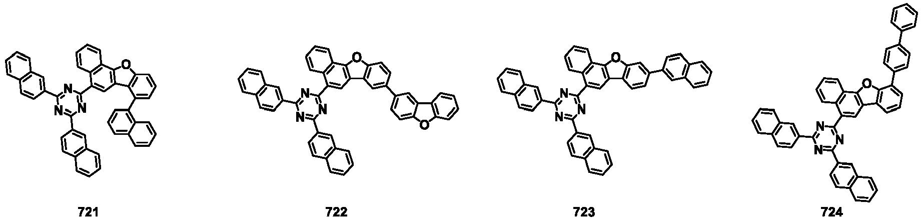

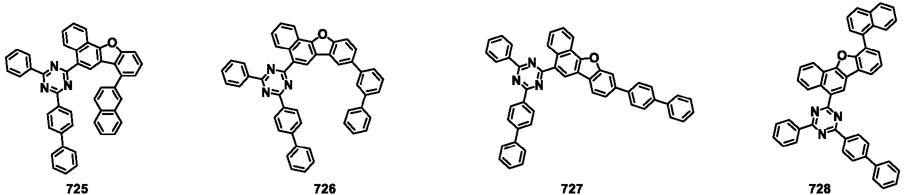

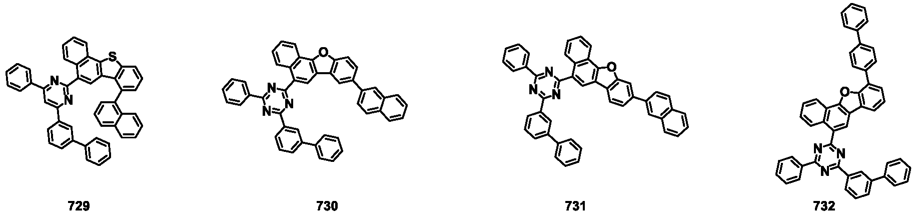

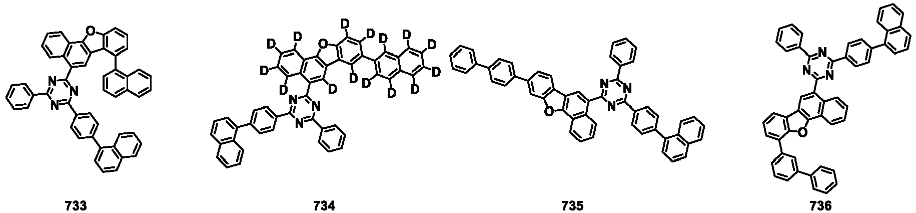

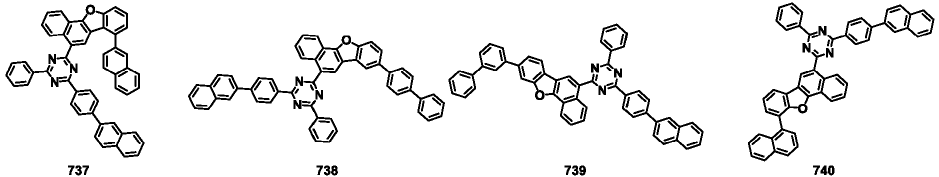

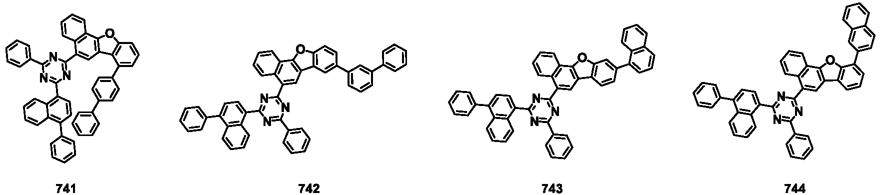

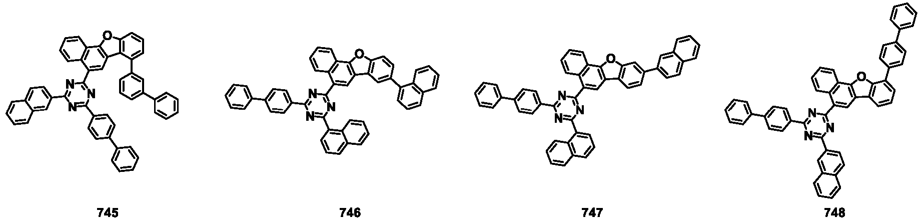

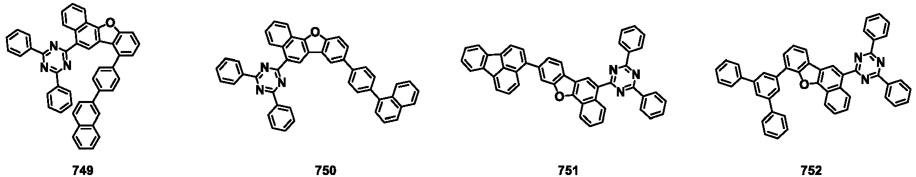

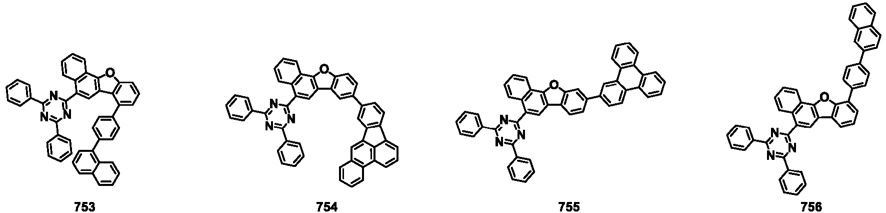

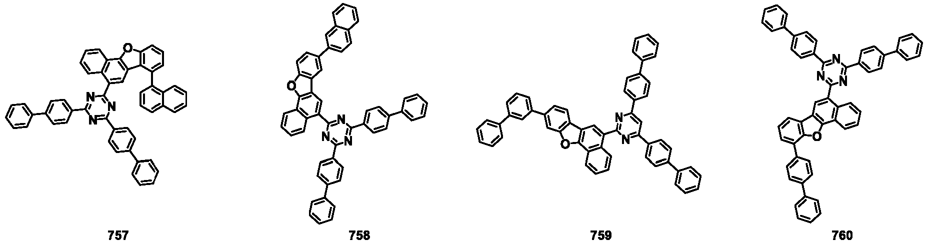

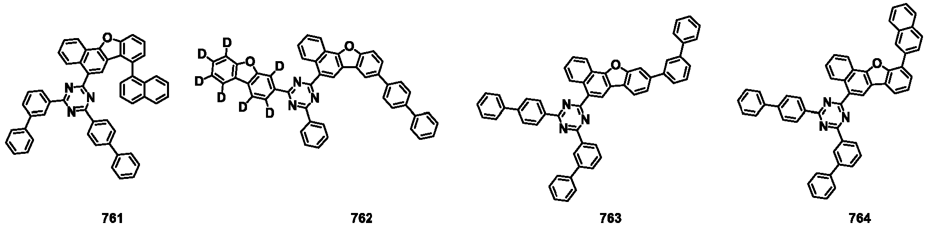

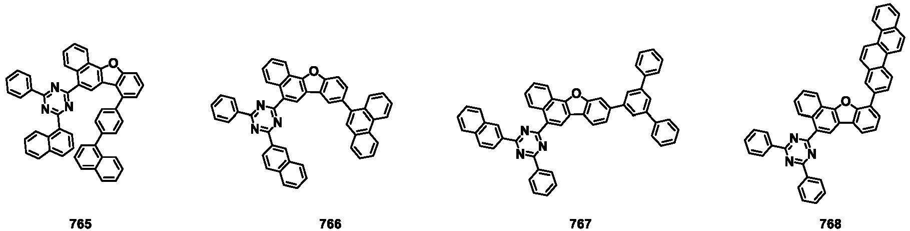

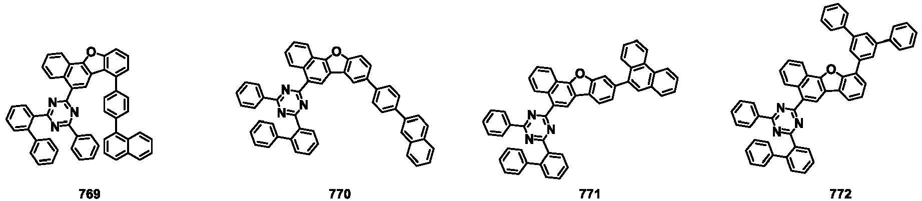

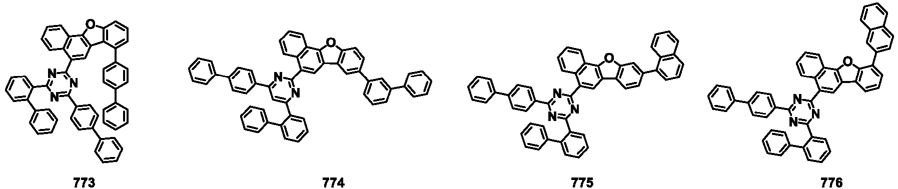

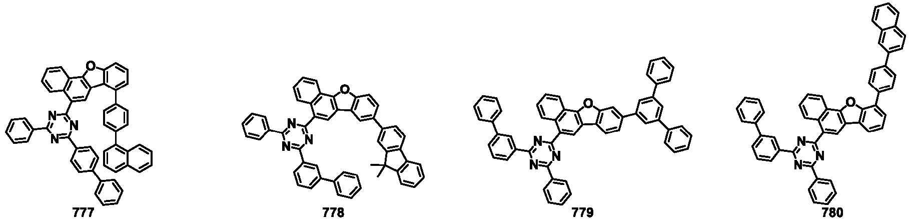

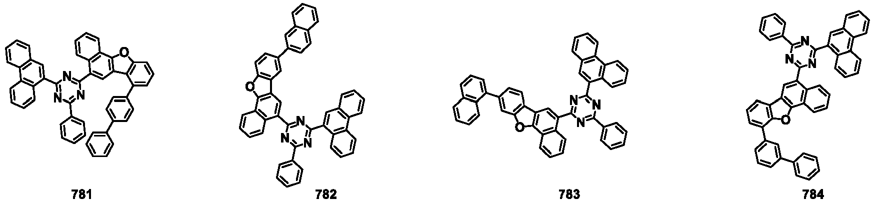

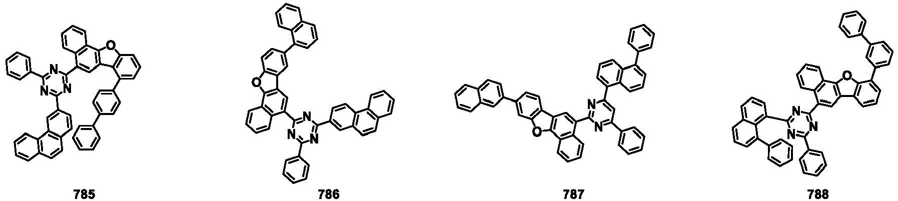

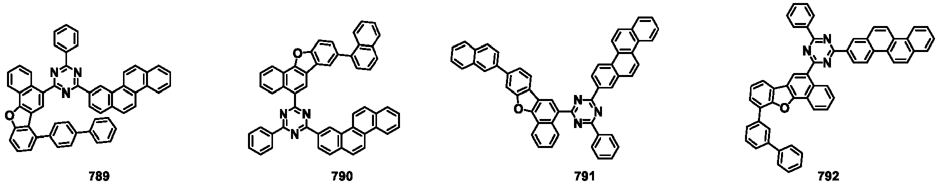

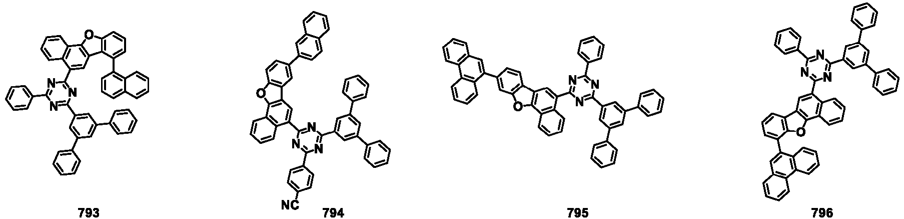

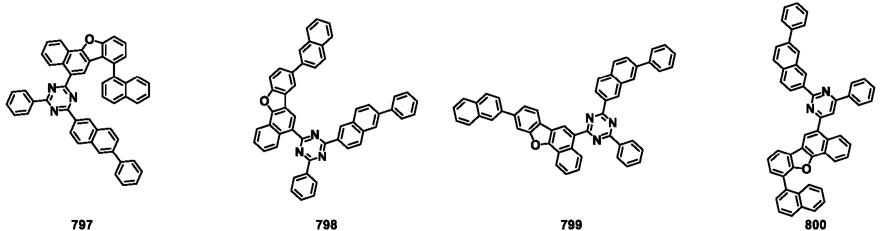

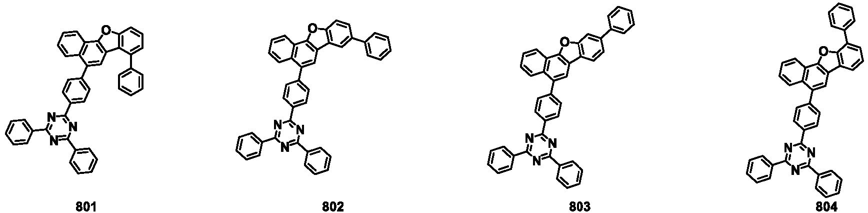

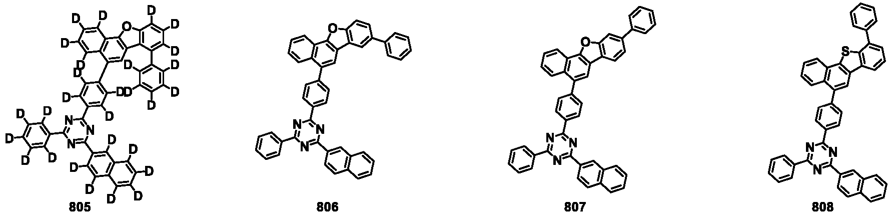

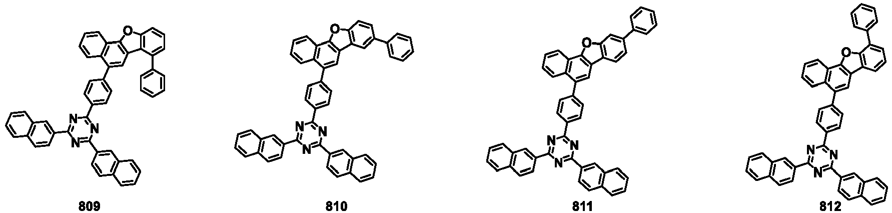

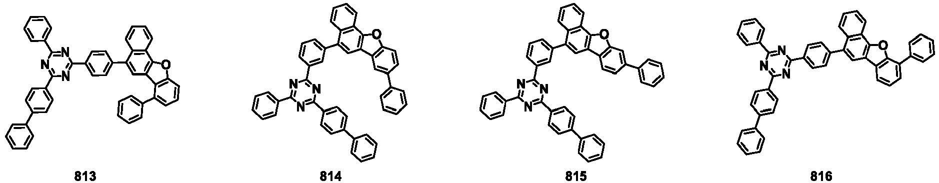

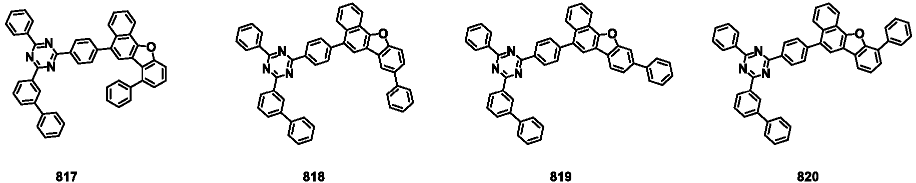

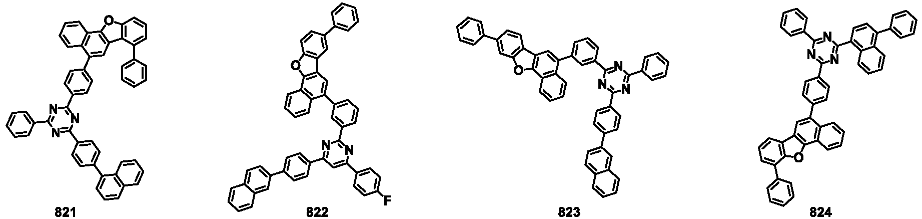

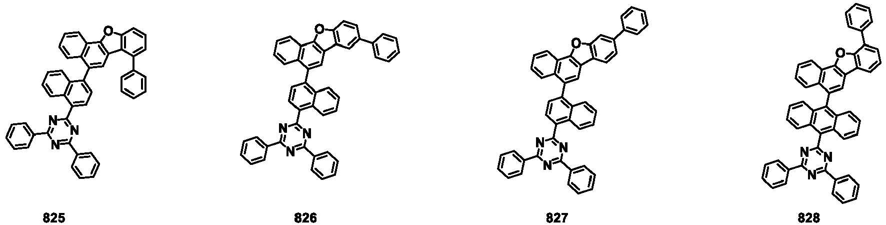

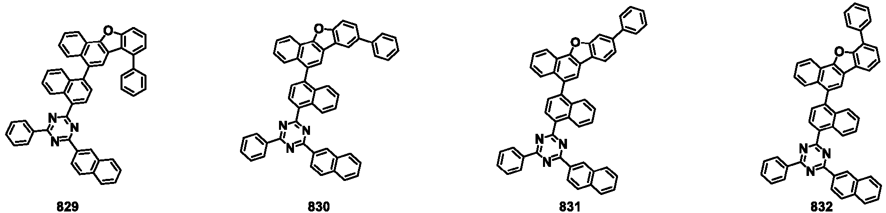

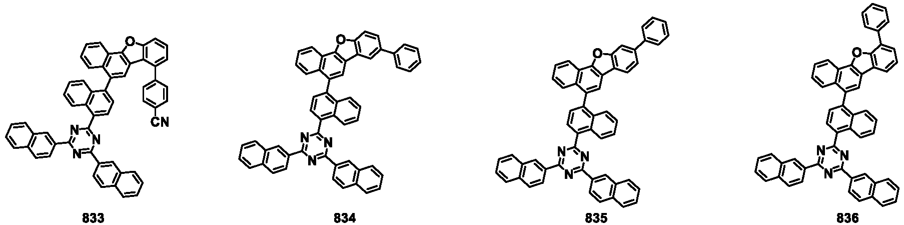

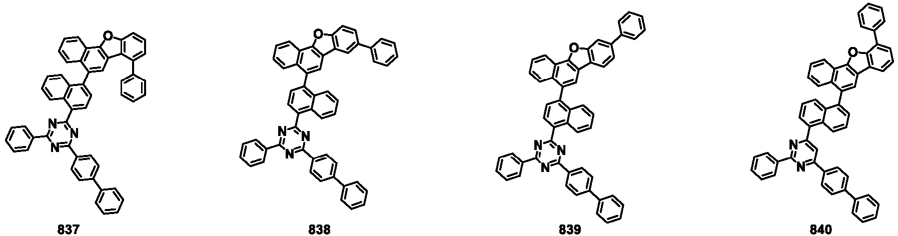

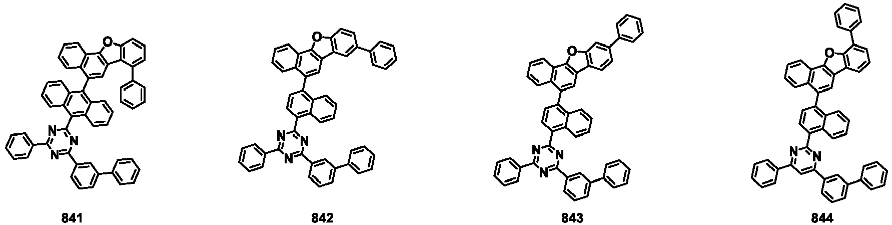

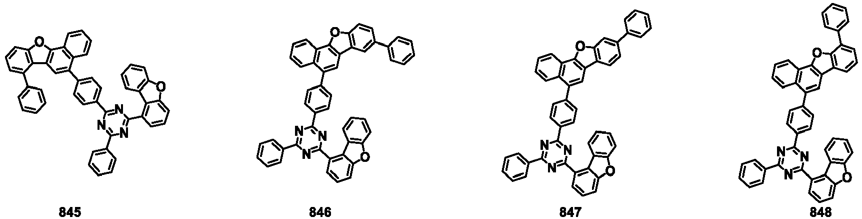

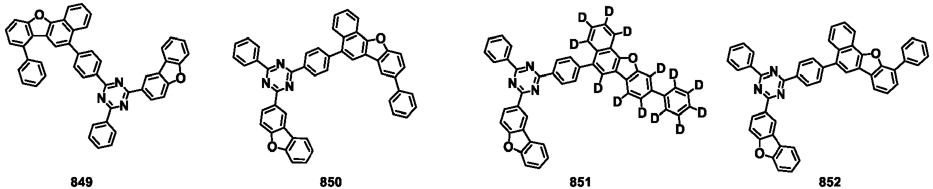

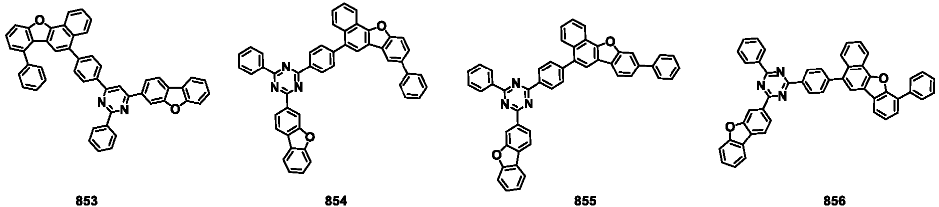

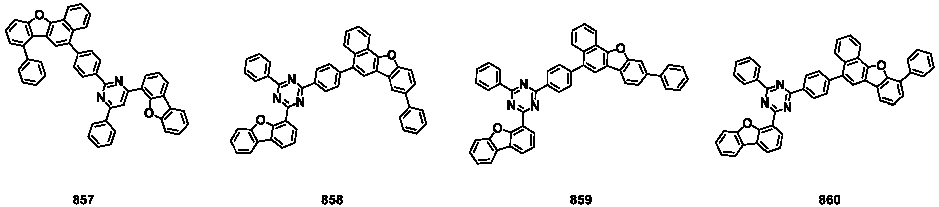

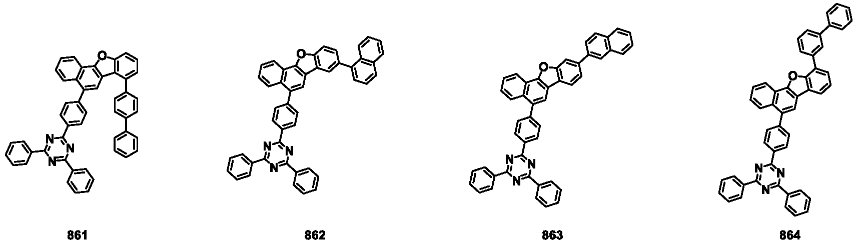

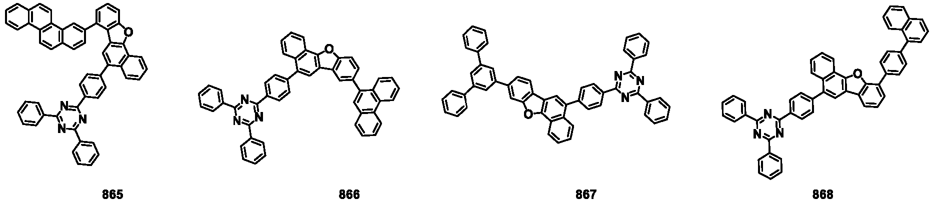

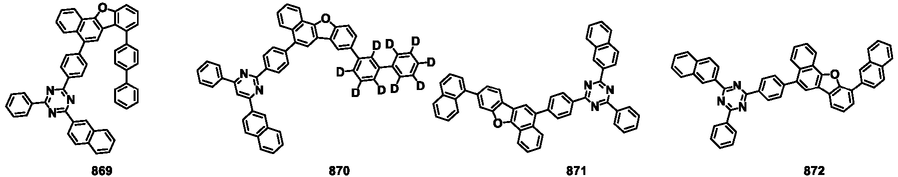

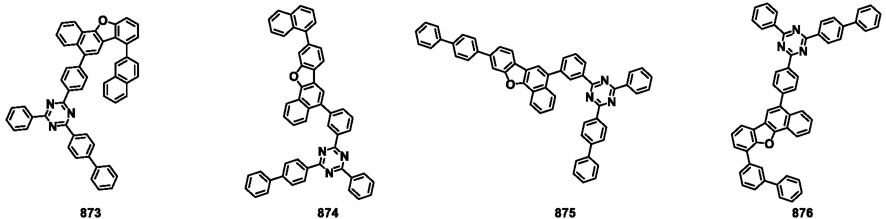

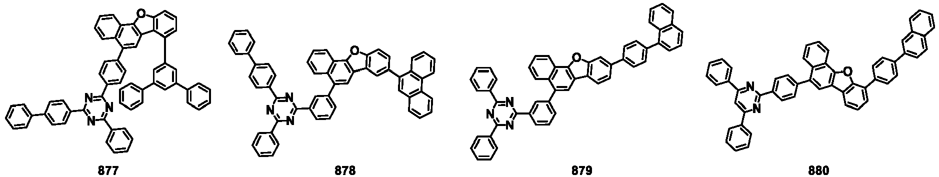

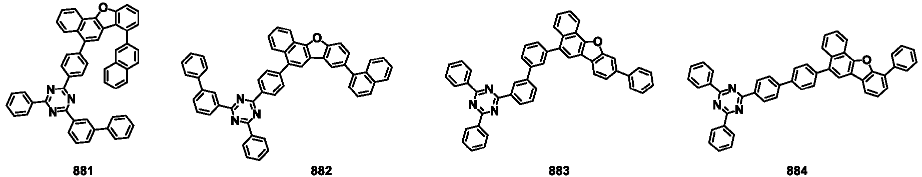

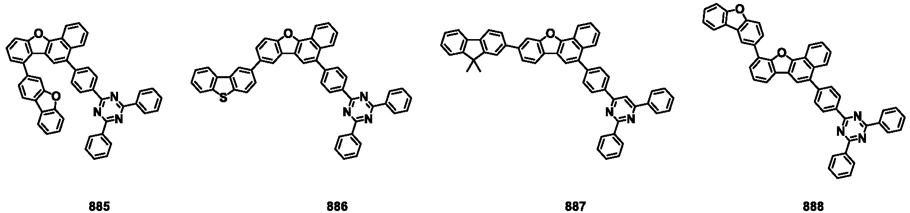

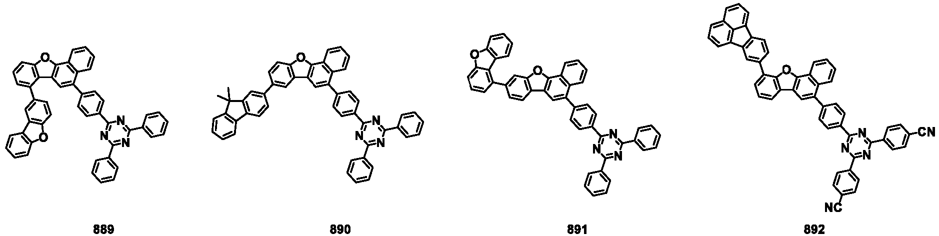

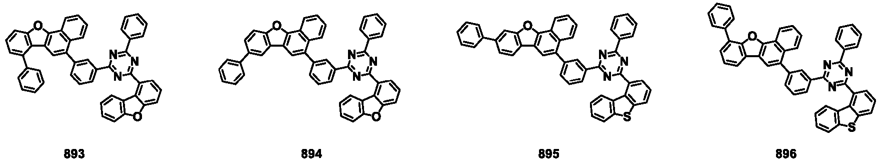

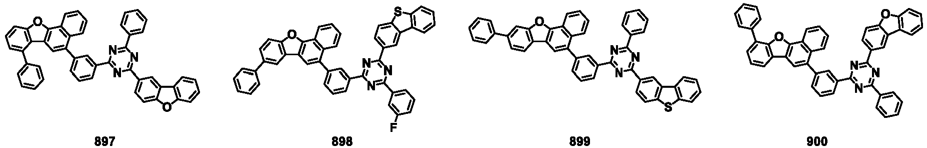

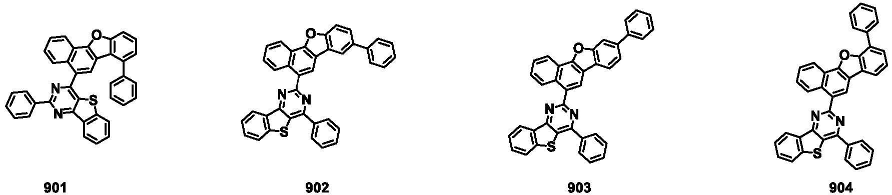

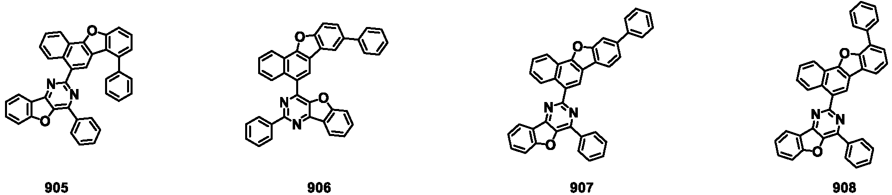

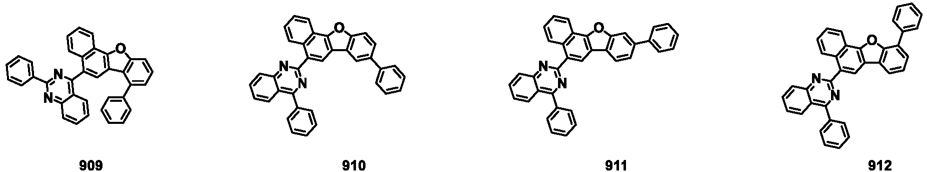

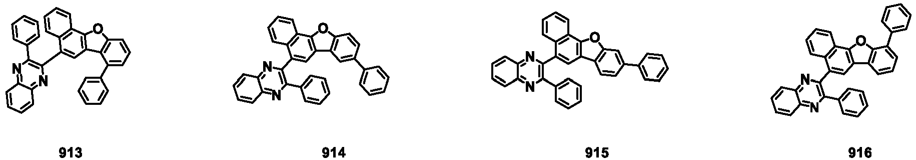

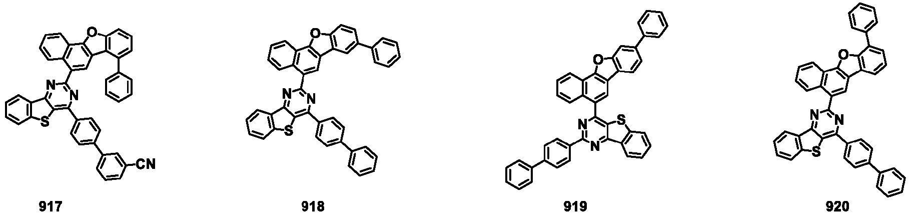

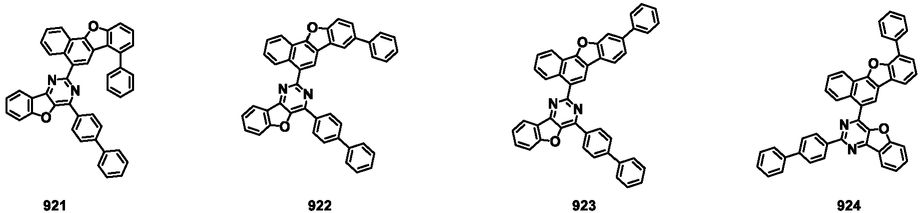

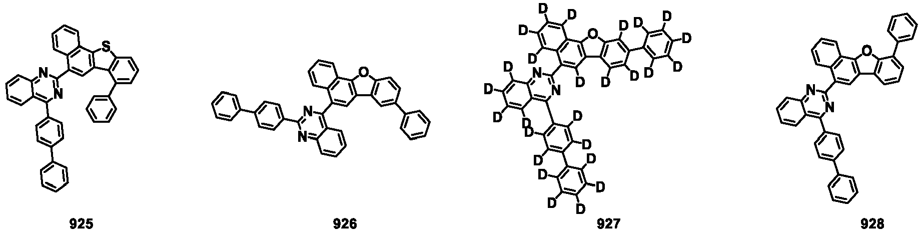

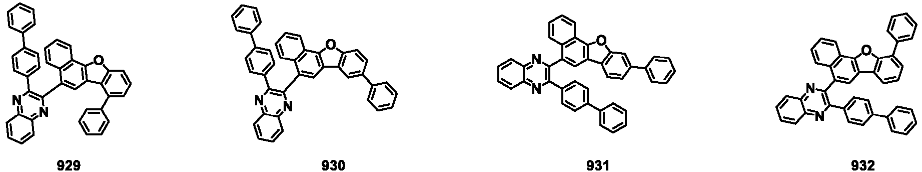

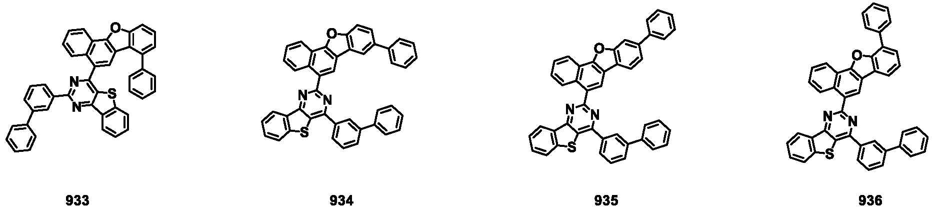

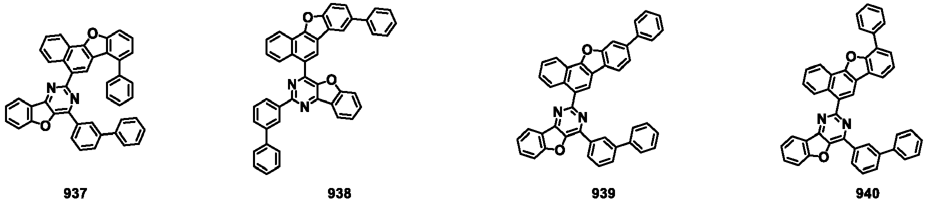

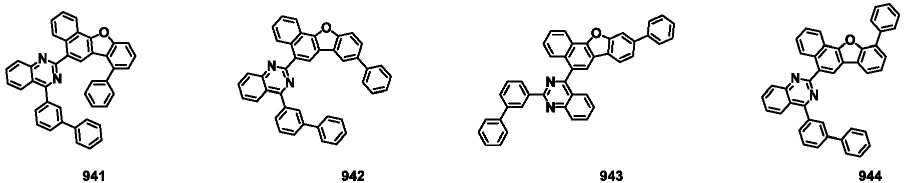

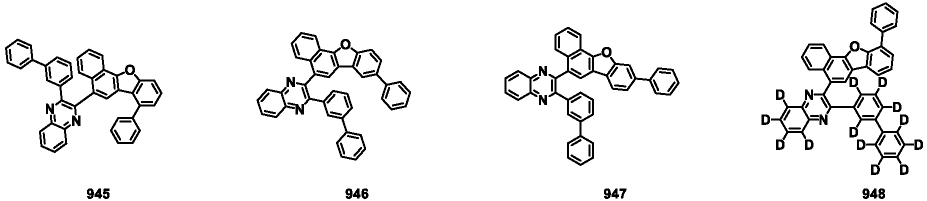

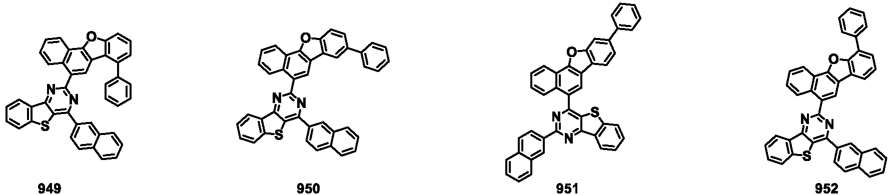

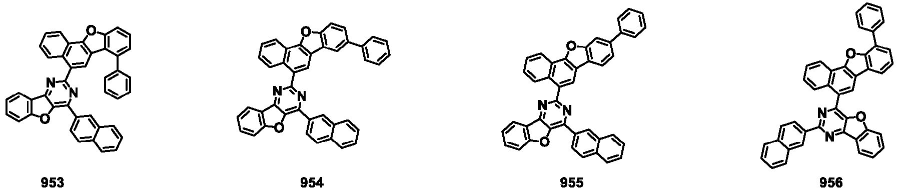

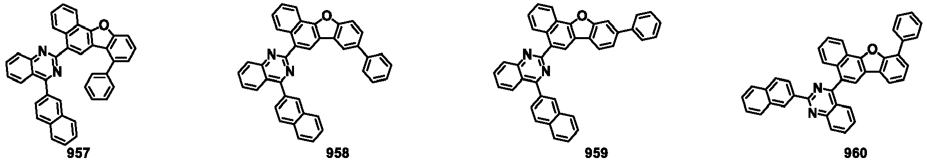

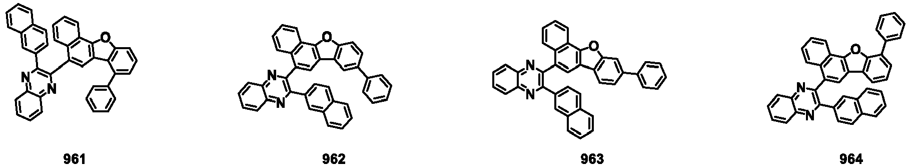

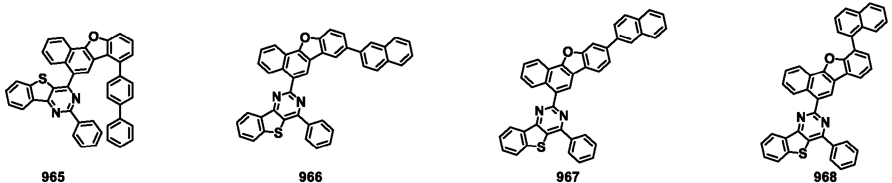

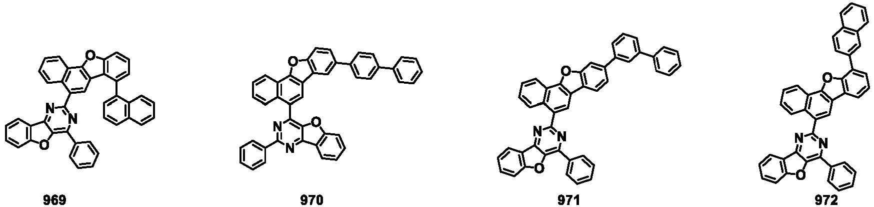

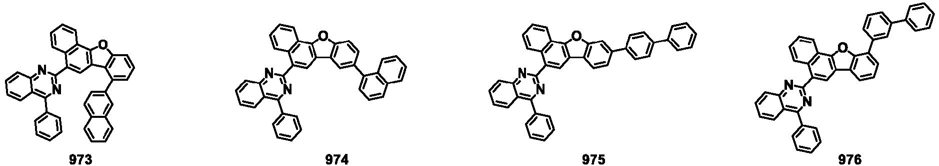

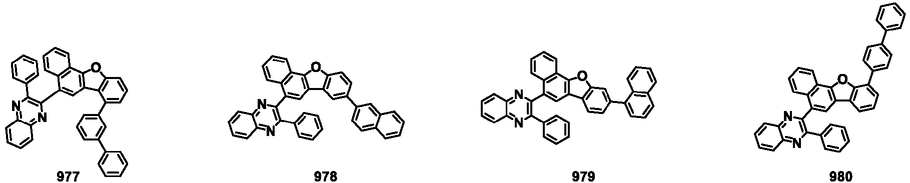

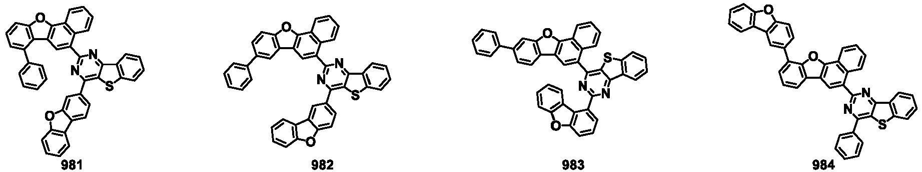

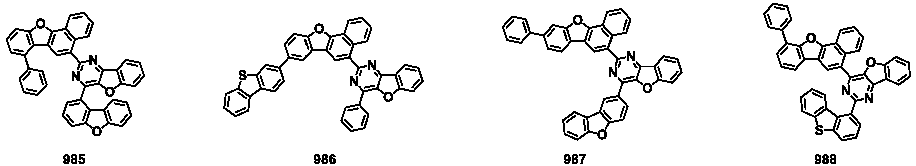

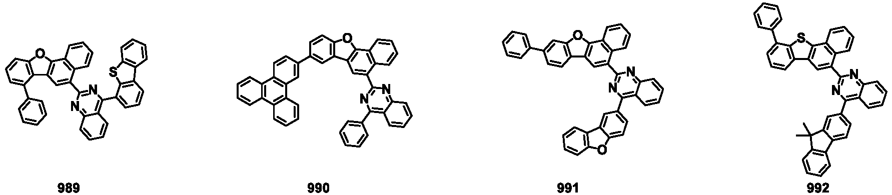

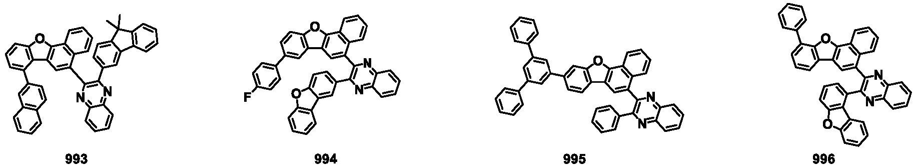

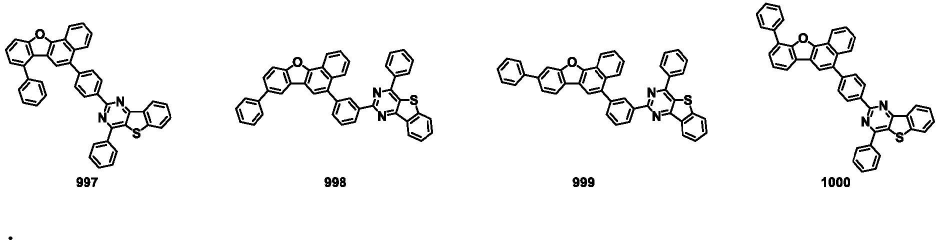

8. The organic light emitting device of claim 1, wherein Chemical Formula 2 is represented by any one of the following compounds:

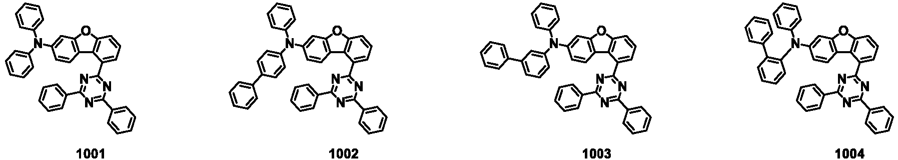

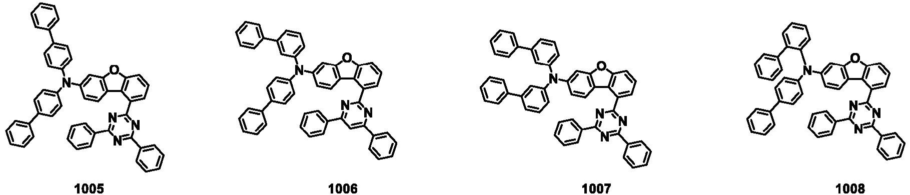

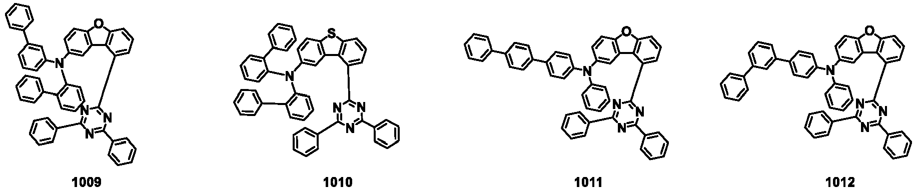

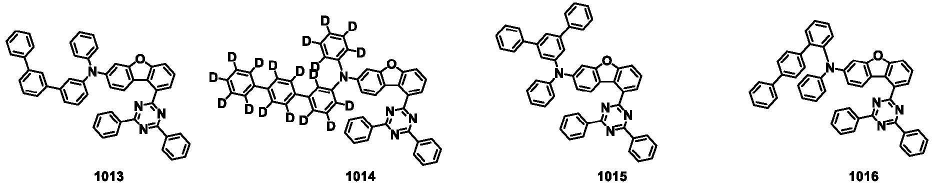

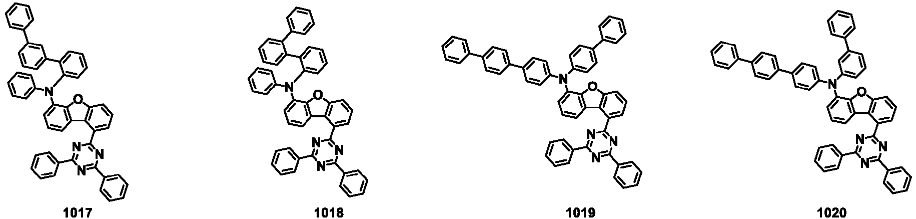

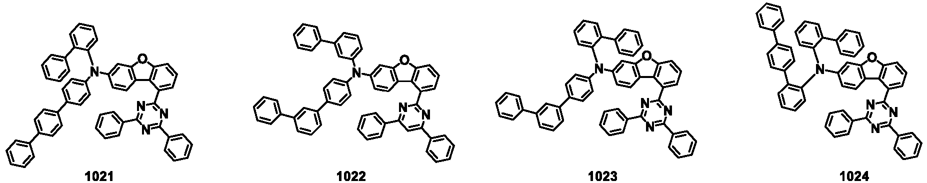

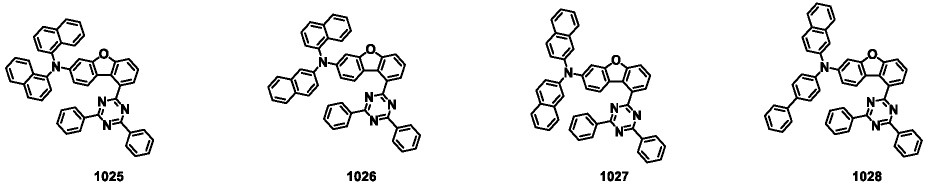

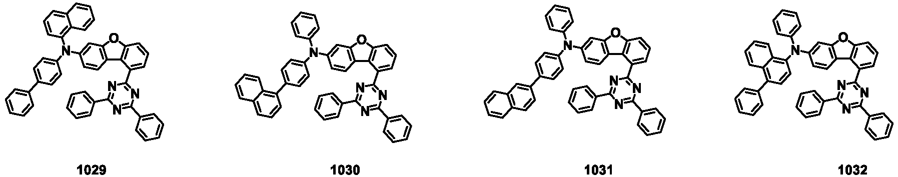

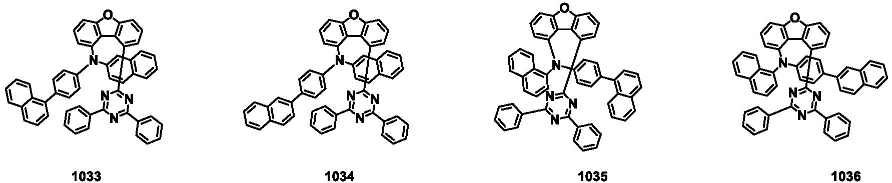

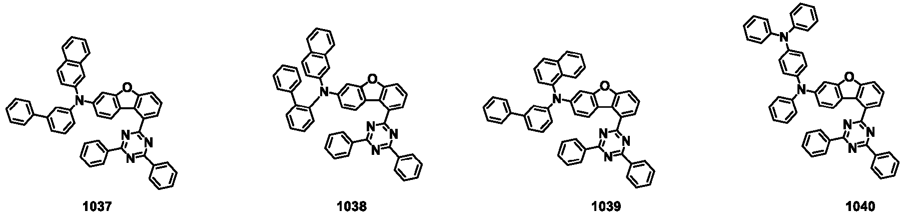

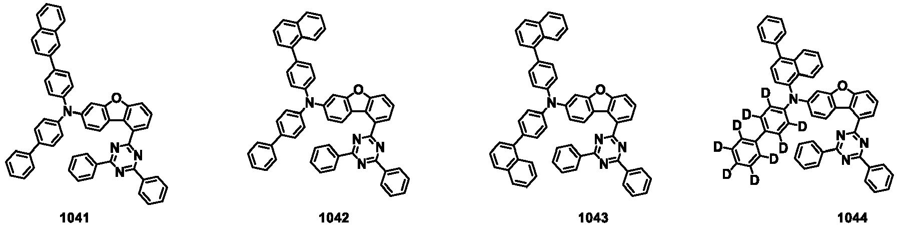

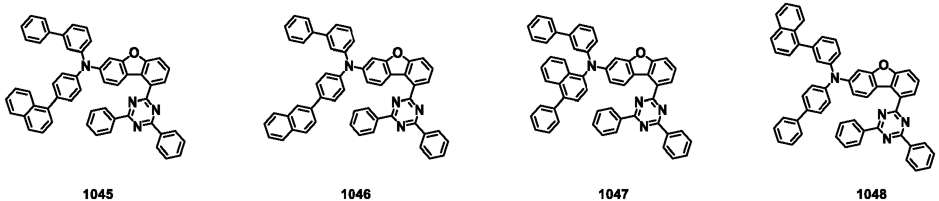

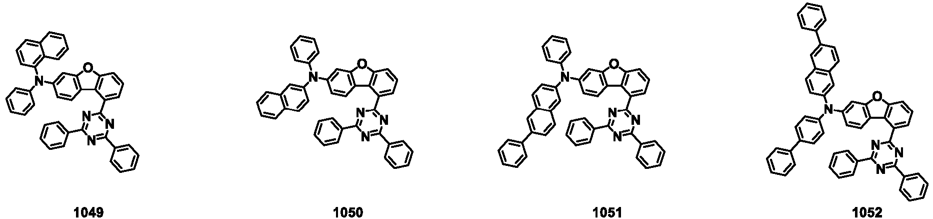

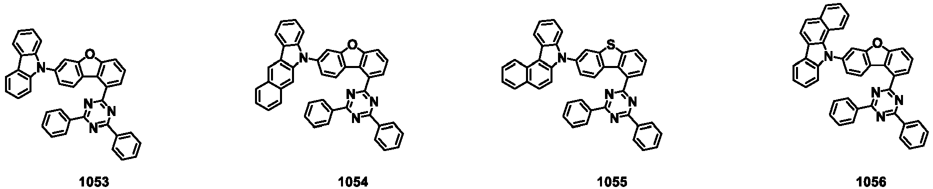

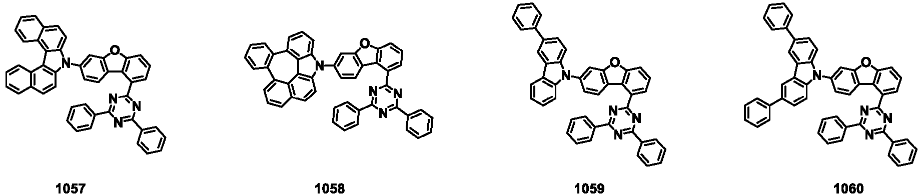

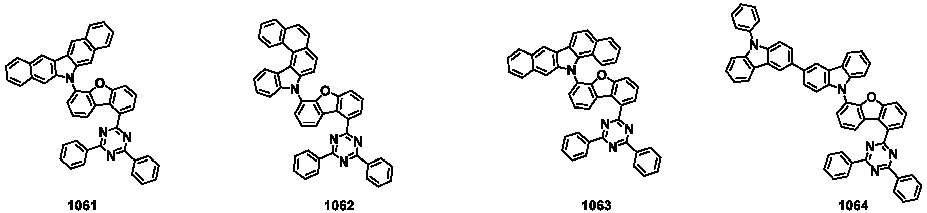

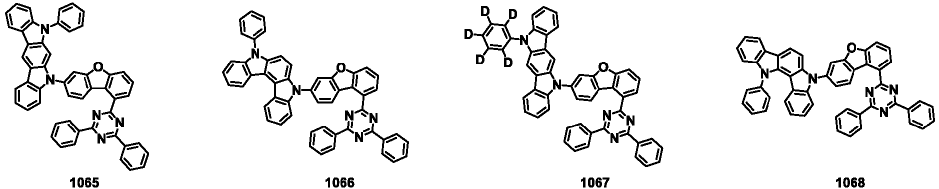

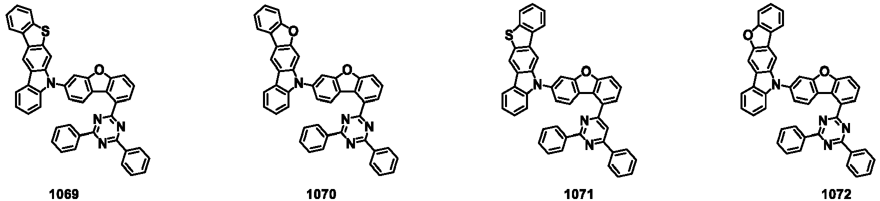

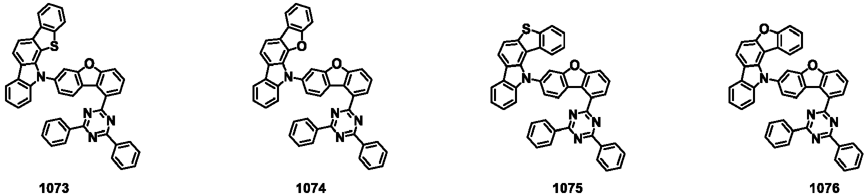

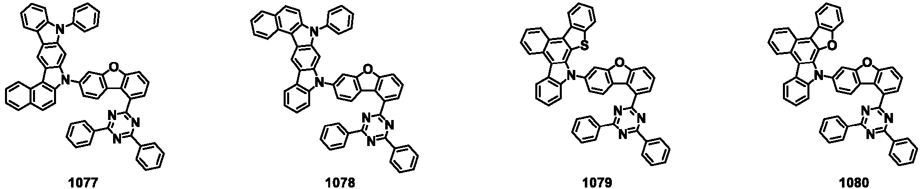

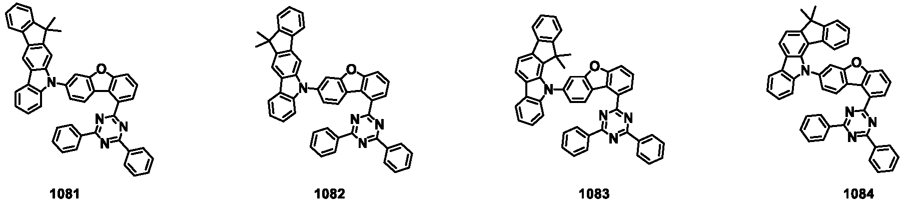

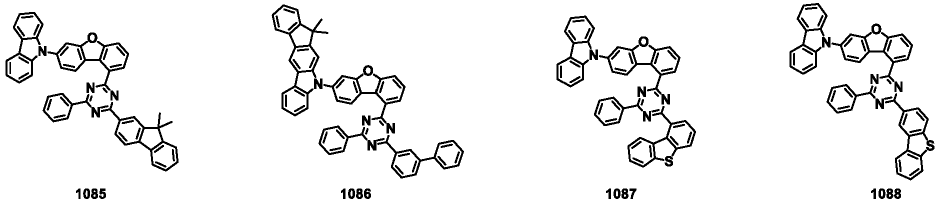

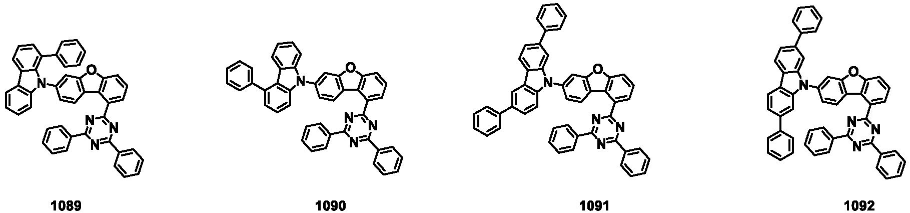

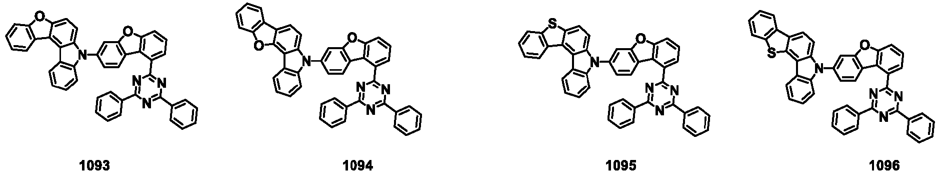

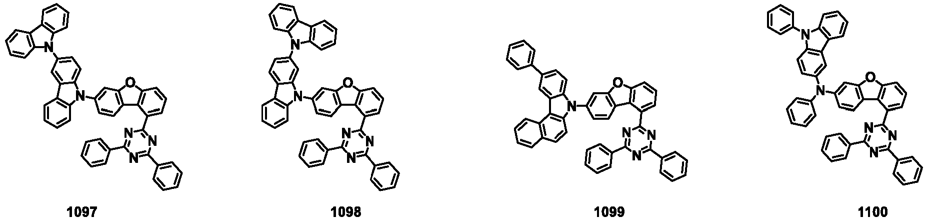

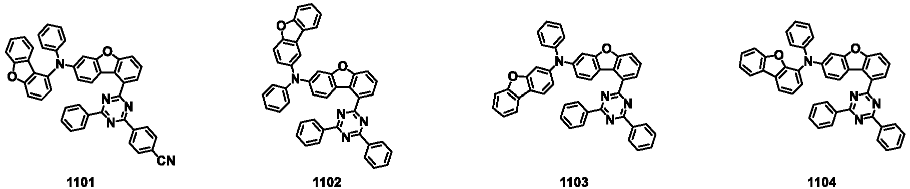

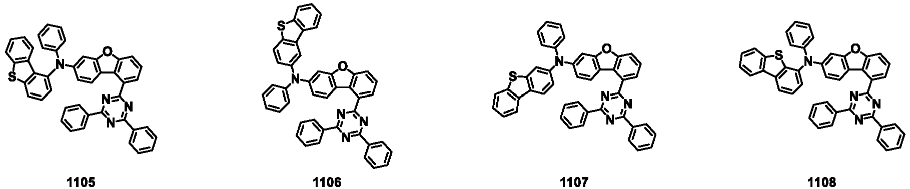

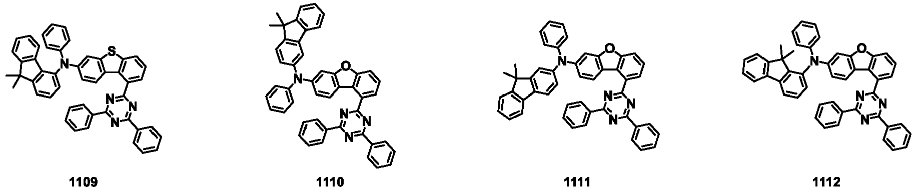

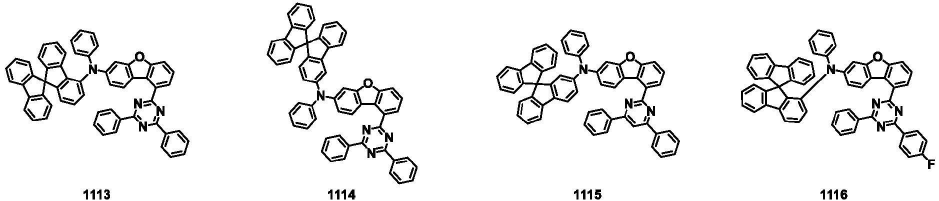

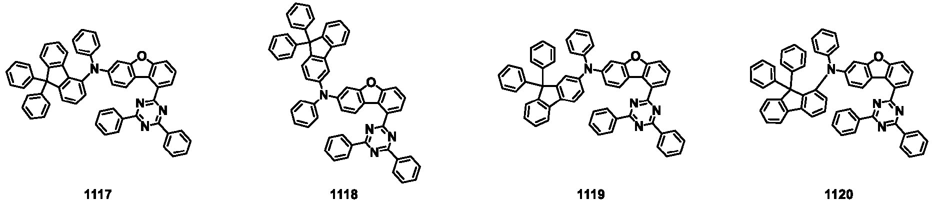

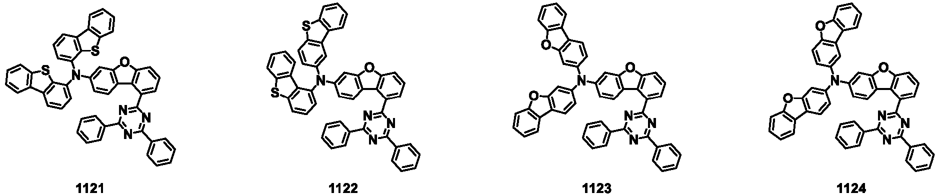

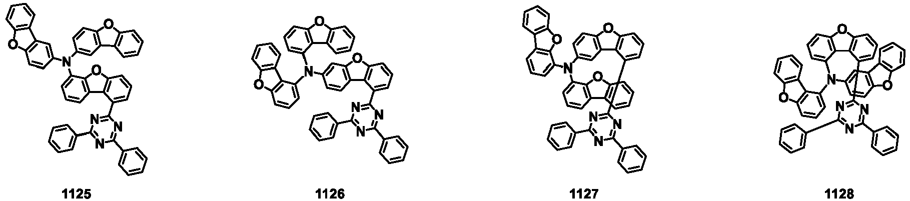

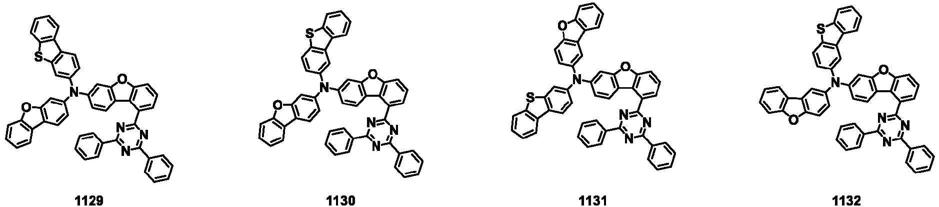

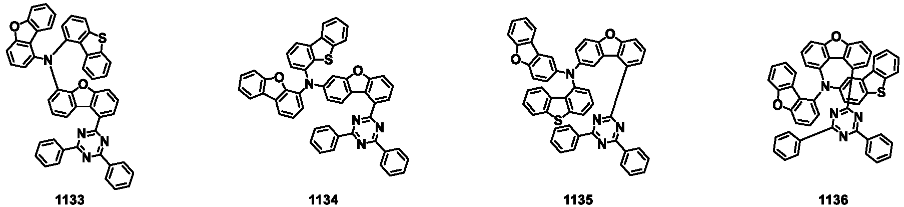

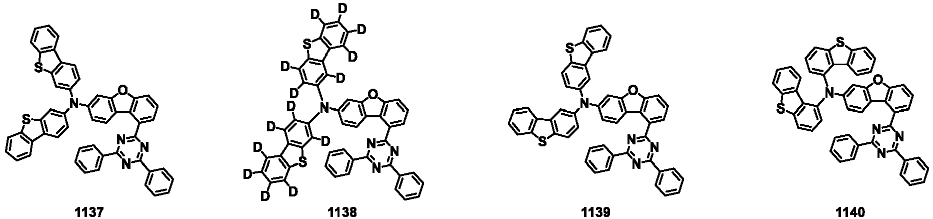

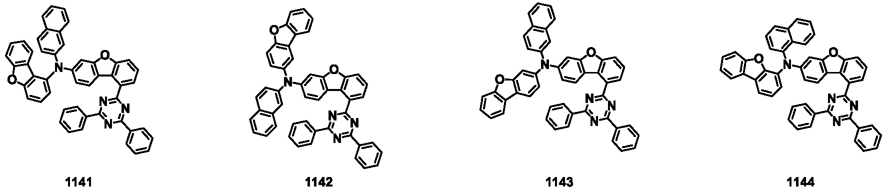

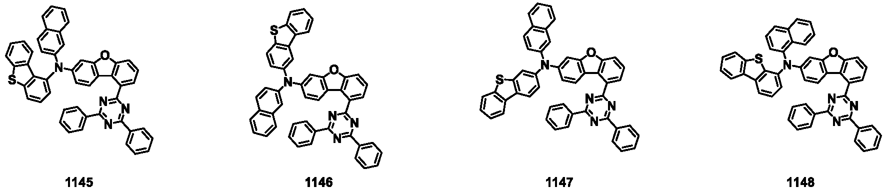

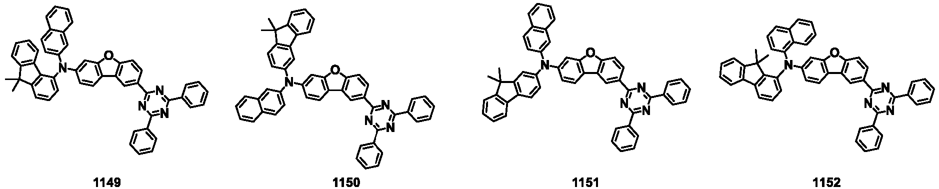

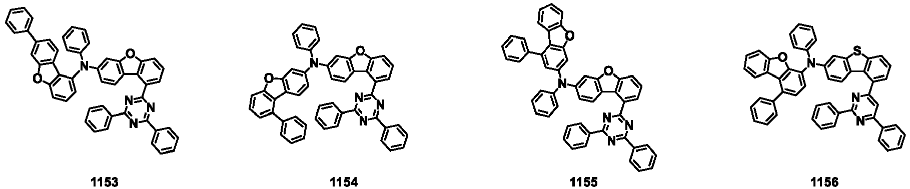

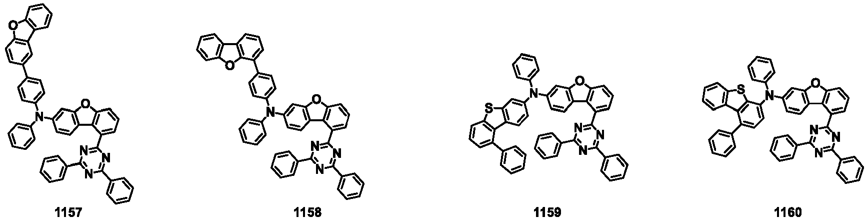

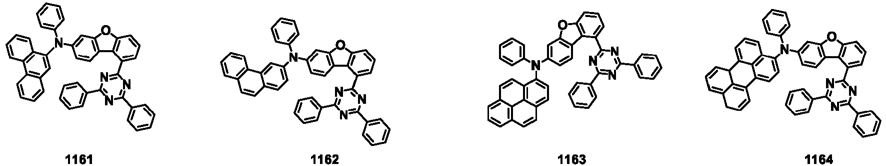

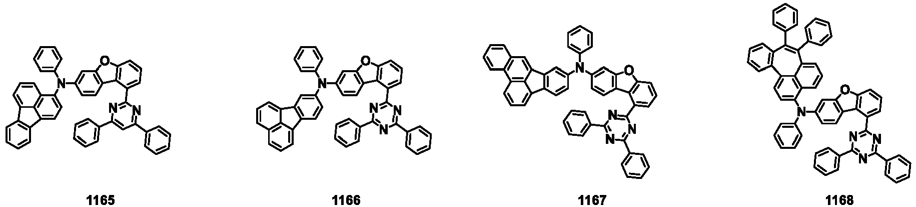

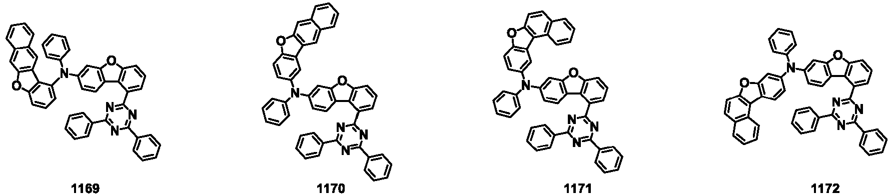

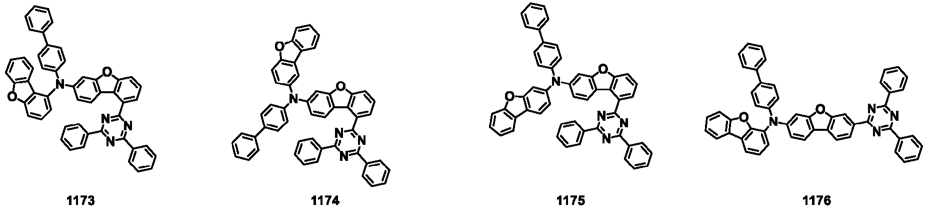

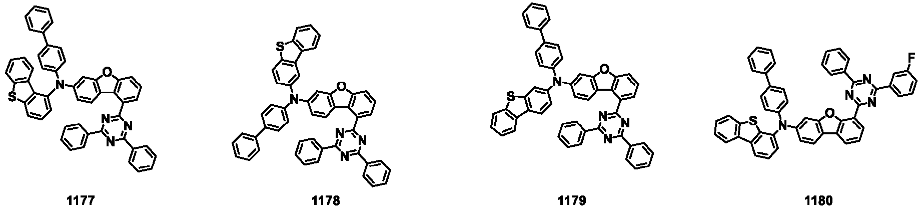

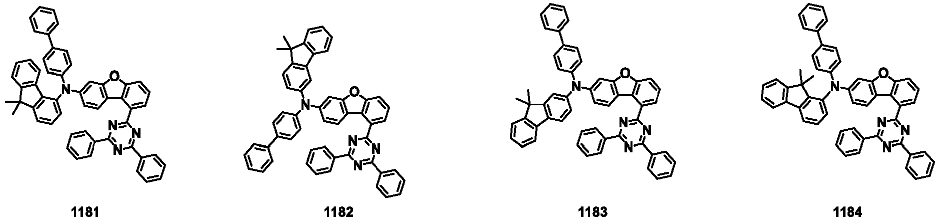

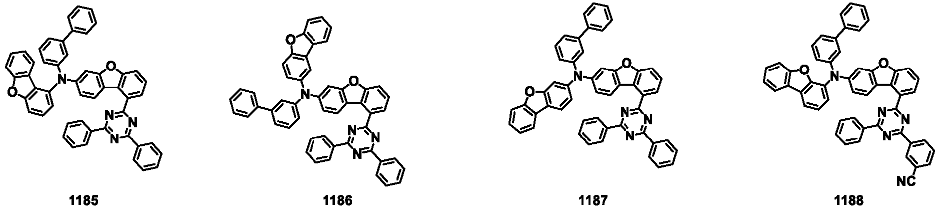

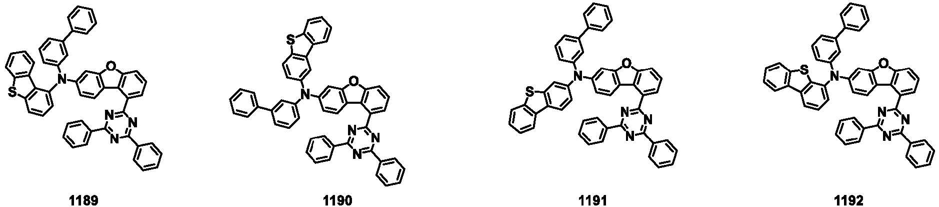

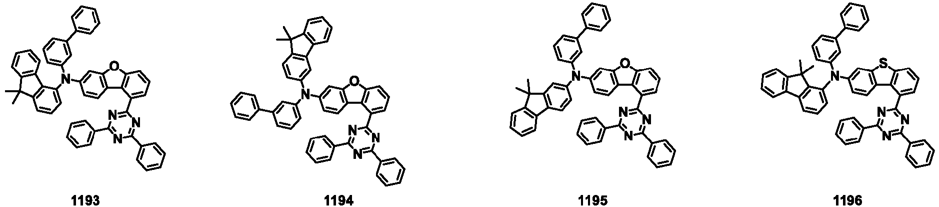

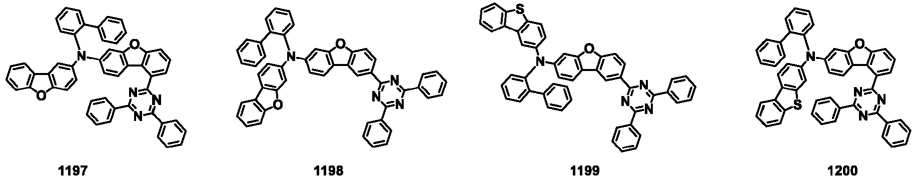

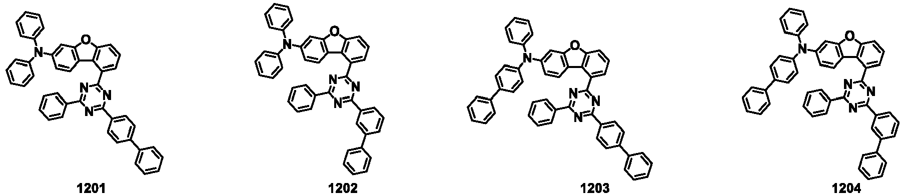

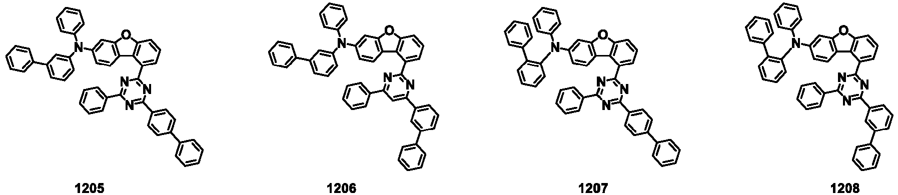

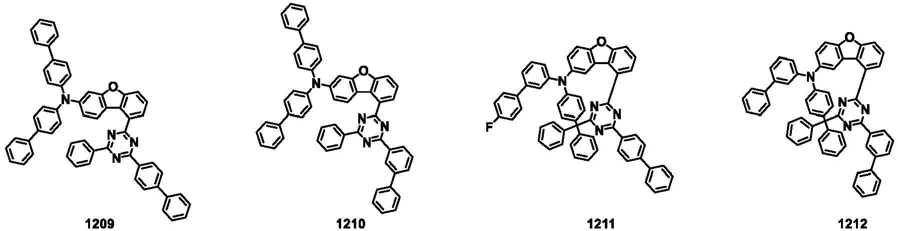

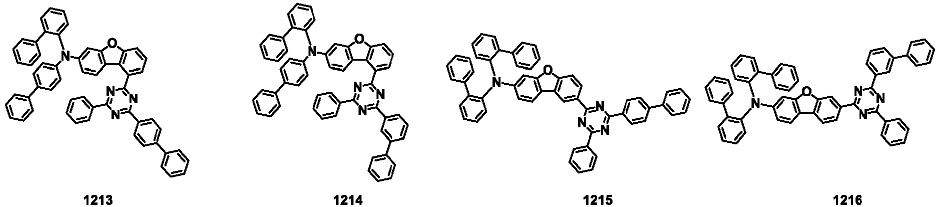

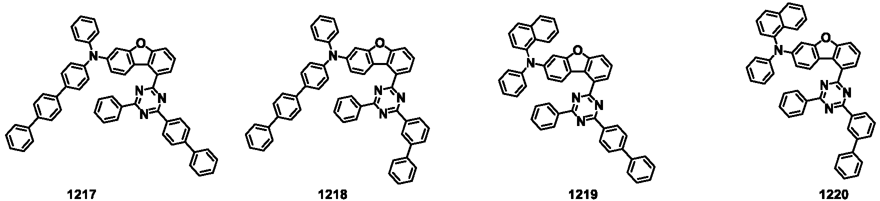

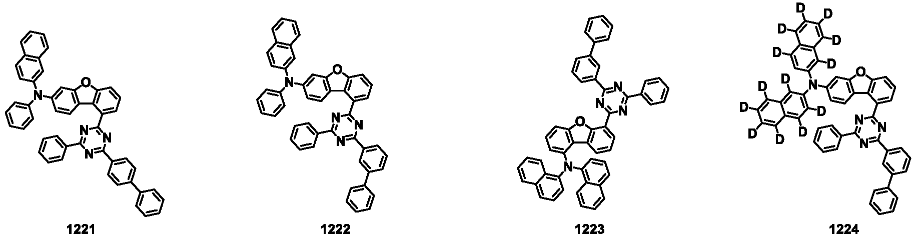

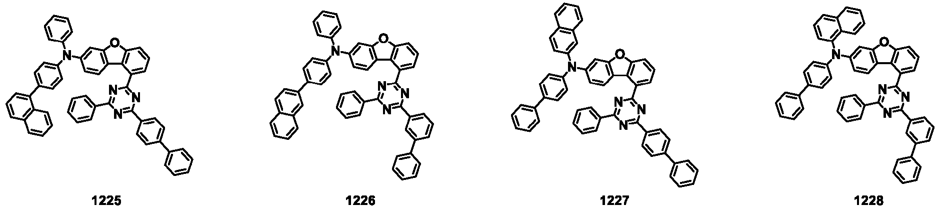

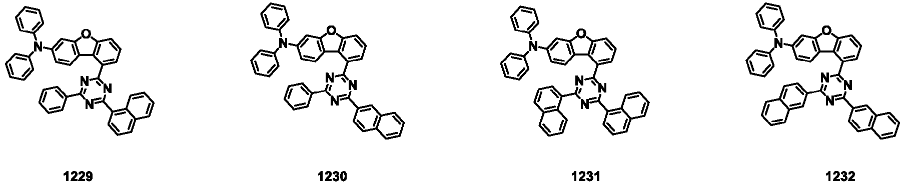

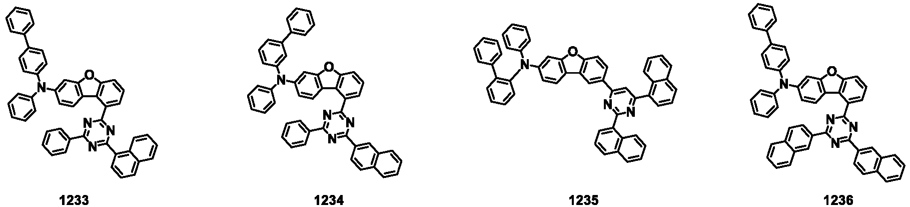

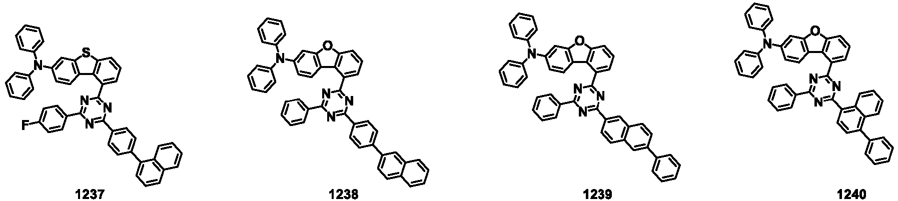

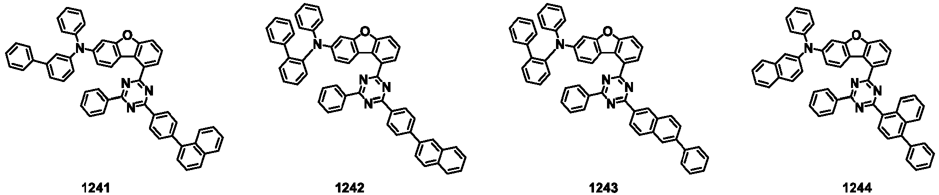

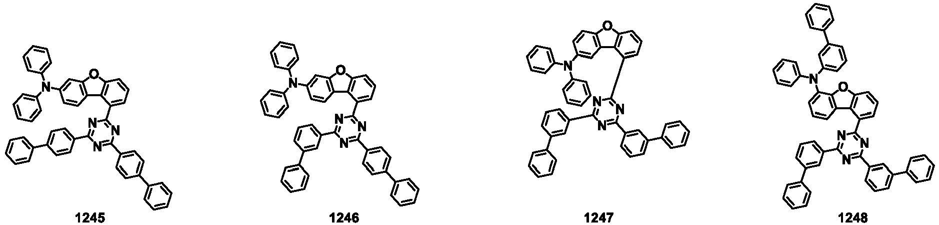

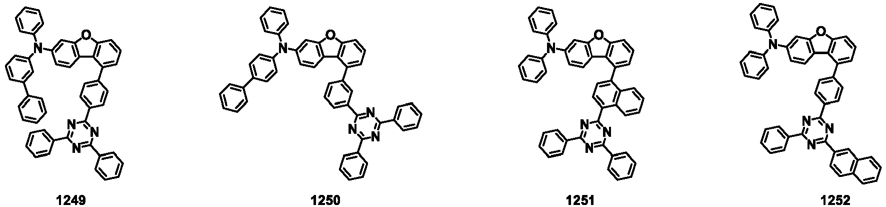

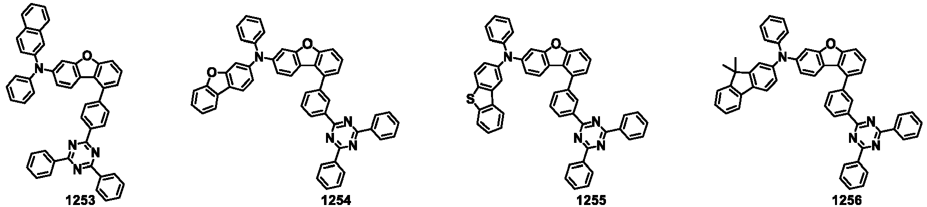

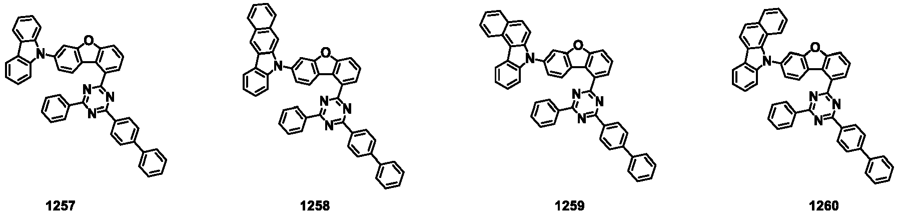

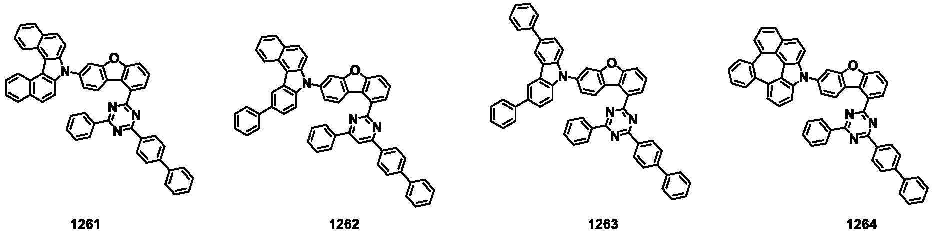

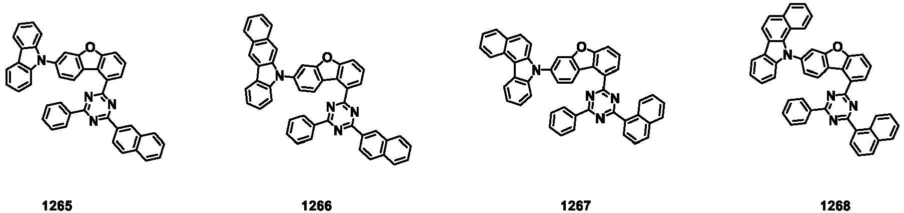

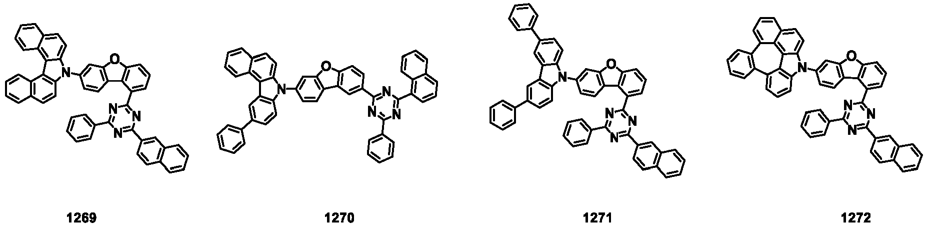

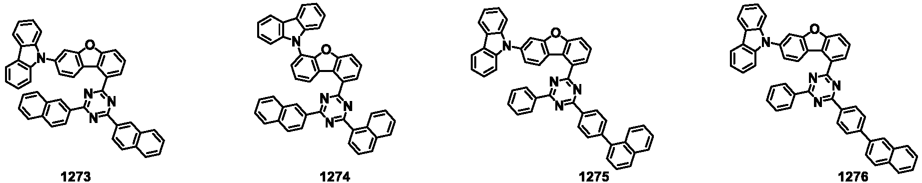

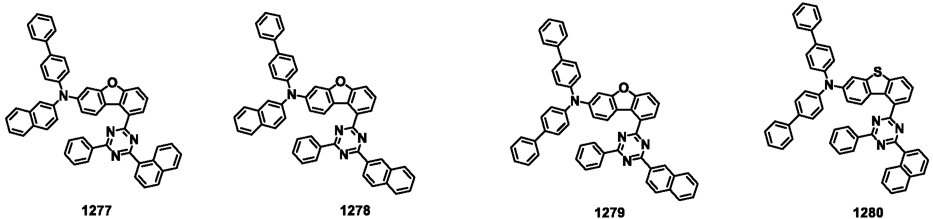

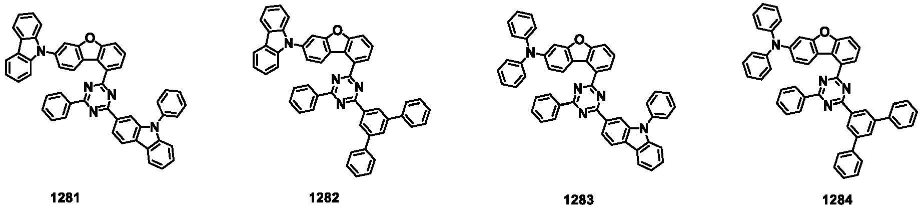

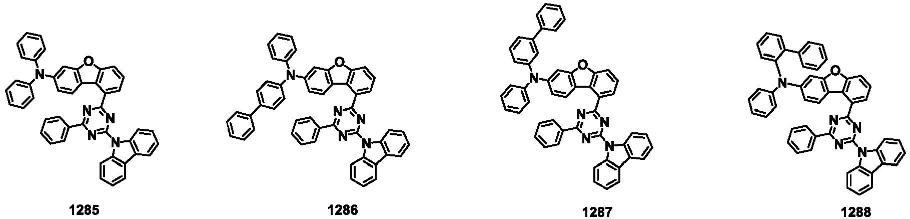

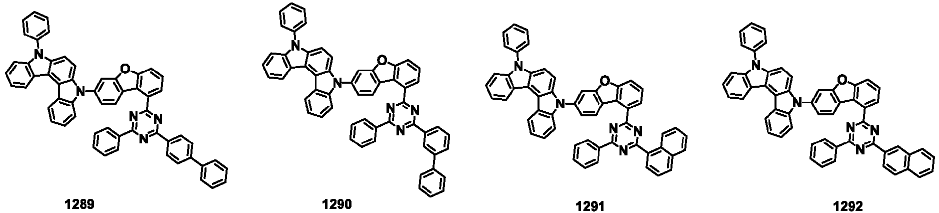

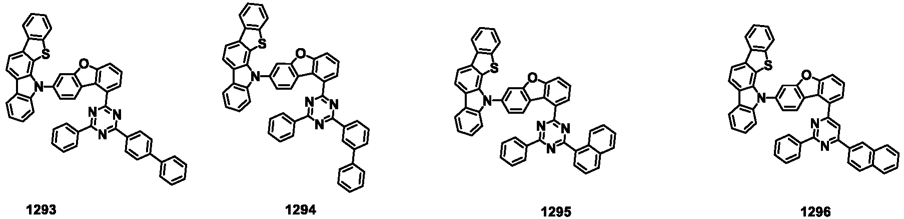

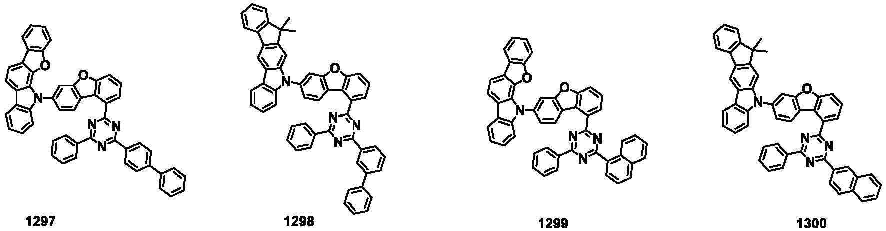

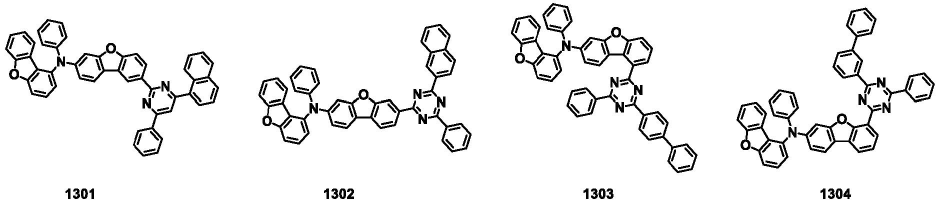

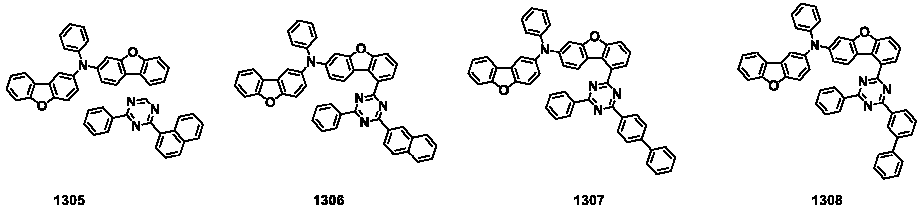

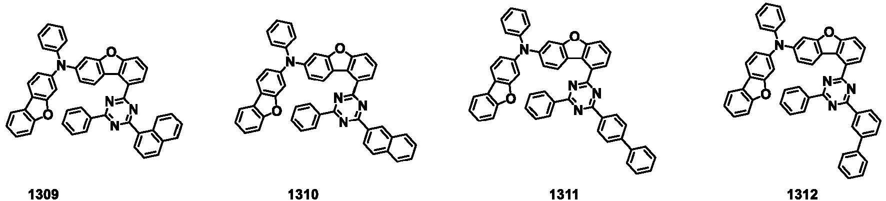

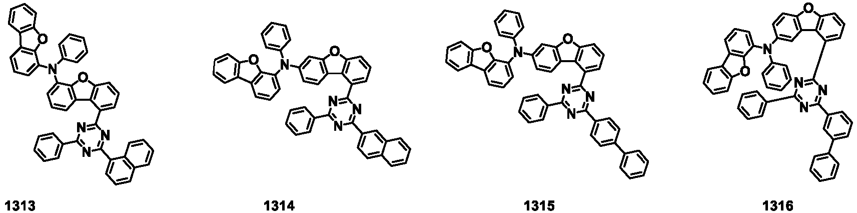

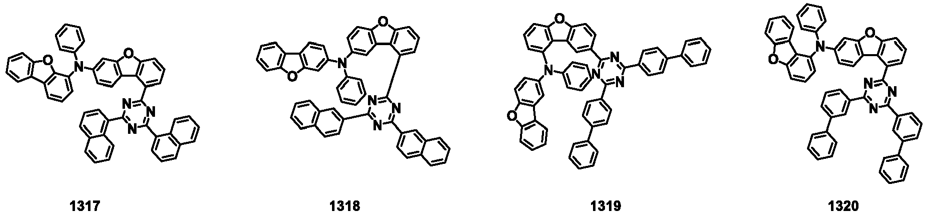

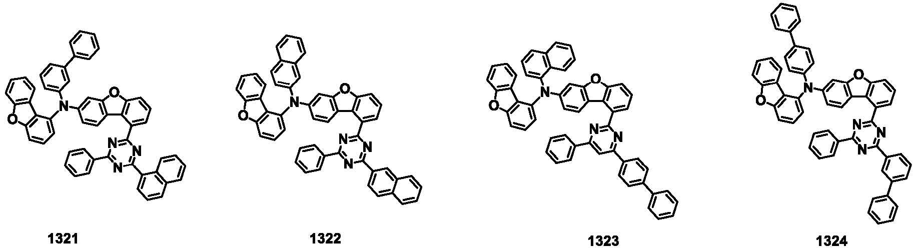

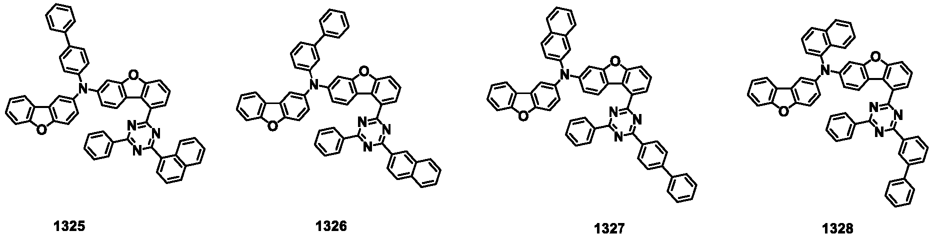

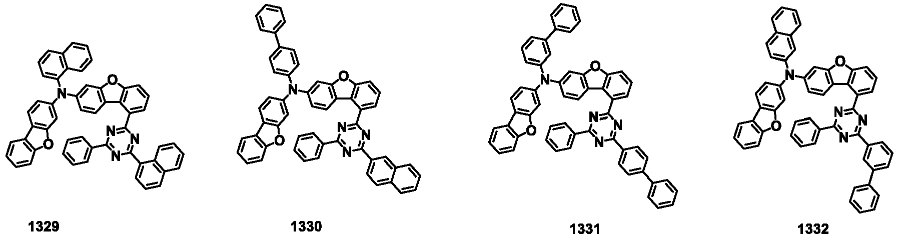

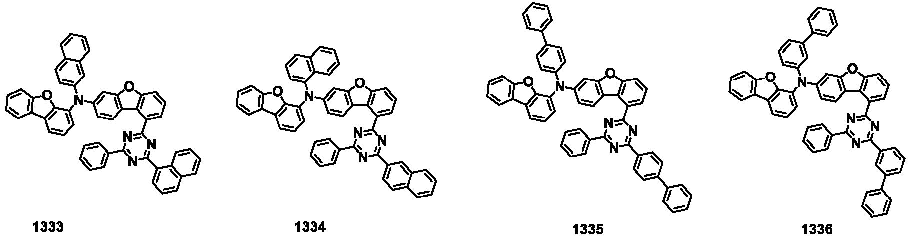

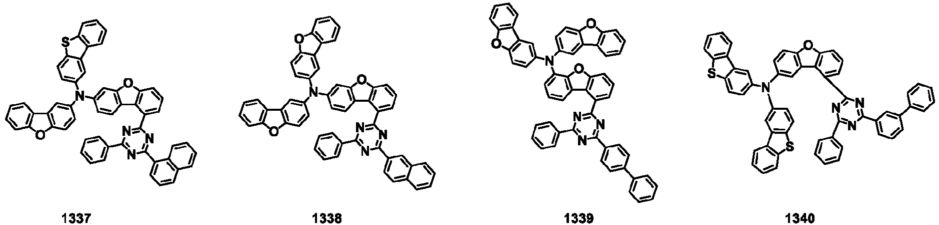

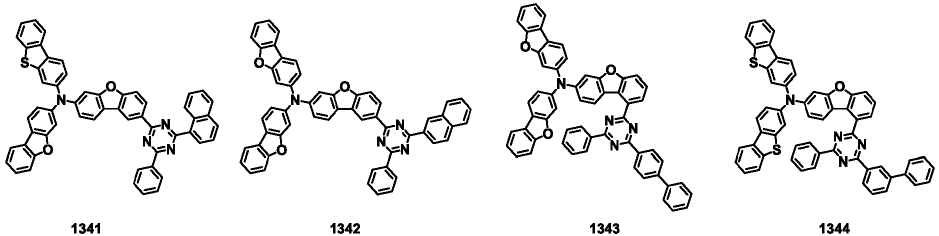

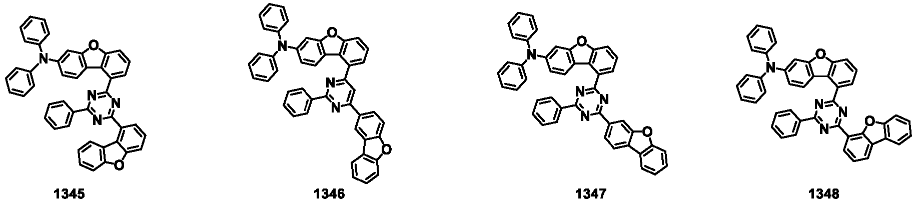

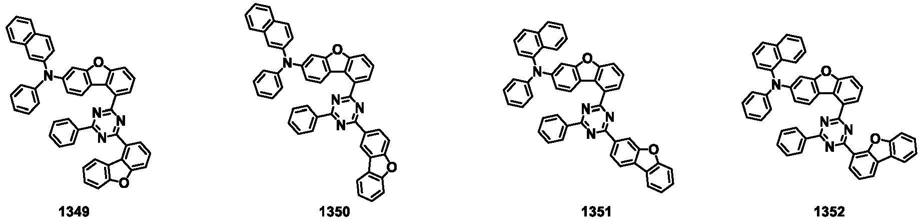

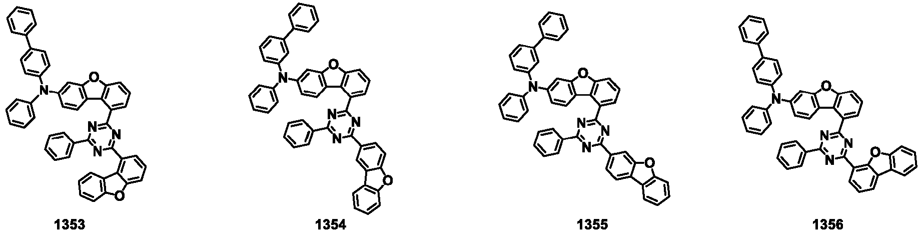

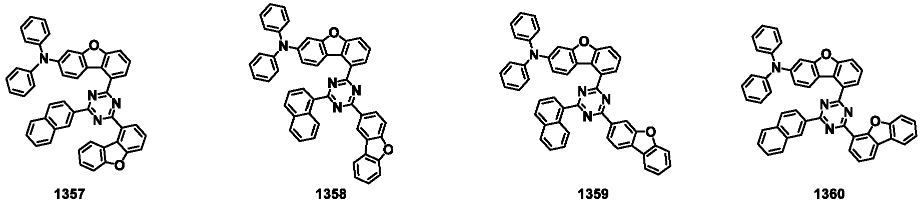

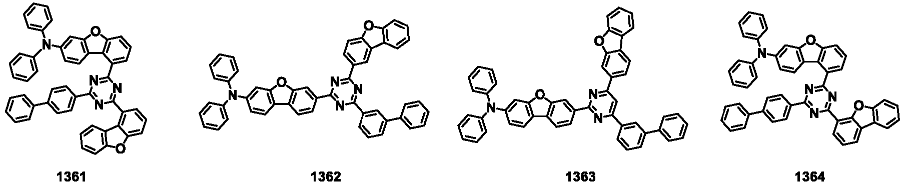

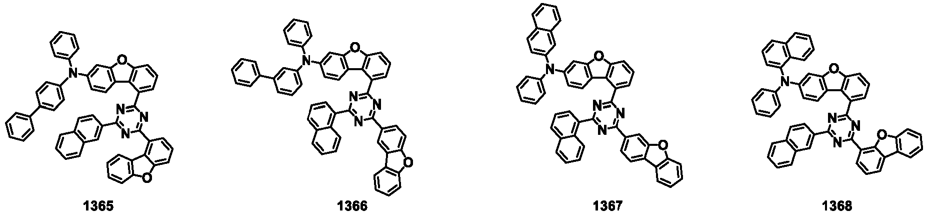

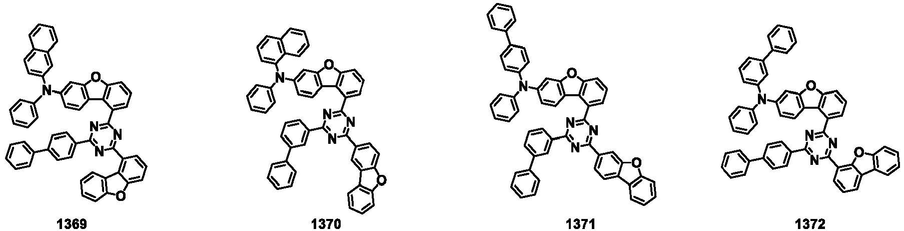

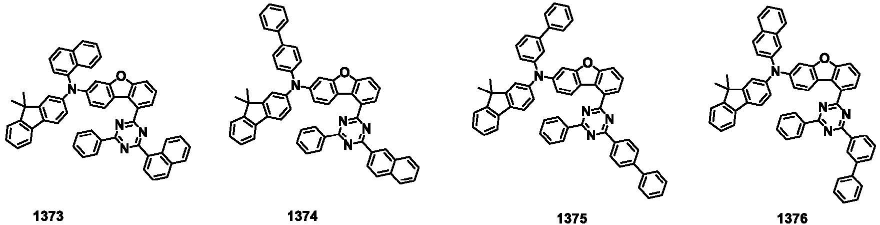

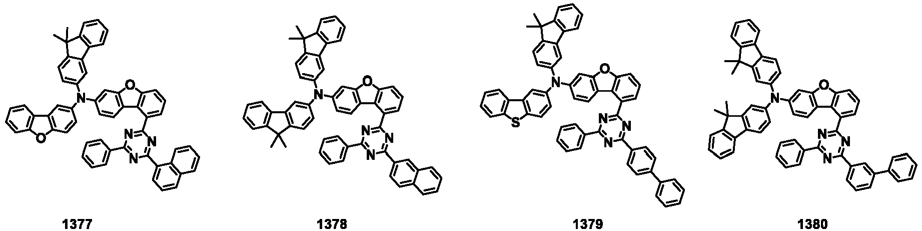

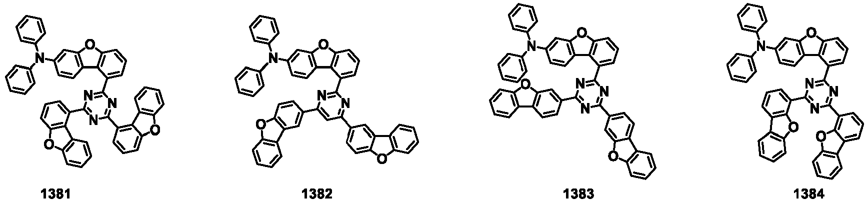

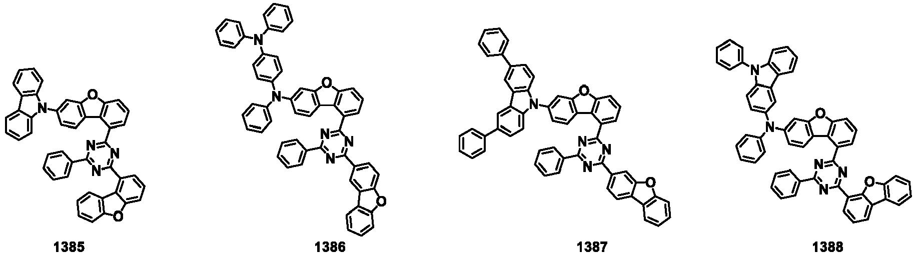

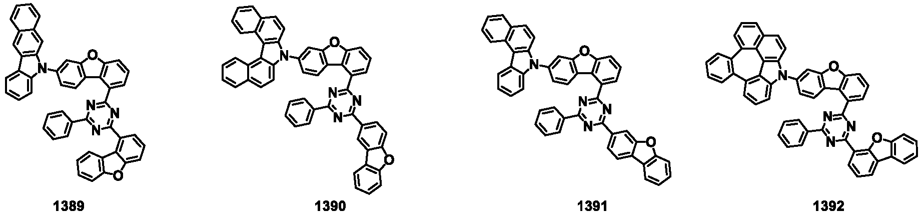

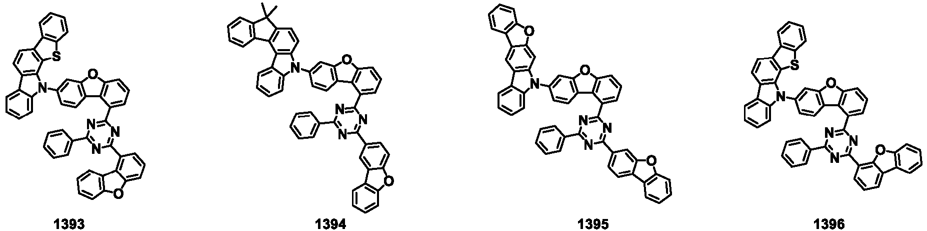

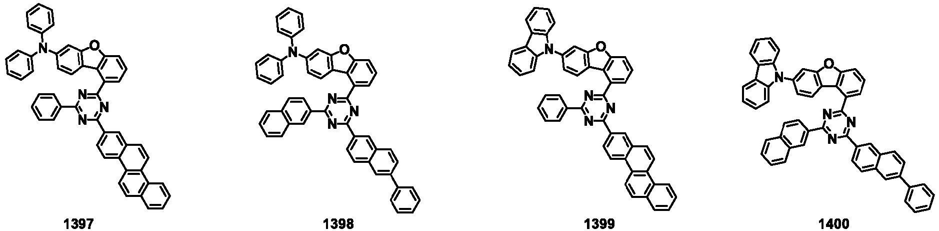

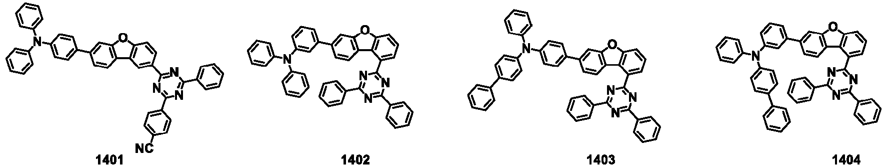

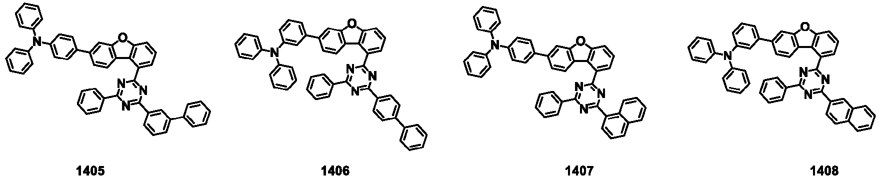

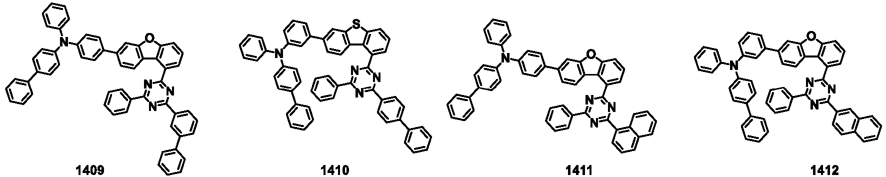

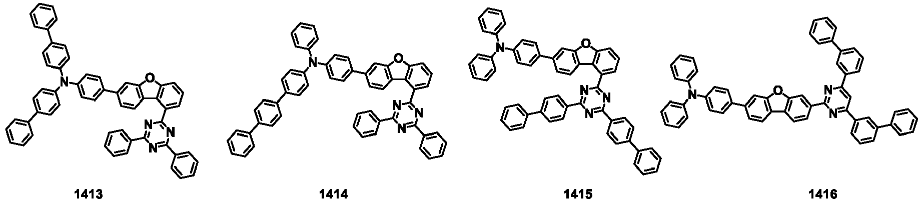

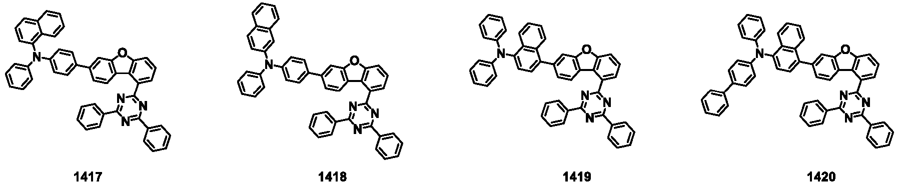

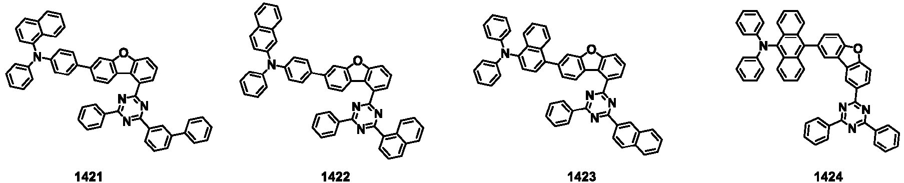

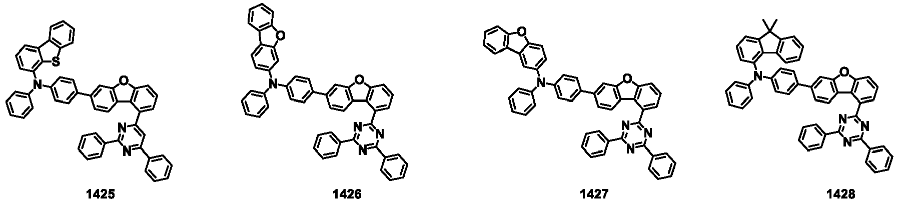

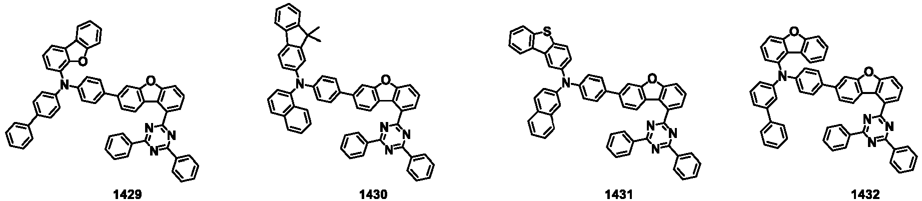

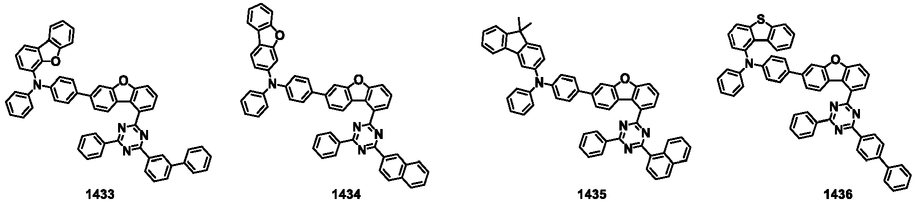

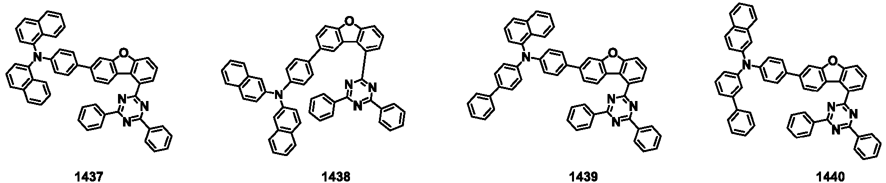

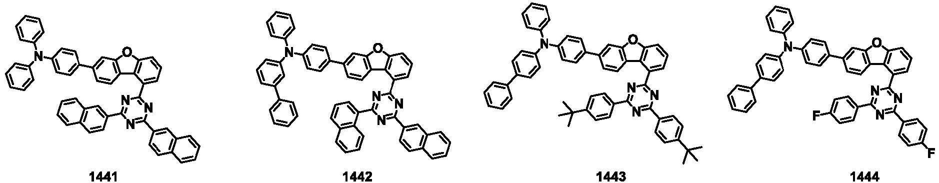

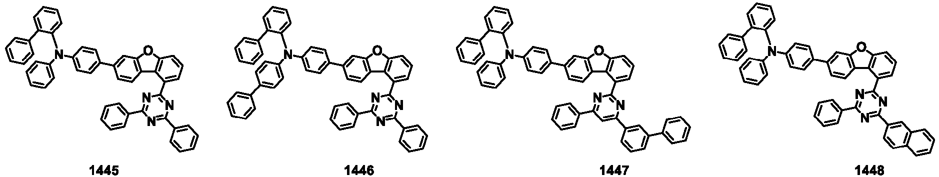

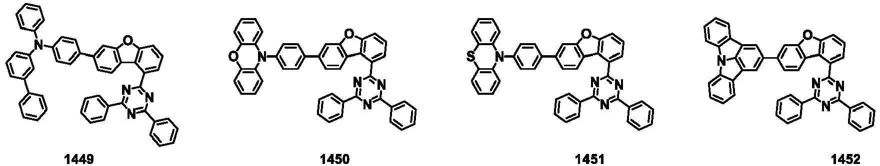

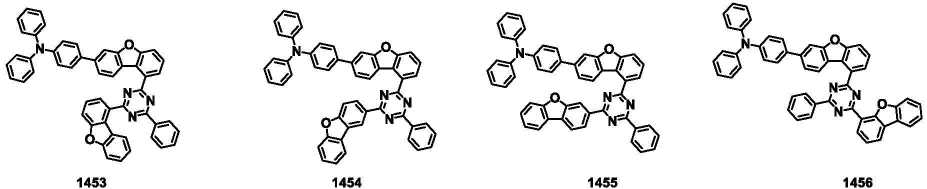

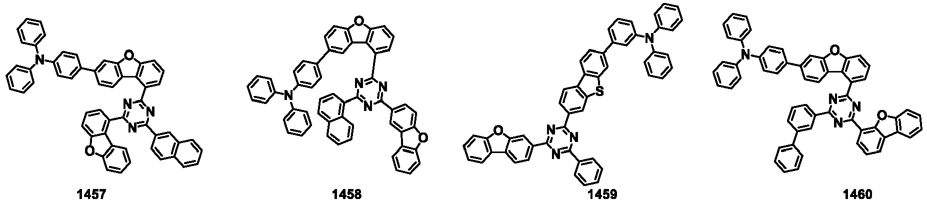

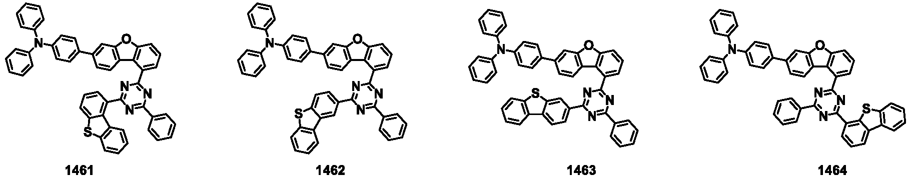

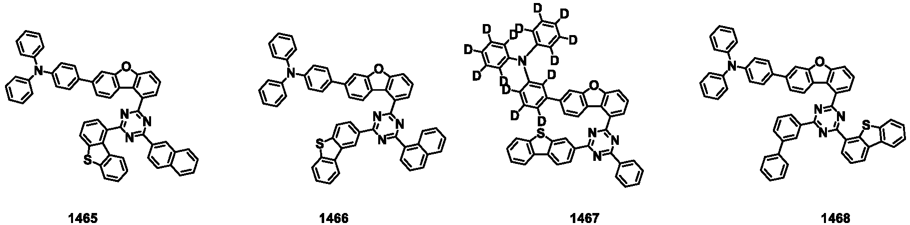

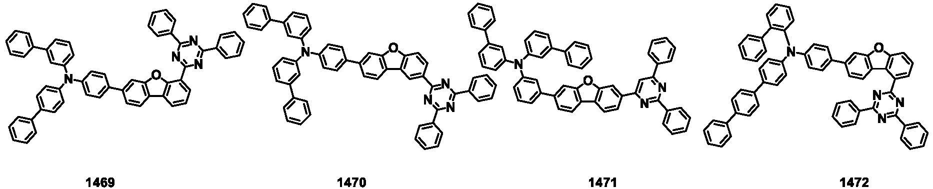

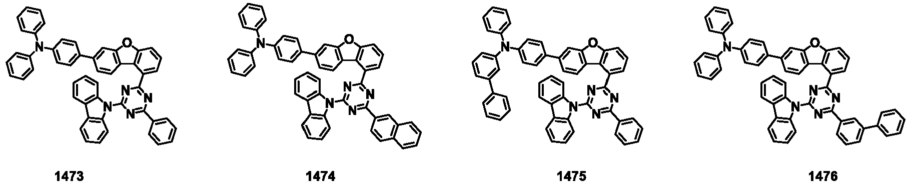

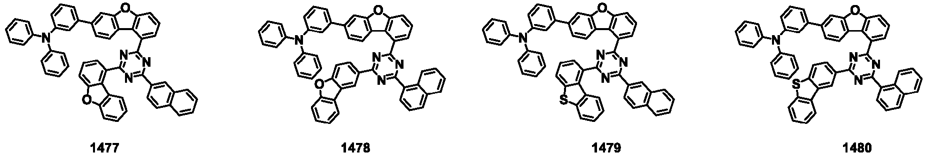

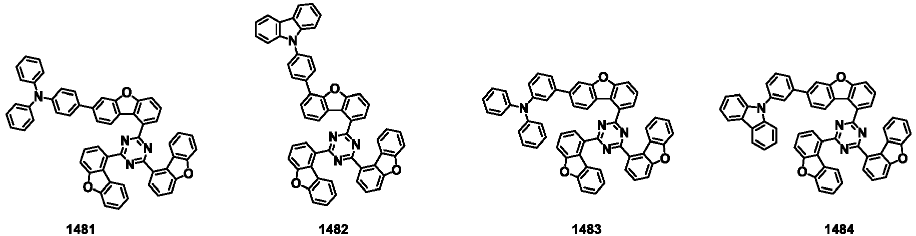

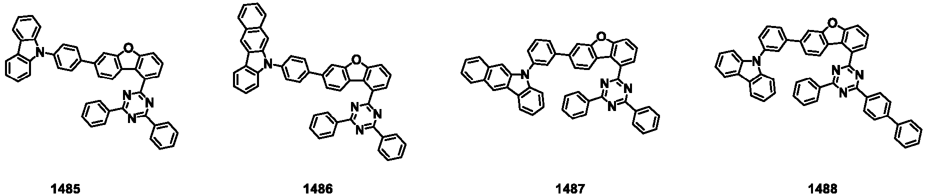

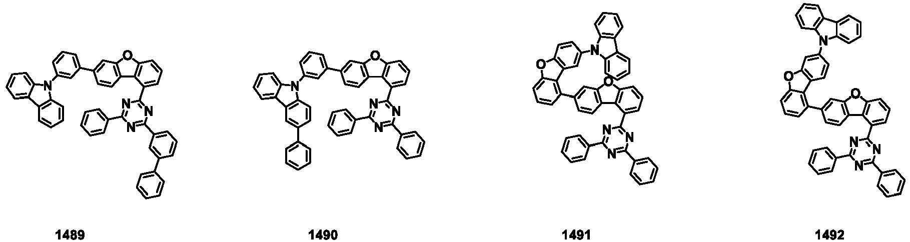

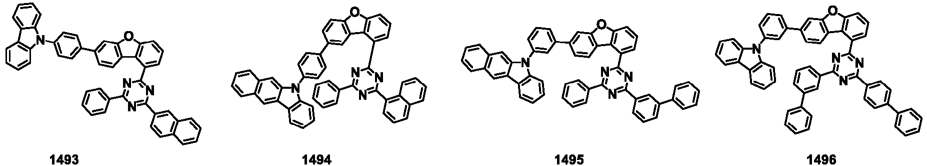

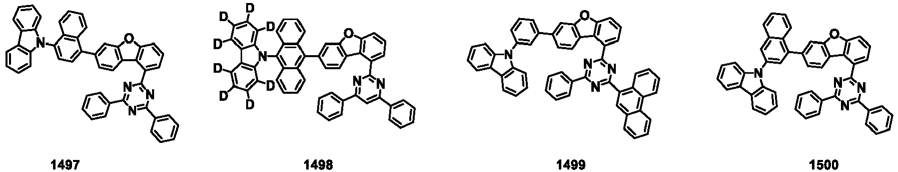

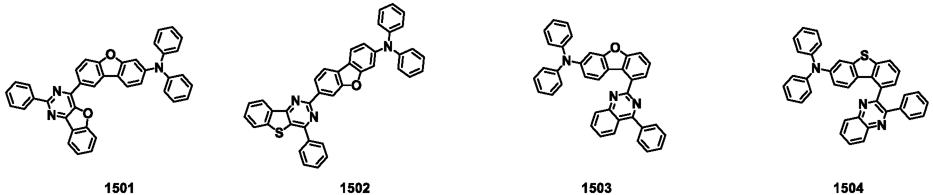

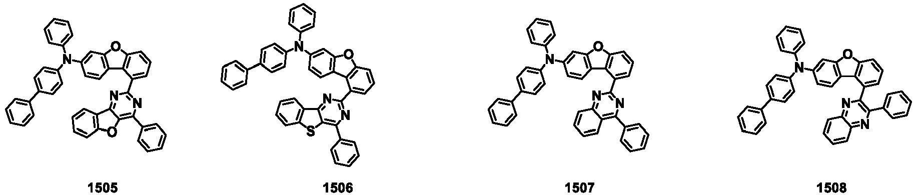

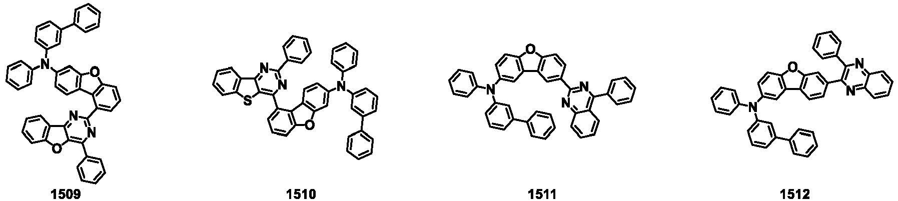

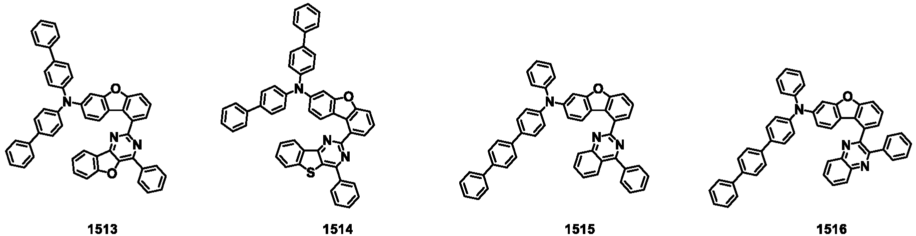

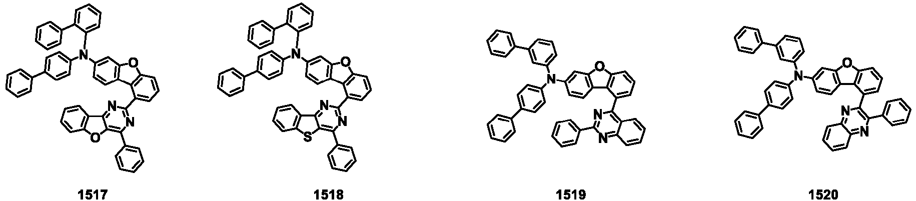

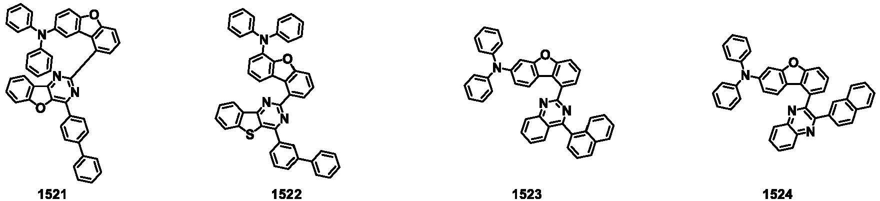

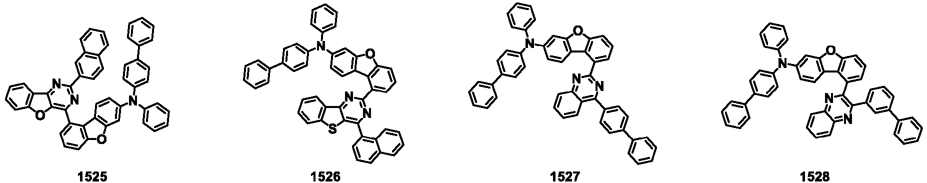

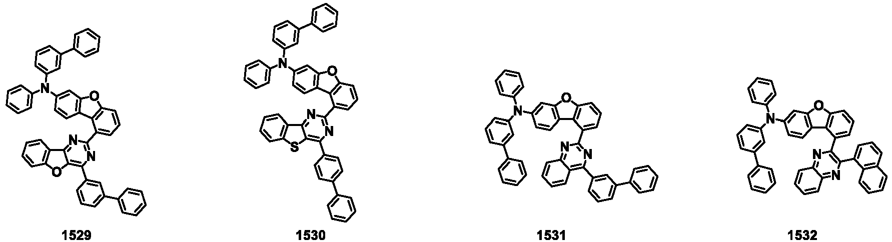

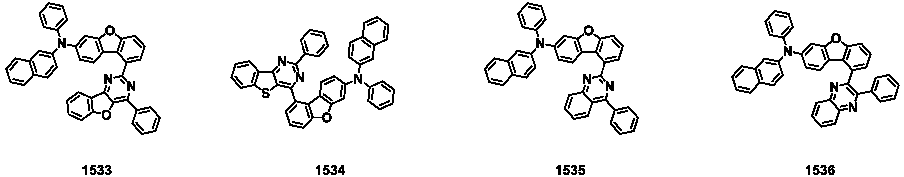

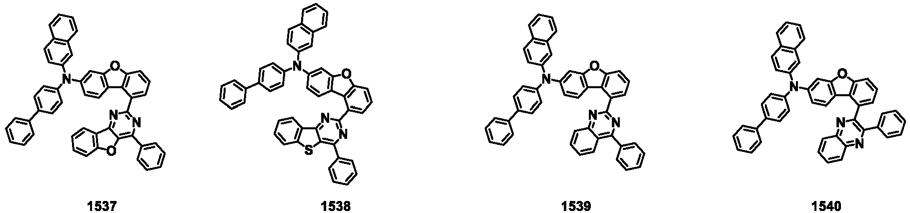

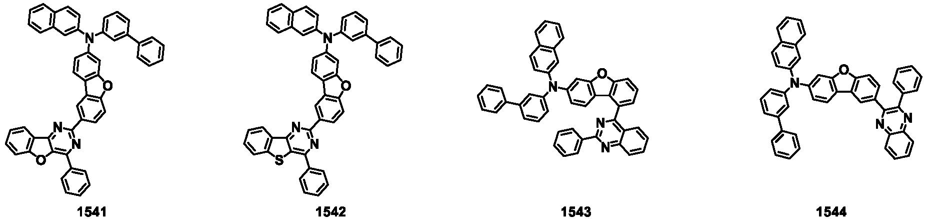

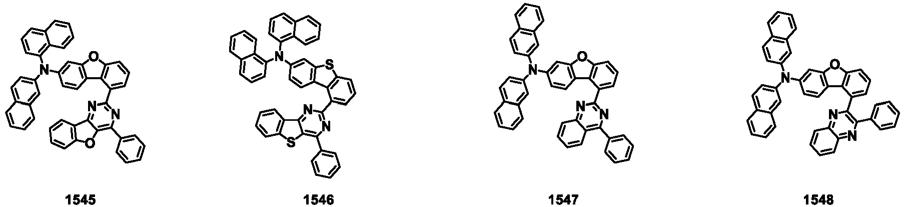

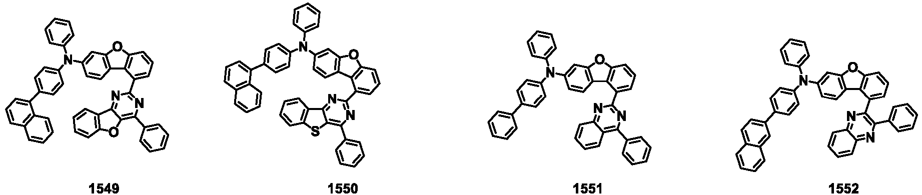

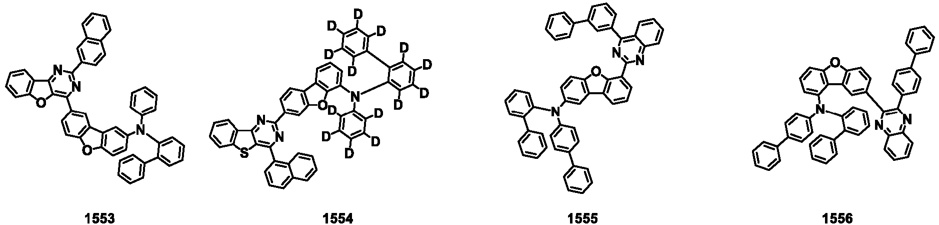

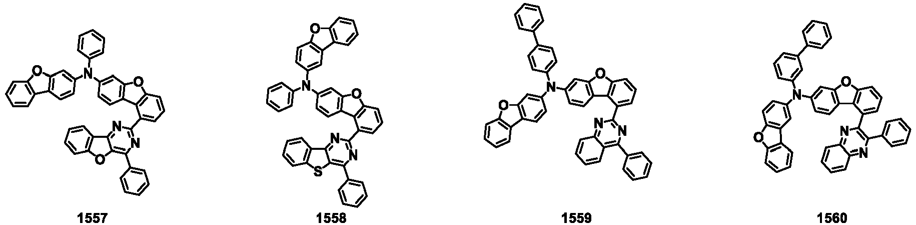

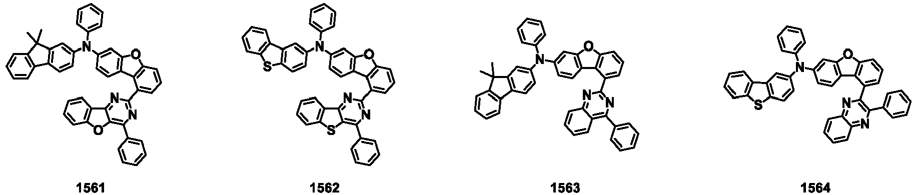

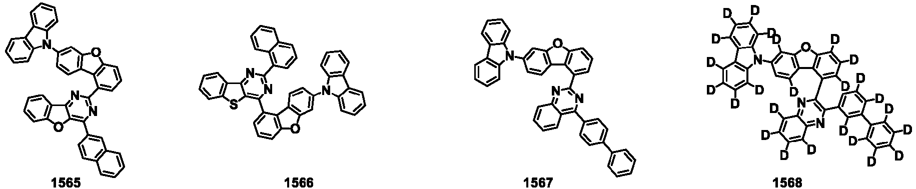

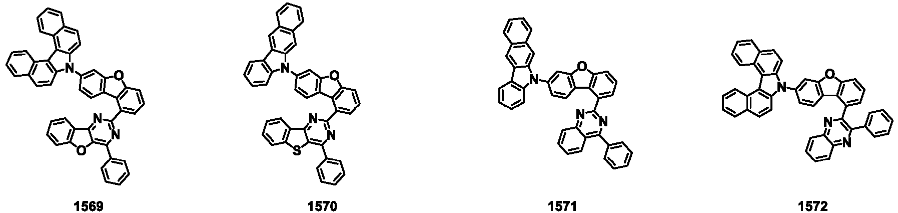

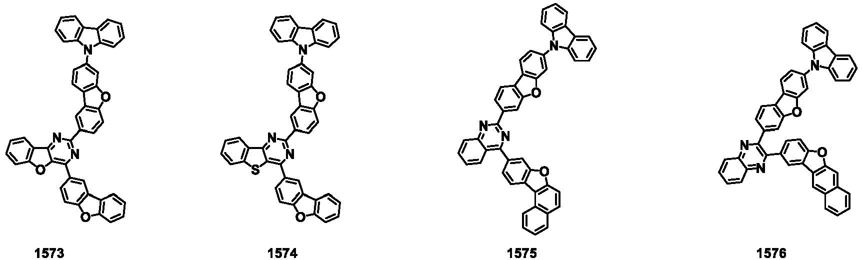

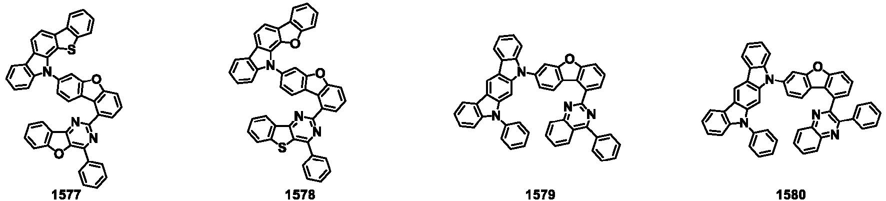

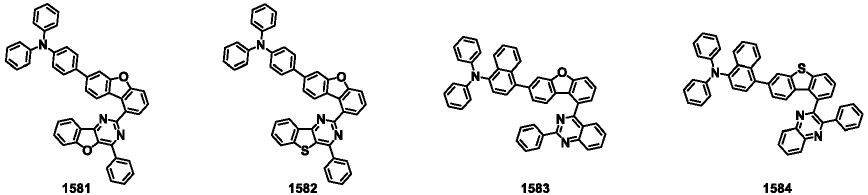

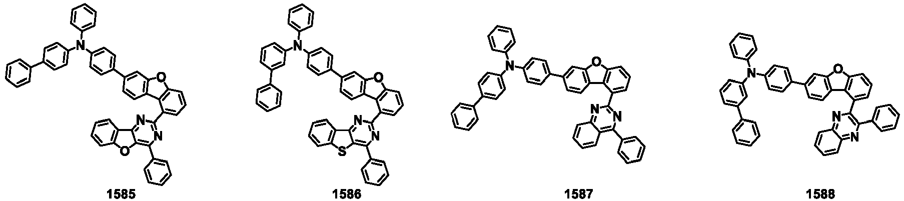

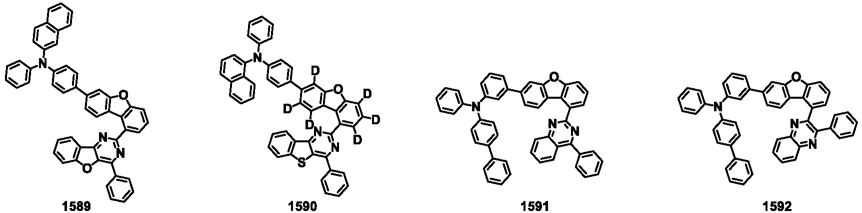

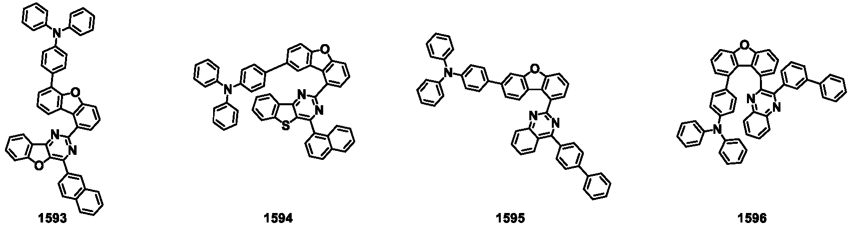

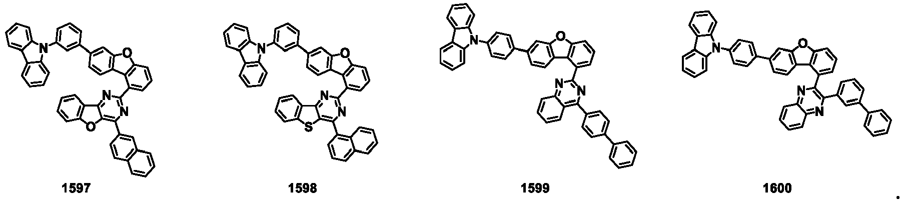

9. The organic light emitting device of claim 1, wherein the organic material layer comprises a light emitting layer, and the light emitting layer comprises the heterocyclic compound represented by Chemical Formula 1 and the heterocyclic compound represented by Chemical Formula 2.

10. The organic light emitting device of claim 9, wherein the light emitting layer optionally comprises a host material, and the host material comprises the heterocyclic compound represented by Chemical Formula 1 and the heterocyclic compound represented by Chemical Formula 2.

11. The organic light emitting device of claim 10, wherein the host material optionally comprises two or more host materials, and among the two or more host materials, the heterocyclic compound represented by Chemical Formula 1 is an N-type host material, and the heterocyclic compound represented by Chemical Formula 2 is a P-type host material.

12. The organic light emitting device of claim 10, wherein the host material optionally comprises two or more host materials, and the two or more host materials are pre-mixed and used.

13. A composition for an organic material layer of the organic light emitting device comprising both the heterocyclic compound represented by Chemical Formula 1 and the compound represented by Chemical Formula 2 according to claim 1.

14. The composition of claim 13, wherein a weight ratio of the heterocyclic compound represented by Chemical Formula 1 : the compound represented by Chemical Formula 2 in the composition is 1 : 10 to 10 : 1.

15. A method of manufacturing an organic light emitting device, the method comprising: preparing a substrate;
forming a first electrode on the substrate;
forming an organic material layer having one or more layers on the first electrode; and
forming a second electrode on the organic material layer,
wherein the forming of the organic material layer comprises forming an organic material layer having one or more layers by using the composition of claim 13.
